# EUROPEAN PATENT SPECIFICATION

(11) **EP 3 188 268 B1**
(45) Date of publication and mention of the grant of the patent: **07.04.2021**
(21) Application number: 16186703.1
(22) Date of filing: 31.08.2016
(51) Int. Cl.: H01L 51/50, H01L 51/54, C09K 11/02, C09K 11/06

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 29.12.2015 KR 20150188909
(43) Date of publication of application: 05.07.2017
(73) Proprietor: Samsung Display Co., Ltd., Gyeonggi-Do (KR)
(72) Inventor: CHO, Hwan-Hee, Gyeonggi-do (KR); KIM, Myeong-Suk, Gyeonggi-do (KR); KIM, Hee-Yeon, Gyeonggi-do (KR); CHU, Chang-Woong, Gyeonggi-do, (KR)
(74) Representative: Russell, Tim

(56) References cited:
- US-A1- 2012 214 993
- US-A1- 2013 234 119
- US-A1- 2014 332 793
- US-A1- 2015 236 264
- US-A1- 2015 318 488
- US-A1- 2015 318 508
- US-A1- 2015 325 798

## Description

### FIELD OF THE INVENTION

The present invention relates to an organic light-emitting device.

### BACKGROUND OF THE INVENTION

Organic light-emitting devices are self-emission devices that have wide viewing angles, high contrast ratios, short response times, and/or excellent luminance, driving voltage, and/or response speed characteristics, and may produce full color images.

For example, an organic light-emitting device may comprise a first electrode on a substrate, and a hole transport region, an emission layer, an electron transport region, and a second electrode that are sequentially formed on the first electrode. Holes injected from the first electrode are transported to the emission layer through the hole transport region, and electrons injected from the second electrode are transported to the emission layer through the electron transport region. Carriers, such as the holes and the electrons, may then recombine in the emission layer to generate excitons. When the excitons drop from an excited state to a ground state, light is emitted

US 2015/318488 A1 discloses OLEDs comprising two host materials selected from pyrrolidine based materials represented by formula 1-10 and the electron transporting material being chosen from known materials such as Alq3, BAlq, TAZ and NTAZ. US 2014/332793 A1 discloses a similar class of host materials, see for example compound of formula 3.

### SUMMARY OF THE INVENTION

The present invention is directed to an organic light-emitting device comprising:
a first electrode;
a second electrode facing the first electrode; and
an organic layer between the first electrode and the second electrode, the organic layer comprising an emission layer, and an electron transport region disposed between the emission layer and the second electrode,
wherein the emission layer comprises a first compound represented by one selected from Formulae 1-14a to 1-14g, and characterized in that the electron transport region comprises a second compound represented by Formula 2:

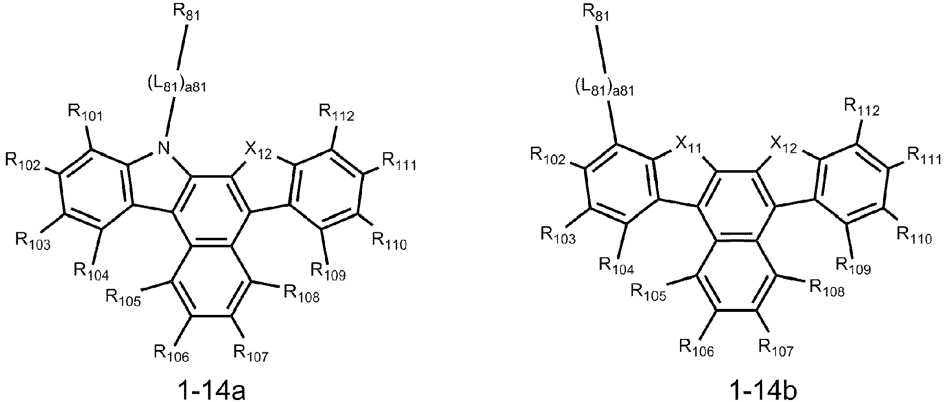

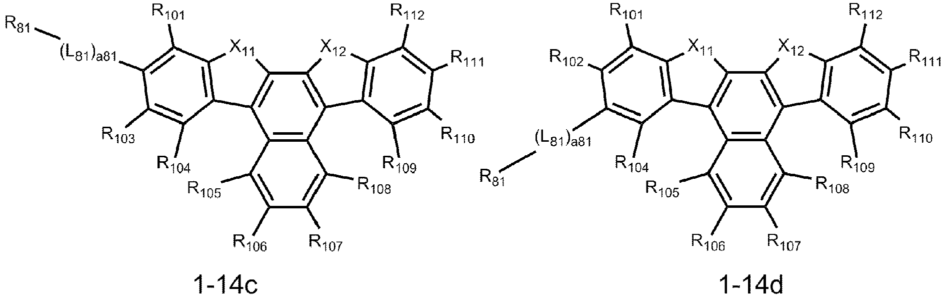

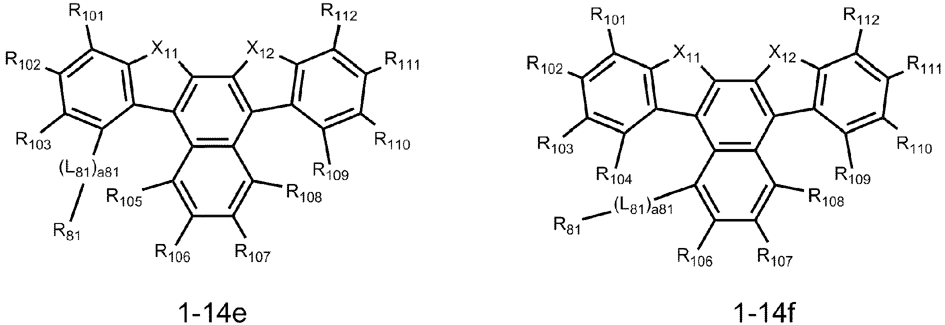

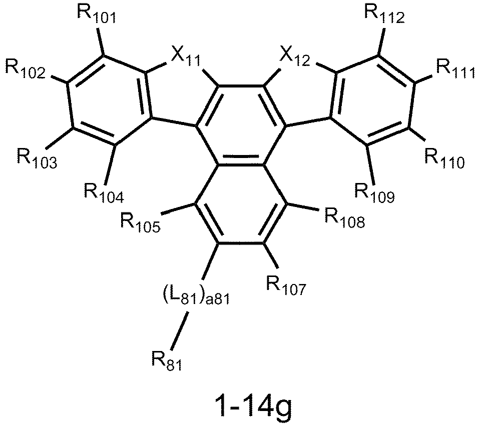

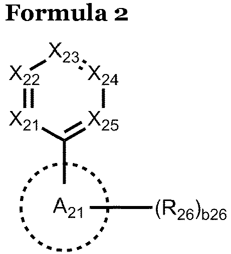

wherein, in Formulae 1-14a to 1-14g, and 2,
X₁₁ is selected from N(R₁₁), C(R₁₁)(R₁₂), O, and S,
X₁₂ is selected from N(R₁₃), C(R₁₃)(R₁₄), O, and S,
A₂₁ is selected from a C₆-C₂₀ arene group and a C₁-C₂₀ heteroarene group, provided that A₂₁ is not an anthracene, pyridine or pyrimidine group,
   i) X₂₁ is N, X₂₂ is C(R₂₂), X₂₃ is N, X₂₄ is C(R₂₄), and X₂₅ is N,
b26 is selected from 1, 2, 3, 4, 5, and 6,
R₁₀₁ to R₁₁₂ are each independently selected from a group represented by Formula 8, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), - N(Q₁)(Q₂), -B(Q₁)(Q₂), -C(=O)(Q₁), -S(=O)₂(Q₁), and -P(=O)(Q₁)(Q₂), wherein at least one selected from R₁₁ to R₁₇ is the group represented by Formula 8,
**Formula 8**
*-(L₈₁)ₐ₈₁-R₈₁
   L₈₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
a81 is selected from 0, 1, and 2,
R₈₁ is selected from a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group,
R22, R₂₄, and R₂₆ are each independently selected from a group represented by Formula 9, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group and a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), provided that R₂₆ is not an anthracenyl, pyridinyl or pyrimidinyl group, wherein at least one selected from R₂₂, R₂₄, and R₂₆ is the group represented by Formula 9,

   **Formula 9** *-(L₉₁)ₐ₉₁-R₉₁,

   L₉₁ is selected from a substituted or unsubstituted C₆-C₆₀ arylene group and a substituted or unsubstituted C₁-C₆₀ heteroarylene group, provided that L₉₁ is not an anthracenylene, pyridinylene or pyrimidinylene group,
a91 is selected from 0, 1, and 2,
R₉₁ is selected from a substituted or unsubstituted C₆-C₆₀ aryl group and a substituted or unsubstituted C₁-C₆₀ heteroaryl group, provided that R₉₁ is not an anthracenyl, pyridinyl or pyrimidinyl group,
Q₁ to Q₃ are each independently selected from hydrogen, deuterium, -F, - Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group, and
* indicates a binding site to a neighboring atom.

### BRIEF DESCRIPTION OF THE DRAWINGS

These and/or other aspects will become apparent and more readily appreciated from the following description of the embodiments, taken in conjunction with the accompanying drawings in which:
FIG. 1 is a schematic cross-sectional view of an organic light-emitting device according to an embodiment;
FIG. 2 is a schematic cross-sectional view of an organic light-emitting device according to another embodiment;
FIG. 3 is a schematic cross-sectional view of an organic light-emitting device according to another embodiment; and
FIG. 4 is a schematic cross-sectional view of an organic light-emitting device according to another embodiment.

### DETAILED DESCRIPTION OF THE INVENTION

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or component is referred to as being "on" or "onto" another layer, region, or component, it may be directly or indirectly formed on the other layer, region, or component. That is, for example, intervening layer(s), region(s), or component(s) may be present.

Sizes of components in the drawings may be exaggerated for convenience of explanation. In other words, since sizes and thicknesses of components in the drawings are arbitrarily illustrated for convenience of explanation, the following embodiments are not limited thereto.

As used herein, the expression "(an organic layer) comprises at least one first compound" may refer to a case where "(an organic layer) may comprise one first compound represented by Formula 1, or two or more different first compounds represented by Formula 1".

As used herein, the term "an organic layer" refers to a single and/or a plurality of layers between a first electrode and a second electrode in an organic light-emitting device. A material comprised in an "organic layer" may comprise other materials (e.g., inorganic materials) in addition to an organic material.

For example, in Formula 8, L₈₁ may be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosiloleylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosiloleylene group, a benzocarbazolylene group, and a dibenzocarbazolylene group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂), and
Q₃₁ to Q₃₃ may each independently be selected from hydrogen, a methyl group, an ethyl group, an n-propyl group, an iso-propyl group, a tert-butyl group, a phenyl group, a biphenyl group, and a terphenyl group

In Formula 8, R₈₁ is selected from a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group.

For example, in Formula 8, R₈₁ may be selected from the group consisting of:
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group;
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and -Si(Q₃₁)(Q₃₂)(Q₃₃); and
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one substituent selected from a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each of the at least one substituent is substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₂₁)(Q₂₂), and -Si(Q₂₁)(Q₂₂)(Q₂₃), and
Q₂₁ to Q₂₃ and Q₃₁ to Q₃₃ may each independently be selected from a C₁-C₆₀ alkyl group and a C₆-C₆₀ aryl group.

In various examples, in Formula 8, R₈₁ may be selected from groups represented by Formulae 5-1 to 5-86:

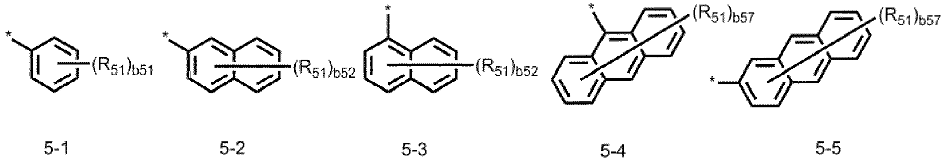

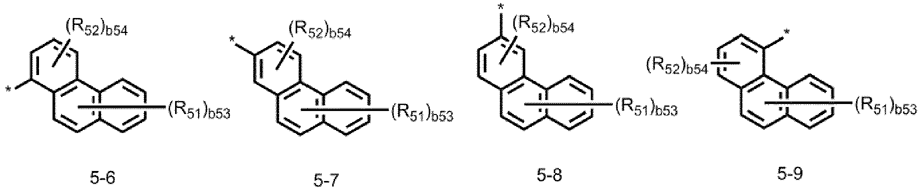

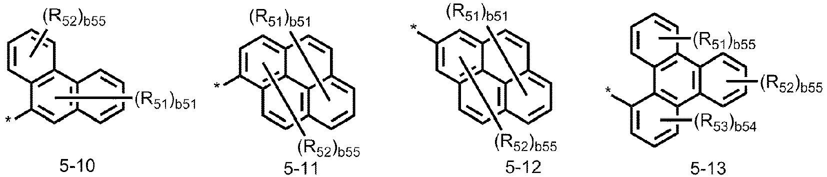

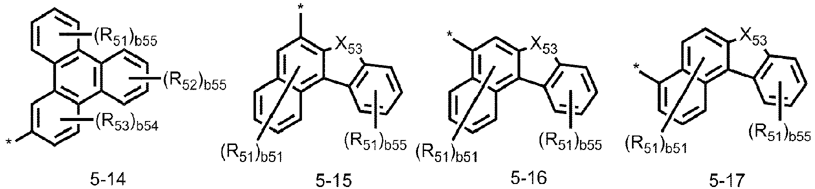

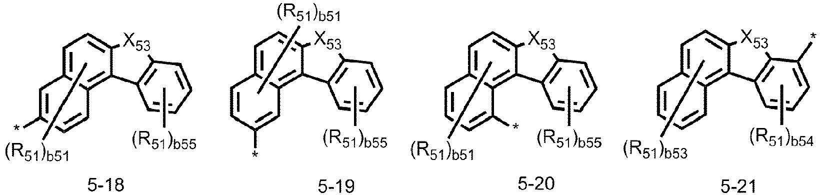

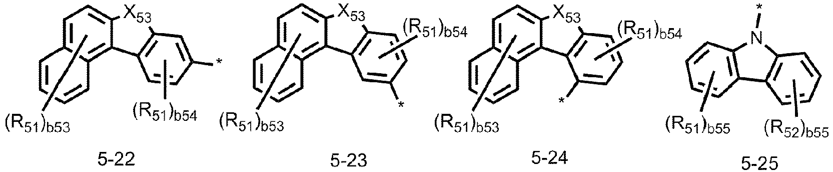

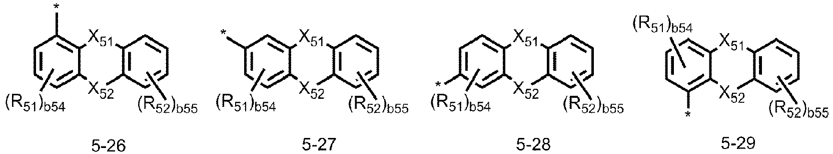

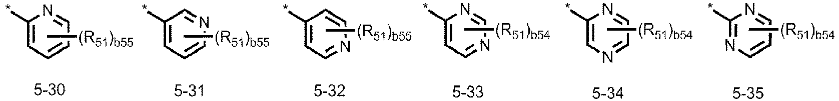

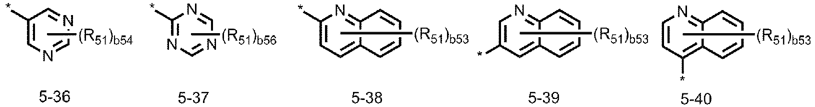

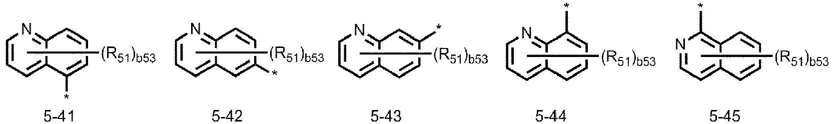

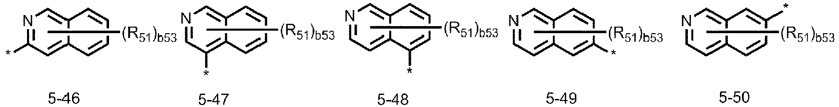

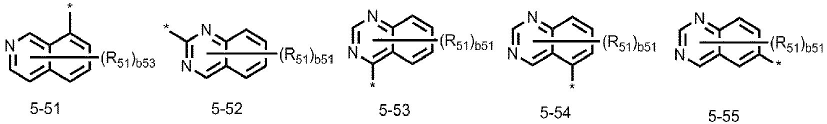

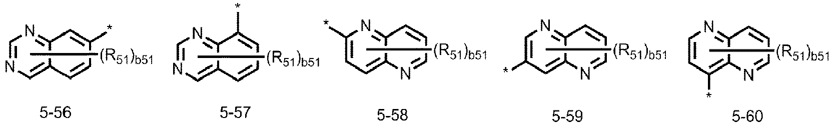

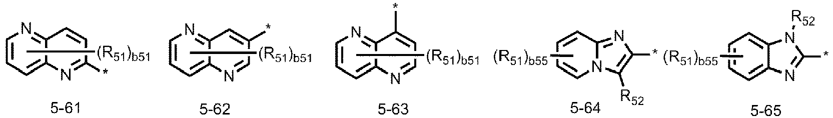

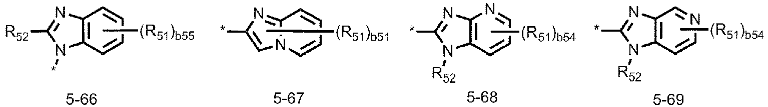

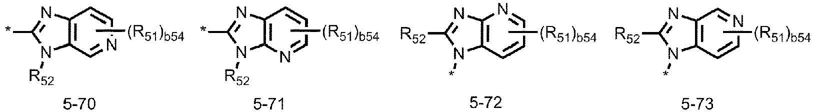

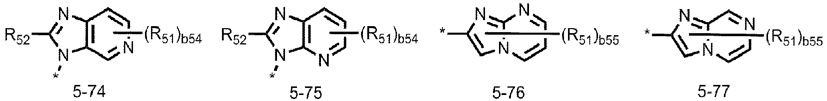

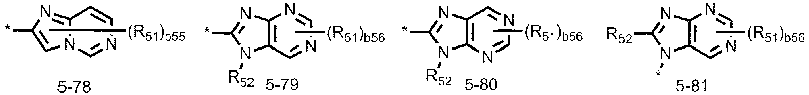

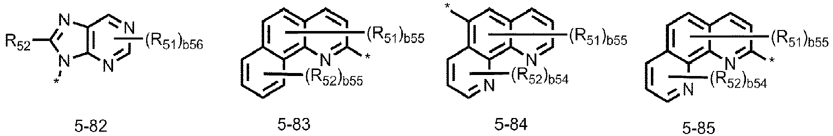

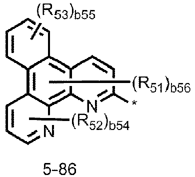

In Formulae 5-1 to 5-86,
X₅₁ may be selected from a single bond, N(R₅₄), C(R₅₄)(R₅₅), O, and S,
X₅₂ may be selected from N(R₅₆), C(R₅₆)(R₅₇), O, and S,
X₅₃ may be C(R₅₈)(R₅₉),
R₅₁ to R₅₉ may each independently be selected from the group consisting of:
hydrogen, deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and-Si(Q₃₁)(Q₃₂)(Q₃₃); and
a phenyl group, a biphenyl group, a terphenyl group, a naphthyl group, a pyridinyl group, a pyrimidinyl group, a pyridazinyl group, and a triazinyl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group,-N(Q₂₁)(Q₂₂), and -Si(Q₂₁)(Q₂₂)(Q₂₃),
Q₂₁ to Q₂₃ and Q₃₁ to Q₃₃ may each independently be selected from a methyl group, an ethyl group, a phenyl group, a biphenyl group, a terphenyl group, and a naphthyl group,
b51 may be selected from 1, 2, 3, 4, and 5,
b52 may be selected from 1, 2, 3, 4, 5, 6, and 7,
b53 may be selected from 1, 2, 3, 4, 5, and 6,
b54 may be selected from 1, 2, and 3,
b55 may be selected from 1, 2, 3, and 4,
b56 may be selected from 1 and 2,
b57 may be selected from 1, 2, 3, 4, 5, 6, 7, 8, and 9, and
* indicates a binding site to a neighboring atom.

In Formula 2
X₂₁ is N, X₂₂ is C(R₂₂), X₂₃ is N, X₂₄ is C(R₂₄), and X₂₅ is N.

In Formula 2, R₂₂, R₂₄ and R₂₆ are each independently selected from a group represented by Formula 9, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, - Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), wherein at least one selected from R₂₁ to R₂₆ may be the group represented by Formula 9, and
Q₁ to Q₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group:

**Formula 9** *-(L₉₁)ₐ₉₁-R₉₁,

wherein, in Formula 9, L₉₁, a91, and R₉₁ are as described below, and
* indicates a binding site to a neighboring atom.

According to the present invention, the first compound is represented by one selected from Formulae 1-14a to 1-14g:

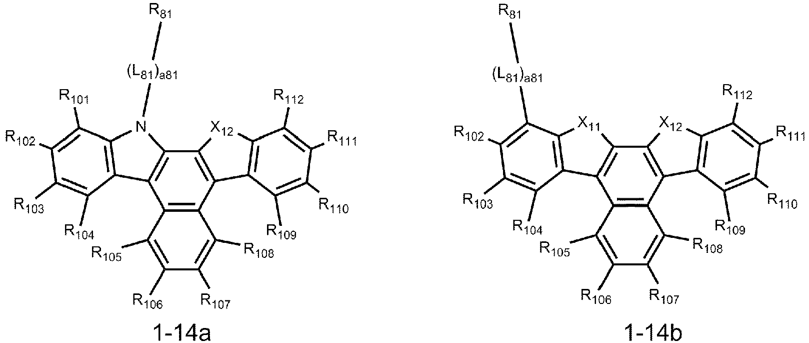

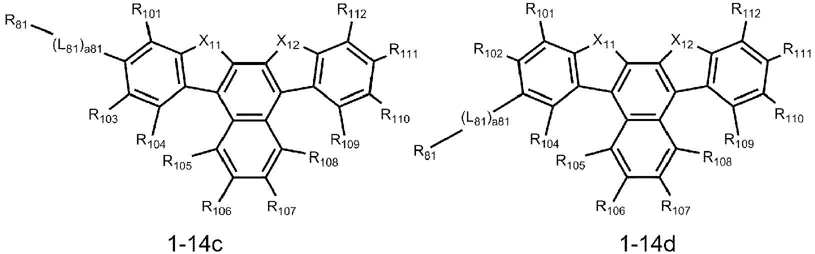

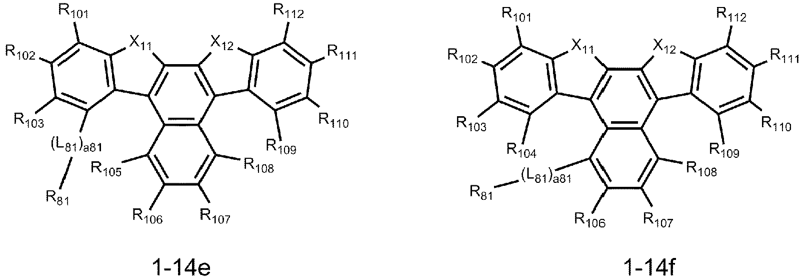

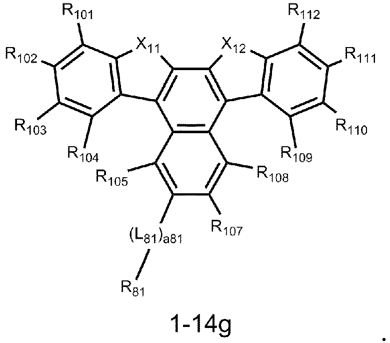

In Formulae 1-14a to 1-14g,
X₁₁ is selected from N(R₁₁), C(R₁₁)(R₁₂), O, and S,
X₁₂ is selected from N(R₁₃), C(R₁₃)(R₁₄), O, and S,
R₁₀₁ to R₁₁₂ are each independently selected from a group represented by Formula 8, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃),-N(Q₁)(Q₂), -B(Q₁)(Q₂), -C(=O)(Q₁), -S(=O)₂(Q₁), and -P(=O)(Q₁)(Q₂), wherein at least one selected from R₁₁ to R₁₇ is the group represented by Formula 8,

**Formula 8** *-(L₈₁)ₐ₈₁-R₈₁

L₈₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
a81 is selected from 0, 1, and 2,
R₈₁ is selected from a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group,
, and
* indicates a binding site to a neighboring atom.

The first compound represented by one selected from Formulae 1-1 and 1-2 may be selected from Compounds B-101 to B-205:

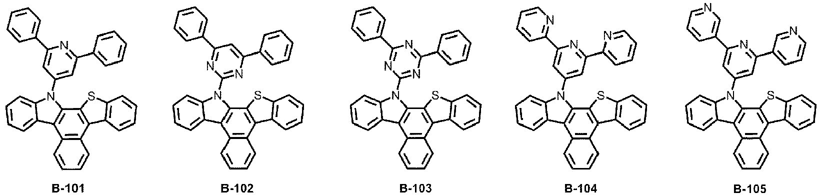

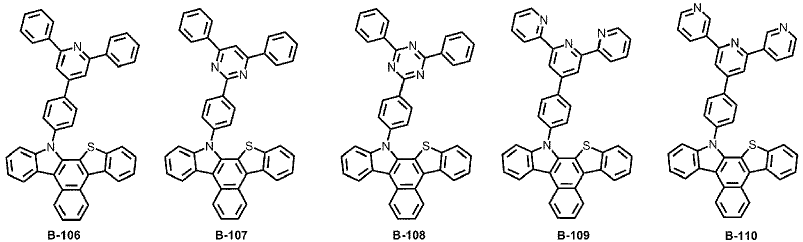

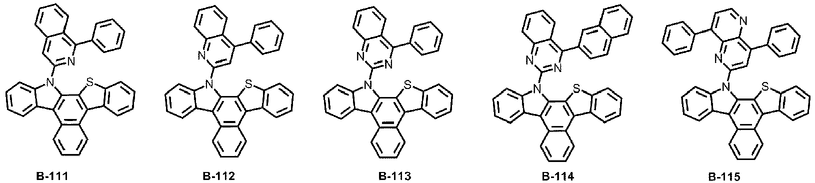

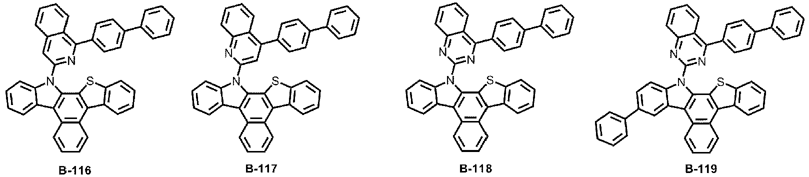

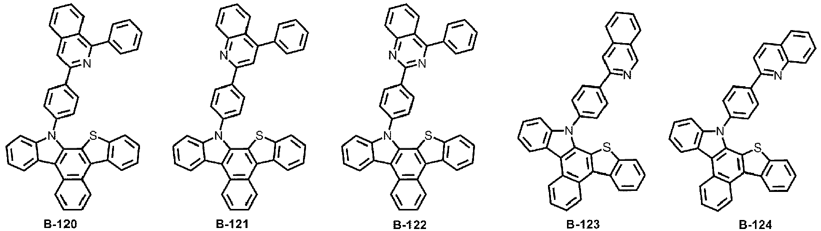

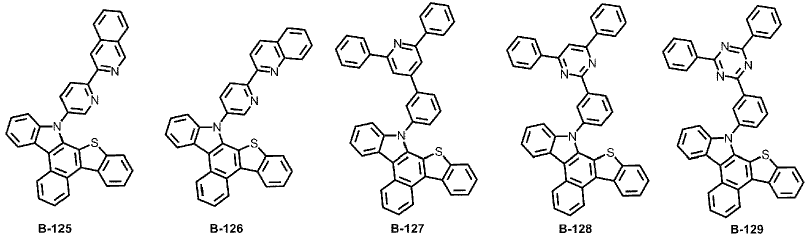

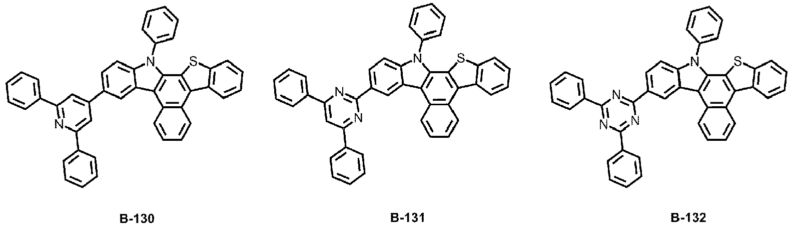

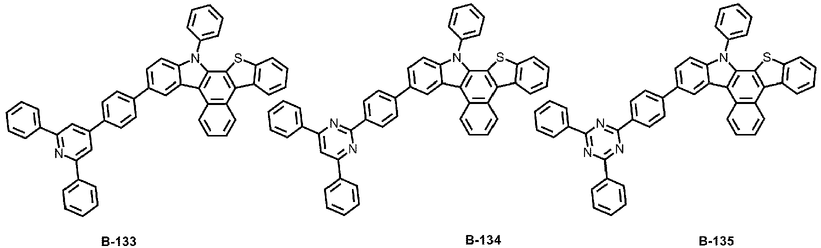

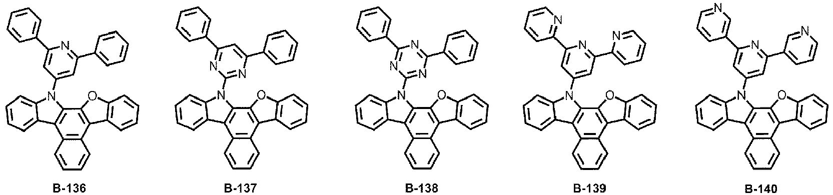

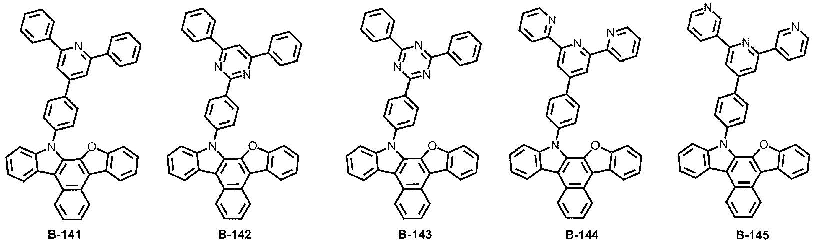

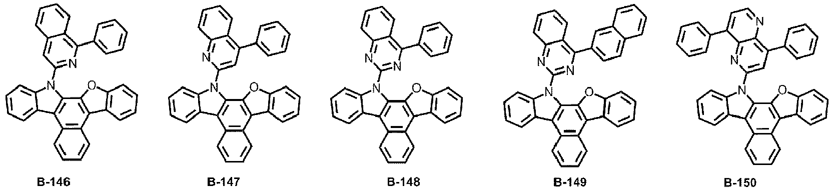

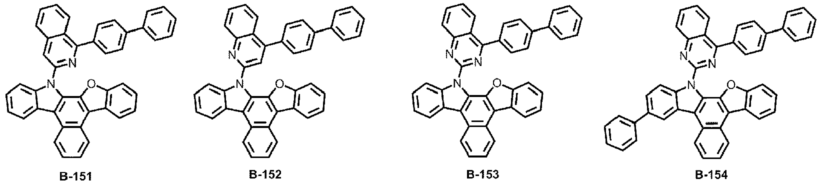

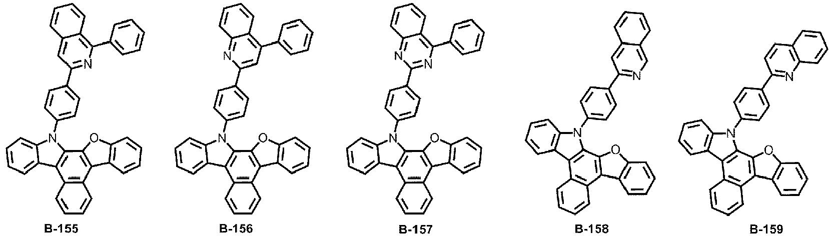

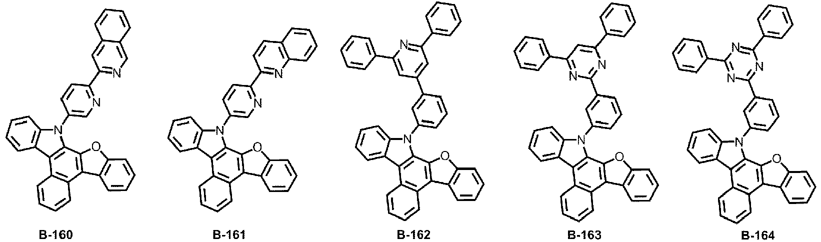

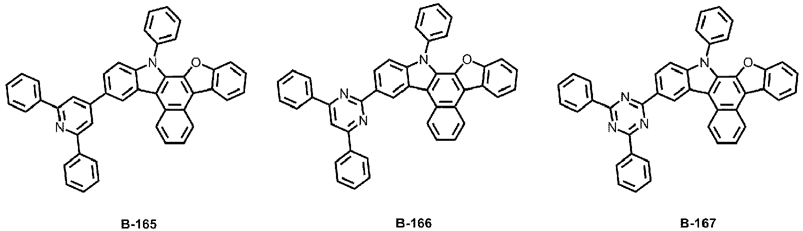

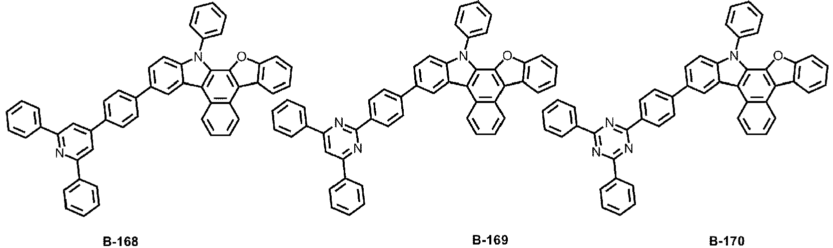

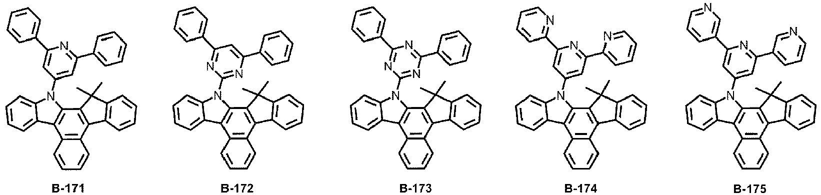

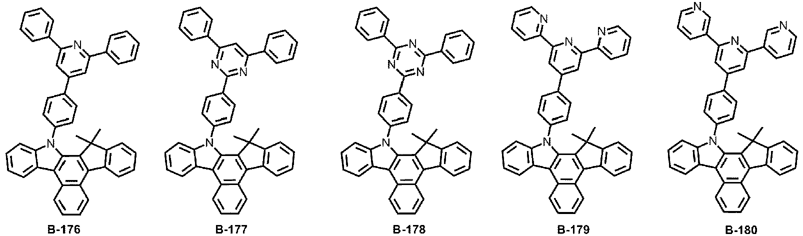

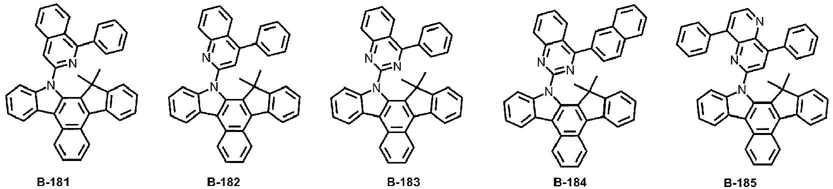

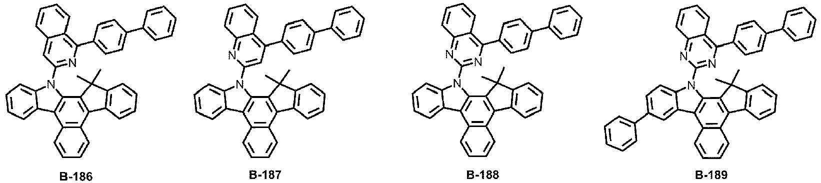

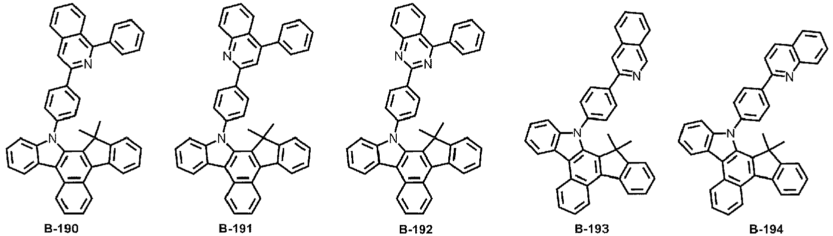

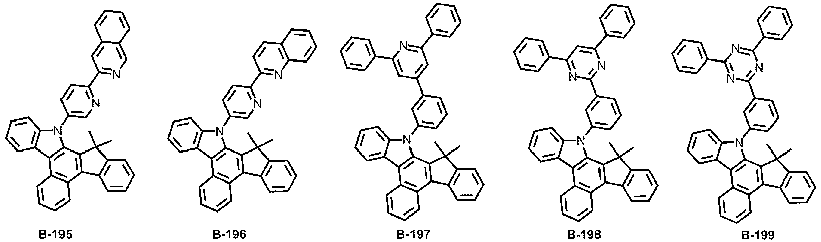

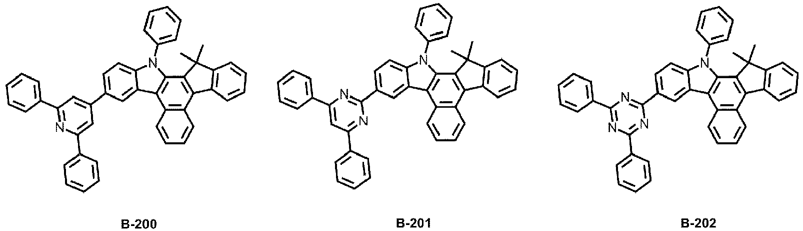

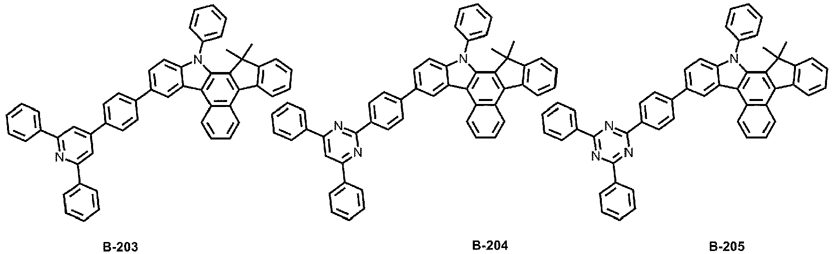

The second compound represented by Formula 2 may be selected from Compounds E-1 to E-20, E-25 to E-36, E-41 to E-52, E-113 to E-115, E-117 to E-122, E-124, E-128, E-129, E-131 to E-134, E-154 to E-169, E-201 to E-203, E-205 to E-210, E-212, E-216, E-218 to E-221, E-226 to E233, E-237 to E-242. Compounds of Formula 2 which do not form part of the present invention include Compounds E-21 to E-24, E-37 to E-40, E-53 to E-112, E-116, E-123, E-125 to E-127, E-130, E-135 to E-153, E-170 to E-200, E-204, E-211, E-213 to E-E-215, E-217, E-222 to E-225, E-234 to E-236, E-243 to E-274:

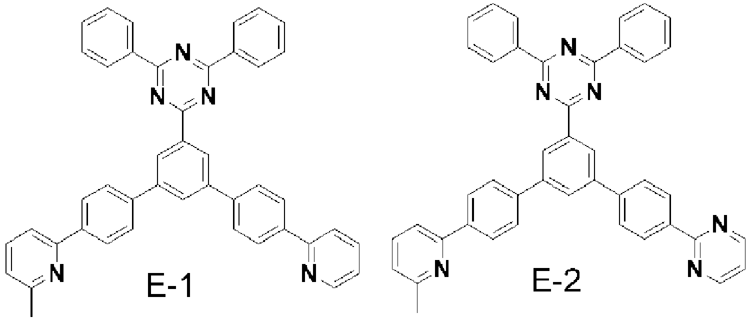

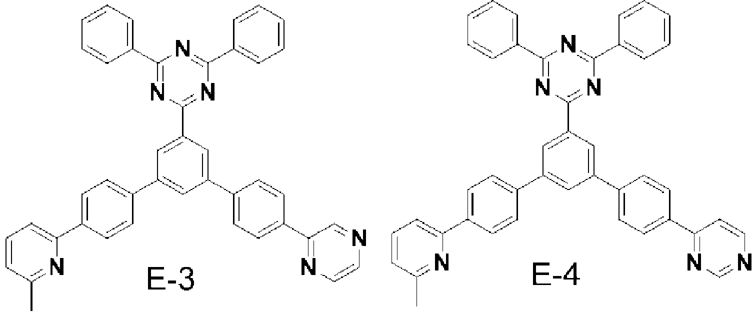

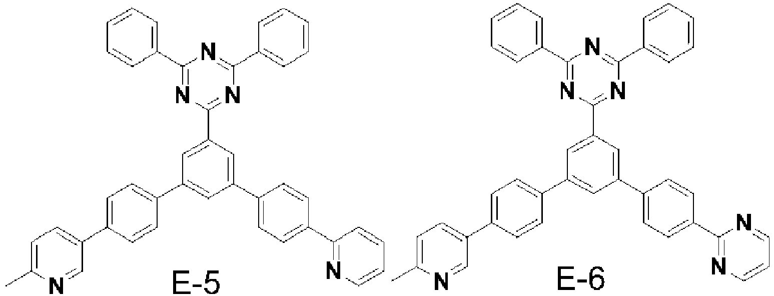

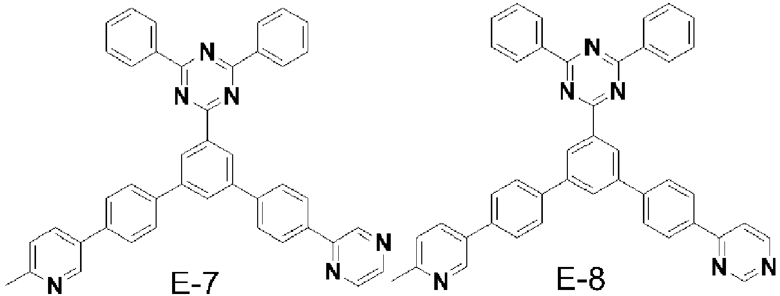

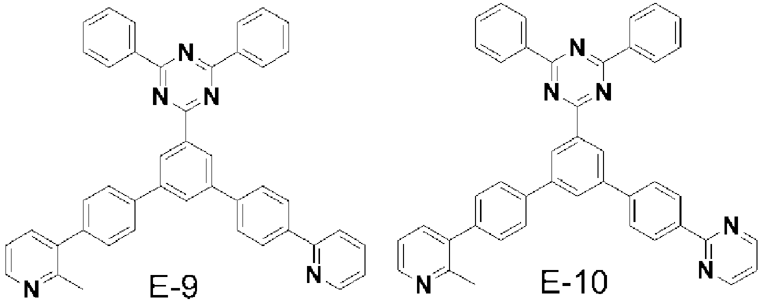

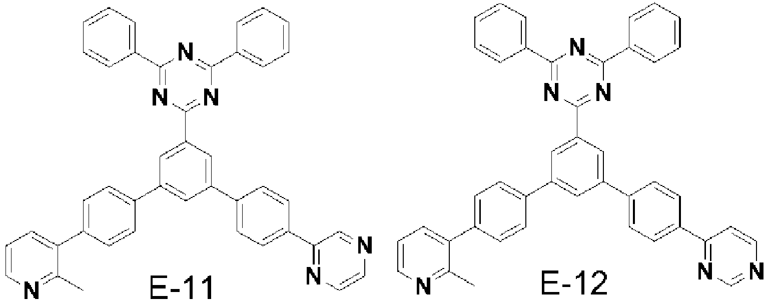

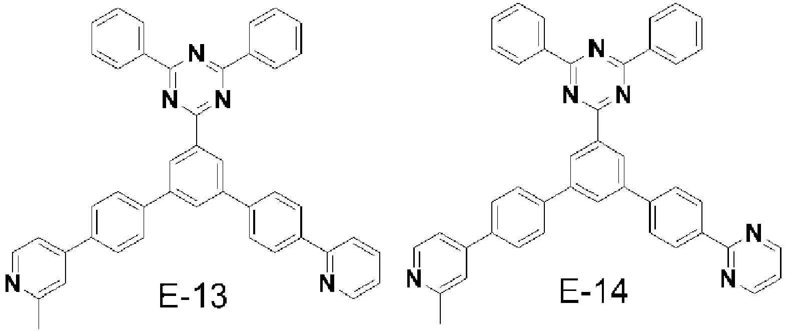

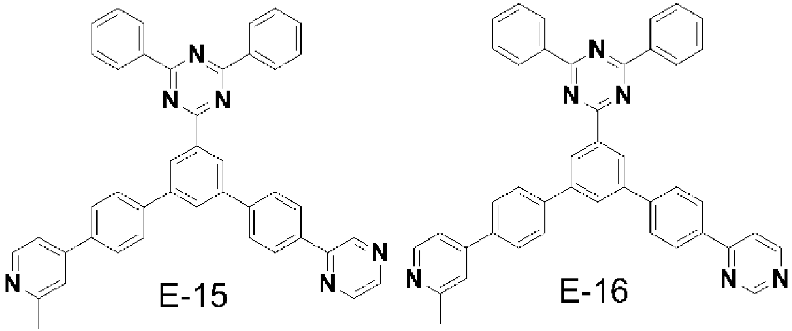

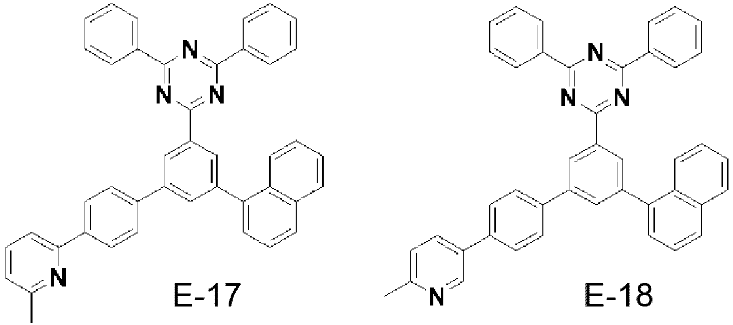

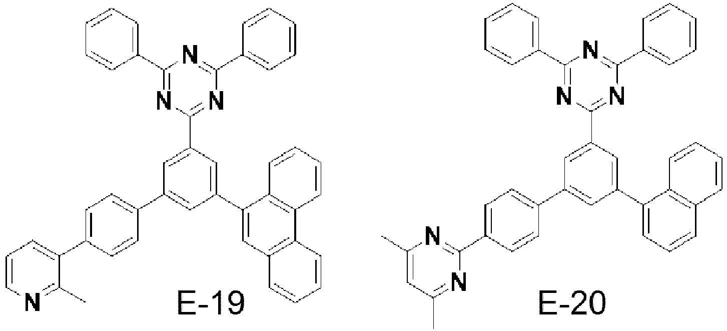

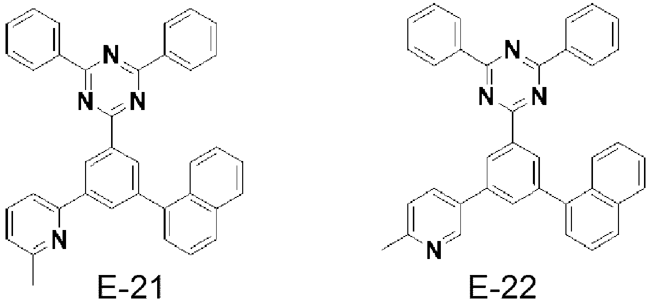

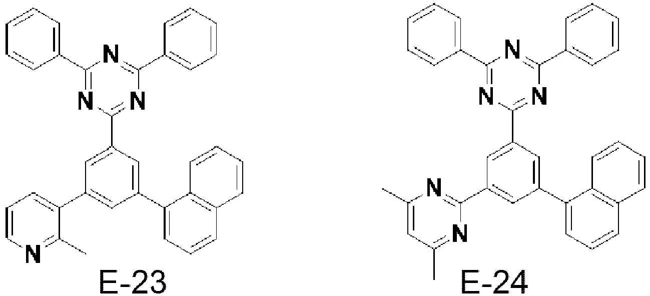

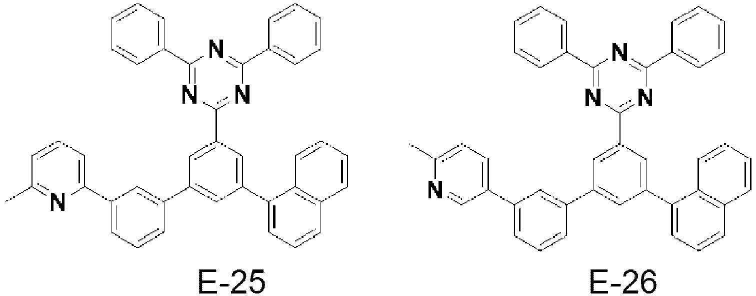

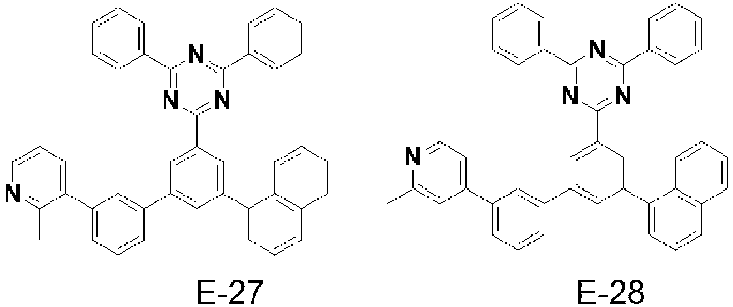

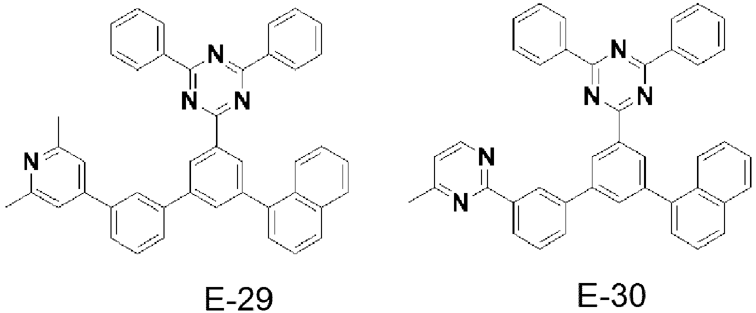

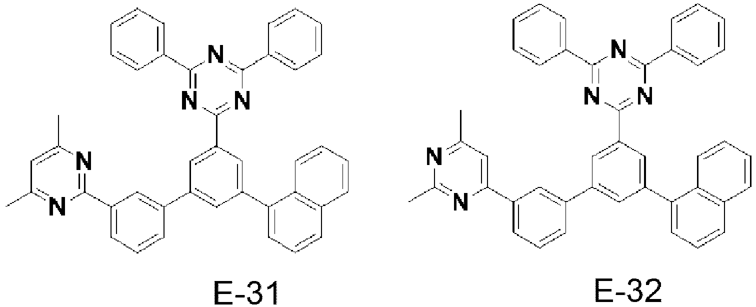

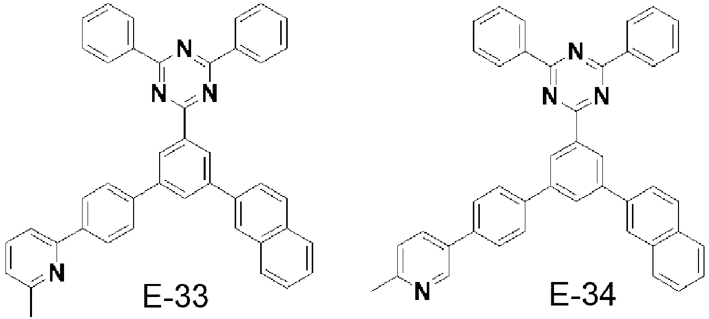

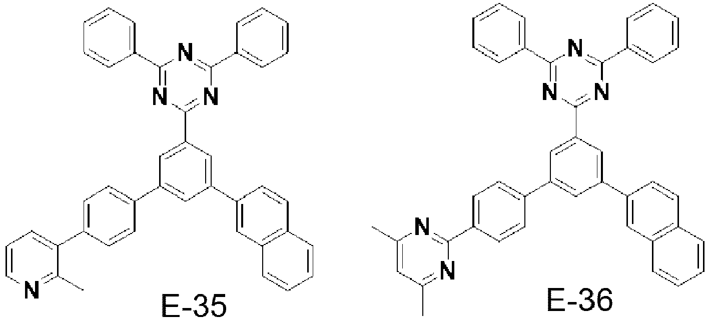

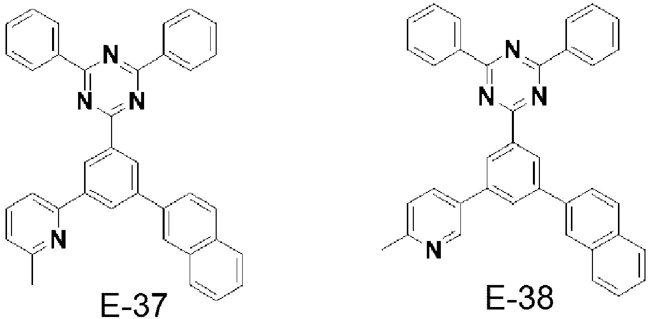

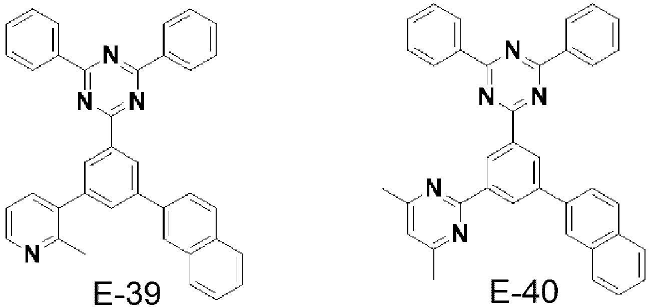

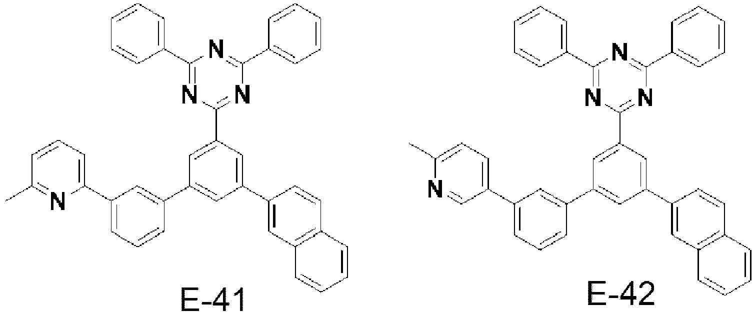

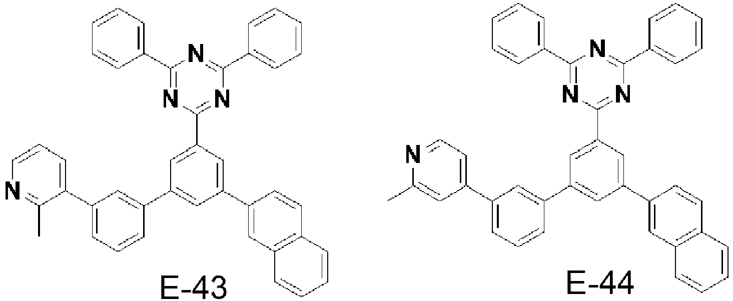

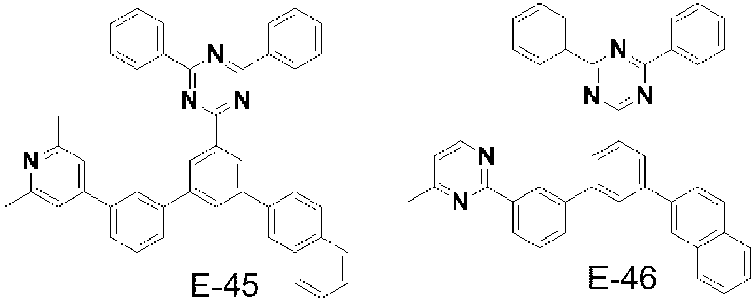

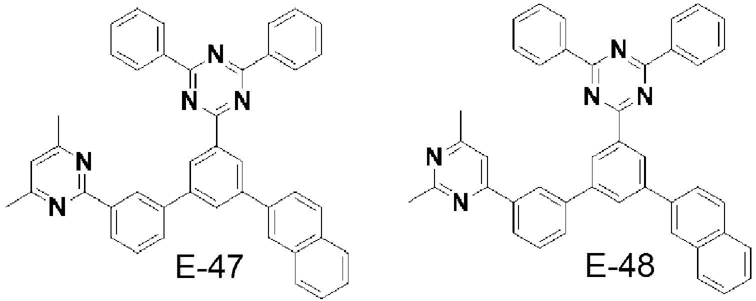

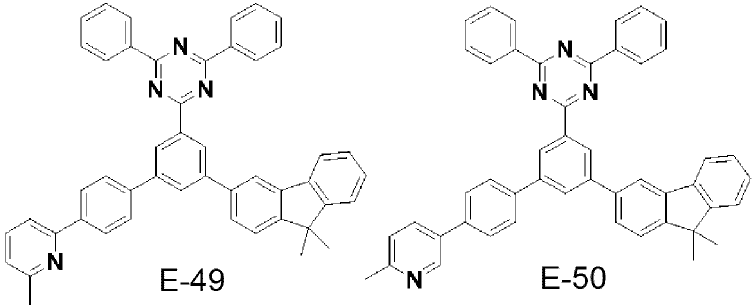

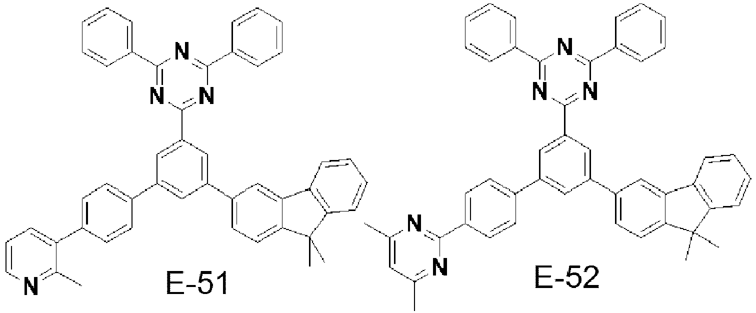

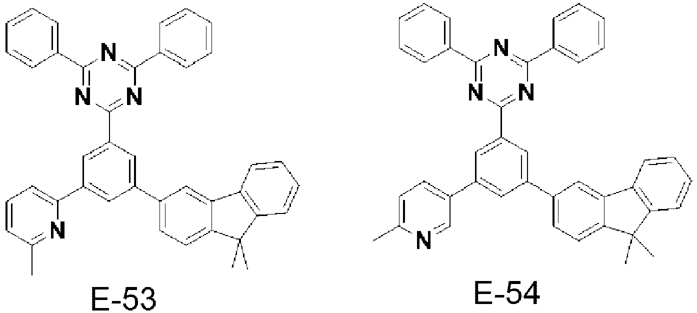

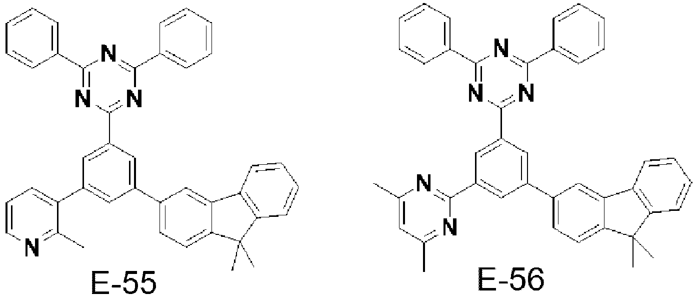

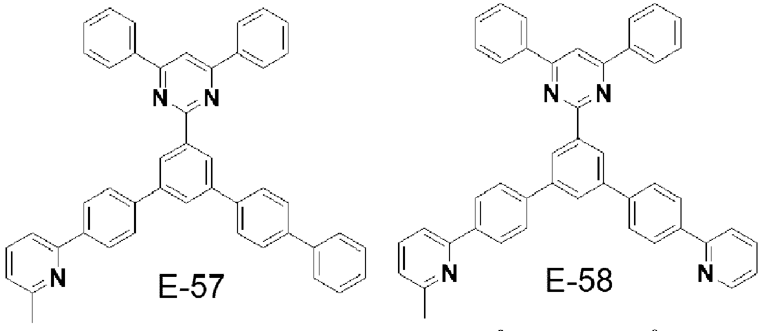

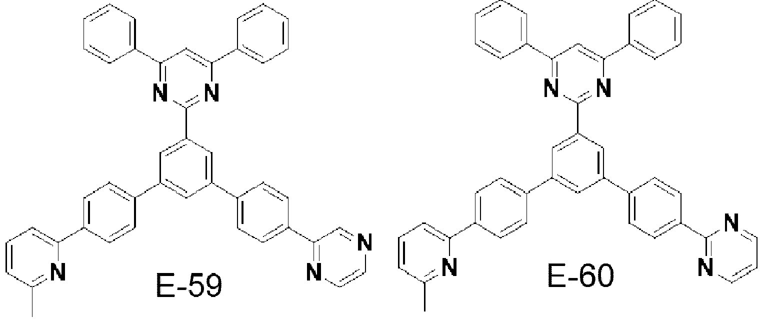

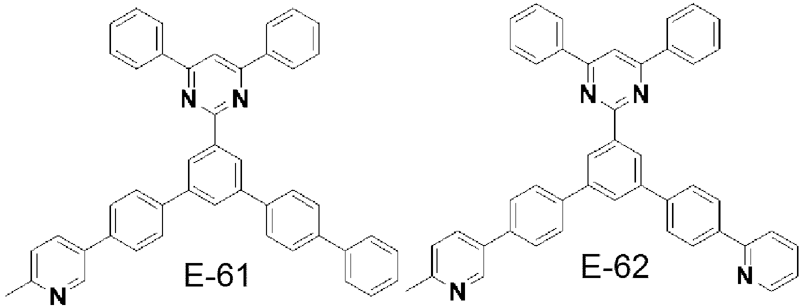

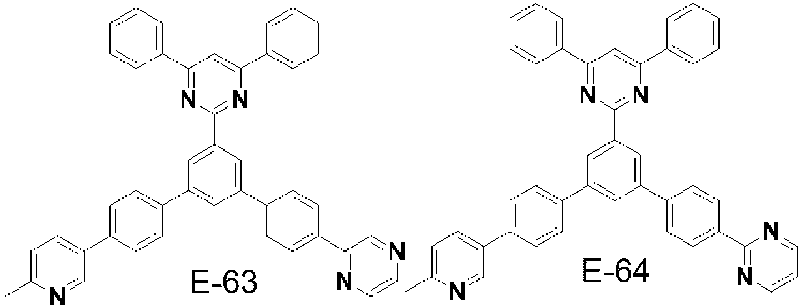

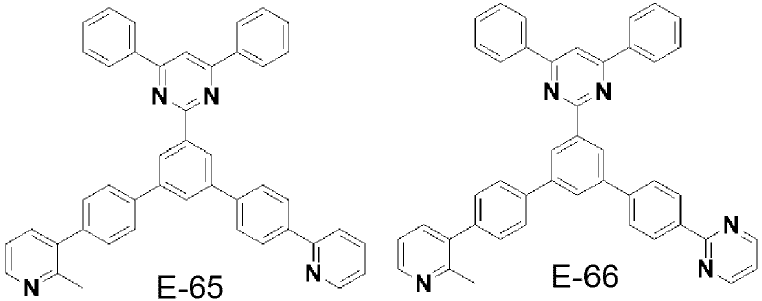

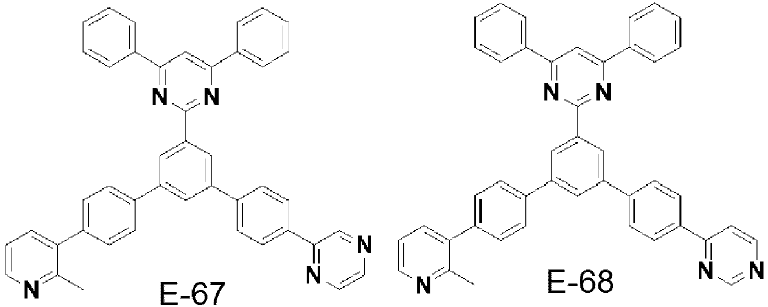

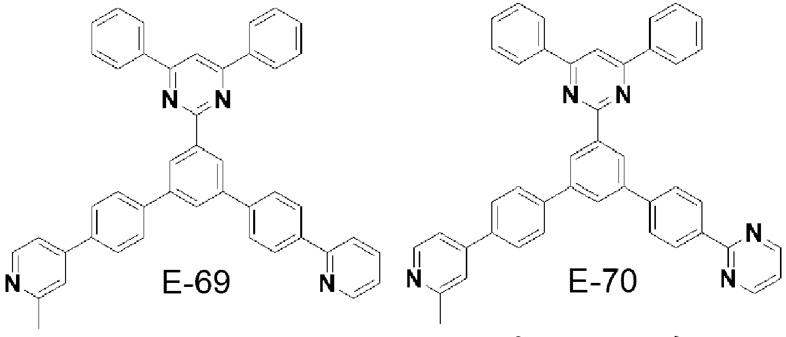

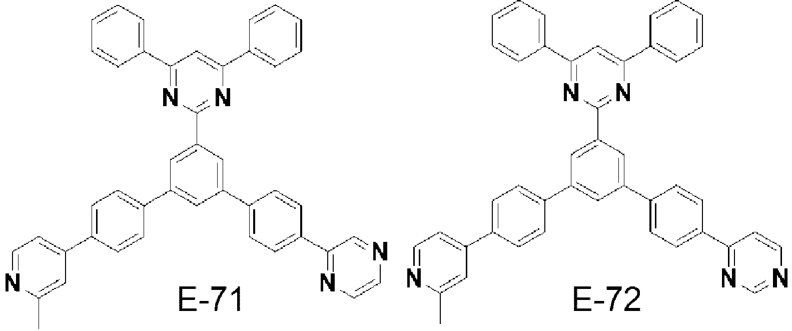

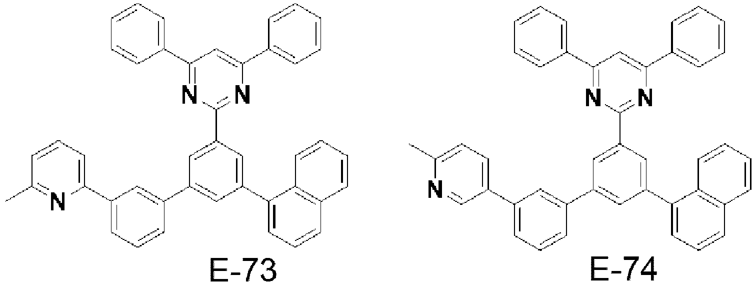

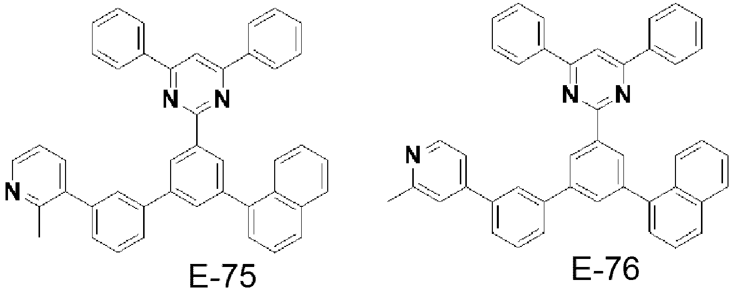

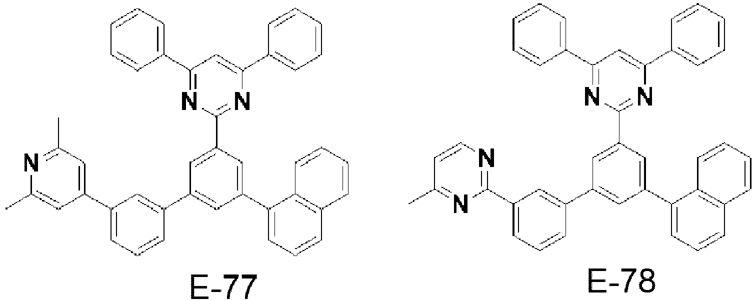

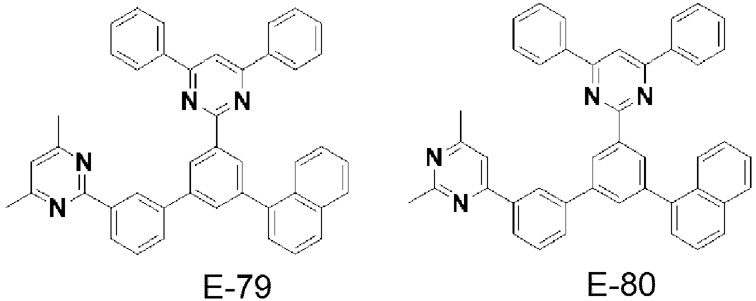

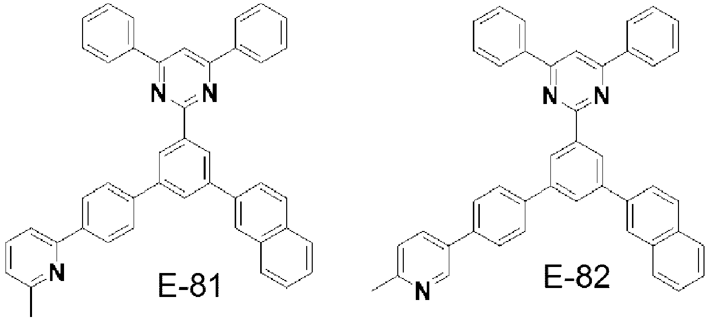

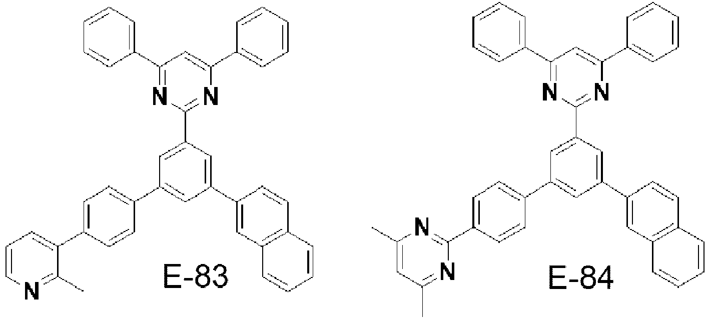

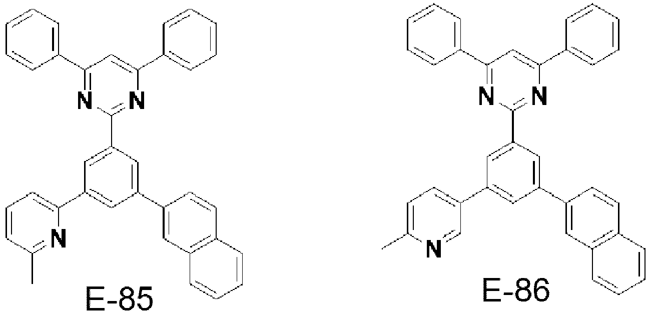

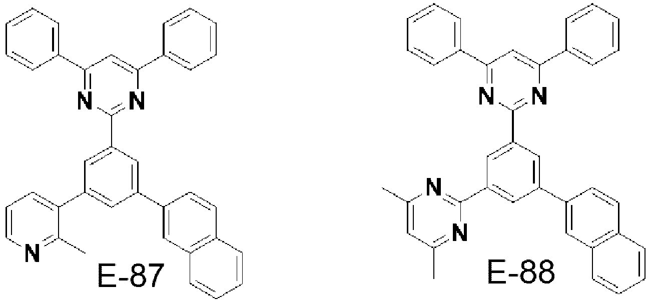

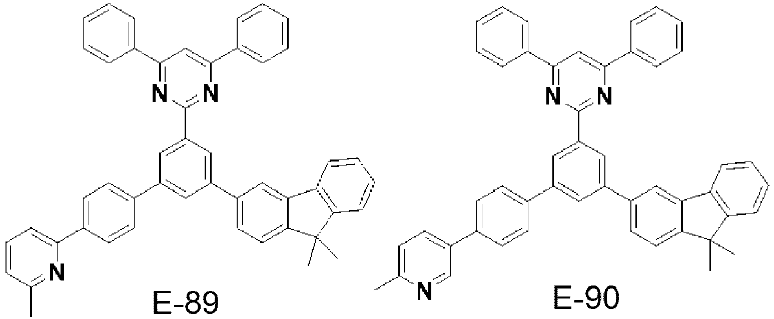

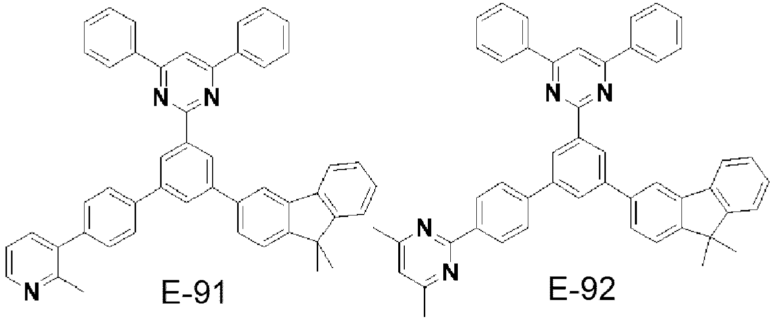

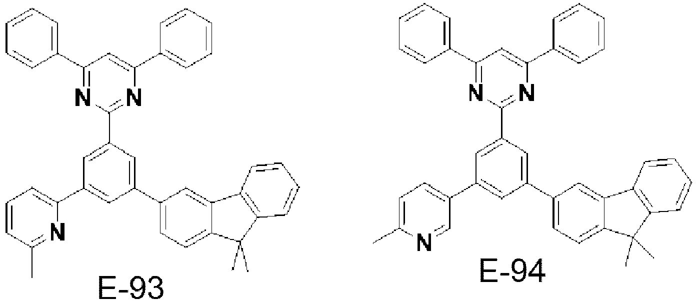

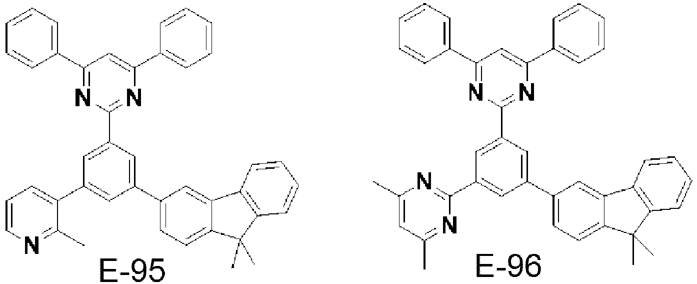

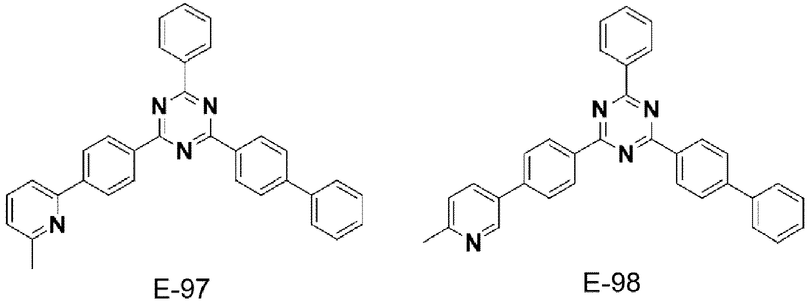

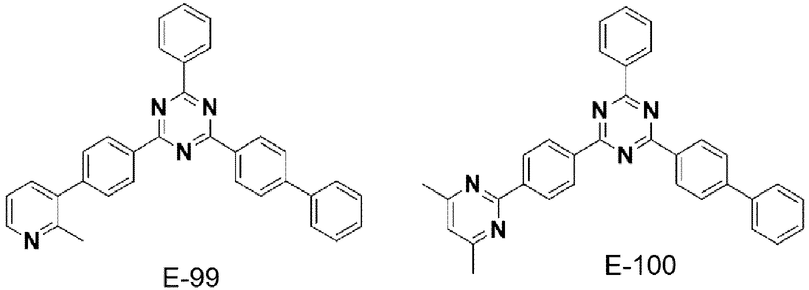

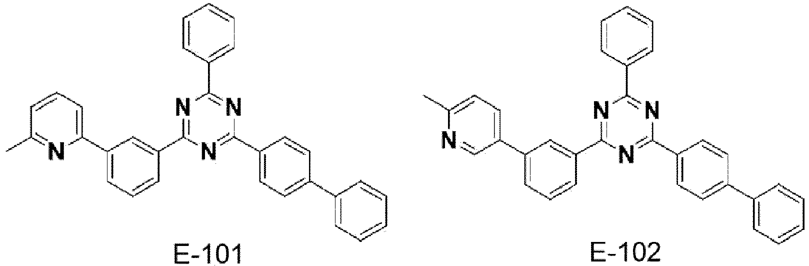

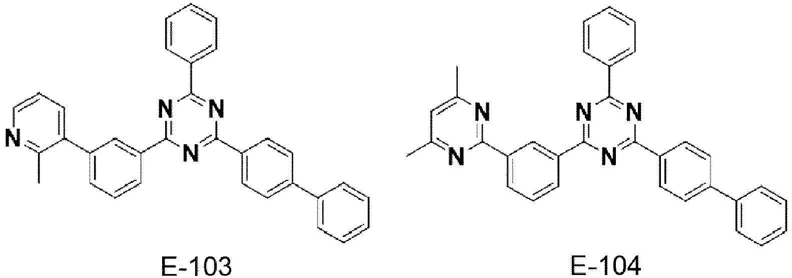

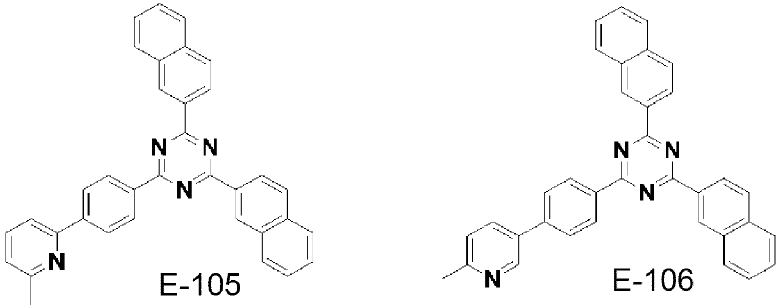

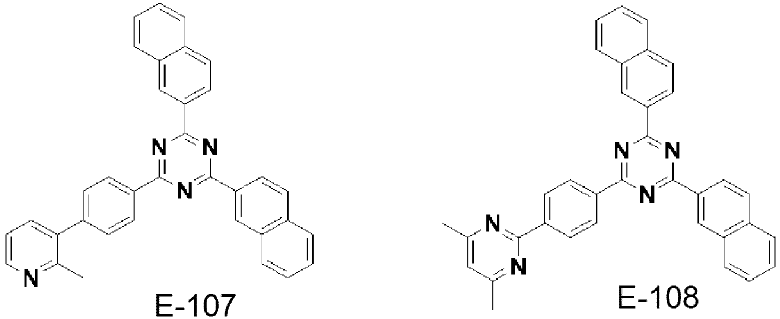

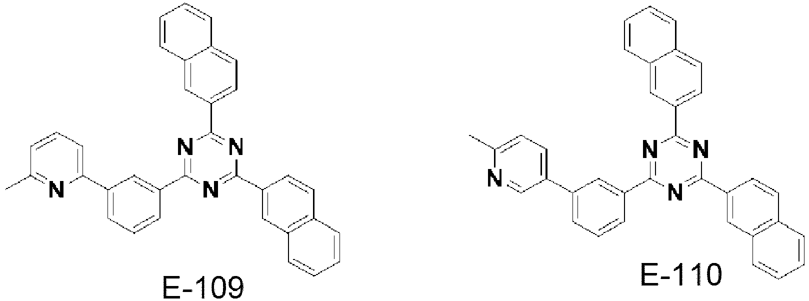

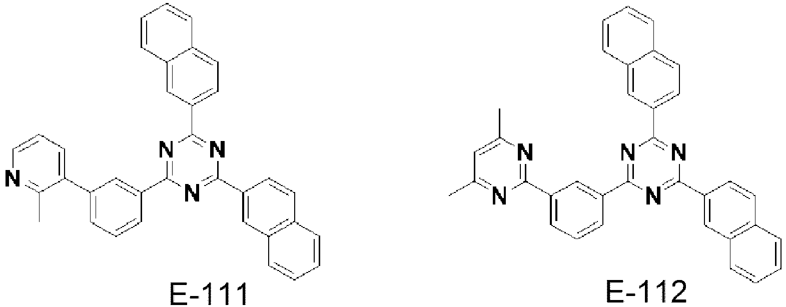

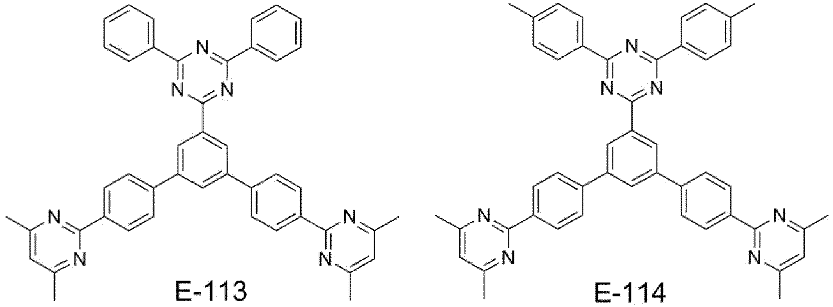

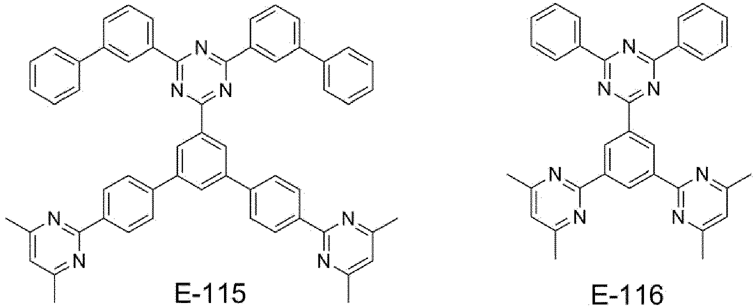

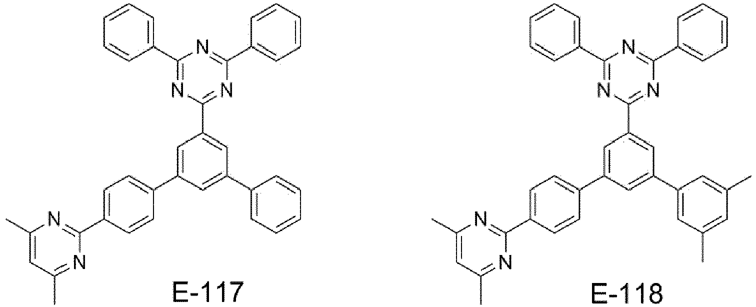

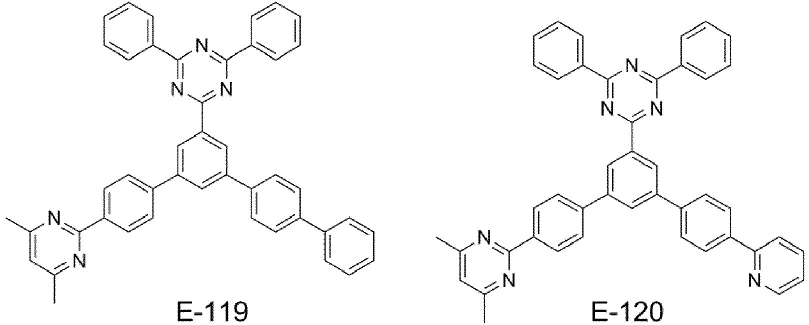

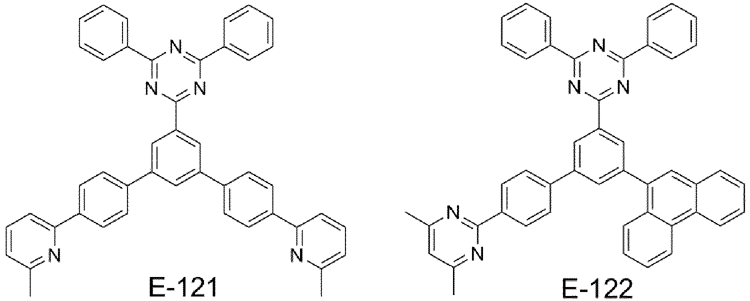

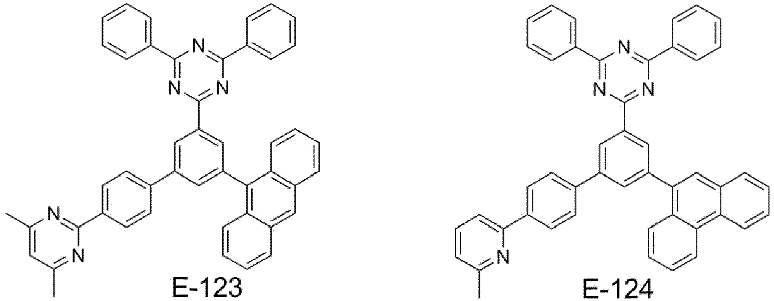

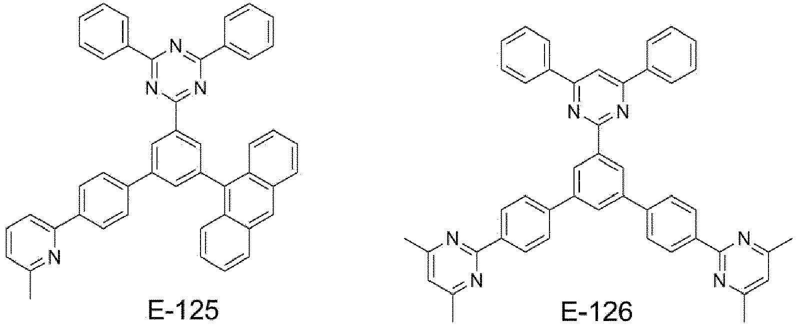

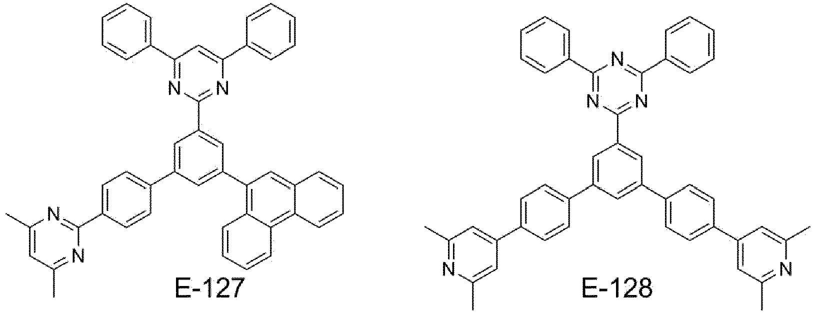

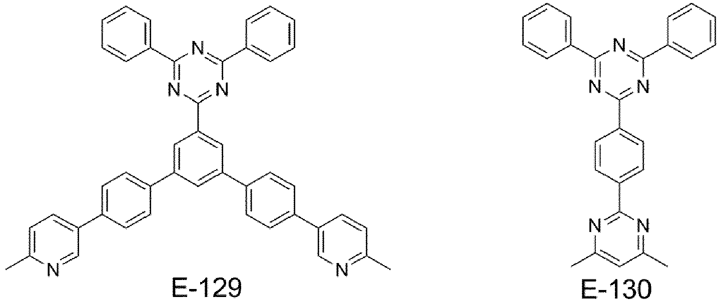

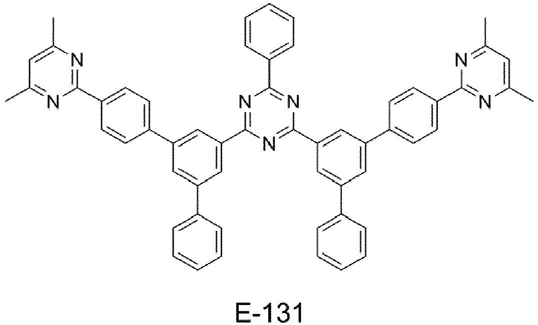

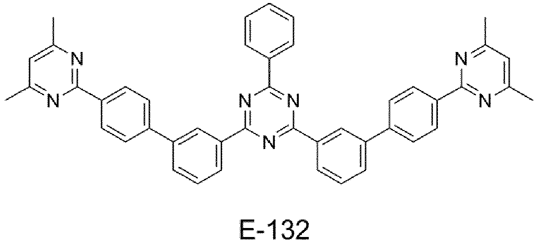

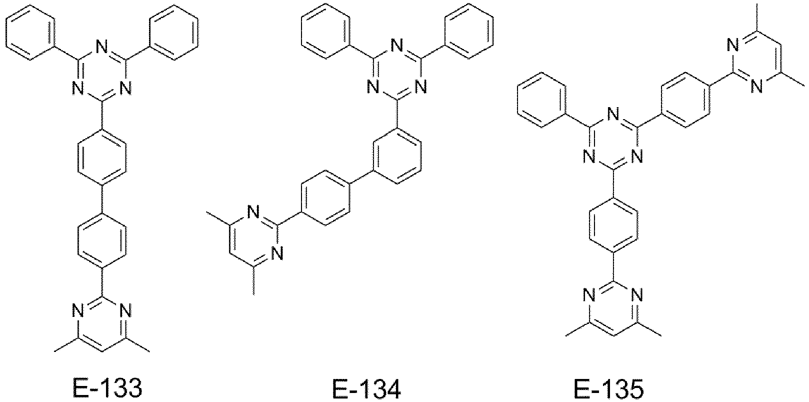

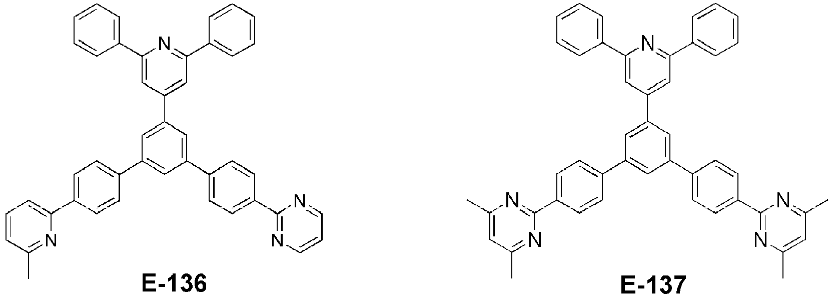

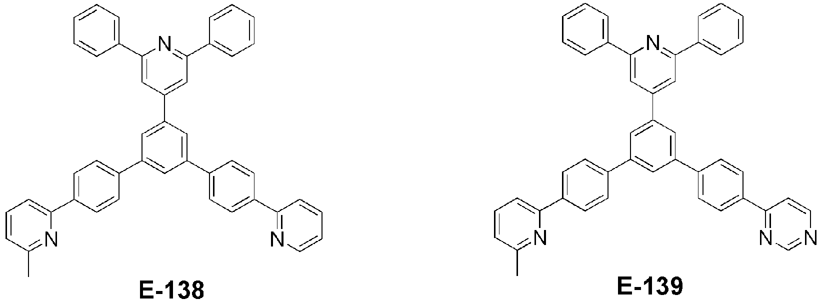

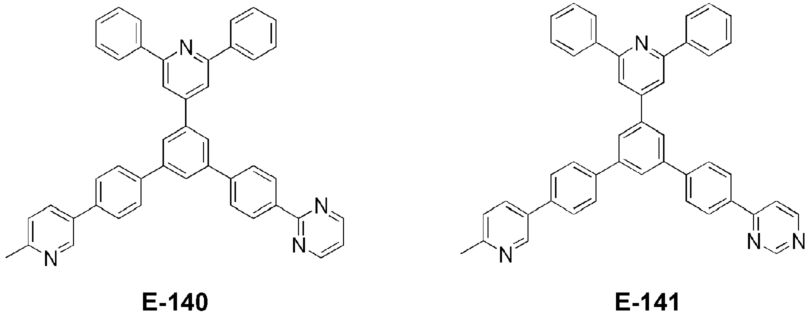

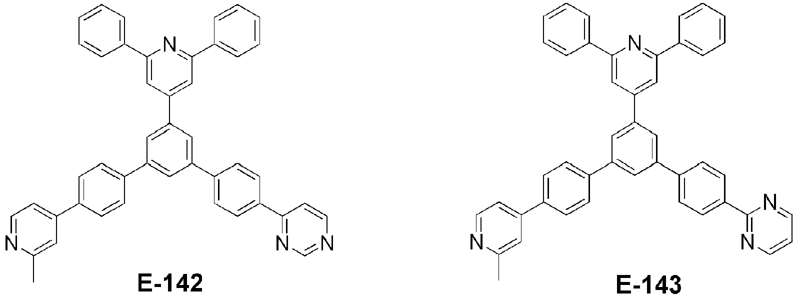

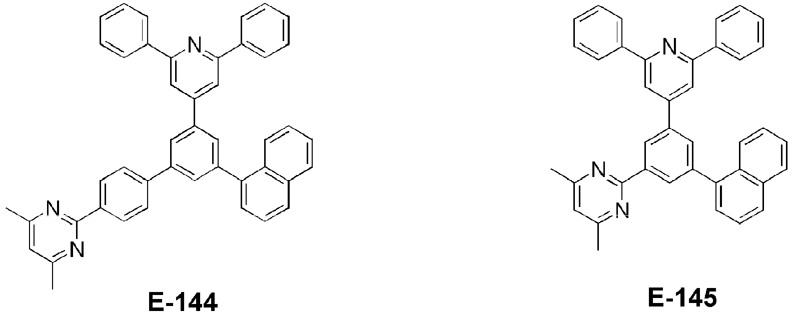

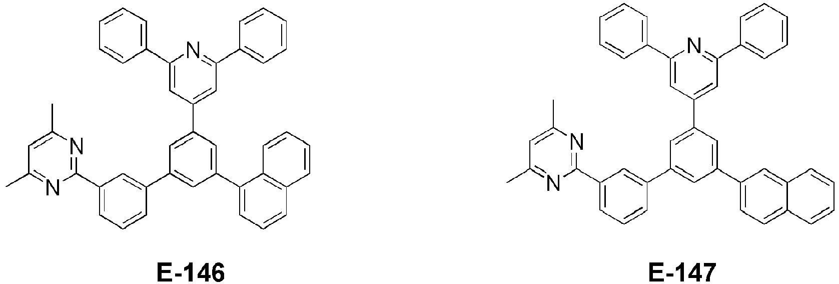

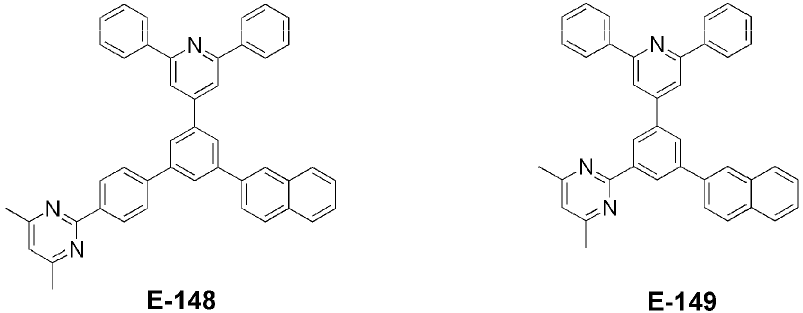

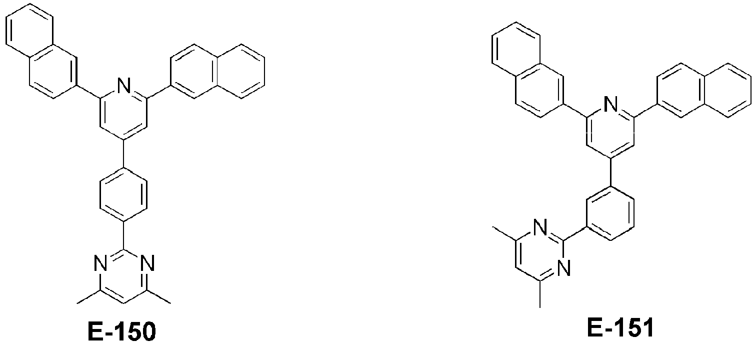

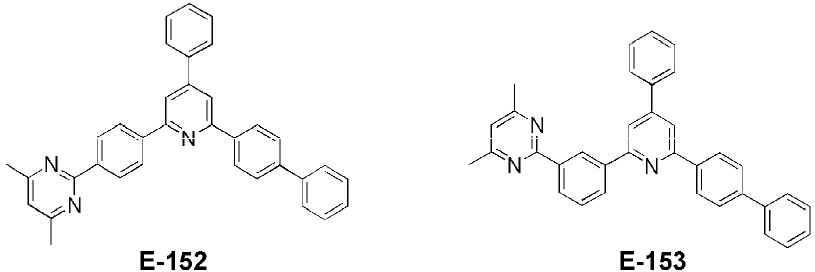

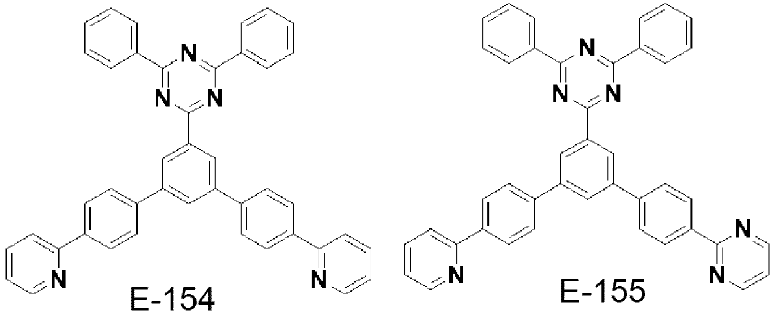

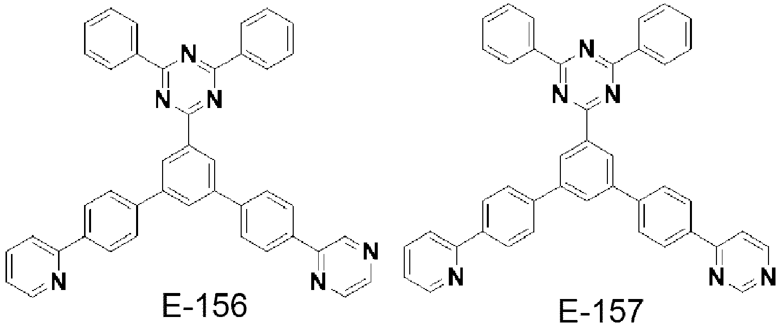

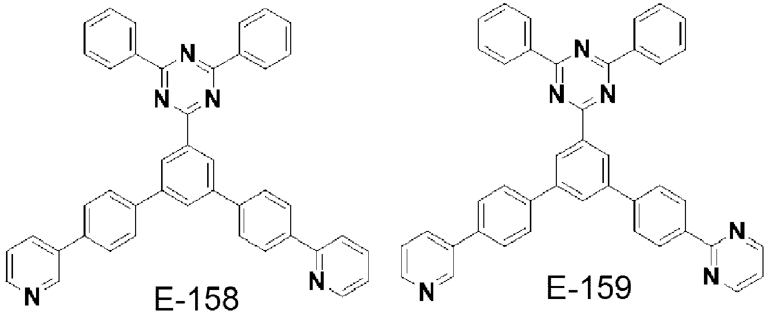

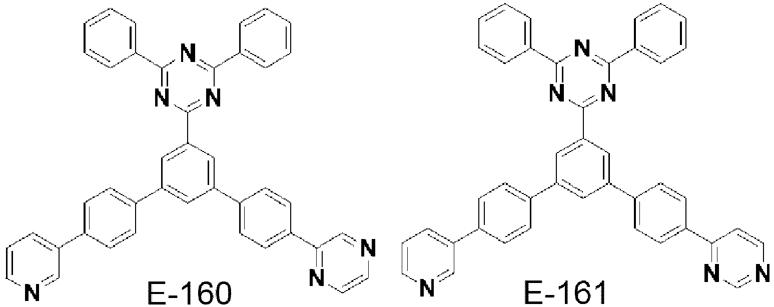

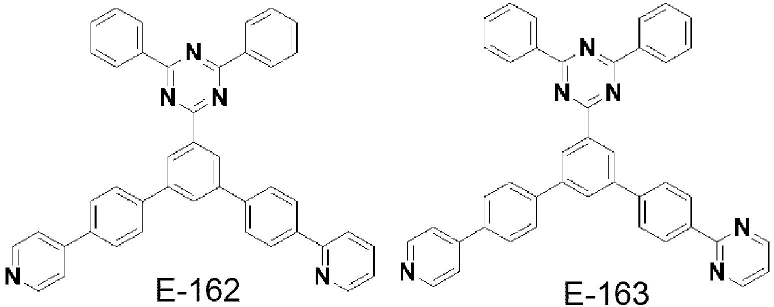

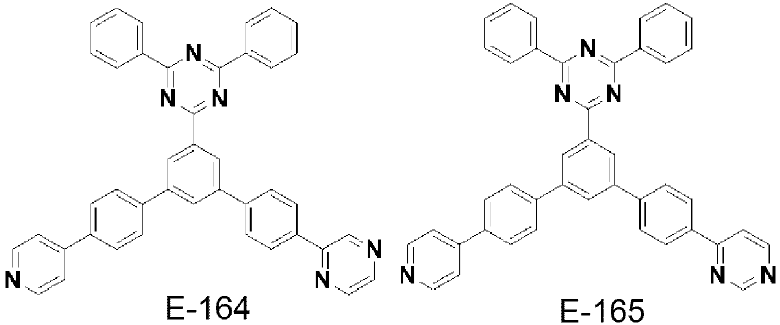

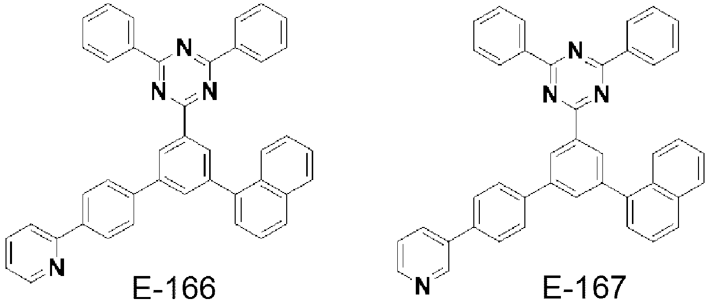

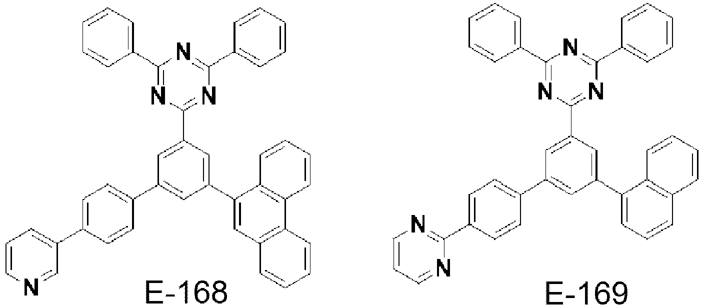

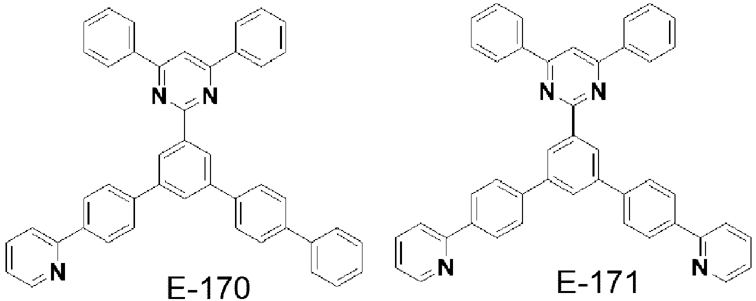

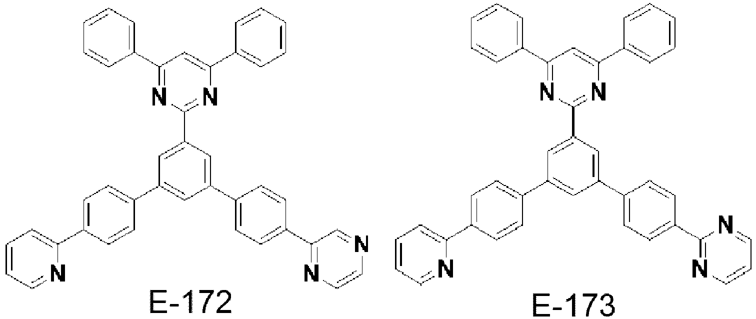

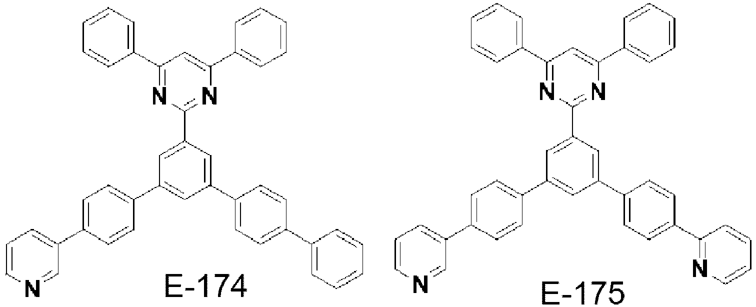

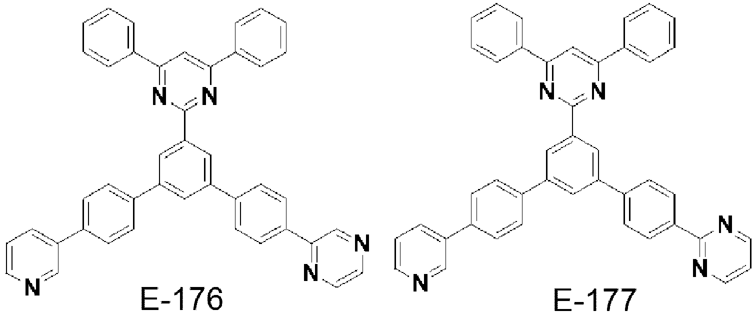

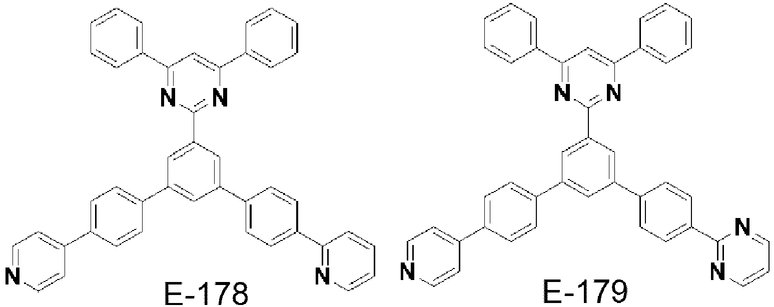

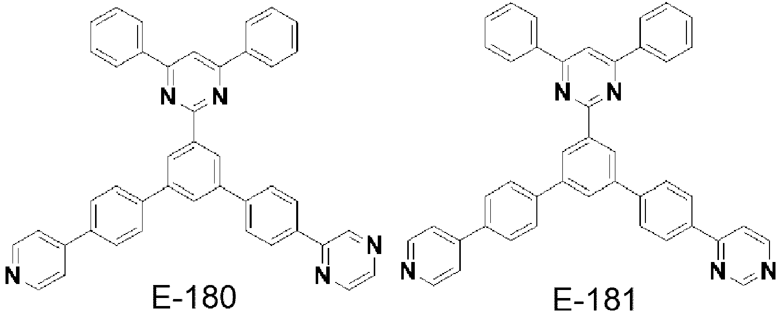

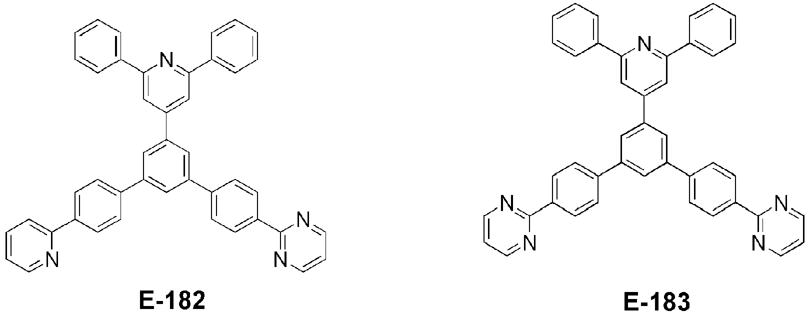

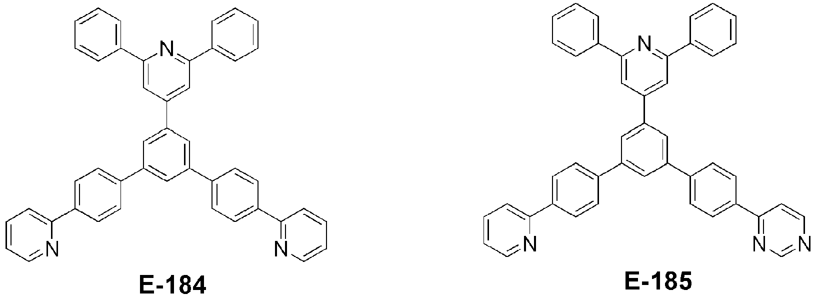

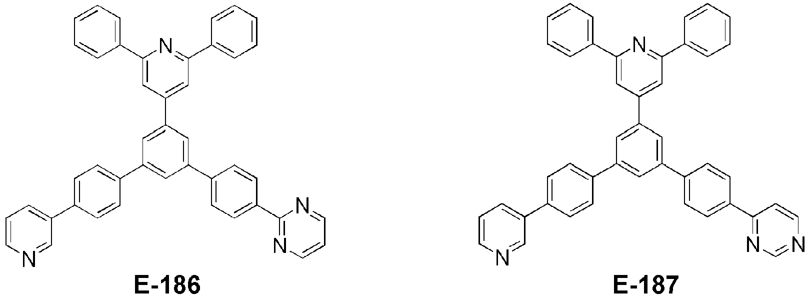

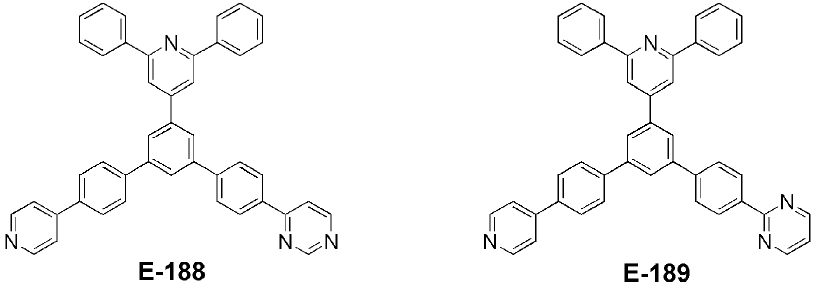

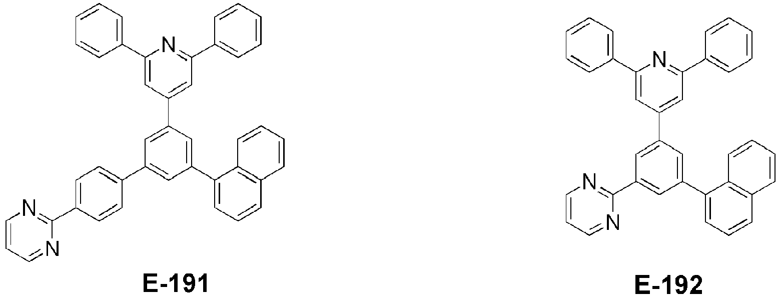

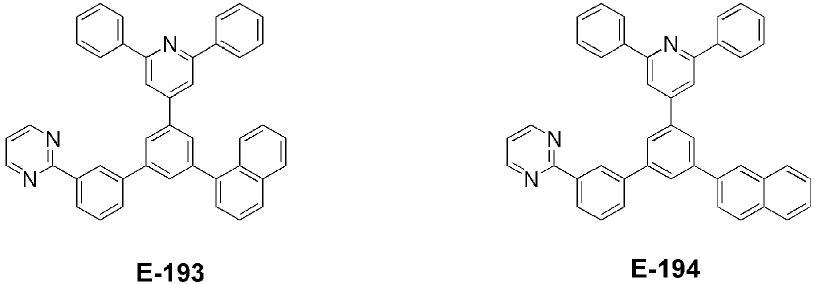

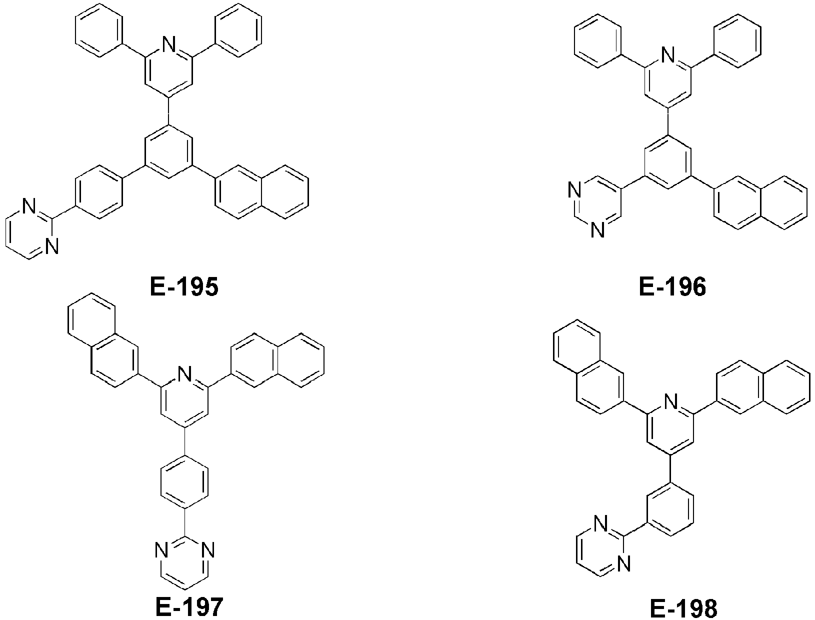

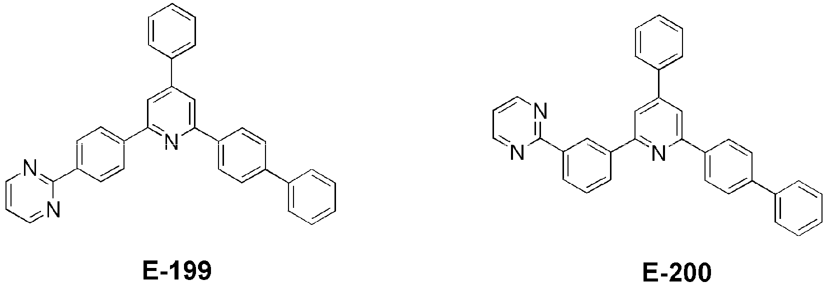

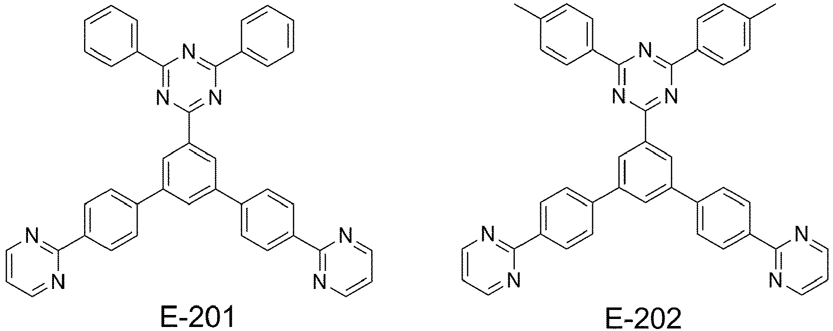

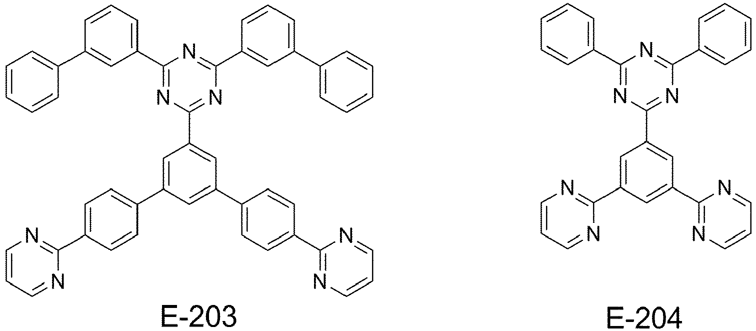

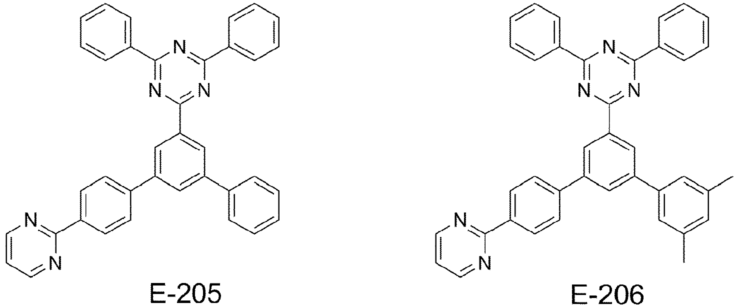

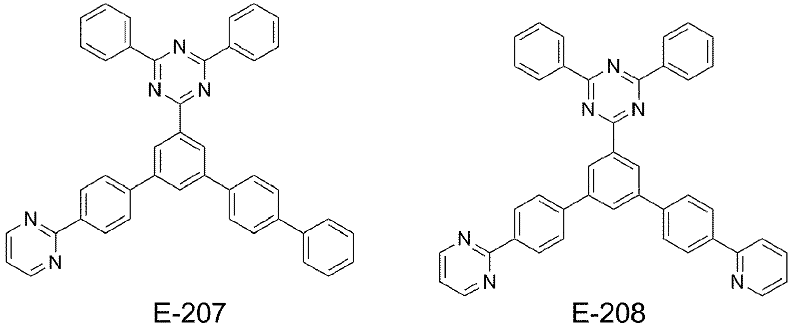

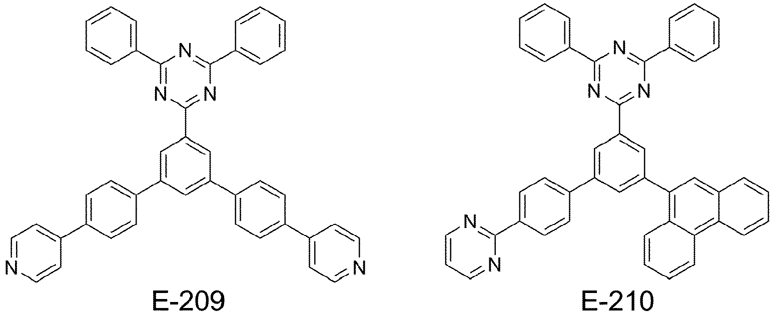

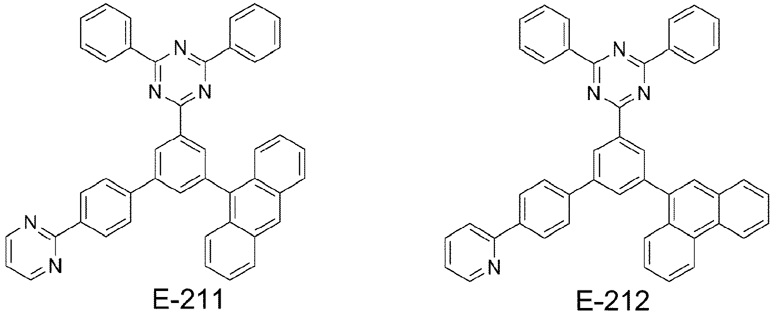

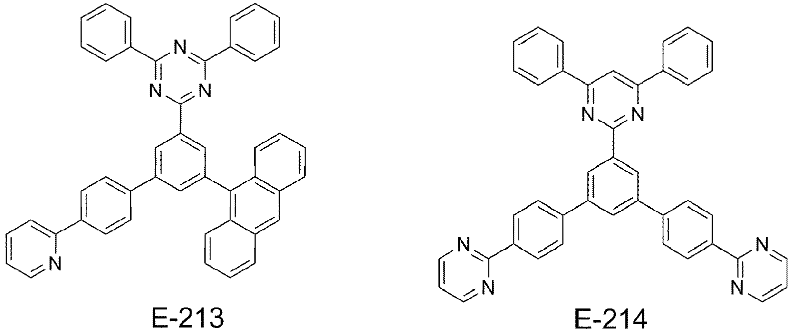

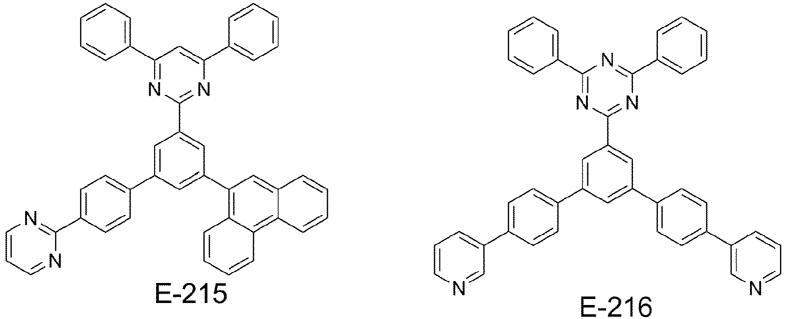

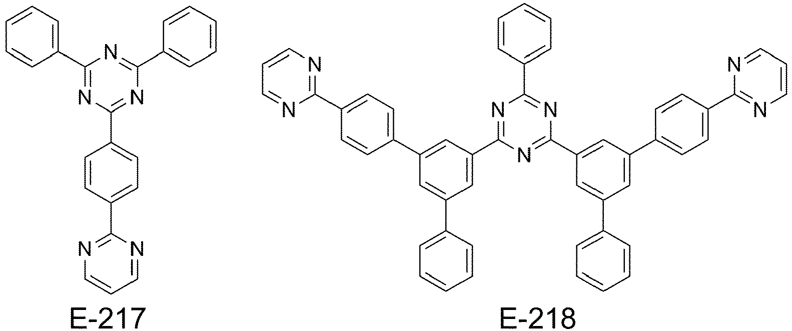

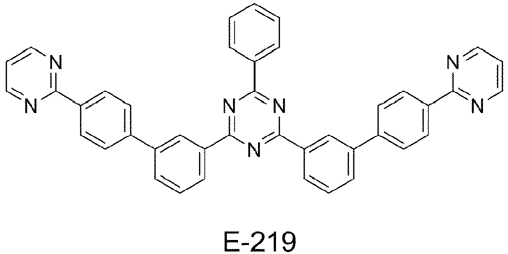

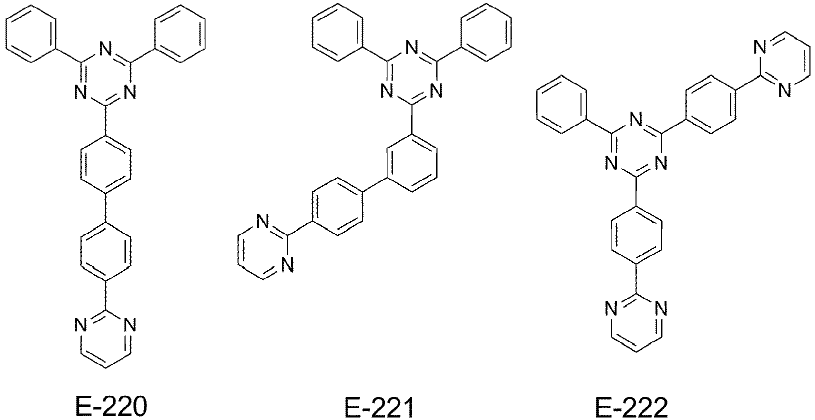

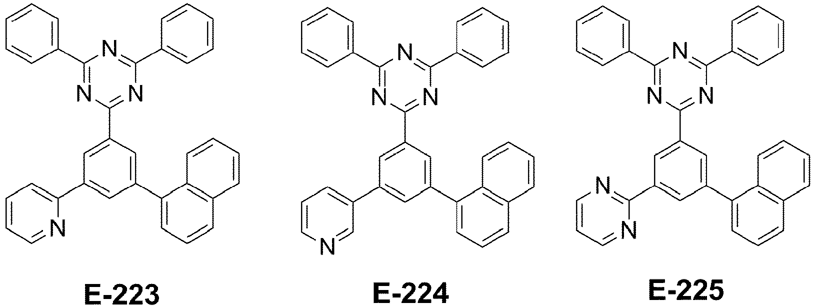

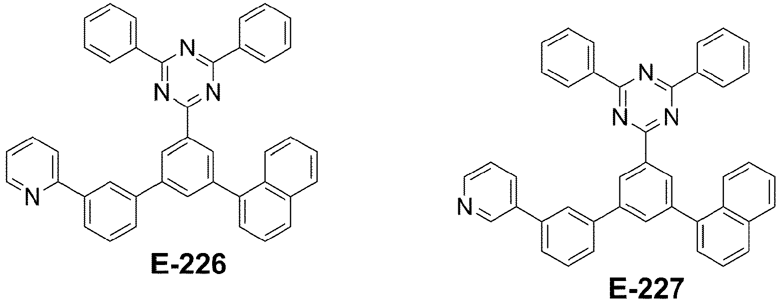

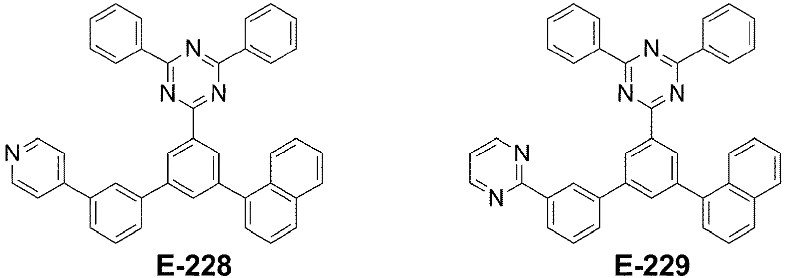

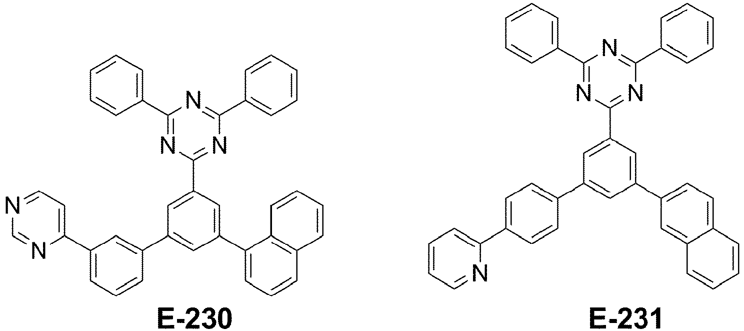

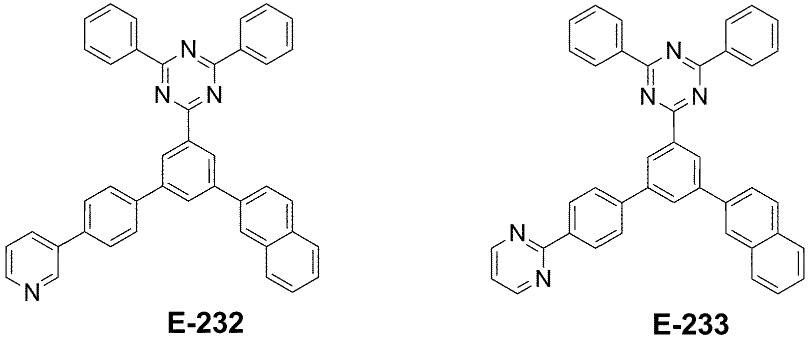

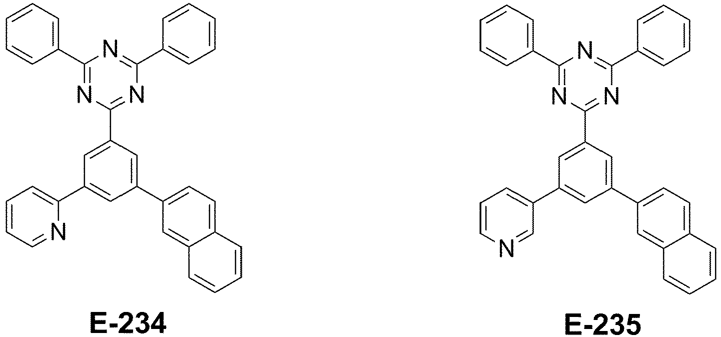

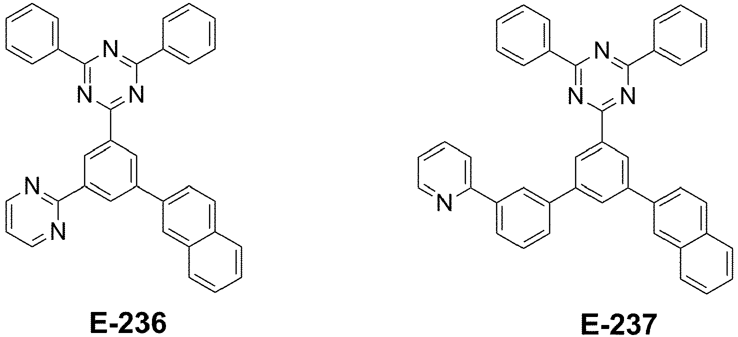

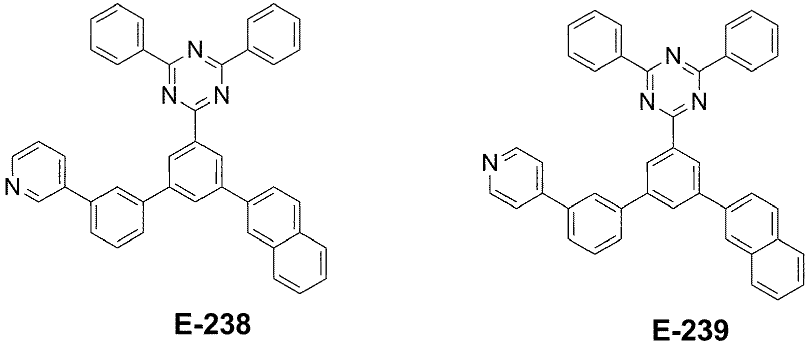

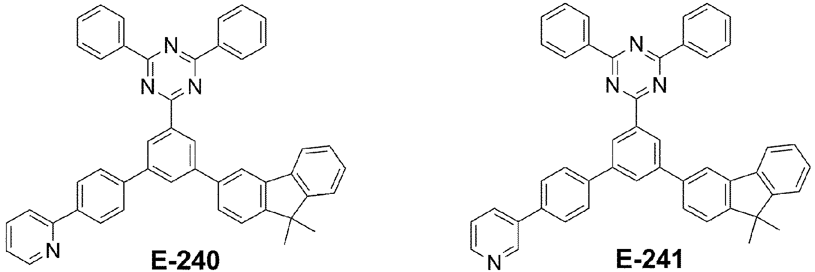

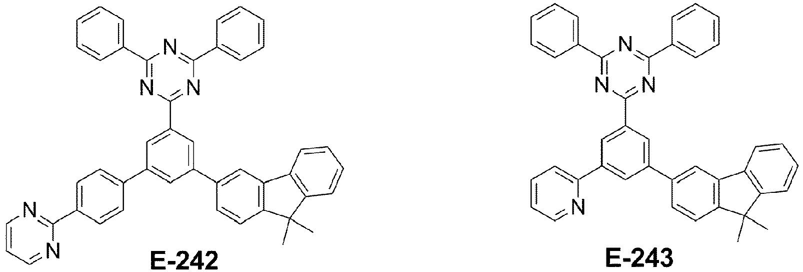

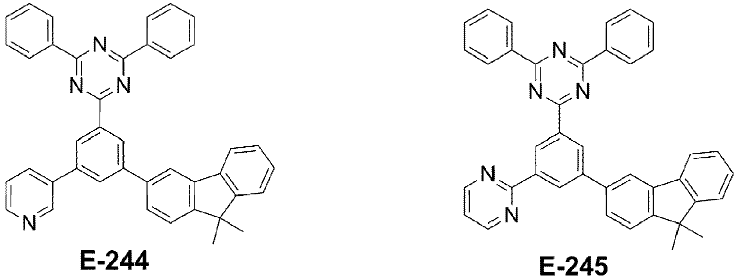

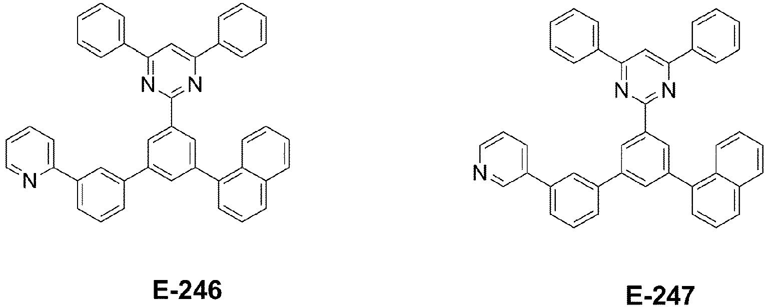

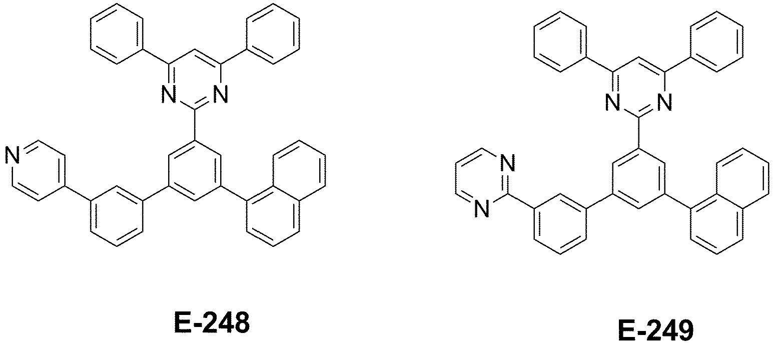

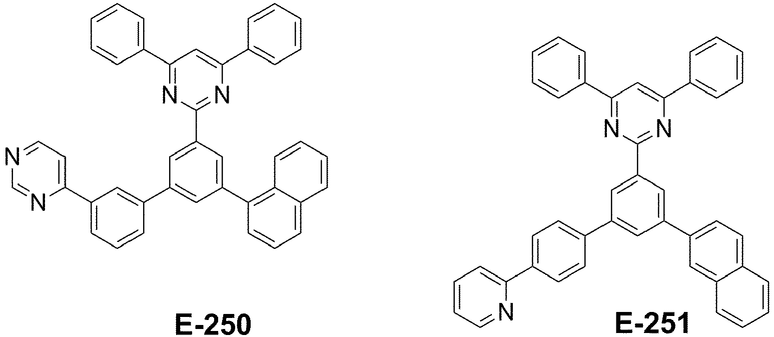

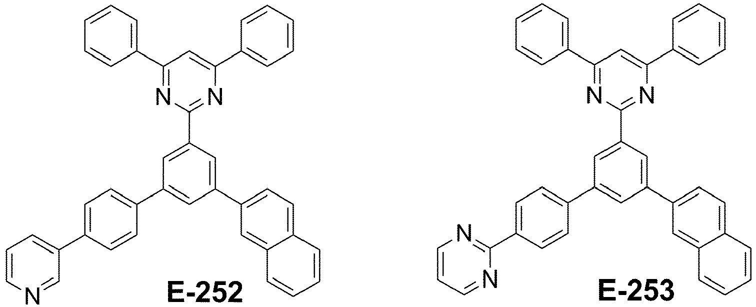

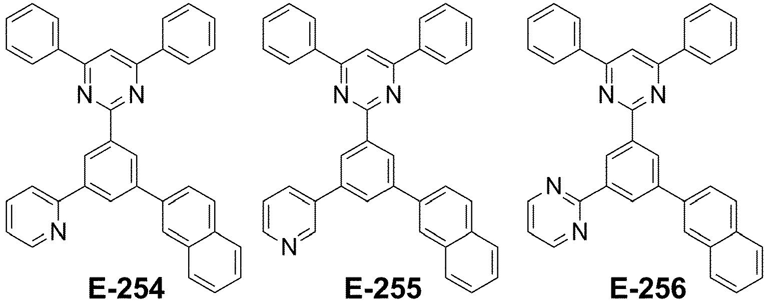

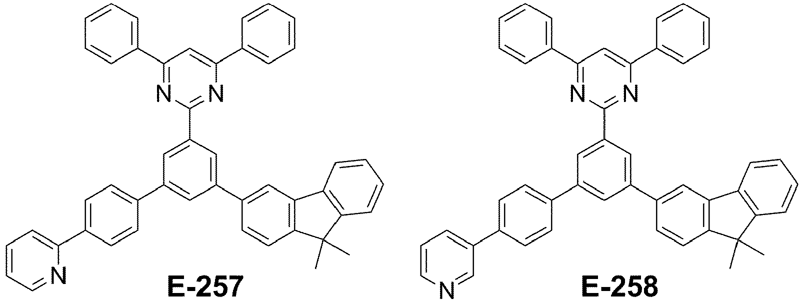

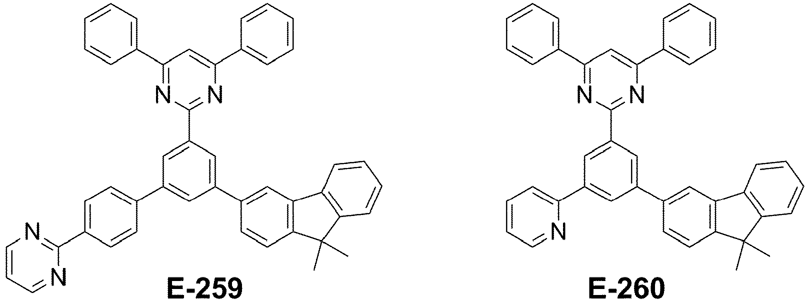

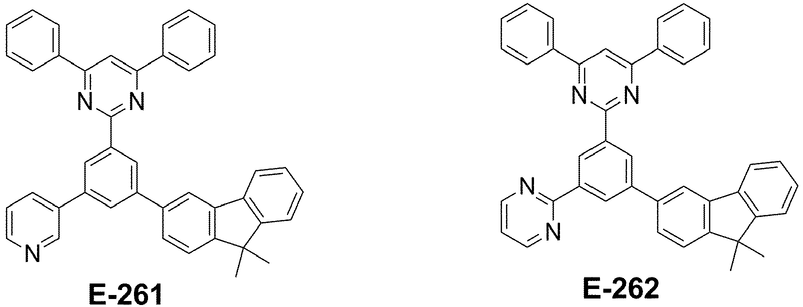

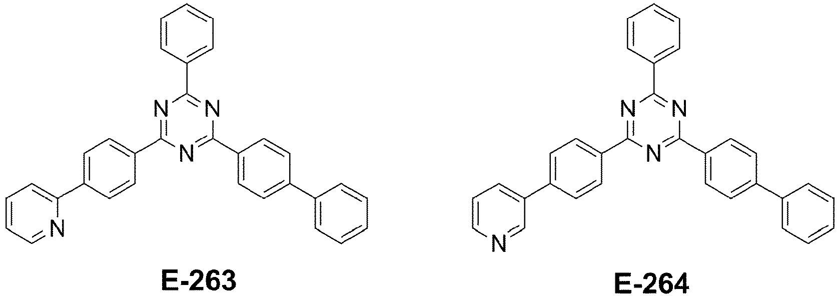

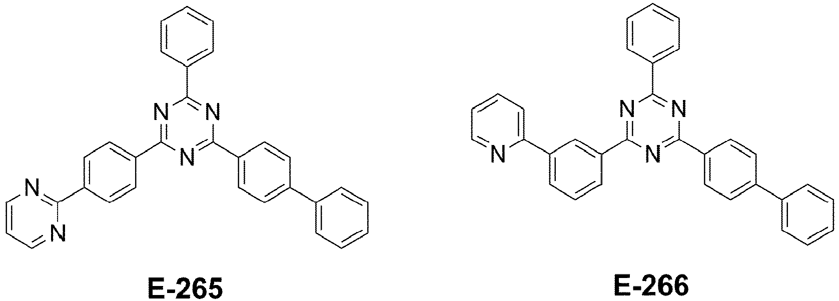

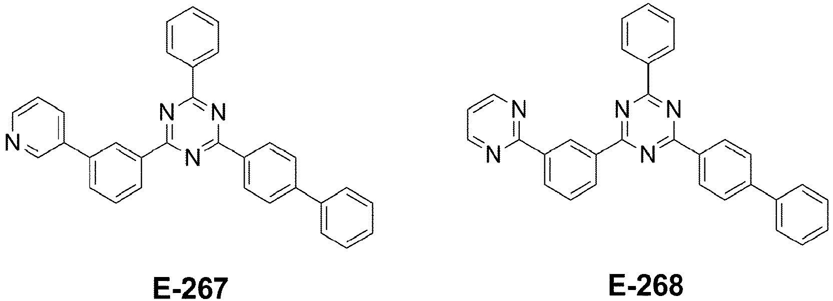

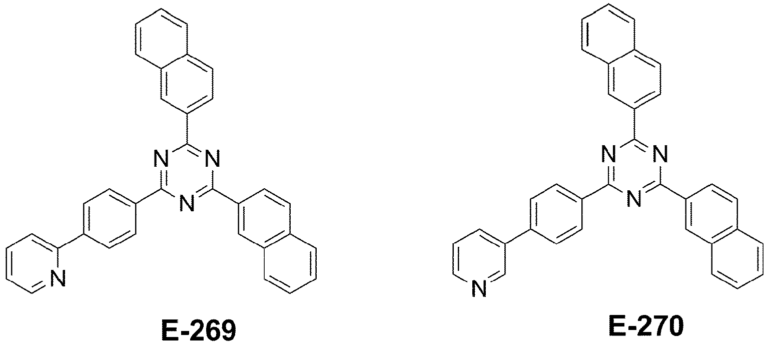

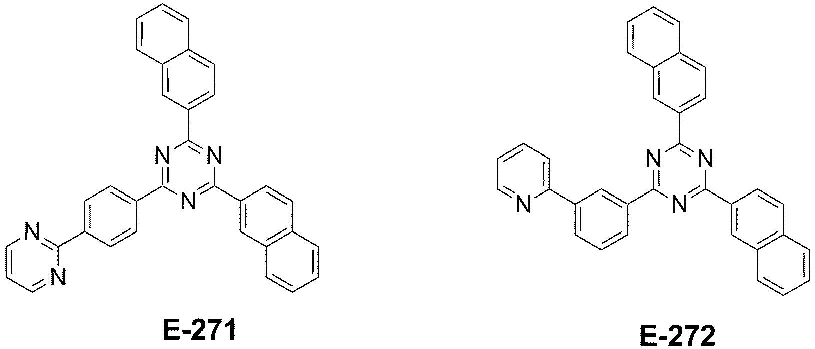

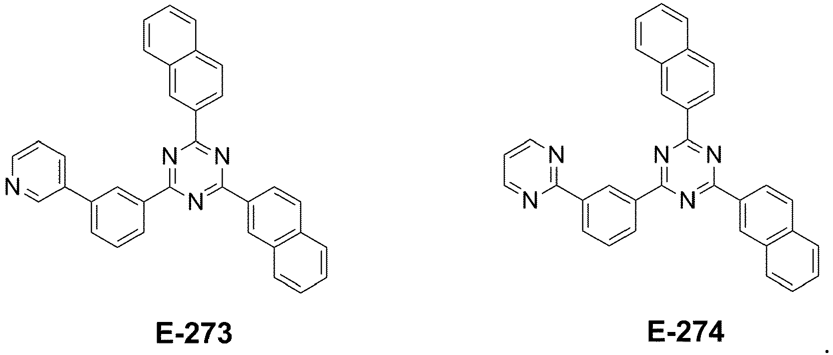

The first compound represented by one selected from Formulae 1-1 and 1-2 may have relatively high triplet energy levels (compared to those of a phosphorescent dopant generally utilized in the art), and thus may be suitable as a host in a phosphorescence organic light-emitting device. Therefore, in an organic light-emitting device comprising the first compound represented by one selected from Formulae 1-1 and 1-2, excitons are effectively generated in an emission layer, thereby exhibiting high efficiency.

However, when electrons are not effectively injected to an emission layer from an electron transport region in an organic light-emitting device, the driving voltage of an organic light-emitting device increases while the efficiency thereof decreases, and the lifespan thereof is reduced.

The second compound represented by Formula 2 has high electron mobility and low electron injection barrier. Thus, when the second compound represented by Formula 2 is utilized in an organic light-emitting device, electrons may be smoothly injected to an emission layer from an electron transport region.

Therefore, an organic light-emitting device comprising the first compound represented by one selected from Formulae 1-1 and 1-2 and the second compound represented by Formula 2 may have improved driving voltage, improved efficiency, and long lifespan.

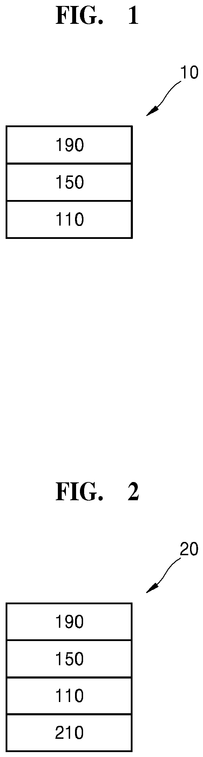

### Description of FIG. 1

FIG. 1 is a diagram schematically illustrating a cross-section of an organic light-emitting device 10 according to an example. The organic light-emitting device 10 comprises a first electrode 110, an organic layer 150, and a second electrode 190.

Hereinafter, the structure of the organic light-emitting device 10 according to an example and a method of manufacturing the organic light-emitting device 10 according to an example will be described in connection with FIG. 1.

### First electrode 110

In FIG. 1, a substrate may be additionally disposed under the first electrode 110 or above the second electrode 190. The substrate may be a glass substrate or a plastic substrate, each having excellent mechanical strength, thermal stability, transparency, surface smoothness, ease of handling, and/or water-resistance.

The first electrode 110 may be formed by, for example, depositing or sputtering a material for forming the first electrode 110 on the substrate. When the first electrode 110 is an anode, the material for forming the first electrode 110 may be selected from materials with a high work function to facilitate hole injection.

The first electrode 110 may be a reflective electrode, a semi-transmissive electrode, or a transmissive electrode. When the first electrode 110 is a transmissive electrode, the material for forming the first electrode 110 may be selected from indium tin oxide (ITO), indium zinc oxide (IZO), tin oxide (SnO₂), zinc oxide (ZnO), and combinations thereof, but examples of the present disclosure are not limited thereto. In various examples, when the first electrode 110 is a semi-transmissive electrode or a reflective electrode, the material for forming the first electrode 110 may be selected from magnesium (Mg), silver (Ag), aluminum (Al), aluminum-lithium (Al-Li), calcium (Ca), magnesium-indium (Mg-In), magnesium-silver (Mg-Ag), and combinations thereof, but examples of the present disclosure are not limited thereto.

The first electrode 110 may have a single-layered structure, or a multi-layered structure comprising two or more layers. For example, the first electrode 110 may have a three-layered structure of ITO/Ag/ITO, but the structure of the first electrode 110 is not limited thereto.

### Organic layer 150

The organic layer 150 may be disposed on the first electrode 110. The organic layer 150 may comprise an emission layer.

The organic layer 150 may further comprise a hole transport region between the first electrode 110 and the emission layer, and an electron transport region between the emission layer and the second electrode 190.

### Hole transport region in organic layer 150

The hole transport region may have i) a single-layered structure comprising a single layer comprising a single material, ii) a single-layered structure comprising a single layer comprising a plurality of different materials, or iii) a multi-layered structure having a plurality of layers comprising a plurality of different materials.

The hole transport region may comprise at least one layer selected from a hole injection layer, a hole transport layer, an emission auxiliary layer, and an electron blocking layer.

For example, the hole transport region may have a single-layered structure comprising a single layer comprising a plurality of different materials, or a multi-layered structure having a structure of hole injection layer/hole transport layer, a structure of hole injection layer/hole transport layer/emission auxiliary layer, a structure of hole injection layer/emission auxiliary layer, a structure of hole transport layer/emission auxiliary layer, or a structure of hole injection layer/hole transport layer/electron blocking layer, but the structure of the hole transport region is not limited thereto.

The hole transport region may comprise at least one selected from m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (Pani/PSS), a compound represented by Formula 201, and a compound represented by Formula 202:

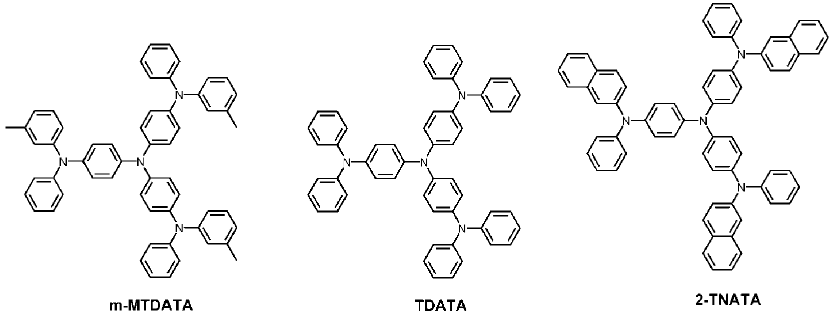

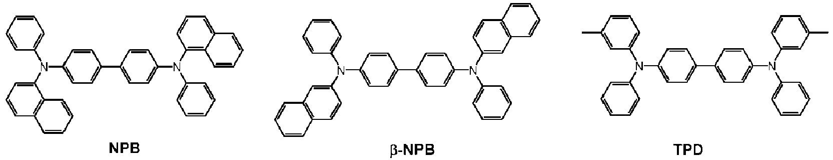

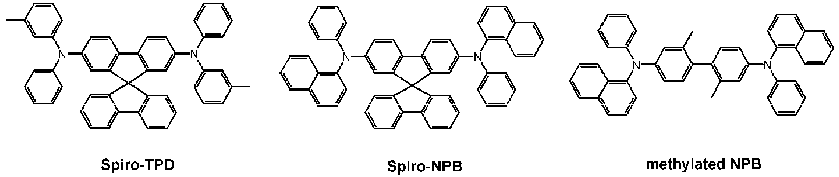

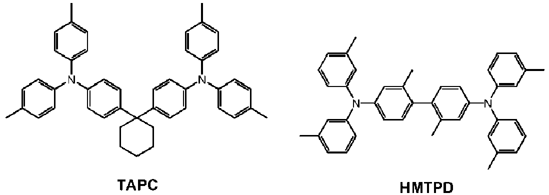

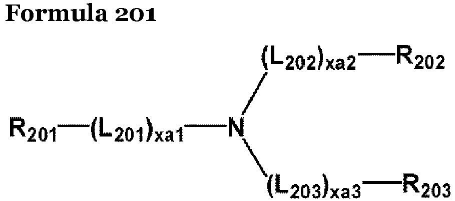

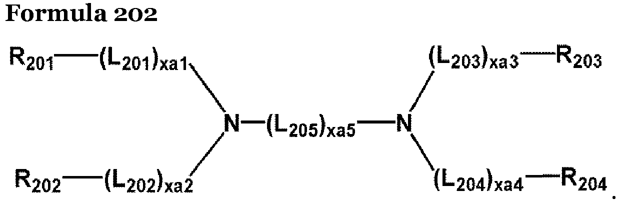

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xa1 to xa4 may each independently be an integer selected from 0 to 3,
xa5 may be an integer selected from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group.

For example, in Formula 202, R₂₀₁ and R₂₀₂ may be optionally linked to each other via a single bond, a dimethyl-methylene group, or a diphenyl-methylene group, and R₂₀₃ and R₂₀₄ may be optionally linked to each other via a single bond, a dimethyl-methylene group, or a diphenyl-methylene group.

In an example, in Formulae 201 and 202,
L₂₀₁ to L₂₀₅ may each independently be selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosiloleylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosiloleylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In various examples, xa1 to xa4 may each independently be 0, 1, or 2.

In various examples, xa5 may be 1, 2, 3, or 4.

In various examples, R₂₀₁ to R₂₀₄ and Q₂₀₁ may each independently be selected from the group consisting of:
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be understood by referring to the descriptions thereof provided in the present specification.

In various examples, in Formula 201, at least one selected from R₂₀₁ to R₂₀₃ may be selected from the group consisting of:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least
one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but examples are not limited thereto.

In various examples, in Formula 202, i) R₂₀₁ and R₂₀₂ may be linked to each other via a single bond, and/or ii) R₂₀₃ and R₂₀₄ may be linked to each other via a single bond.

In various examples, in Formula 202, at least one selected from R₂₀₁ to R₂₀₄ may be selected from the group consisting of:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group, but examples are not limited thereto.

The compound represented by Formula 201 may be represented by Formula 201A:

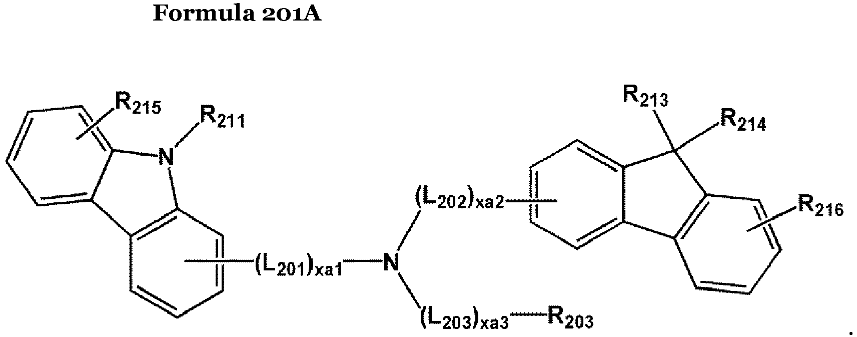

For example, the compound represented by Formula 201 may be represented by Formula 201A(1), but examples are not limited thereto:

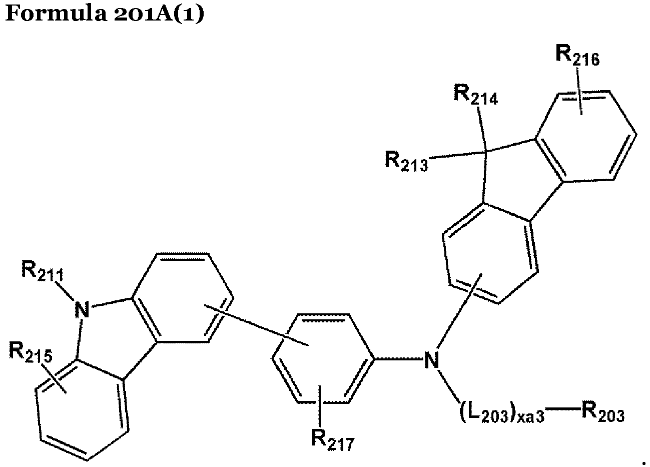

In various examples, the compound represented by Formula 201 may be represented by Formula 201A-1, but examples are not limited thereto:

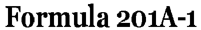

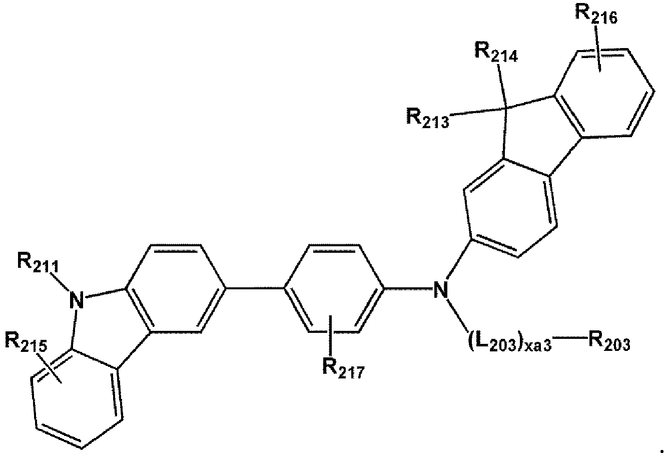

For example, the compound represented by Formula 202 may be represented by Formula 202A:

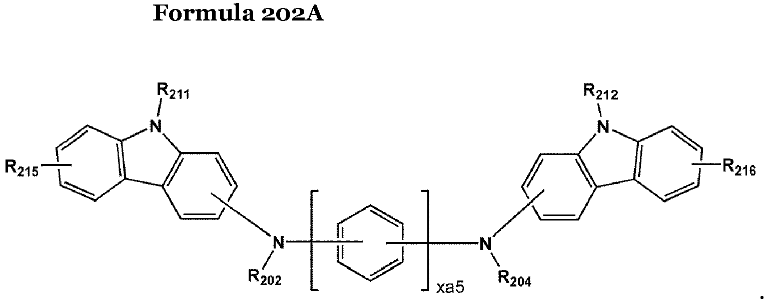

In various examples, the compound represented by Formula 202 may be represented by Formula 202A-1:

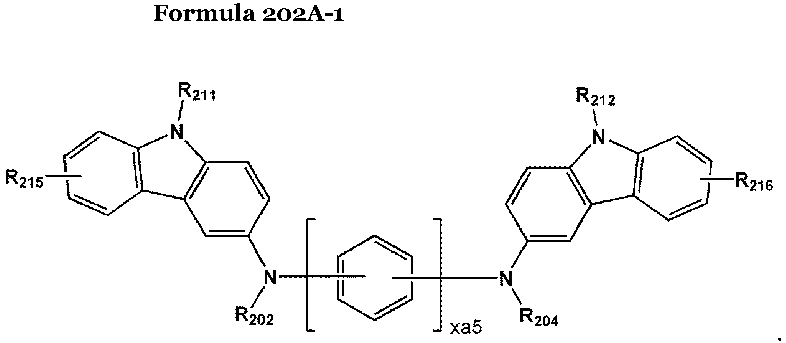

In Formulae 201A, 201A(1), 201A-1, 202A, and 202A-1,
L₂₀₁ to L₂₀₃, xa1 to xa3, xa5, and R₂₀₂ to R₂₀₄ may each independently be understood by referring to descriptions thereof provided in the present specification,
R₂₁₁ and R₂₁₂ may each independently be understood by referring to the description of R₂₀₃ provided herein, and
R₂₁₃ to R₂₁₇ may each independently be selected from hydrogen, deuterium, -F,-Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In an example, the hole transport region may comprise at least one compound selected from Compounds HT1 to HT39, but examples are not limited thereto:

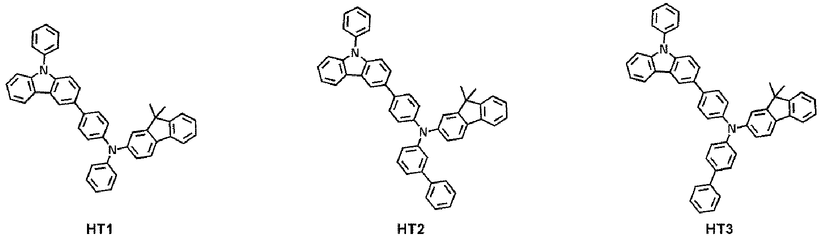

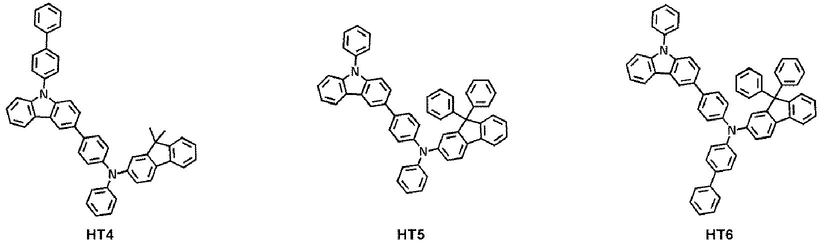

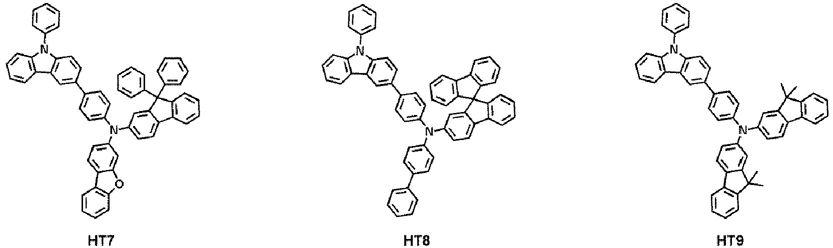

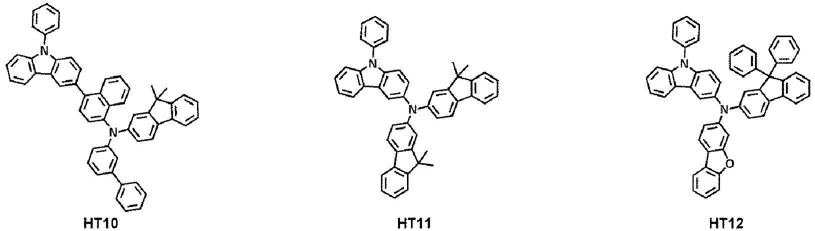

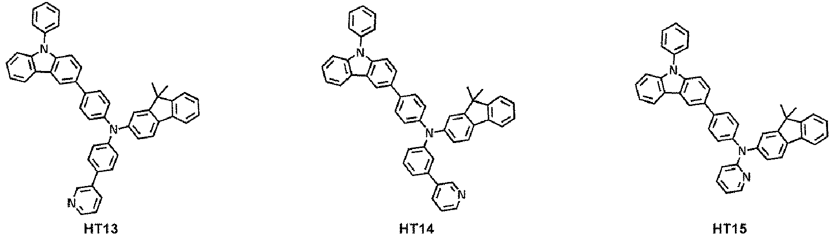

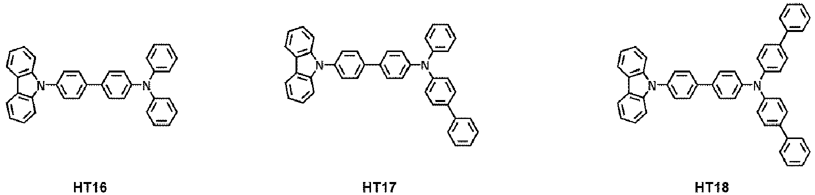

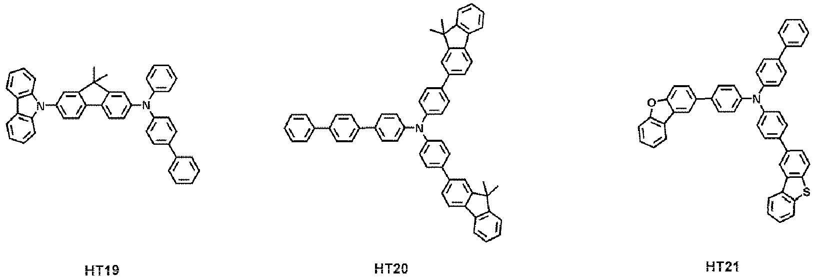

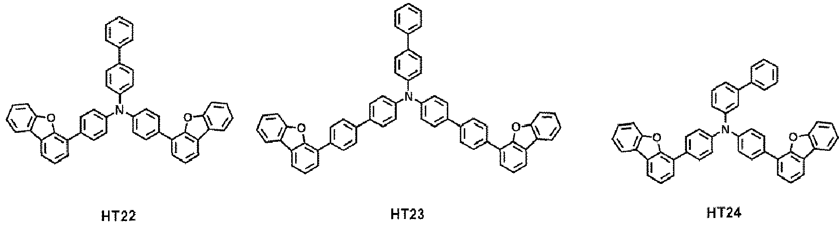

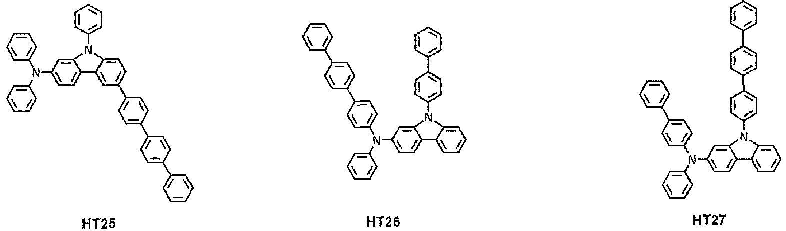

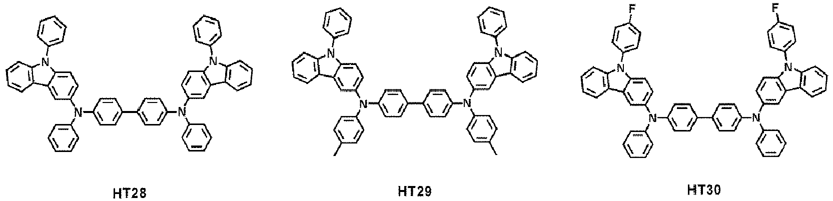

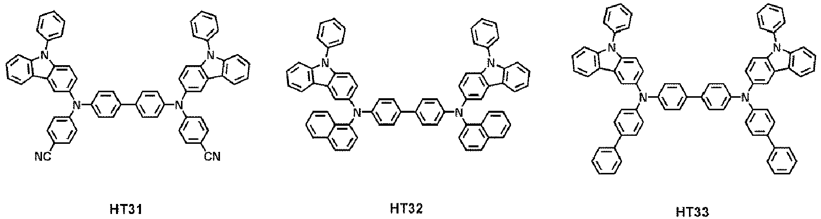

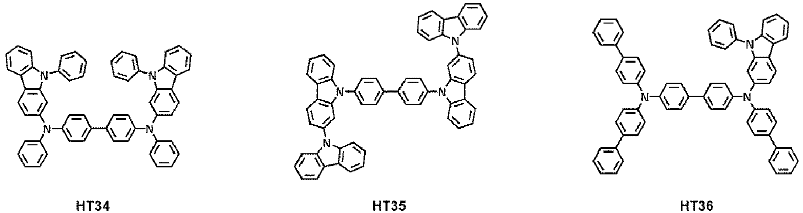

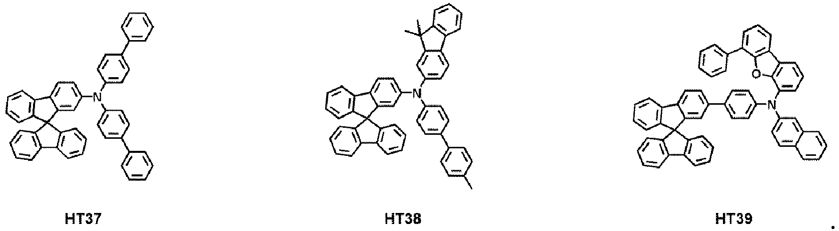

A thickness of the hole transport region may be in a range of about 100 Å to about 10,000 Å, for example, about 100 Å to about 1,000 Å. When the hole transport region comprises at least one selected from a hole injection layer and a hole transport layer, the thickness of the hole injection layer may be in a range of about 100 Å to about 9,000 Å, for example, about 100 Å to about 1,000 Å, and the thickness of the hole transport layer may be in a range of about 50 Å to about 2,000 Å, for example, about 100 Å to about 1,500 Å. When the thicknesses of the hole transport region, the hole injection layer and the hole transport layer are within these ranges, satisfactory hole transporting characteristics may be obtained without a substantial increase in driving voltage.

The emission auxiliary layer may increase light-emission efficiency by compensating for an optical resonance distance according to a wavelength of light emitted from the emission layer, and the electron blocking layer may block the flow of electrons from the electron transport region. The emission auxiliary layer and the electron blocking layer may comprise the materials as described above.

### P-dopant

The hole transport region may further comprise, in addition to the materials described above, a charge-generation material for the improvement of conductive properties. The charge-generation material may be homogeneously or non-homogeneously dispersed in the hole transport region.

The charge-generation material may be, for example, a p-dopant.

In an example, a lowest unoccupied molecular orbital (LUMO) of the p-dopant may be about -3.5 eV or less.

The p-dopant may comprise at least one selected from a quinone derivative, a metal oxide, and a cyano group-containing compound, but examples are not limited thereto.

For example, the p-dopant may comprise at least one selected from the group consisting of:
quinone derivatives, such as tetracyanoquinodimethane (TCNQ) and/or 2,3,5,6-tetrafluoro-7,7,8,8-tetracyanoquinodimethane (F4-TCNQ);
metal oxides, such as a tungsten oxide and/or a molybdenum oxide;
1,4,5,8,9,11-hexaazatriphenylene-hexacarbonitrile (HAT-CN); and
a compound represented by Formula 221, but examples are not limited thereto:

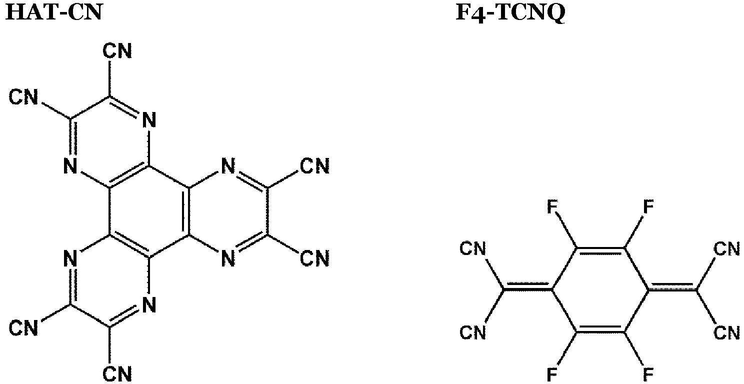

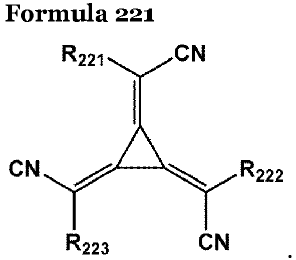

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group, wherein at least one selected from R₂₂₁ to R₂₂₃ may have at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

When the organic light-emitting device 10 is a full color organic light-emitting device, the emission layer may be patterned into a red emission layer, a green emission layer, or a blue emission layer, according to an individual sub-pixel. In various examples, the emission layer may have a stacked structure of two or more layers selected from a red emission layer, a green emission layer, and a blue emission layer, in which the two or more layers contact each other or are separated from each other. In various examples, the emission layer may comprise two or more materials selected from a red-light emission material, a green-light emission material, and a blue-light emission material, in which the two or more materials are mixed with each other in a single layer to emit white light.

The emission layer may comprise a host and a dopant. The dopant may comprise at least one selected from a phosphorescent dopant and a fluorescent dopant.

In the emission layer, an amount of the dopant may be, in general, in a range of about 0.01 to about 15 parts by weight based on 100 parts by weight of the host, but examples of the present disclosure are not limited thereto.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

### Host in emission layer

The host may comprise the first compound represented by one selected from Formulae 1-1 and 1-2.

In various examples, the host may further comprise, in addition to the first compound represented by one selected from Formulae 1-1 and 1-2, a compound represented by Formula 301:

**Formula 301** [Ar₃₀₁]_{xb11}-[(L₃₀₁)_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xb1 may be an integer selected from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₃₀₁)(Q₃₀₂)(Q₃₀₃), -N(Q₃₀₁)(Q₃₀₂), -B(Q₃₀₁)(Q₃₀₂),-C(=O)(Q₃₀₁), -S(=O)₂(Q₃₀₁), and -P(=O)(Q₃₀₁)(Q₃₀₂),
xb2i may be an integer selected from 1 to 5, and
Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but examples are not limited thereto.

In an example, in Formula 301, Ar₃₀₁ may be selected from the group consisting of:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group,-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but examples are not limited thereto.

In Formula 301, when xb11 is two or more, two or more Ar₃₀₁(s) may be linked to each other via a single bond.

In various examples, the compound represented by Formula 301 may be represented by Formula 301-1 or 301-2:

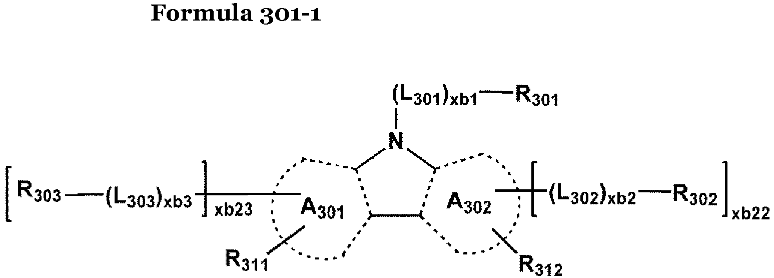

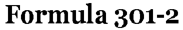

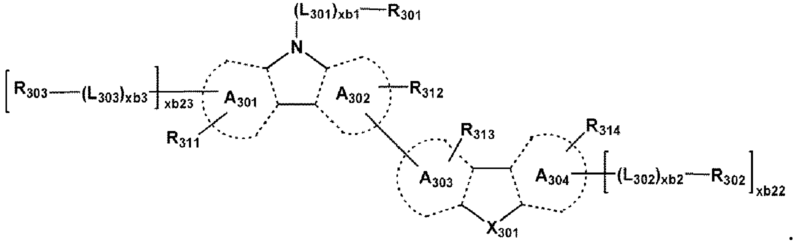

In Formulae 301-1 and 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and a dinaphthothiophene group,
X₃₀₁ may be O, S, or N-[(L₃₀₄)_{xb4}-R₃₀₄],
R₃₁₁ to R₃₁₄ may each independently be selected from hydrogen, deuterium, -F,-Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group,-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂),
xb22 and xb23 may each independently be 0, 1, or 2,
L₃₀₁, xb1, R₃₀₁, and Q₃₁ to Q₃₃ may each independently be understood by referring to the descriptions thereof provided in the present specification,
L₃₀₂ to L₃₀₄ may each independently be the same as described in connection with L₃₀₁ in Formula 301,
Xb2 to xb4 may each independently be the same as described in connection with xb1 in Formula 301, and
R₃₀₂ to R₃₀₄ may each independently be the same as described in connection with R₃₀₁ in Formula 301.

For example, in Formulae 301, 301-1, and 301-2, L₃₀₁ to L₃₀₄ may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosiloleylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosiloleylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group,-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and-P(=O)(Q₃₁)(Q₃₂), and
Q₃₁ to Q₃₃ may each independently be understood by referring to the descriptions thereof in the present specification.

In various examples, in Formulae 301, 301-1, and 301-2, R₃₀₁ to R₃₀₄ may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂),-B(Q₃₁)(Q₃₂), -C(=O)(Q₃₁), -S(=O)₂(Q₃₁), and -P(=O)(Q₃₁)(Q₃₂), and
Q₃₁ to Q₃₃ may each independently be understood by referring to the descriptions thereof in the present specification.

In various examples, the host may comprise an alkaline earth-metal complex. For example, the host may be selected from a Be complex (for example, Compound H₅₅), a Mg complex, and a Zn complex.

In various examples, the host may comprise at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds Hi to H55, however, examples are not limited thereto:

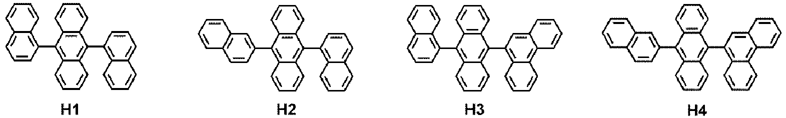

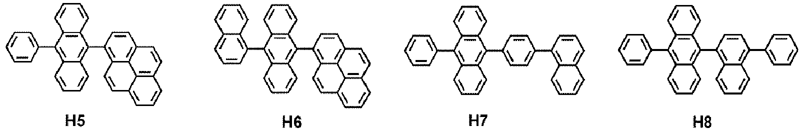

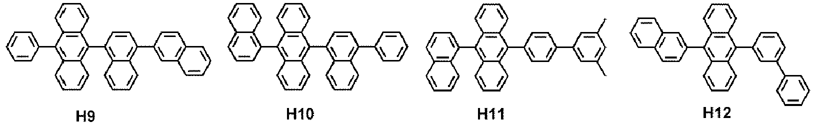

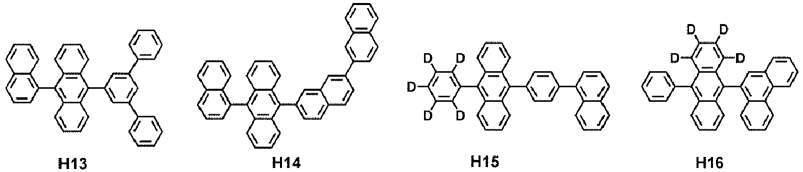

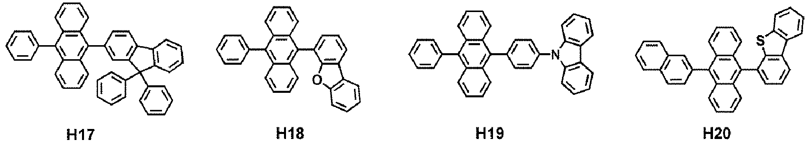

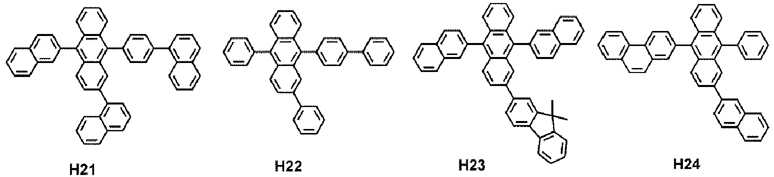

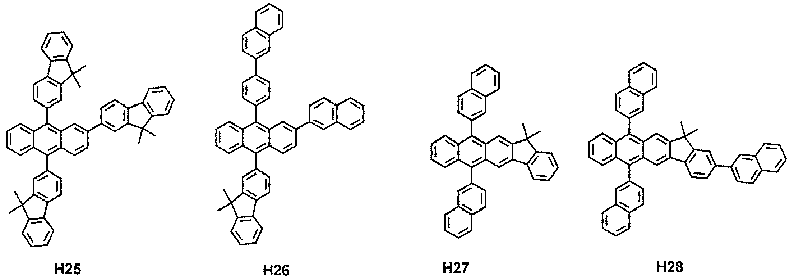

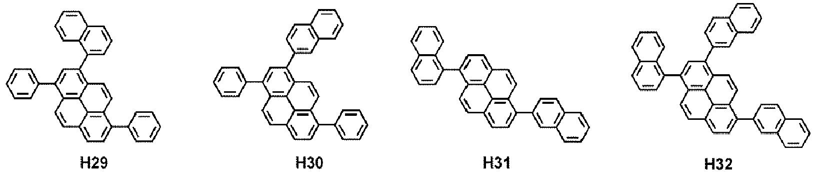

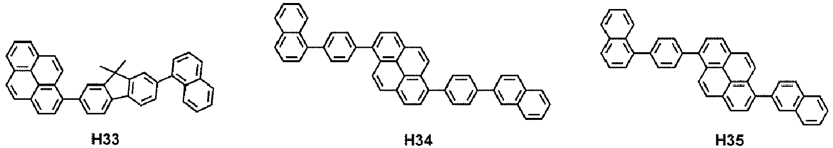

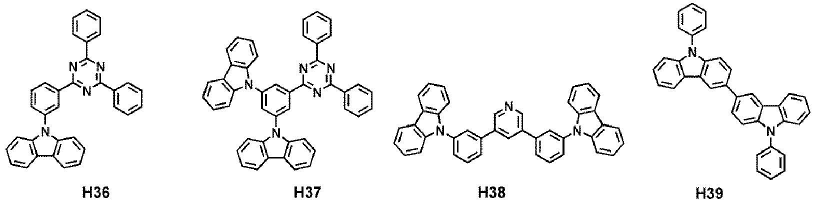

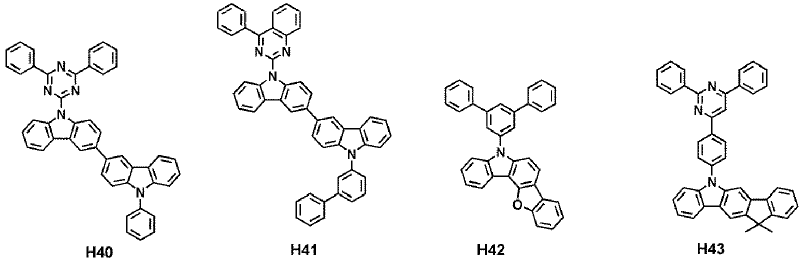

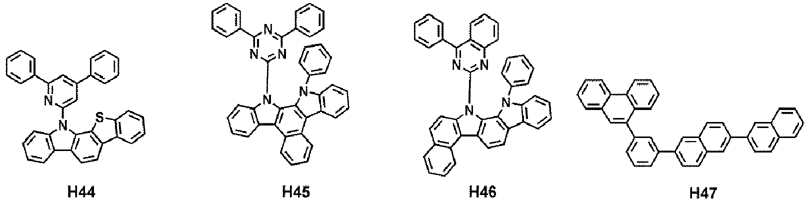

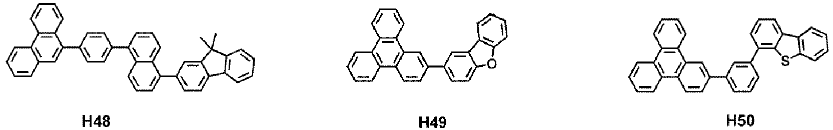

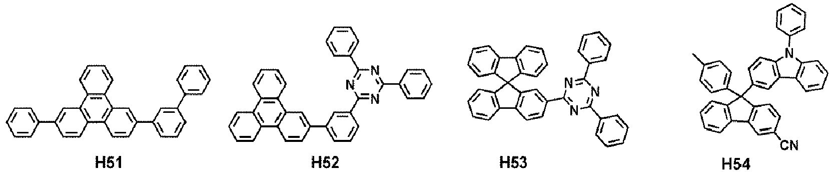

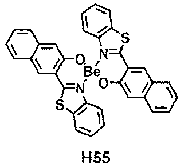

### Phosphorescent dopant included in emission layer in organic layer 150

The phosphorescent dopant may comprise an organometallic complex represented by Formula 401:

**Formula 401** M(L₄₀₁)_{xc1}(L₄₀₂)_{xc2}

in which L₄₀₁ may be a ligand represented by Formula 402,

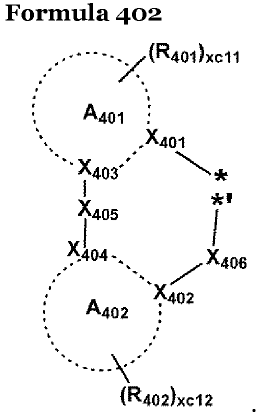

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 may be 1, 2, or 3, wherein when xc1 is two or more, two or more L₄₀₁(s) may be identical to or different from each other,
L₄₀₂ may be an organic ligand, and xc2 may be an integer selected from 0 to 4, wherein when xc2 is two or more, two or more L₄₀₂(s) may be identical to or different from each other,
X₄₀₁ to X₄₀₄ may each independently be nitrogen or carbon, wherein X₄₀₁ and X₄₀₃ may be linked to each other via a single bond or a double bond, and X₄₀₂ and X₄₀₄ may be linked to each other via a single bond or a double bond,
A₄₀₁ and A₄₀₂ may each independently be a C₅-C₆₀ carbocyclic group or a C₁-C₆₀ heterocyclic group,
X₄₀₅ may be a single bond, -O-, -S-, -C(=O)-, -N(Q₄₁₁)-, -C(Q₄₁₁)(Q₄₁₂)-,-C(Q₄₁₁)=C(Q₄₁₂)-, -C(Q₄₁₁)=, or =C(Q₄₁₁)=, wherein Q₄₁₁ and Q₄₁₂ may each independently be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium,-F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₄₀₁)(Q₄₀₂)(Q₄₀₃), -N(Q₄₀₁)(Q₄₀₂), -B(Q₄₀₁)(Q₄₀₂),-C(=O)(Q₄₀₁), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer 0 to 10, and
* and *' in Formula 402 may each independently indicate a binding site to M of Formula 401.

In an example, in Formula 402, A₄₀₁ and A₄₀₂ may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In various examples, in Formula 402, i) X₄₀₁ may be nitrogen, and X₄₀₂ may be carbon, or ii) X₄₀₁ and X₄₀₂ may both be nitrogen.

In various examples, in Formula 402, R₄₀₁ and R₄₀₂ may each independently be selected from the group consisting of:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), and
Q₄₀₁ to Q₄₀₃ may each independently be selected from a C₁-C₁₀ alkyl group, a C₁-C₁₀ alkoxy group, a phenyl group, a biphenyl group, and a naphthyl group, but examples are not limited thereto.

In various examples, when xc1 in Formula 401 is two or more, two A₄₀₁(s) in two or more L₄₀₁(s) may be optionally linked to each other via X₄₀₇, which is a linking group, two A₄₀₂(s) in two or more L₄₀₁(s) may be optionally linked to each other via X₄₀₈, which is a linking group (see Compounds PD1 to PD4 and PD7). In various examples, X₄₀₇ and X₄₀₈ may each independently be a single bond, -O-, -S-, -C(=O)-, -N(Q₄₁₃)-,-C(Q₄₁₃)(Q₄₁₄)-, or -C(Q₄₁₃)=C(Q₄₁₄)- (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but examples are not limited thereto.

In Formula 401, L₄₀₂ may be a monovalent, divalent, or trivalent organic ligand. For example, in Formula 401, L₄₀₂ may be selected from a halogen ligand, a diketone ligand (for example, acetylacetonate), a carboxylic acid ligand (for example, picolinate), -C(=O), an isontrile ligand, -CN, and a phosphorus ligand (for example, phosphine and/or phosphite), but examples of the present disclosure are not limited thereto.

In various examples, the phosphorescent dopant may be, for example, selected from Compounds PD1 to PD27, but examples of the present disclosure are not limited thereto:

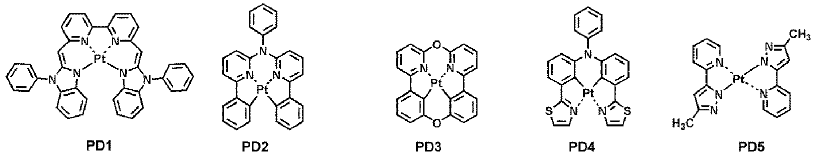

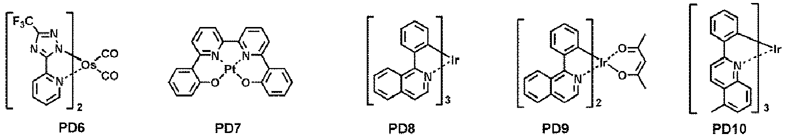

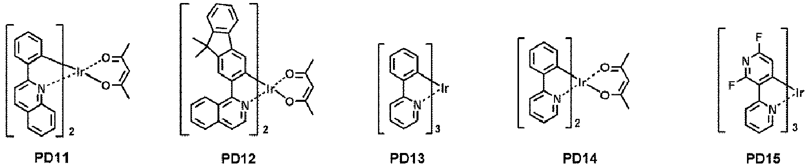

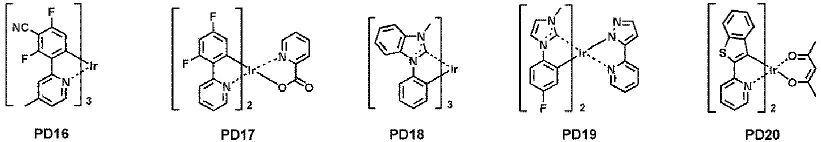

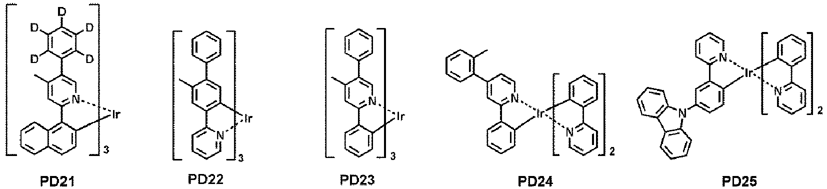

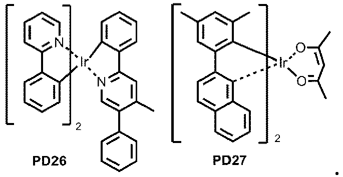

### Electron transport region in organic layer 150

The electron transport region may have i) a single-layered structure including a single layer including a single material, ii) a single-layered structure including a single layer comprising a plurality of different materials, or iii) a multi-layered structure having a plurality of layers comprising a plurality of different materials.

The electron transport region may comprise at least one selected from a buffer layer, a hole blocking layer, an electron control layer, an electron transport layer, and an electron injection layer, but examples of the present disclosure are not limited thereto.

For example, the electron transport region may have a structure of electron transport layer/electron injection layer, a structure of hole blocking layer/electron transport layer/electron injection layer, a structure of electron control layer/electron transport layer/electron injection layer, or a structure of buffer layer/electron transport layer/electron injection layer, wherein for each structure, constituting layers are sequentially stacked from the emission layer in each stated order, but the structure of the electron transport region is not limited thereto.

The electron transport region (for example, a buffer layer, a hole blocking layer, an electron control layer, and/or an electron transport layer in the electron transport region) may comprise a metal-free compound containing at least one π electron-depleted nitrogen-containing ring.

The "π electron-depleted nitrogen-containing ring" indicates a C₁-C₆₀ heterocyclic group having at least one *-N=*' moiety as a ring-forming moiety.

For example, the "π electron-depleted nitrogen-containing ring" may be i) a 5-membered to 7-membered hetero monocyclic group having at least one *-N=*' moiety, ii) a hetero-polycyclic group in which two or more 5-membered to 7-membered hetero monocyclic groups each having at least one *-N=*' moiety are condensed with each other, or iii) a hetero-polycyclic group in which at least one of 5-membered to 7-membered hetero monocyclic groups, each having at least one *-N=*' moiety, is condensed with at least one C₅-C₆₀ carbocyclic group.

Examples of the π electron-depleted nitrogen-containing ring include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, a thiadiazol, an imidazopyridine, an imidazopyrimidine, and an azacarbazole, but examples of the present disclosure are not limited thereto.

For example, the electron transport region may comprise a compound represented by Formula 601.

For example, the electron transport region (for example, a buffer layer, a hole blocking layer, an electron control layer, and/or an electron transport layer in the electron transport region) may comprise the second compound represented by Formula 2.

In an example, the electron transport region may comprise a first layer, the first layer comprising the second compound represented by Formula 2, but examples are not limited thereto. Here, the first layer may be an electron transport layer.

In various examples, the electron transport region may comprise a first layer and a second layer, the first layer being disposed between the emission layer and the second layer. The first layer may comprise the second compound represented by Formula 2, but examples of the present disclosure are not limited thereto. Here, the first layer may be a buffer layer, and the second layer may be an electron transport layer.

The electron transport region may further comprise, in addition to the second compound represented by Formula 2, a compound represented by Formula 601:

**Formula 601** [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
xe1 may be an integer selected from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₆₀₁)(Q₆₀₂)(Q₆₀₃), - -C(=O)(Q₆₀₁), -S(=O)₂(Q₆₀₁), and-P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe2i may be an integer selected from 1 to 5.

In an example, at least one of Ar₆₀₁ in the number of xe11 and R₆₀₁(s) in the number of xe2i may comprise the π electron-depleted nitrogen-containing ring.

In an example, in Formula 601, ring Ar₆₀₁ may be selected from the group consisting of:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazol group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -S(=O)₂(Q₃₁), and -P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In Formula 601, when xe11 is two or more, two or more Ar₆₀₁(s) may be linked to each other via a single bond.

In various examples, Ar₆₀₁ in Formula 601 may be an anthracene group.

In various examples, the compound represented by Formula 601 may be represented by Formula 601-1:

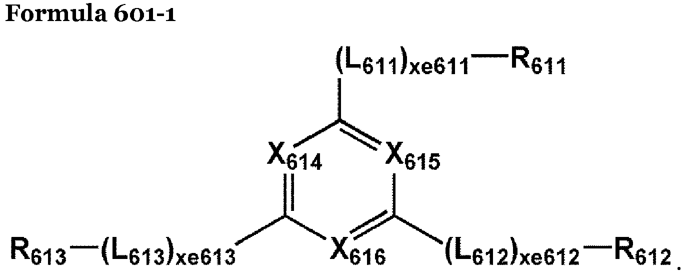

In Formula 601-1,
X₆₁₄ may be N or C(R₆₁₄), X₆₁₅ may be N or C(R₆₁₅), and X₆₁₆ may be N or C(R₆₁₆), wherein at least one selected from X₆₁₄ to X₆₁₆ may be nitrogen,
L₆₁₁ to L₆₁₃ may each independently be the same as described in connection with L₆₀₁ in Formula 601,
xe611 to xe613 may each independently be the same as described in connection with xe1 in Formula 601,
R₆₁₁ to R₆₁₃ may each independently be the same as described in connection with R₆₀₁ in Formula 601, and
R₆₁₄ to R₆₁₆ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In an example, in Formulae 601 and 601-1, L₆₀₁ and L₆₁₁ to L₆₁₃ may each independently be selected from the group consisting of:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosiloleylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosiloleylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but examples are not limited thereto.

In various examples, in Formulae 601 and 601-1, xe1 and xe611 to xe₆₁₃ may each independently be 0, 1, or 2.

In various examples, in Formulae 601 and 601-1, R₆₀₁ and R₆₁₁ to R₆₁₃ may each independently be selected from the group consisting of:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁), and -P(=O)(Q₆₀₁)(Q₆₀₂), and
Q₆₀₁ and Q₆₀₂ may each independently be understood by referring to the descriptions thereof provided herein.

The electron transport region may comprise at least one compound selected from Compounds ET1 to ET36, but examples are not limited thereto:

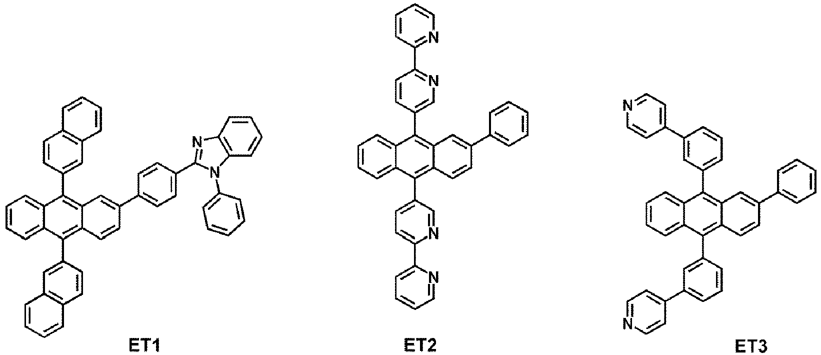

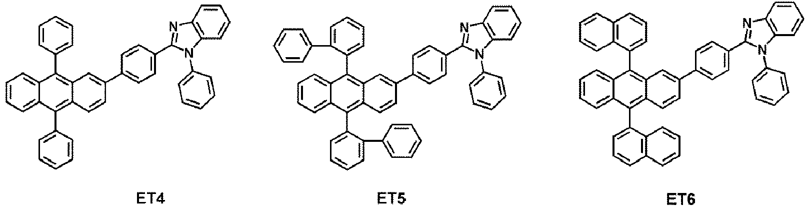

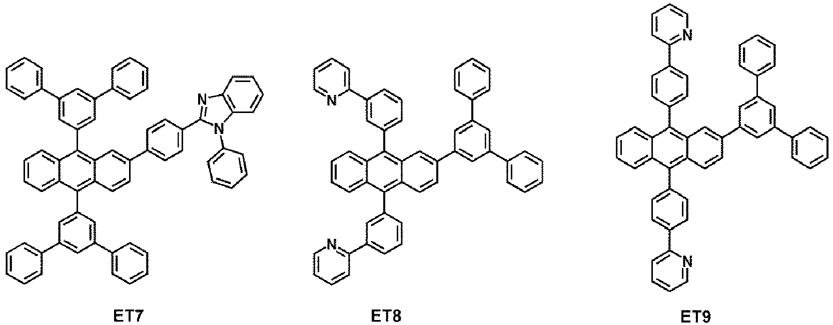

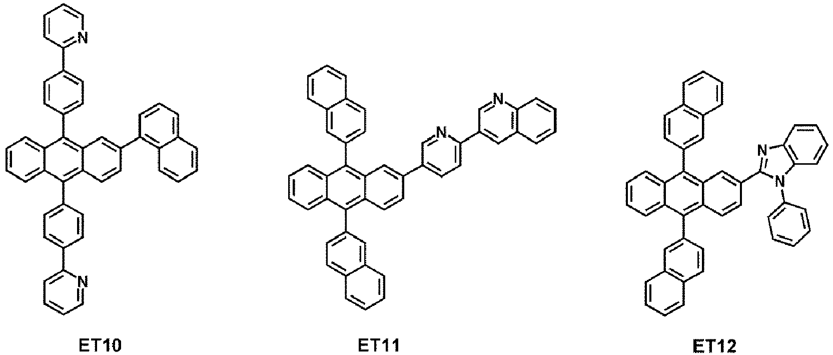

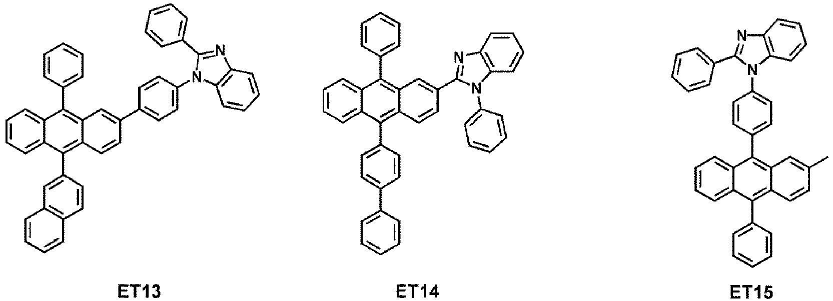

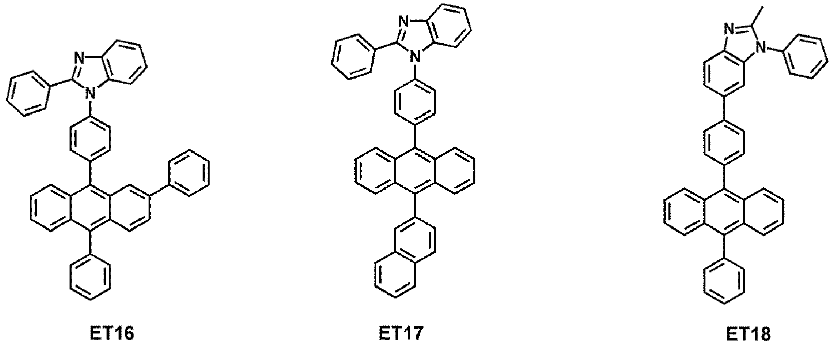

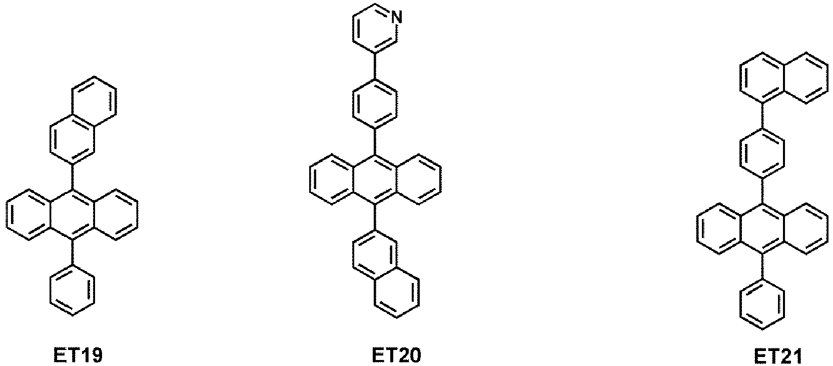

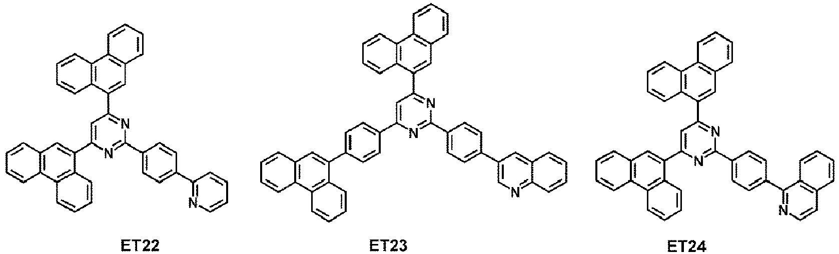

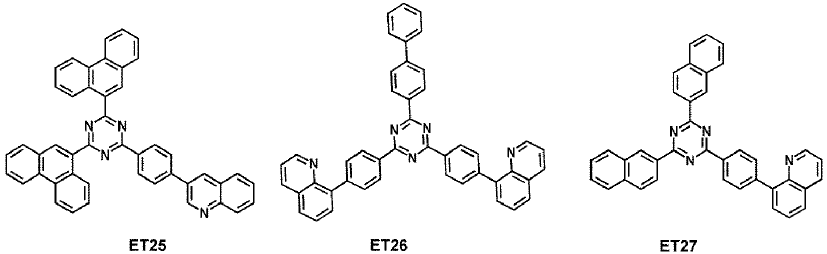

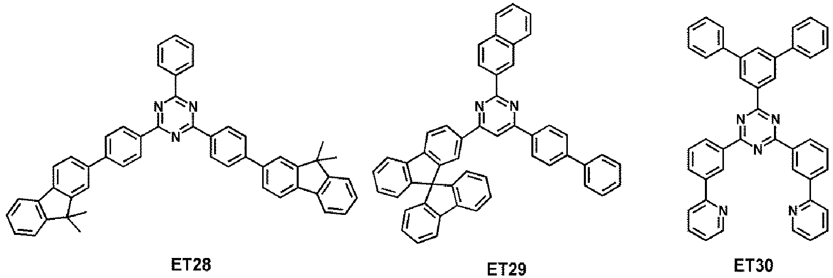

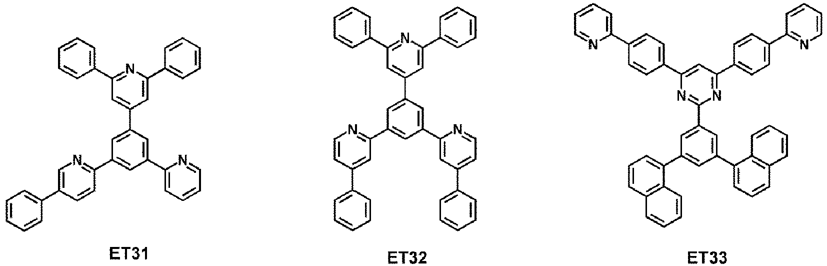

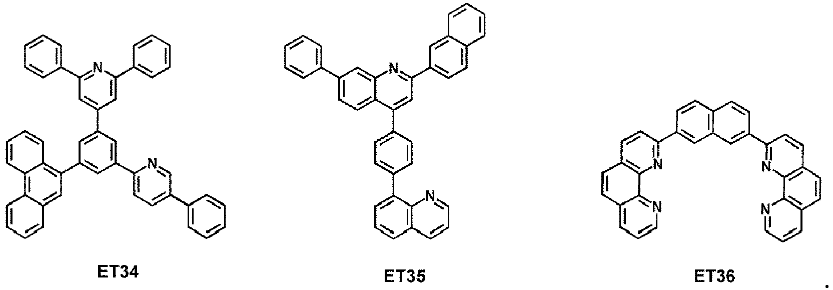

In various examples, the electron transport region may comprise at least one compound selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ:

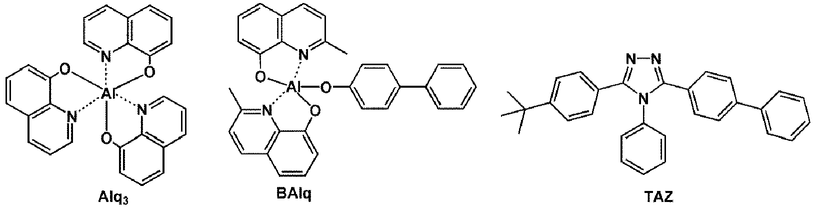

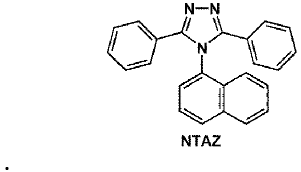

A thickness of the buffer layer, the hole blocking layer, and/or the electron control layer may each independently be in a range of about 20 Å to about 1,000 Å, for example, about 30 Å to about 300 Å. When the thicknesses of the buffer layer, the hole blocking layer, and the electron control layer are within these ranges, the electron blocking layer may have excellent electron blocking characteristics or electron control characteristics without a substantial increase in driving voltage.

A thickness of the electron transport layer may be in a range of about 100 Å to about 1,000 Å, for example, about 150 Å to about 500 Å. When the thickness of the electron transport layer is within the ranges described above, the electron transport layer may have satisfactory electron transporting characteristics without a substantial increase in driving voltage.

The electron transport region (for example, the electron transport layer in the electron transport region) may further comprise, in addition to the materials described above, a metal-containing material.

The metal-containing material may comprise at least one selected from an alkaline metal complex and an alkaline earth-metal complex. The alkaline metal complex may comprise a metal ion selected from an Li ion, a Na ion, a K ion, a Rb ion, and a Cs ion, and the alkaline earth-metal complex may comprise a metal ion selected from a Be ion, a Mg ion, a Ca ion, an Sr ion, and a Ba ion. A ligand coordinated with the metal ion of the alkaline metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy phenyloxadiazole, a hydroxy diphenylthiadiazol, a hydroxy phenylpyridine, a hydroxy phenylbenzimidazole, a hydroxy phenylbenzothiazole, a bipyridine, a phenanthroline, and a cyclopentadiene, but examples of the present disclosure are not limited thereto.

For example, the metal-containing material may comprise a Li complex. The Li complex may comprise, for example, Compound ET-Di (lithium quinolate, LiQ) or ET-D2:

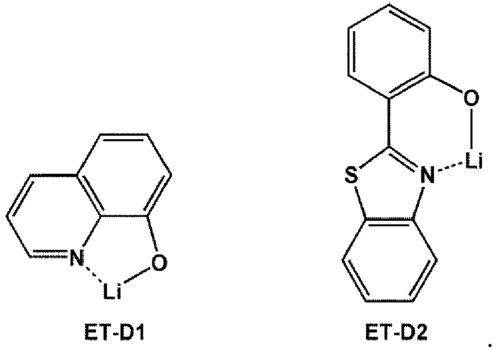

The electron transport region may comprise an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer comprising a plurality of different materials, or iii) a multi-layered structure having a plurality of layers comprising a plurality of different materials.

The electron injection layer may comprise an alkaline metal, an alkaline earth-metal, a rare-earth-metal, an alkaline metal compound, an alkaline earth-metal compound, a rare-earth-metal compound, an alkaline metal complex, an alkaline earth-metal complex, a rare-earth metal complex, or a combination thereof.

The alkaline metal may be selected from Li, Na, K, Rb, and Cs. In an example, the alkaline metal may be Li, Na, and/or Cs. In various examples, the alkaline metal may be Li and/or Cs, but examples of the present disclosure are not limited thereto.

The alkaline earth metal may be selected from Mg, Ca, Sr, and Ba.

The rare-earth metal may be selected from Sc, Y, Ce, Tb, Yb, Gd, and Tb.

The alkaline metal compound, the alkaline earth-metal compound, and the rare-earth metal compound may be selected from oxides and halides (for example, fluorides, chlorides, bromides, and/or iodines) of the alkaline metal, the alkaline earth-metal, and the rare-earth metal.

The alkaline metal compound may be selected from alkaline metal oxides, such as Li₂O, Cs₂O, and/or K₂O, and alkaline metal halides, such as LiF, NaF, CsF, KF, Lil, NaI, CsI, and/or KI. In an example, the alkaline metal compound may be selected from LiF, Li₂O, NaF, Lil, Nal, CsI, and KI, but examples of the present disclosure are not limited thereto.

The alkaline earth-metal compound may be selected from alkaline earth-metal compounds, such as BaO, SrO, CaO, BaₓSr₁₋ₓO (where 0<x<1), and/or BaₓCa₁₋ₓO (where 0<x<1). For example, the alkaline earth-metal compound may be selected from BaO, SrO, and CaO, but examples of the present disclosure are not limited thereto.

The rare-earth metal compound may be selected from YbF₃, ScF₃, ScO₃, Y₂O₃, Ce₂O₃, GdF₃, and TbF₃. For example, in an example, the rare-earth metal compound maybe selected from YbF₃, ScF₃, TbF₃, YbI₃, ScI₃, and TbI₃, but examples of the present disclosure are not limited thereto.

The alkaline metal complex, the alkaline earth-metal complex, and the rare-earth metal complex may comprise an ion of the alkaline metal, the alkaline earth-metal, and the rare-earth metal, and a ligand coordinated with a metal ion of the alkaline metal complex, the alkaline earth-metal complex, and the rare-earth metal complex may each independently be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazol, a hydroxy phenylpyridine, a hydroxy phenylbenzimidazole, a hydroxy phenylbenzothiazole, a bipyridine, a phenanthroline, and a cyclopentadiene, but examples of the present disclosure are not limited thereto.

The electron injection layer may comprise (e.g., consist of) the alkaline metal, the alkaline earth metal, the rare-earth metal, the alkaline metal compound, the alkaline earth-metal compound, the rare-earth metal compound, the alkaline metal complex, the alkaline earth-metal complex, the rare-earth metal complex, or a combination thereof. In various examples, the electron injection layer may further comprise an organic material. When the electron injection layer further comprises an organic material, the alkaline metal, the alkaline earth metal, the rare-earth metal, the alkaline metal compound, the alkaline earth-metal compound, the rare-earth metal compound, the alkaline metal complex, the alkaline earth-metal complex, the rare-earth metal complex, or the combination thereof may be homogeneously or non-homogeneously dispersed in a matrix comprising the organic material.

A thickness of the electron injection layer may be in a range of about 1 Å to about 100 Å, for example, about 3 Å to about 90 Å. When the thickness of the electron injection layer is within the ranges described above, the electron injection layer may have satisfactory electron injecting characteristics without a substantial increase in driving voltage.

### Second electrode 190

The second electrode 190 may be disposed on the organic layer 150 having such a structure described above. The second electrode 190 may be a cathode which is an electron injection electrode, and in this regard, a material for forming the second electrode 190 may be selected from a metal, an alloy, an electrically conductive compound, and combinations thereof, which have a relatively low work function.

The second electrode 190 may comprise at least one selected from Li, Ag, Mg, Al, Al-Li, Ca, Mg-In, Mg-Ag, ITO, and IZO, but examples of the present disclosure are not limited thereto. The second electrode 190 may be a transmissive electrode, a semi-transmissive electrode, or a reflective electrode.

The second electrode 190 may have a single-layered structure, or a multi-layered structure comprising two or more layers.

### Descriptions of FIGS. 2 to 4

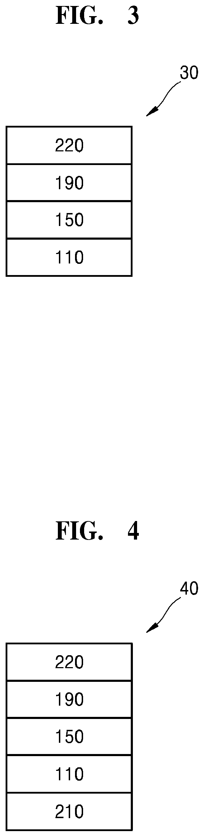

An organic light-emitting device 20 of FIG. 2 comprises a first capping layer 210, a first electrode 110, an organic layer 150, and a second electrode 190, which are sequentially stacked in this stated order, an organic light-emitting device 30 of FIG. 3 comprises a first electrode 110, an organic layer 150, a second electrode 190, and a second capping layer 220, which are sequentially stacked in this stated order, and an organic light-emitting device 40 of FIG. 4 comprises a first capping layer 210, a first electrode 110, an organic layer 150, a second electrode 190, and a second capping layer 220, which are sequentially stacked in this stated order.

Regarding FIGS. 2 to 4, the first electrode 110, the organic layer 150, and the second electrode 190 may each independently be understood by referring to the descriptions thereof presented in connection with FIG. 1.

In the organic layer 150 of each of the organic light-emitting devices 20 and 40, light generated in the emission layer may pass through the first electrode 110, which is a semi-transmissive electrode or a transmissive electrode, and the first capping layer 210 toward the outside, and in the organic layer 150 of each of the organic light-emitting devices 30 and 40, light generated in the emission layer may pass through the second electrode 190, which is a semi-transmissive electrode or a transmissive electrode, and the second capping layer 220 toward the outside.

The first capping layer 210 and the second capping layer 220 may increase external luminescent efficiency according to the principle of constructive interference.

The first capping layer 210 and the second capping layer 220 may each independently be an organic capping layer comprising an organic material, an inorganic capping layer comprising an inorganic material, or a composite capping layer comprising an organic material and an inorganic material.

At least one selected from the first capping layer 210 and the second capping layer 220 may comprise at least one material selected from a carbocyclic compound, a heterocyclic compound, an amine-based compound, a porphine derivative, a phthalocyanine derivative, a naphthalocyanine derivative, an alkaline metal complex, and an alkaline earth-based complex. The carbocyclic compound, the heterocyclic compound, and the amine-based compound may be optionally substituted with a substituent containing at least one element selected from O, N, S, Se, Si, F, Cl, Br, and I.

In an example, at least one selected from the first capping layer 210 and the second capping layer 220 may comprise an amine-based compound.

In various examples, at least one selected from the first capping layer 210 and the second capping layer 220 may comprise the compound represented by Formula 201 or the compound represented by Formula 202.

In various examples, at least one selected from the first capping layer 210 and the second capping layer 220 may comprise a compound selected from Compounds HT28 to HT33 and Compounds CP1 to CP5, but examples of the present disclosure are not limited thereto:

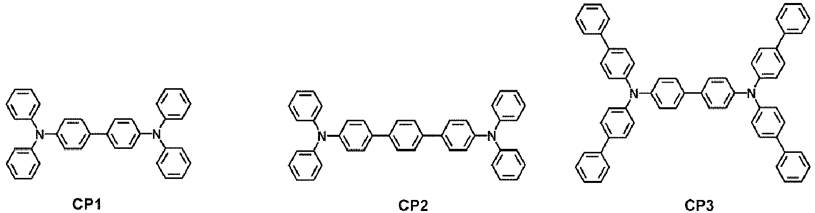

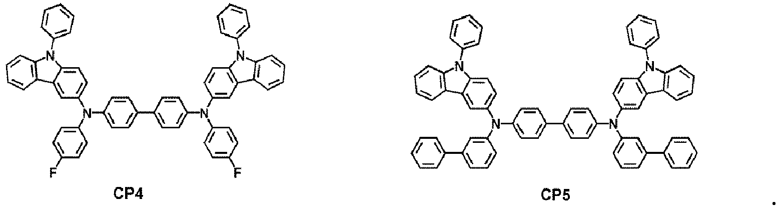

Hereinbefore, the organic light-emitting device according to an example has been described in connection with FIGS. 1 to 4. However, examples are not limited thereto.

Layers constituting the hole transport region, the emission layer, and layers constituting the electron transport region may each independently be formed in a certain region by utilizing one or more suitable methods selected from vacuum deposition, spin coating, casting, langmuir-blodgett (LB) deposition, ink-jet printing, laser-printing, and laser-induced thermal imaging (LITI).

When layers constituting the hole transport region, the emission layer, and layers constituting the electron transport region are each independently formed by vacuum deposition, the vacuum deposition may be, for example, performed at a deposition temperature of about 100°C to about 500°C, at a vacuum degree of about 10⁻⁸ to about 10⁻³ torr, and at a deposition rate of about 0.01 to about 100 Å/sec by taking into account a material to be comprised in a layer to be formed, and a structure of the layer to be formed.

When layers constituting the hole transport region, the emission layer, and layers constituting the electron transport region are each independently formed by spin coating, the spin coating may be, for example, performed at a coating speed of about 2,000 rpm to about 5,000 rpm and at a heat treatment temperature of about 80°C to 200°C by taking into account a material to be comprised in a layer to be formed, and a structure of the layer to be formed.

### General definition of substituents

A "C₁-C₆₀ alkyl group," as used herein, refers to a linear or branched aliphatic saturated hydrocarbon monovalent group having 1 to 60 carbon atoms, e.g. 1 to 30 carbon atoms, 1 to 20 carbon atoms, 1 to 10 carbon atoms, 1 to 6 carbon atoms or 1 to 4 carbon atoms. Examples thereof include a methyl group, an ethyl group, a propyl group, an isobutyl group, a sec-butyl group, a ter-butyl group, a pentyl group, an isoamyl group, and a hexyl group. A "C₁-C₆₀ alkylene group," as used herein, refers to a divalent group having substantially the same structure as the C₁-C₆₀ alkyl group.

A "C₂-C₆₀ alkenyl group," as used herein, refers to a hydrocarbon group having at least one carbon-carbon double bond at one or more positions along the hydrocarbon chain (e.g., in the in the middle or at either terminal end of the C₂-C₆₀ alkyl group), and examples thereof include an ethenyl group, a propenyl group, and a butenyl group. A "C₂-C₆₀ alkenylene group," as used herein, refers to a divalent group having substantially the same structure as the C₂-C₆₀ alkenyl group.

A "C₂-C₆₀ alkynyl group," as used herein, refers to a hydrocarbon group having at least one carbon-carbon triple bond at one or more positions along the hydrocarbon chain (e.g., in the in the middle or at either terminal end of the C₂-C₆₀ alkyl group), and examples thereof include an ethynyl group and a propynyl group. A "C₂-C₆₀ alkynylene group," as used herein, refers to a divalent group having substantially the same structure as the C₂-C₆₀ alkynyl group.

A "C₁-C₆₀ alkoxy group," as used herein, refers to a monovalent group represented by -OA₁₀₁ (where A₁₀₁ is the C₁-C₆₀ alkyl group), and examples thereof include a methoxy group, an ethoxy group, and an isopropyloxy group.

A "C₃-C₁₀ cycloalkyl group," as used herein, refers to a monovalent saturated hydrocarbon monocyclic saturated group having 3 to 10 carbon atoms, and examples thereof include a cyclopropyl group, a cyclobutyl group, a cyclopentyl group, a cyclohexyl group, and a cycloheptyl group. A "C₃-C₁₀ cycloalkylene group," as used herein, may refer to a divalent group having the same structure as the C₃-C₁₀ cycloalkyl group.

A "C₁-C₁₀ heterocycloalkyl group," as used herein, refers to a monovalent saturated monocyclic group having at least one heteroatom (e.g. 1, 2, 3, 4 or 5 hereoatoms) selected from N, O, P, Si and S as a ring-forming atom in addition to 1 to 10 carbon atoms, and examples thereof include a 1,2,3,4-oxatriazolidinyl group, a tetrahydrofuranyl group, and a tetrahydrothiophenyl group. A "C₁-C₁₀ heterocycloalkylene group," as used herein, refers to a divalent group having substantially the same structure as the C₁-C₁₀ heterocycloalkyl group.

A "C₃-C₁₀ cycloalkenyl group," as used herein, refers to a monovalent saturated monocyclic group that has 3 to 10 carbon atoms and at least one carbon-carbon double bond in the ring thereof and does not have aromaticity, and examples thereof include a cyclopentenyl group, a cyclohexenyl group, and a cycloheptenyl group. A "C₃-C₁₀ cycloalkenylene group," as used herein, refers to a divalent group having substantially the same structure as the C₃-C₁₀ cycloalkenyl group.

A "C₁-C₁₀ heterocycloalkenyl group," as used herein, refers to a monovalent monocyclic group that has at least one heteroatom (e.g. 1, 2, 3, 4 or 5 hereoatoms) selected from N, O, P, Si, and S as a ring-forming atom in addition to 1 to 10 carbon atoms, and at least one carbon-carbon double bond in the ring. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. A "C₁-C₁₀ heterocycloalkenylene group," as used herein, refers to a divalent group having substantially the same structure as the C₁-C₁₀ heterocycloalkenyl group.

A "C₆-C₆₀ aryl group," as used herein, refers to a monovalent group having a cyclic aromatic system having 6 to 60 carbon atoms e.g. 6 to 20 ring carbon atoms, 6 to 14 ring cabon atoms or 6 to 10 ring carbon atoms. A "C₆-C₆₀ arylene group," as used herein, refers to a divalent group having an aromatic system having 6 to 60 carbon atoms e.g. 6 to 20 ring carbon atoms, 6 to 14 ring cabon atoms or 6 to 10 ring carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each independently comprise two or more rings, the respective rings may be fused to each other or may be linked with each other via a single bond.

A "C₁-C₆₀ heteroaryl group," as used herein, refers to a monovalent group having a heterocyclic aromatic system that has at least one heteroatom (e.g. 1, 2, 3, 4 or 5 hereoatoms) selected from N, O, Si, P, and S as a ring-forming atom in addition to 1 to 60 carbon atoms e.g. 1 to 19 ring carbon atoms, 1 to 13 ring cabon atoms or 1 to 9 ring carbon atoms. A "C₁-C₆₀ heteroarylene group," as used herein, refers to a divalent group having a heterocyclic aromatic system that has at least one heteroatom (e.g. 1, 2, 3, 4 or 5 hereoatoms) selected from N, O, Si, P, and S as a ring-forming atom in addition to 1 to 60 carbon atoms e.g. 1 to 19 ring carbon atoms, 1 to 13 ring cabon atoms or 1 to 9 ring carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently comprise two or more rings, the respective rings may be fused to each other or may be linked with each other via a single bond.

A "C₆-C₆₀ aryloxy group," as used herein, refers to a group represented by -OA₁₀₂ (where A₁₀₂ is the C₆-C₆₀ aryl group), and a "C₆-C₆₀ arylthio group," as used herein, refers to a group represented by -SA₁₀₃ (where A₁₀₃ is the C₆-C₆₀ aryl group).

A "monovalent non-aromatic condensed C8-C60 polycyclic group," as used herein, refers to a monovalent group that has two or more rings condensed to each other, has 8 to 60 carbon atoms as the only ring-forming atoms (for example, 8 to 20, 8 to 14 or 8 to 10 ring carbon atoms), and has non-aromaticity in the entire molecular structure. Examples of the monovalent non-aromatic condensed C8-C60 polycyclic group include a fluorenyl group and a spiro-bifluorenyl group. A "divalent non-aromatic condensed C8-C60 polycyclic group," as used herein, refers to a divalent group having substantially the same structure as the monovalent non-aromatic condensed C8-C60 polycyclic group.

A "monovalent non-aromatic condensed 8- to 60-membered heteropolycyclic group," as used herein, refers to a monovalent group that has two or more rings condensed to each other, has at least one heteroatom (e.g. 1, 2, 3, 4 or 5 hereoatoms) selected from N, O, Si, P, and S as a ring-forming atom, in addition to carbon atoms (for example, 1 to 59, 2 to 59, 2 to 19, 2 to 13 or 2 to 9 ring carbon atoms), and has non-aromaticity in the entire molecular structure. An example of the monovalent non-aromatic condensed 8- to 60-membered heteropolycyclic group includes a carbazolyl group. A "divalent non-aromatic condensed 8- to 60-membered heteropolycyclic group," as used herein, refers to a divalent group having substantially the same structure as the monovalent non-aromatic condensed 8- to 60-membered heteropolycyclic group.

A "C₅-C₆₀ carbocyclic group," as used herein, refers to a monocyclic or polycyclic group having 5 to 60 carbon atoms e.g. 5 to 20 ring carbon atoms, 5 to 14 ring cabon atoms or 5 to 10 ring carbon atoms, in which the ring-forming atoms include only carbon atoms. The C₅-C₆₀ carbocyclic group may be a saturated carbocyclic group or an unsaturated carbocyclic group. The C₅-C₆₀ carbocyclic group may be an aromatic carbocyclic group or a non-aromatic carbocyclic group. The C₅-C₆₀ carbocyclic group may be a ring, such as benzene, a monovalent group, such as a phenyl group, or a divalent group, such as a phenylene group. In various examples, depending on the number of substituents connected to the C₅-C₆₀ carbocyclic group, the C₅-C₆₀ carbocyclic group may be a trivalent group or a quadrivalent group.

A "C₁-C₆₀ heterocyclic group," as used herein, refers to a group having substantially the same structure as the C₅-C₆₀ carbocyclic group, except that as a ring-forming atom, at least one heteroatom (e.g. 1, 2, 3, 4 or 5 hereoatoms) selected from N, O, Si, P, and S is used in addition to carbon atom (the number of carbon in the C₁-C₆₀ heterocyclic group may be in a range of 1 to 60, e.g. 1 to 19 ring carbon atoms, 1 to 13 ring cabon atoms or 1 to 9 ring carbon atoms).

A "C₆-C₆₀ arene group," as used herein, refers to an aliphatic monocyclic group or a polycyclic group, each having 6 to 60 carbon atoms (e.g. 6 to 20 ring carbon atoms, 6 to 14 ring cabon atoms or 6 to 10 ring carbon atoms) in which a ring-forming atom is a carbon atom only. The C₆-C₆₀ arene group may be a ring, such as benzene, a monovalent group, such as a phenyl group, or a divalent group, such as a phenylene group. In various examples, depending on the number of substituents connected to the C₆-C₆₀ arene group, the C₆-C₆₀ arene group may be a trivalent group or a quadrivalent group.

A "C₁-C₆₀ heteroarene group," as used herein, refers to a group having substantially the same structure as the C₆-C₆₀ arene group, except that as a ring-forming atom, at least one heteroatom (e.g. 1, 2, 3, 4 or 5 hereoatoms) selected from N, O, Si, P, and S is used in addition to carbon (the number of carbon in the C₁-C₆₀ heteroarene group may be in a range of 1 to 60, e.g. 1 to 19 ring carbon atoms, 1 to 13 ring cabon atoms or 1 to 9 ring carbon atoms).

Certain groups are specified herein as being substituted or unsubstituted. Unless otherwise specified, when a group is substituted it is typically substituted with 1, 2, 3 or 4 substituents. For example, when a group is substituted it may substituted with 1, 2 or 3 substituents; 1 or 2 substituents; or 1 substituent. Groups which are not specified as being substituted or unsubstituted are typically unsubstituted.

Unless otherwise specified, when a group is substituted it is typically substituted with at least one substituent (e.g. 1, 2, 3 or 4 substituents) selected from the group consisting of:
deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, -Br, - I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₁₁ to Q₁₃, Q₂₁ to Q₂₃ and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group.

The term "Ph," as used herein, refers to a phenyl group, the term "Me," as used herein, refers to a methyl group, the term "Et," as used herein, refers to an ethyl group, the term "ter-Bu" or "Bu^{t}," as used herein, refers to a tert-butyl group, the term "D," as used herein, refers to deuterium, and the term "OMe," as used herein, refers to a methoxy group.

The term "biphenyl group," as used therein, refers to "a phenyl group substituted with a phenyl group". The "biphenyl group" belongs to "a substituted phenyl group" having a "C₆-C₆₀ aryl group" as a substituent.

The term "terphenyl group," as used herein, refers to "a phenyl group substituted with a biphenyl group". The "terphenyl group" belongs to "a substituted phenyl group" having "a C₆-C₆₀ aryl group substituted with a C₆-C₆₀ aryl group".

* and *', as used herein, unless defined otherwise, each indicate a binging site to a neighboring atom in a corresponding formula.

Hereinafter, a compound according to one or more examples and an organic light-emitting device according to one or more examples will be described in more detail with reference to Synthesis Examples and Examples. The phrase "B was utilized instead of A" used in describing Synthesis Examples refers to that an identical number of molar equivalents of B was utilized in place of molar equivalents of A.

### Examples

### Example 1-1

An anode was prepared by cutting a glass substrate, on which ITO/Ag/ITO having a thickness of 70 Å/1,000 Å/70 Å was formed, to a size of 50 mm x 50 mm x 0.4 mm, ultrasonically cleaning the glass substrate by utilizing isopropyl alcohol and pure water for 10 minutes each, and then irradiating UV light for 10 minutes thereto and exposing the glass substrate to ozone to clean the glass substrate. Then, the anode was loaded into a vacuum deposition apparatus.

Compound HT28 was vacuum-deposited on the ITO anode of the glass substrate to form a hole injection layer having a thickness of 700 Å, and then, Compound HT3 was vacuum-deposited on the hole injection layer to form a hole transport layer having a thickness of 1,200 Å.

Compound B-108 and PD27 (as a dopant) were co-deposited on the hole transport region at a weight ratio of 97:3 to form an emission layer having a thickness of 400 Å.

Subsequently, Compound E-36 and LiQ were deposited (e.g., co-deposited) on the emission layer at a ratio of 1:1 to form an electron transport layer having a thickness of 360 Å. Then, LIQ was deposited on the electron transport layer to form an electron injection layer having a thickness of 10 Å, thereby forming an electron transport region. Mg and Ag were vacuum-deposited on the electron transport layer at a weight ratio of 9:1 to form a cathode having a thickness of 120 Å, thereby completing the manufacturing of an organic light-emitting device.

### Examples 1-2 to 1-16 and Comparative Examples 1-1 to 1-5

Organic light-emitting devices were manufactured in substantially the same manner as in Example 1-1, except that compounds shown in Table 1 were utilized instead of Compounds B-108 and E-36 in the formation of the emission layer and the electron transport layer.

**Table 1**

| Example | Host in emission layer | Electron transport layer |
|---|---|---|
| Example 1-1 | B-108 | E-36 |
| Example 1-2 | B-148 | E-36 |
| Example 1-3 | B-173 | E-36 |
| Example 1-4 | B-135 | E-36 |
| Example 1-5 (Reference) | B-108 | E-173 |
| Example 1-6 (Reference) | B-148 | E-173 |
| Example 1-7 (Reference) | B-173 | E-173 |
| Example 1-8 (Reference) | B-135 | E-173 |
| Example 1-9 (Reference) | B-108 | E-100 |
| Example 1-10 (Reference) | B-148 | E-100 |
| Example 1-11 (Reference) | B-173 | E-100 |
| Example 1-12 (Reference) | B-135 | E-100 |
| Example 1-13 (Reference) | B-108 | E-273 |
| Example 1-14 (Reference) | B-148 | E-273 |
| Example 1-15 (Reference) | B-173 | E-273 |
| Example 1-16 (Reference) | B-135 | E-273 |
| Comparative Example 1-1 | B-108 | ET1 |
| Comparative Example 1-2 | B-148 | ET1 |
| Comparative Example 1-3 | B-173 | ET1 |
| Comparative Example 1-4 | B-135 | ET1 |
| Comparative Example 1-5 | CBP | B |

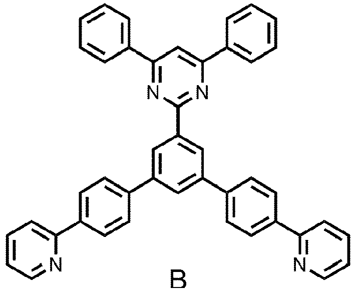

### Evaluation Example

The driving voltage, current density, efficiency, and lifespan of the organic light-emitting devices manufactured in Examples 1-1 to 1-16 and Comparative Examples 1-1 to 1-5 were evaluated utilizing a Keithley 236 source-measure unit (SMU) and a PR650 luminance meter. Here, the lifespan results were obtained by measuring the time at which the luminance of an organic light-emitting device was 97% of the initial luminance. The results are shown in Table 4.

**Table 4 Examples 1-5 to 1-16 not according to the invention.**

| Example | Host in mission layer | Electron transport layer | Driving voltage (V) | Current density (mA/cm²) | Efficiency (cd/A) | Lifespan ( hours) |
|---|---|---|---|---|---|---|
| Example 1-1 | B-108 | E-36 | 3.8 | 10.0 | 32.9 | 567 |
| Example 1-2 | B-148 | E-36 | 3.9 | 10.0 | 31.8 | 585 |
| Example 1-3 | B-173 | E-36 | 3.8 | 10.0 | 33.2 | 555 |
| Example 1-4 | B-135 | E-36 | 3.8 | 10.0 | 32.5 | 541 |
| Example 1-5 | B-108 | E-173 | 4.0 | 10.0 | 32.2 | 572 |
| Example 1-6 | B-148 | E-173 | 4.1 | 10.0 | 31.8 | 590 |
| Example 1-7 | B-173 | E-173 | 4.1 | 10.0 | 33.2 | 581 |
| Example 1-8 | B-135 | E-173 | 4.0 | 10.0 | 31.6 | 558 |
| Example 1-9 | B-108 | E-100 | 3.9 | 10.0 | 33.3 | 577 |
| Example 1-10 | B-148 | E-100 | 3.9 | 10.0 | 33.4 | 601 |
| Example 1-11 | B-173 | E-100 | 3.8 | 10.0 | 32.7 | 568 |
| Example 1-12 | B-135 | E-100 | 3.9 | 10.0 | 32.1 | 575 |
| Example 1-13 | B-108 | E-273 | 3.8 | 10.0 | 32.4 | 582 |
| Example 1-14 | B-148 | E-273 | 3.8 | 10.0 | 33.0 | 593 |
| Example 1-15 | B-173 | E-273 | 3.7 | 10.0 | 32.1 | 560 |
| Example 1-16 | B-135 | E-273 | 3.8 | 10.0 | 32.8 | 570 |
| Comparative Example 1-1 | B-108 | ET1 | 4.3 | 10.0 | 29.1 | 452 |
| Comparative Example 1-2 | B-148 | ET1 | 4.5 | 10.0 | 29.3 | 481 |
| Comparative Example 1-3 | B-173 | ET1 | 4.4 | 10.0 | 28.2 | 463 |
| Comparative | B-135 | ET1 | 4.3 | 10.0 | 27.5 | 449 |
| Example 1-4 | | | | | | |
| Comparative Example 1-5 | CBP | B | 4.9 | 10.0 | 24.4 | 288 |

Referring to the results of Table 4, it was confirmed that the organic light-emitting devices manufactured in Examples 1-1 to 1-16 exhibited excellent efficiency and lifespan, as compared with the organic light-emitting devices manufactured in Comparative Examples 1-1 to 1-5.

As described above, an organic light-emitting device according to one or more examples may have high efficiency and long lifespan.

It should be understood that examples described herein should be considered in a descriptive sense only and not for purposes of limitation. Descriptions of features or aspects within each example should typically be considered as available for other similar features or aspects in other examples.

While one or more examples have been described with reference to the figures, it will be understood by those of ordinary skill in the art that various changes in form and details may be made therein without departing from the scope of the invention as defined by the following claims.

## Claims

1. An organic light-emitting device (10,20,30,40) comprising:
a first electrode (110);
a second electrode (190) facing the first electrode (110); and
an organic layer (150) between the first electrode and the second electrode, the organic layer (150) comprising an emission layer, and an electron transport region disposed between the emission layer and the second electrode,
wherein the emission layer comprises a first compound represented by one selected from Formulae 1-14a to 1-14g, and **characterized in that** the electron transport region comprises a second compound represented by Formula 2: 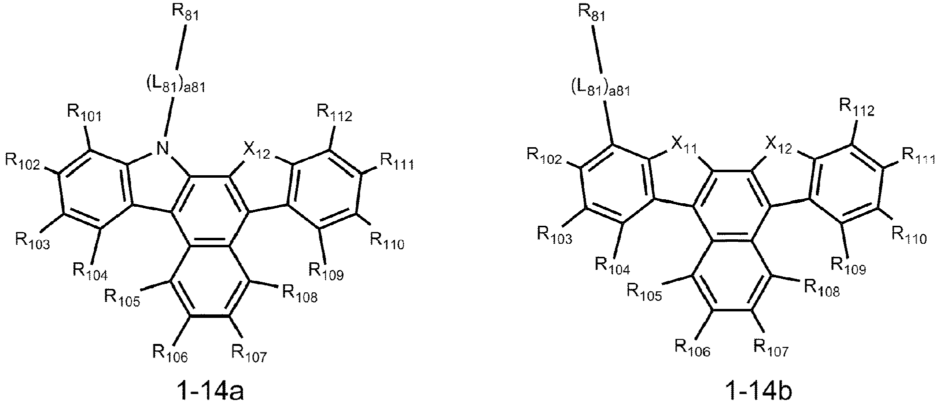 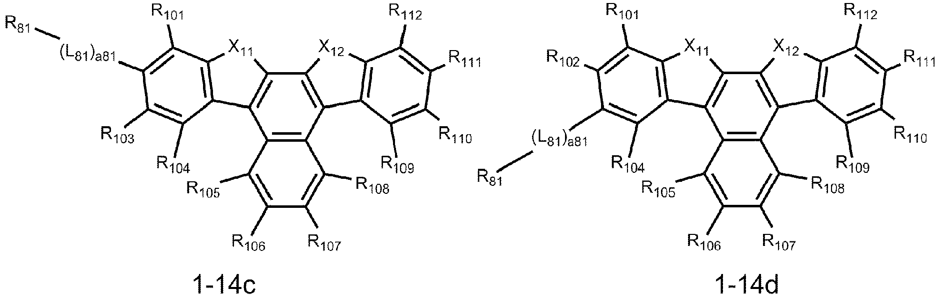 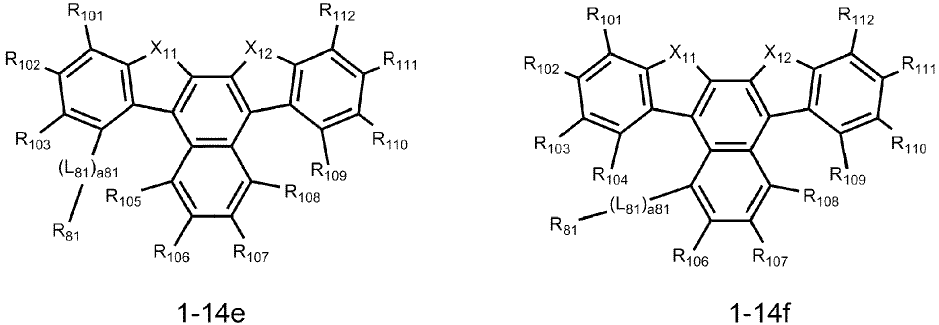 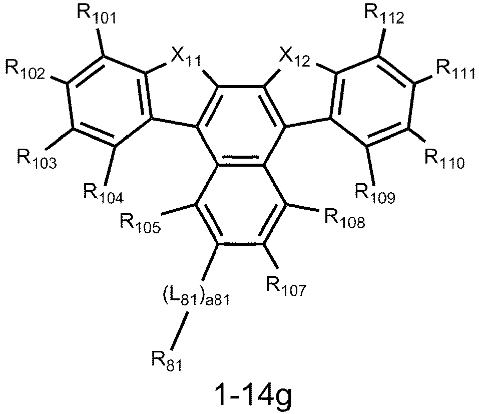 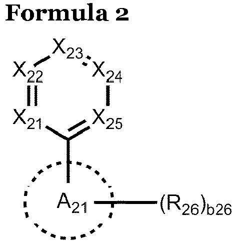 wherein, in Formulae 1-14a to 1-14g, and 2,
X₁₁ is selected from N(R₁₁), C(R₁₁)(R₁₂), O, and S,
X₁₂ is selected from N(R₁₃), C(R₁₃)(R₁₄), O, and S,
A₂₁ is selected from a C₆-C₂₀ arene group and a C₁-C₂₀ heteroarene group, provided that A₂₁ is not an anthracene, pyridine or pyrimidine group,
i) X₂₁ is N, X₂₂ is C(R₂₂), X₂₃ is N, X₂₄ is C(R₂₄), and X₂₅ is N, b26 is selected from 1, 2, 3, 4, 5, and 6, R₁₁ to R₁₄ and R₁₀₁ to R₁₁₂ are each independently selected from a group represented by Formula 8, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group, a substituted or unsubstituted monovalent non-aromatic condensed 8- to 60-membered heteropolycyclic group, -Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), wherein at least one selected from R₁₁ to R₁₄ or R₁₀₁ to R₁₁₂ is the group represented by Formula 8,
**Formula 8** *-(L₈₁)ₐ₈₁-R₈₁
L₈₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed C8-C60 polycyclic group, and a substituted or unsubstituted divalent non-aromatic condensed 8- to 60-membered heteropolycyclic group,
a81 is selected from 0, 1, and 2,
R₈₁ is selected from a substituted or unsubstituted C₆-C₆₀ aryl group, a substituted or unsubstituted C₁-C₆₀ heteroaryl group, a substituted or unsubstituted monovalent non-aromatic condensed C8-C60 polycyclic group, and a substituted or unsubstituted monovalent non-aromatic condensed 8- to 60-membered heteropolycyclic group,
R₂₂, R₂₄, and R₂₆ are each independently selected from a group represented by Formula 9, hydrogen, deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group and a substituted or unsubstituted monovalent non-aromatic condensed 8- to 60-membered heteropolycyclic group, -Si(Q₁)(Q₂)(Q₃), -N(Q₁)(Q₂), -B(Q₁)(Q₂), -C(=O)(Q₁), -S(=O)₂(Q₁), and -P(=O)(Q₁)(Q₂), provided that R₂₆ is not an anthracenyl, pyridinyl or pyrimidinyl group, wherein at least one selected from R₂₂, R₂₄, and R₂₆ is the group represented by Formula 9,
**Formula 9** *-(L₉₁)ₐ₉₁-R₉₁,
L₉₁ is selected from a substituted or unsubstituted C₆-C₆₀ arylene group and a substituted or unsubstituted C₁-C₆₀ heteroarylene group, provided that L₉₁ is not an anthracenylene, pyridinylene or pyrimidinylene group,
a₉₁ is selected from 0, 1, and 2,
R₉₁ is selected from a substituted or unsubstituted C₆-C₆₀ aryl group and a substituted or unsubstituted C₁-C₆₀ heteroaryl group, provided that R₉₁ is not an anthracenyl, pyridinyl or pyrimidinyl group,
Q₁ to Q₃ are each independently selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group, and
* indicates a binding site to a neighboring atom.

2. The organic light-emitting device of claim 1, wherein R₁₀₁ to R₁₁₂ are each independently selected from the group consisting of:
a group represented by Formula 8, hydrogen, deuterium, -F, -Cl, -Br, -I, a C₁-C₂₀ alkyl group, a C₁-C₂₀ alkoxy group, a C₆-C₆₀ aryl group, a C₆-C₆₀ aryloxy group, a C₆-C₆₀ arylthio group, a C₁-C₆₀ heteroaryl group, a monovalent non-aromatic condensed C8-C60 polycyclic group, a monovalent non-aromatic condensed 8- to 60-membered heteropolycyclic group, -N(Q₁)(Q₂), and -Si(Q₁)(Q₂)(Q₃);
a C₁-C₂₀ alkyl group and a C₁-C₂₀ alkoxy group, each substituted with at least one selected from deuterium, -F, -Cl, -Br, -I, a cyano group, and a nitro group; and
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a cyano group, a nitro group, a methyl group, a methoxy group, a phenyl group, a naphthyl group, -N(Q₃₁)(Q₃₂), and -Si(Q₃₁)(Q₃₂)(Q₃₃), and
Q₁ to Q₃ and Q₃₁ to Q₃₃ are each independently selected from a C₁-C₂₀ alkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, a biphenyl group, and a terphenyl group
wherein at least one selected from R₁₀₁ to R₁₁₂ is a group represented by Formula 8.

3. The organic light-emitting device of any one of the preceding claims, wherein L₈₁ is selected from the group consisting of:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosiloleylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a dibenzosiloleylene group, a benzocarbazolylene group, and a dibenzocarbazolylene group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ are each independently selected from hydrogen, a methyl group, an ethyl group, an n-propyl group, an iso-propyl group, a tert-butyl group, a phenyl group, a biphenyl group, and a terphenyl group.

4. The organic light-emitting device of any one of the preceding claims, wherein R₈₁ is selected from the group consisting of:
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group;
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and -Si(Q₃₁)(Q₃₂)(Q₃₃); and
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one substituent selected from a C₆-C₆₀ aryl group, a C₁-C₆₀ heteroaryl group, a monovalent non-aromatic condensed C8-C60 polycyclic group and a monovalent non-aromatic condensed 8- to 60-membered heteropolycyclic group, each of the at least one substituent is substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₂₁)(Q₂₂), and -Si(Q₂₁)(Q₂₂)(Q₂₃), and
Q₂₁ to Q₂₃ and Q₃₁ to Q₃₃ are each independently selected from a C₁-C₆₀ alkyl group and a C₆-C₆₀ aryl group.

5. The organic light-emitting device of any one of claims 1 to 3, wherein R₈₁ is selected from groups represented by Formulae 5-1 to 5-86: 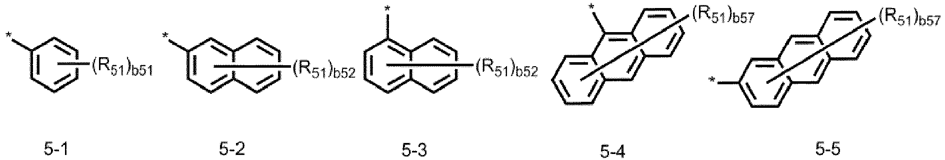 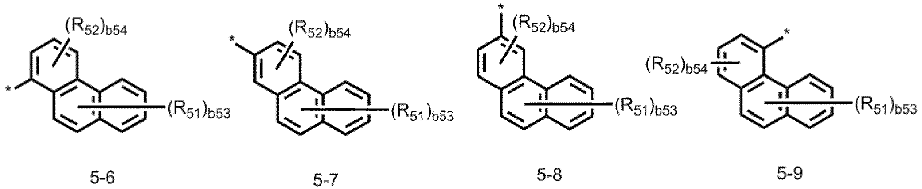 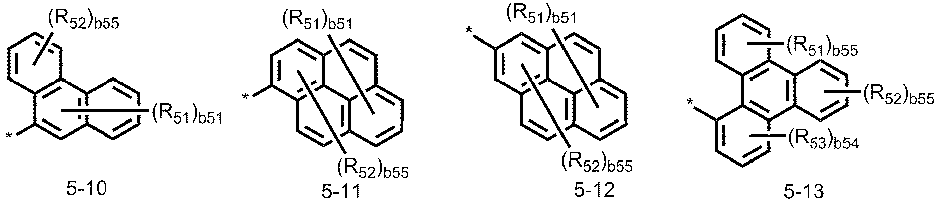 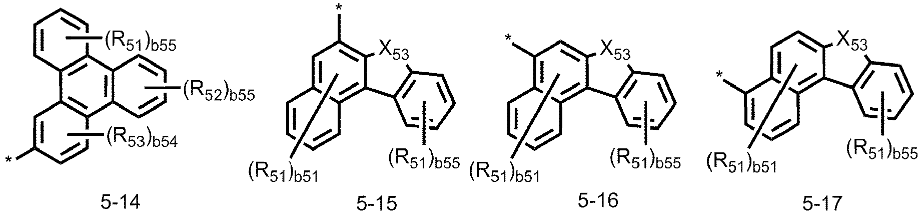 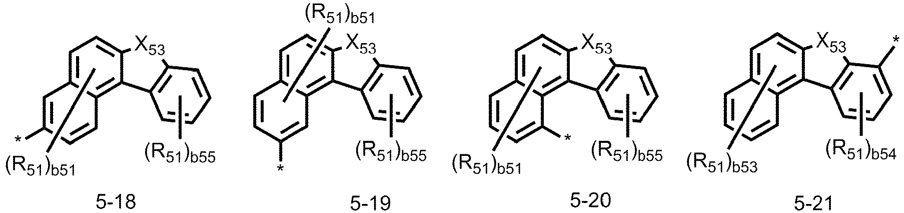 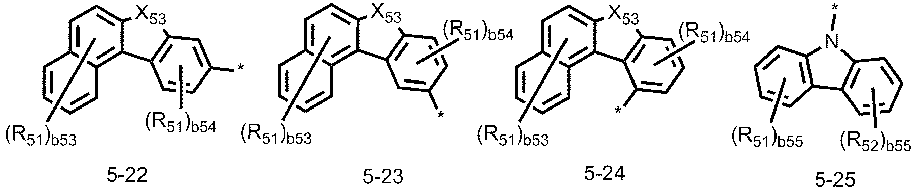 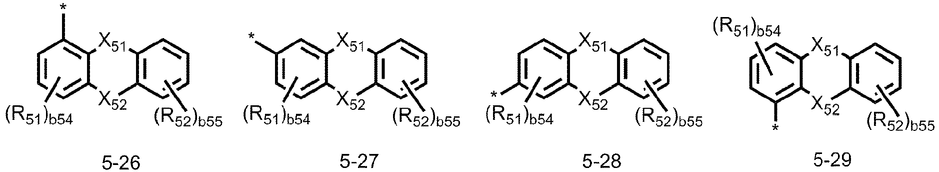 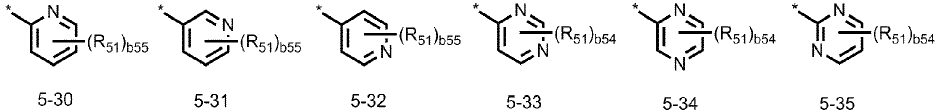 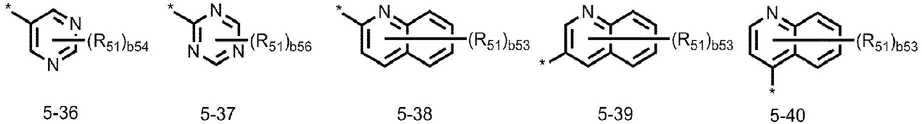 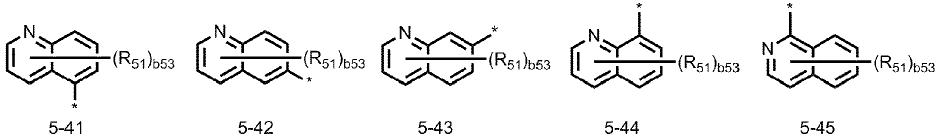 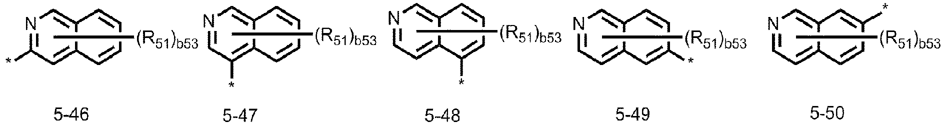 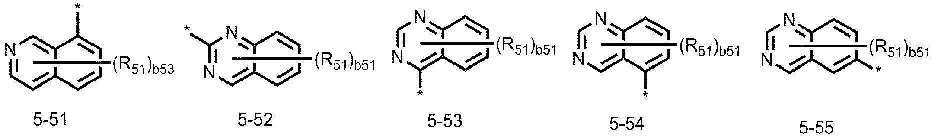 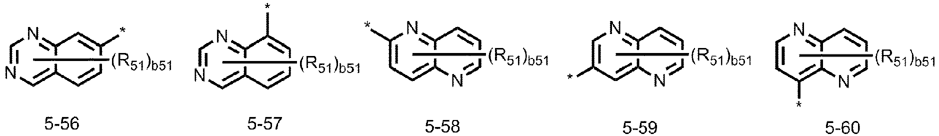 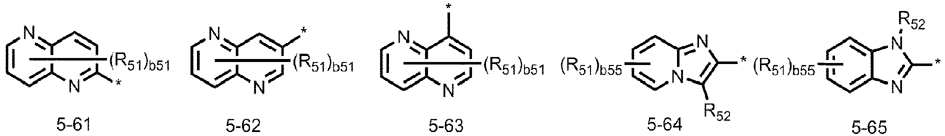 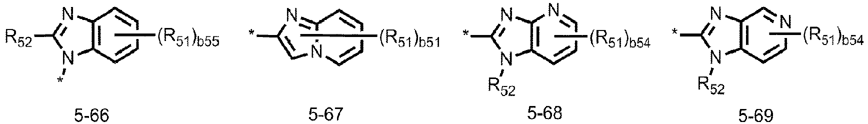 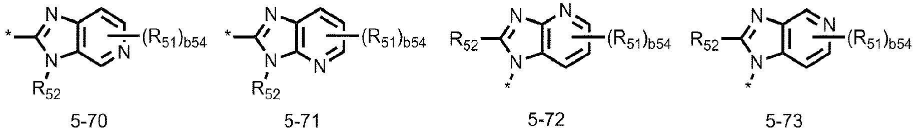 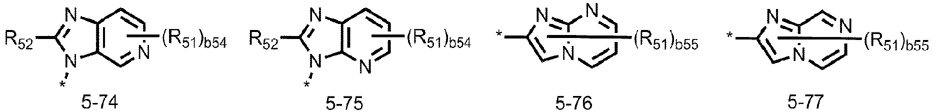 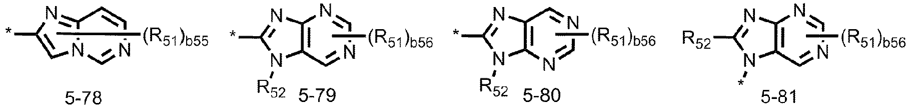 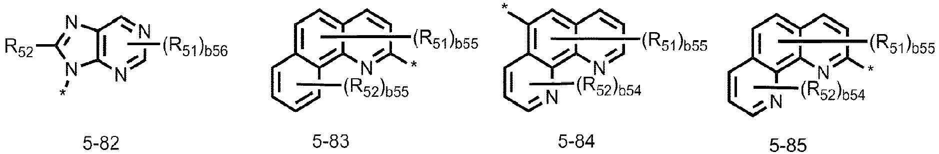 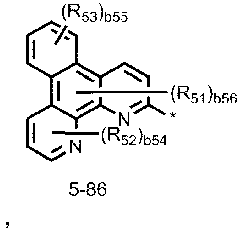 wherein, in Formulae 5-1 to 5-86,
X₅₁ is selected from a single bond, N(R₅₄), C(R₅₄)(R₅₅), O, and S,
X₅₂ is selected from N(R₅₆), C(R₅₆)(R₅₇), O, and S,
X₅₃ is C(R₅₈)(R₅₉),
R₅₁ to R₅₉ are each independently selected from the group consisting of:
hydrogen, deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and -Si(Q₃₁)(Q₃₂)(Q₃₃); and
a phenyl group, a biphenyl group, a terphenyl group, a naphthyl group, a pyridinyl group, a pyrimidinyl group, a pyridazinyl group, and a triazinyl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8-to 60-membered heteropolycyclic group, -N(Q₂₁)(Q₂₂), and -Si(Q₂₁)(Q₂₂)(Q₂₃),
Q₂₁ to Q₂₃ and Q₃₁ to Q₃₃ are each independently selected from a methyl group, an ethyl group, a phenyl group, a biphenyl group, a terphenyl group, and a naphthyl group,
b51 is selected from 1, 2, 3, 4, and 5,
b52 is selected from 1, 2, 3, 4, 5, 6, and 7,
b53 is selected from 1, 2, 3, 4, 5, and 6,
b54 is selected from 1, 2, and 3,
b55 is selected from 1, 2, 3, and 4,
b56 is selected from 1 and 2,
b57 is selected from 1, 2, 3, 4, 5, 6, 7, 8, and 9, and
* indicates a binding site to a neighboring atom.

6. The organic light-emitting device of any one of the preceding claims, wherein:
(a) A₂₁ is selected from a benzene group, a naphthalene group, a phenanthrene group, a pyrazine group, a triazine group, a quinoline group, an isoquinoline group, a quinoxaline group, and a quinazoline group; and/or
(c) R₂₂, R₂₄, and R₂₆ are each independently selected from the group consisting of:
a group represented by Formula 9, hydrogen, a C₁-C₂₀ alkyl group, and a C₃-C₁₀ cycloalkyl group;
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group;
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one selected from deuterium, -F, -Cl, -Br, -I, a C₁-C₂₀ alkyl group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, - N(Q₃₁)(Q₃₂), and -Si(Q₃₁)(Q₃₂)(Q₃₃); and
a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each substituted with at least one substituent selected from a C₆-C₆₀ aryl group, a C₁-C₆₀ heteroaryl group, a monovalent non-aromatic condensed C8-C60 polycyclic group, and a monovalent non-aromatic condensed 8- to 60-membered heteropolycyclic group, each of the at least one substituent is substituted with at least one selected from deuterium, -F, -Cl, -Br, -I, a C₁-C₂₀ alkyl group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₂₁)(Q₂₂), and -Si(Q₂₁)(Q₂₂)(Q₂₃), provided that R₂₆ is not an anthracenyl, a pyridinyl or a pyrimidinyl group, and
Q₂₁ to Q₂₃ and Q₃₁ to Q₃₃ are each independently selected from a C₁-C₆₀ alkyl group and a C₆-C₆₀ aryl group,
wherein at least one selected from R₂₂, R₂₄, and R₂₆ is the group represented by Formula 9.

7. The organic light-emitting device of any one of the preceding claims, wherein L₉₁ is selected from the group consisting of:
a phenylene group, a naphthylene group, a phenanthrenylene group, a triphenylenylene group, a pyrenylene group, a chrysenylene group, a pyrazinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group; and
a phenylene group, a naphthylene group, a phenanthrenylene group, a triphenylenylene group, a pyrenylene group, a chrysenylene group, a pyrazinylene group, a quinolinylene group, an isoquinolinylene group, a benzoquinolinylene group, a phthalazinylene group, a naphthyridinylene group, a quinoxalinylene group, a quinazolinylene group, a phenanthridinylene group, an acridinylene group, a phenanthrolinylene group, and a triazinylene group, each substituted with at least one selected from deuterium, -F, -Cl, -Br, -I, a cyano group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -Si(Q₃₁)(Q₃₂)(Q₃₃), -N(Q₃₁)(Q₃₂), -B(Q₃₁)(Q₃₂), -C(=O)(Q₃₁), - S(=O)₂(Q₃₁), and -P(=O)(Q₃₁)(Q₃₂), and
Q₃₁ to Q₃₃ are each independently selected from hydrogen, a methyl group, an ethyl group, an n-propyl group, an iso-propyl group, a tert-butyl group, a phenyl group, a biphenyl group, and a terphenyl group.

8. The organic light-emitting device of any one of the preceding claims, wherein R₉₁ is selected from the group consisting of:
a C₆-C₆₀ aryl group and a C₁-C₆₀ heteroaryl group;
a C₆-C₆₀ aryl group and a C₁-C₆₀ heteroaryl group, each substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8- to 60-membered heteropolycyclic group, -N(Q₃₁)(Q₃₂), and -Si(Q₃₁)(Q₃₂)(Q₃₃); and
a C₆-C₆₀ aryl group and a C₁-C₆₀ heteroaryl group, each substituted with at least one substituent selected from a C₆-C₆₀ aryl group, a C₁-C₆₀ heteroaryl group, a monovalent non-aromatic condensed C8-C60 polycyclic group, and a monovalent non-aromatic condensed 8-to 60-membered heteropolycyclic group, each of the at least one substituent is substituted with at least one selected from deuterium, -F, -Cl, -Br, -I, a C₁-C₂₀ alkyl group, a C₁-C₂₀ alkoxy group, a C₃-C₁₀ cycloalkyl group, a C₆-C₆₀ aryl group, a C₁-C₆₀ heteroaryl group, a monovalent non-aromatic condensed C8-C60 polycyclic group, a monovalent non-aromatic condensed 8-to 60-membered heteropolycyclic group, -N(Q₂₁)(Q₂₂), and -Si(Q₂₁)(Q₂₂)(Q₂₃), provided that R₉₁ is not an anthracenyl, pyridinyl or pyrimidinyl group, and
Q₂₁ to Q₂₃ and Q₃₁ to Q₃₃ are each independently selected from a C₁-C₆₀ alkyl group and a C₆-C₆₀ aryl group.

9. The organic light-emitting device of claim 8, wherein R₉₁ is selected from groups represented by Formulae 5-1 to 5-3, 5-6 to 5-14, 5-37 to 5-63, and 5-83 to 5-86,
wherein Formulae 5-1 to 5-3, 5-6 to 5-14, 5-37 to 5-63, and 5-83 to 5-86 are as defined in claim 5.

10. The organic light-emitting device of claim 1, wherein the first compound represented by one selected from Formulae 1-14a to 1-14g is selected from Compounds B-101 to B-205, and the second compound represented by Formula 2 is selected from Compounds E-1 to E-20, E-25 to E-36, E-41 to E-52, E-113 to E-115, E-117 to E-122, E-124, E-128, E-129, E-131 to E-134, E-154 to E-169, E-201 to E-203, E-205 to E-210, E-212, E-216, E-218 to E-221, E-226 to E233, E-237 to E-242:

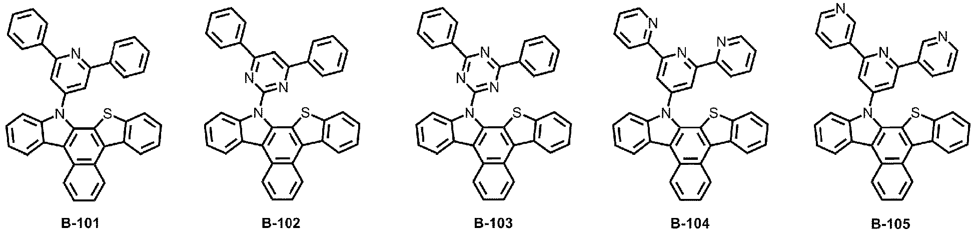

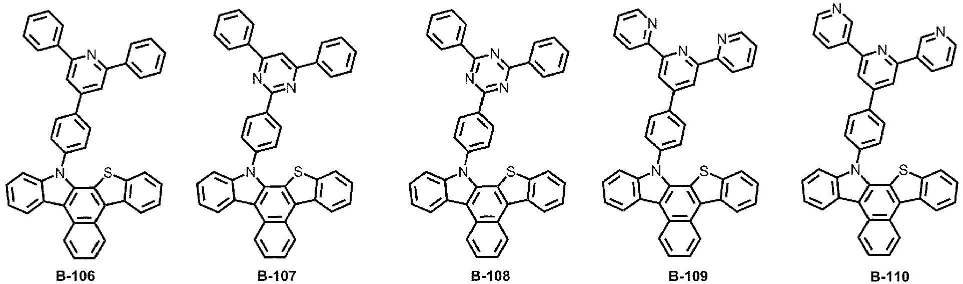

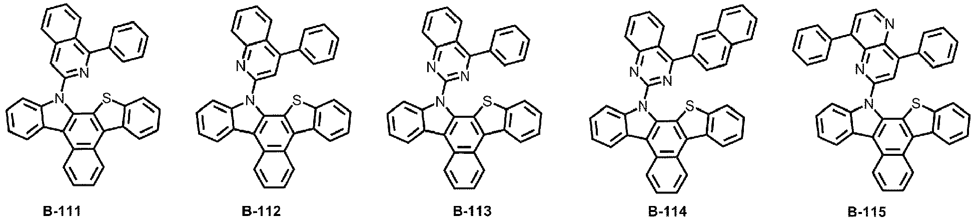

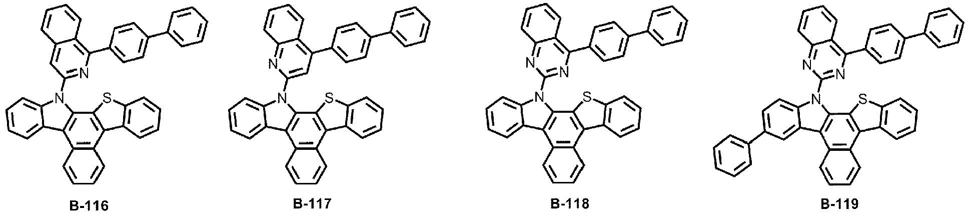

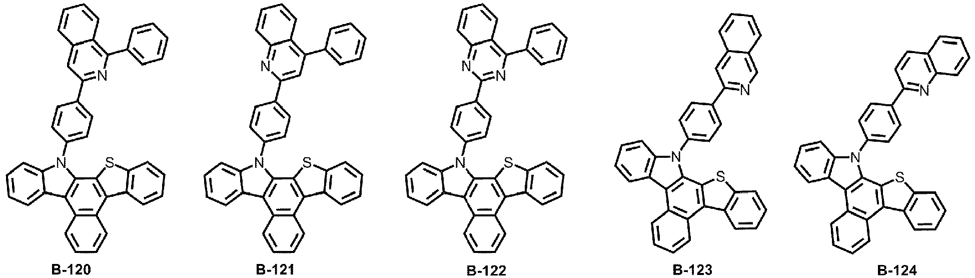

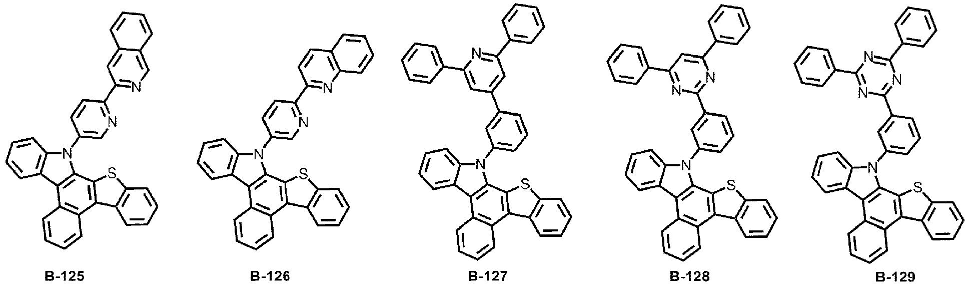

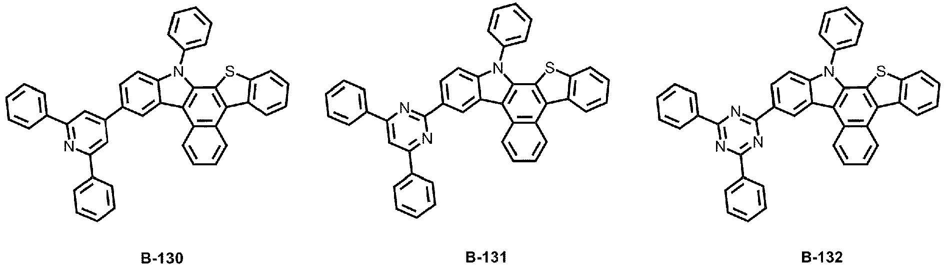

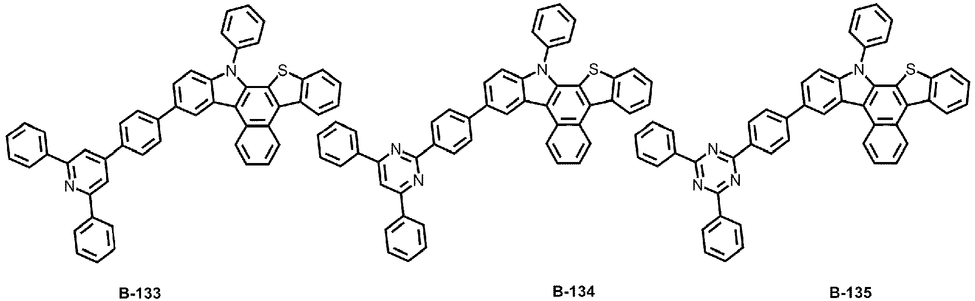

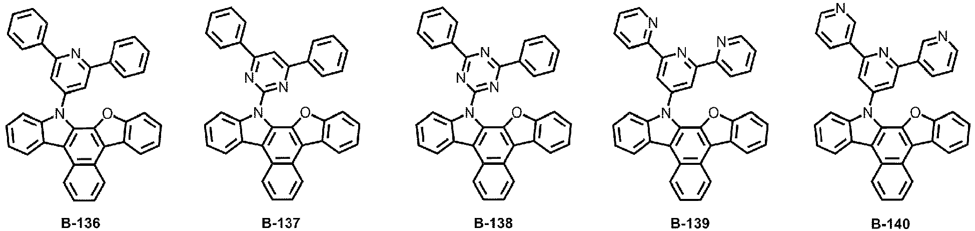

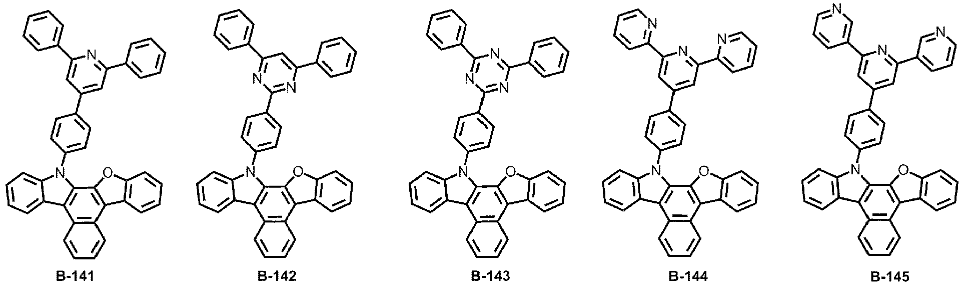

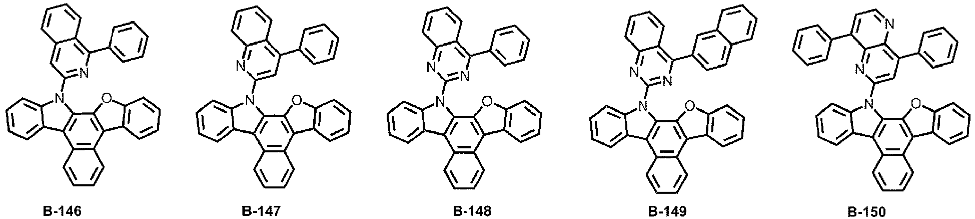

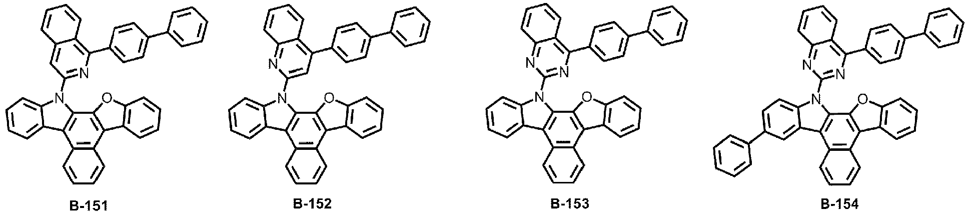

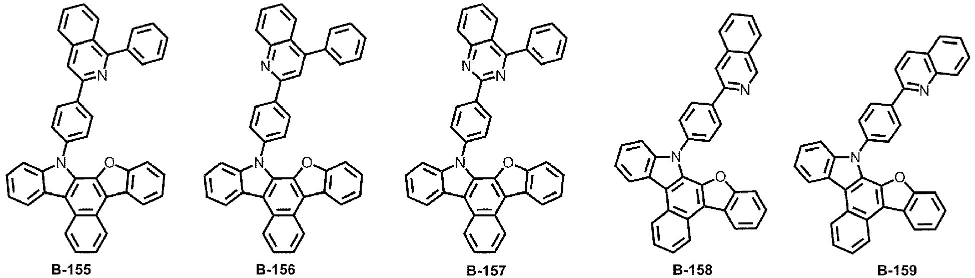

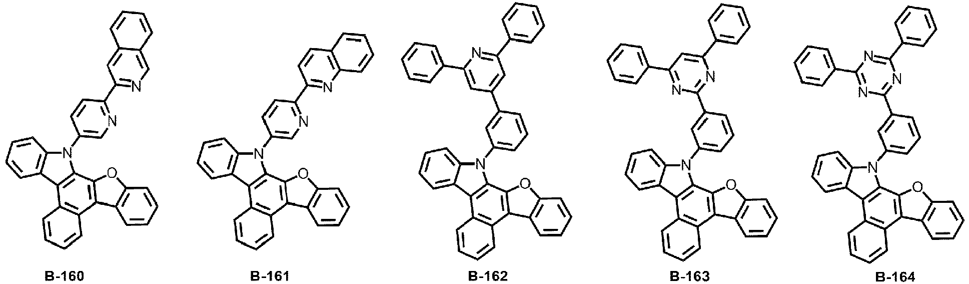

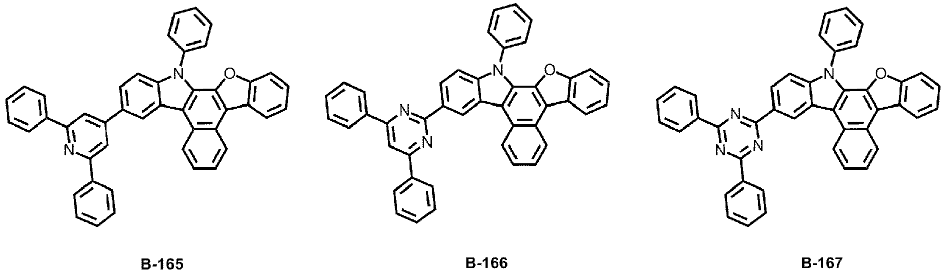

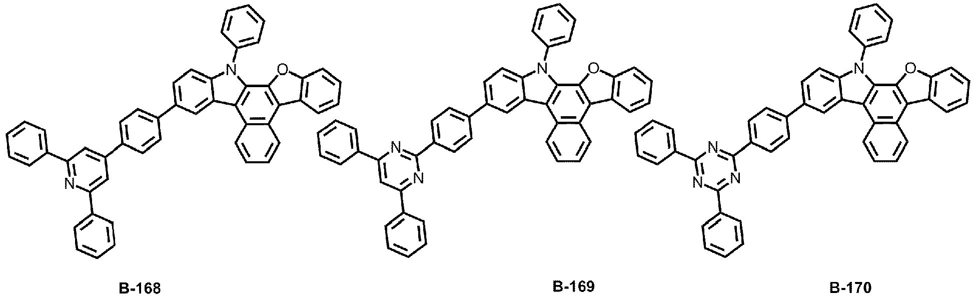

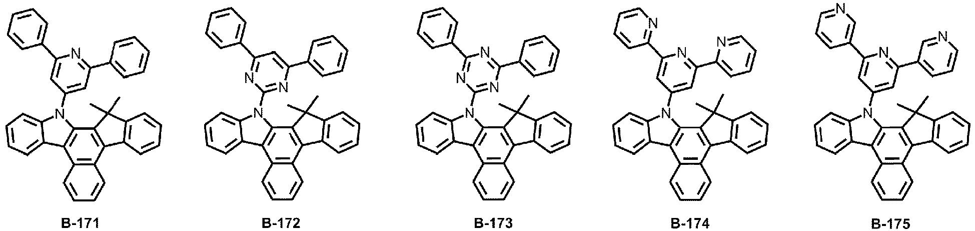

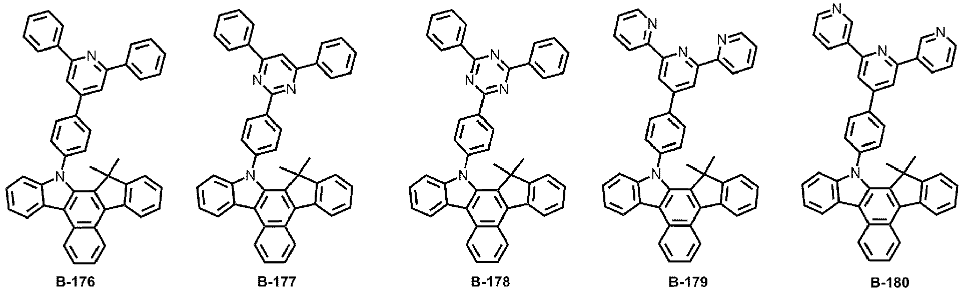

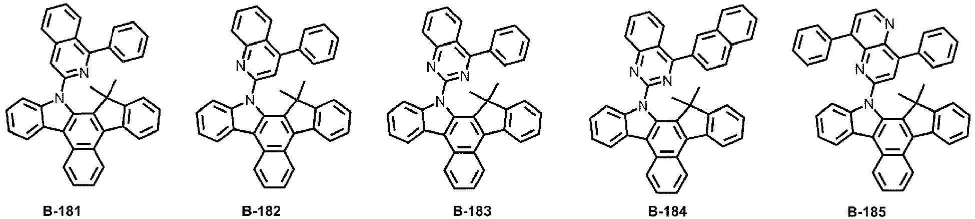

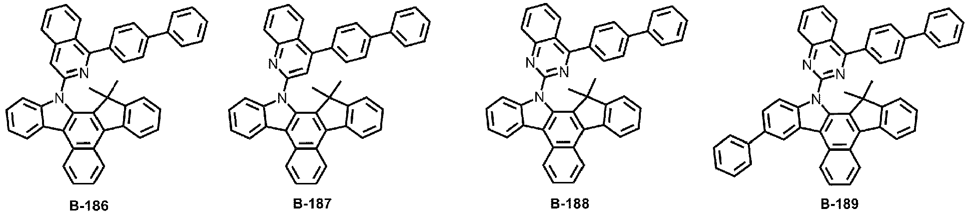

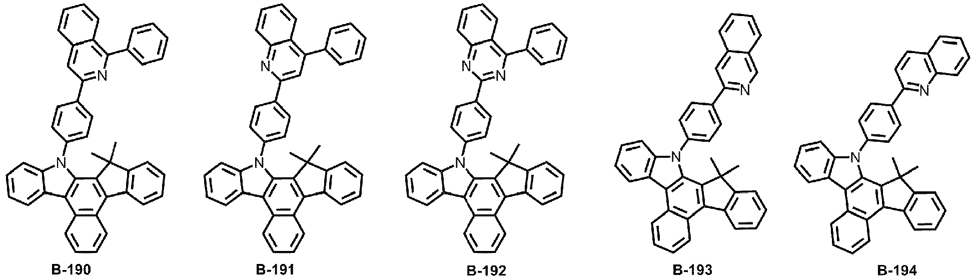

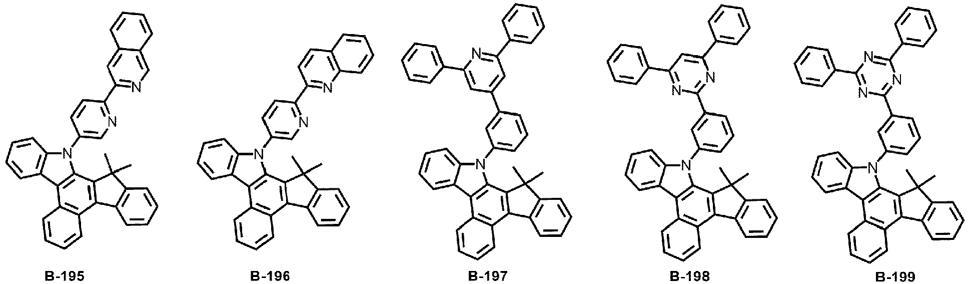

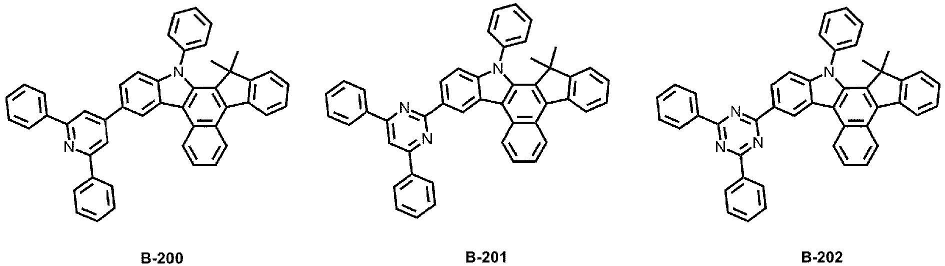

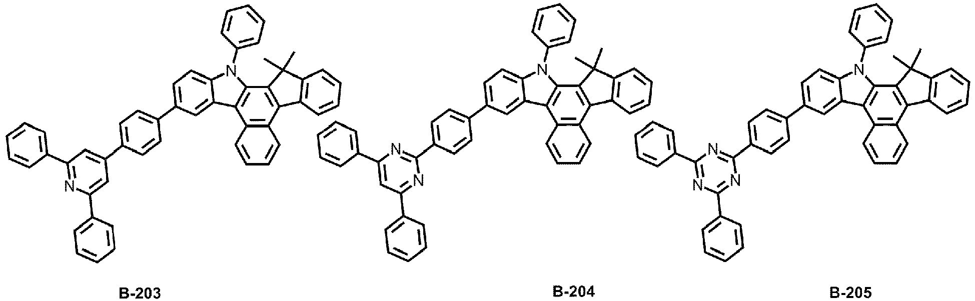

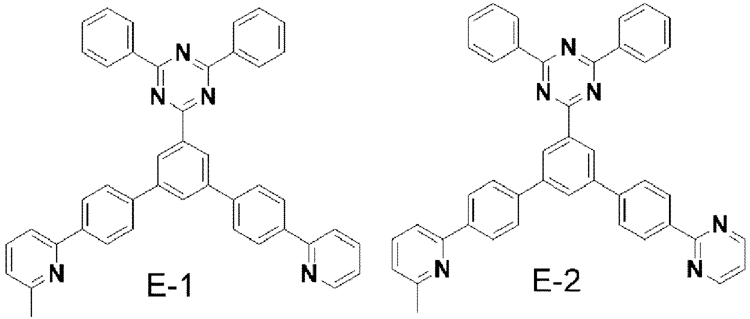

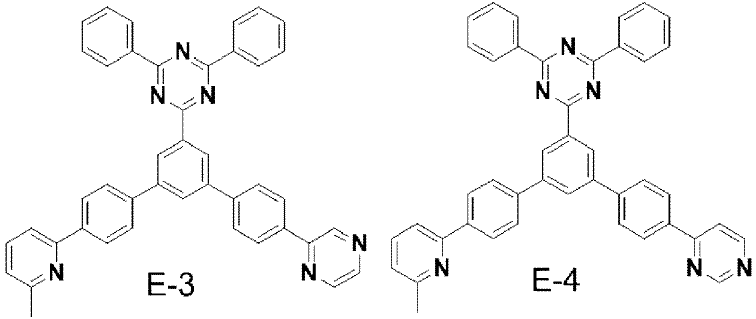

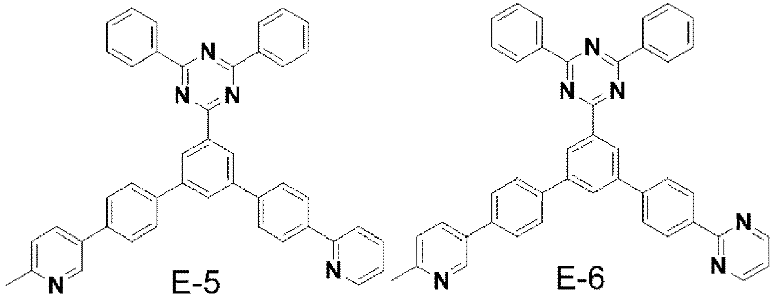

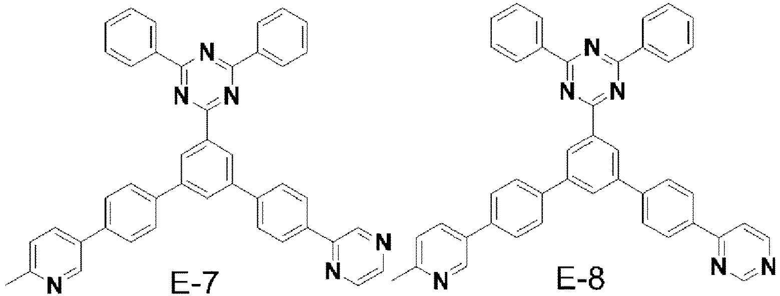

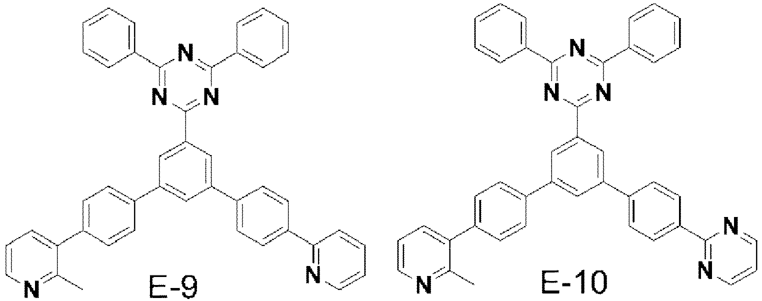

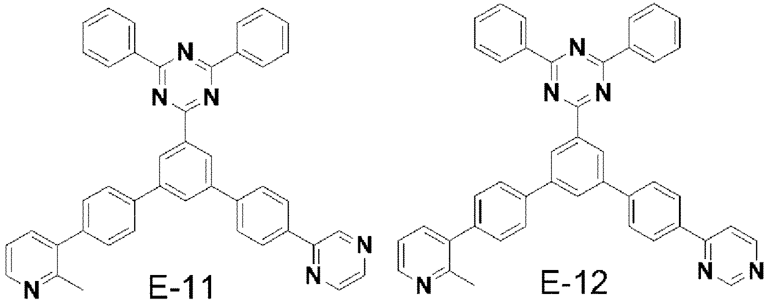

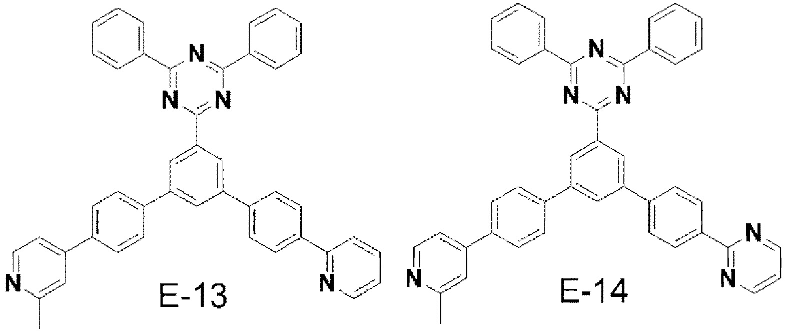

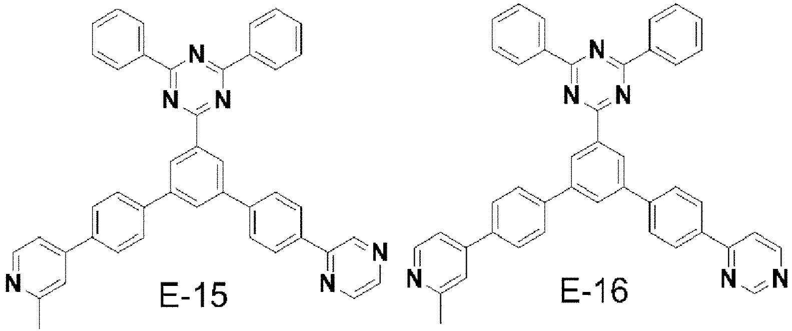

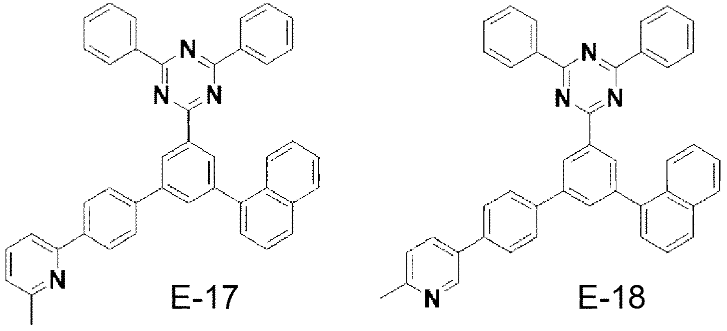

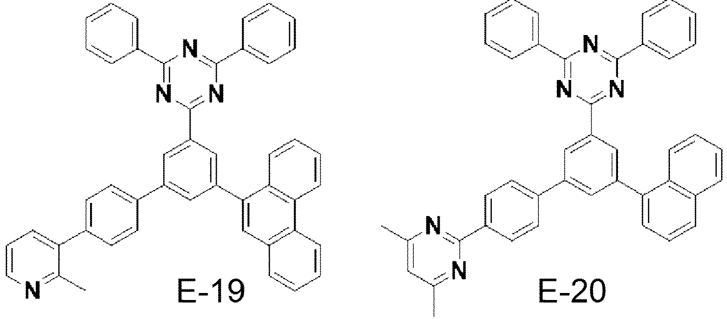

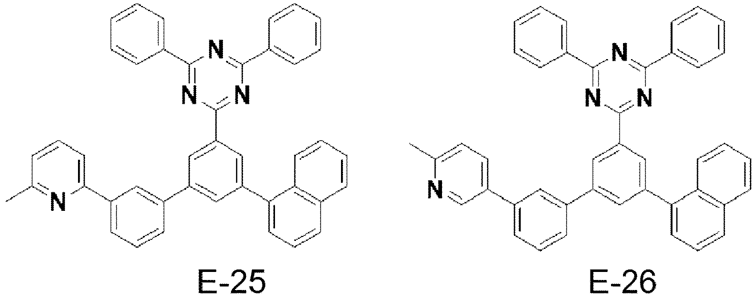

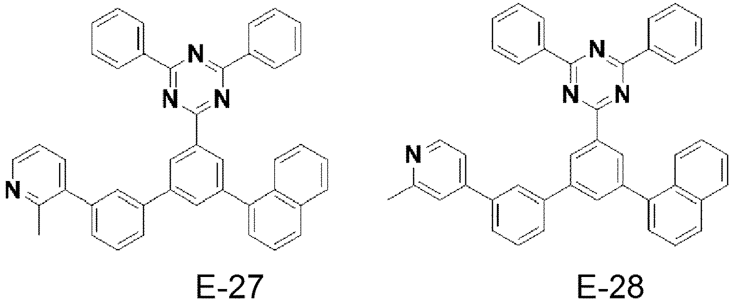

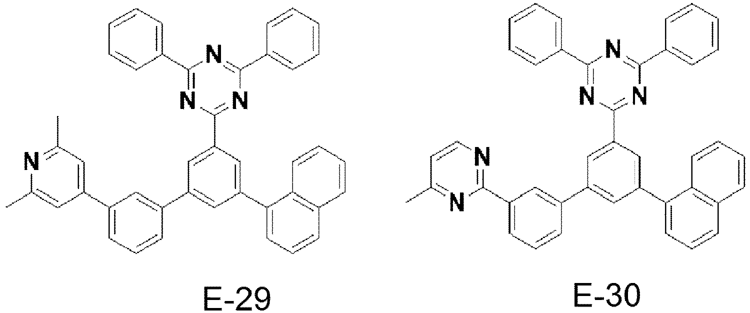

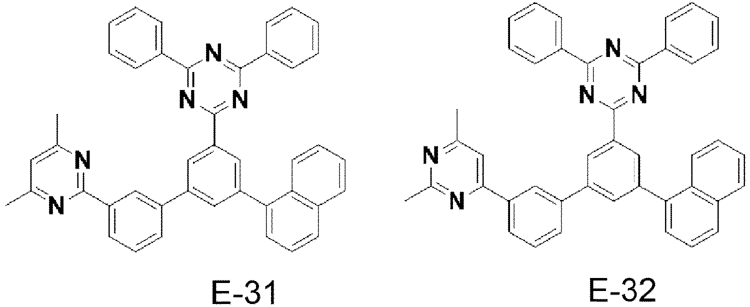

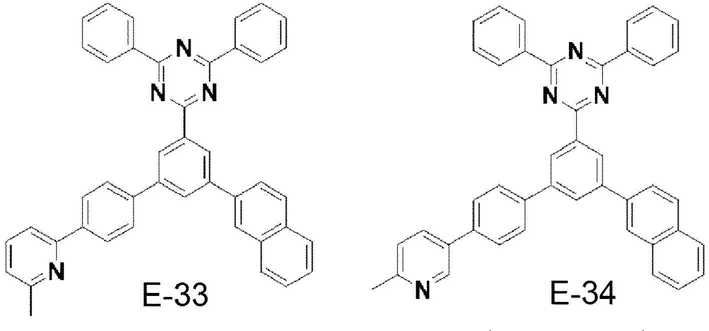

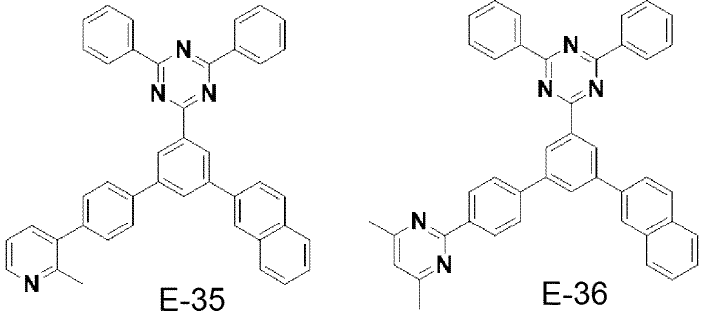

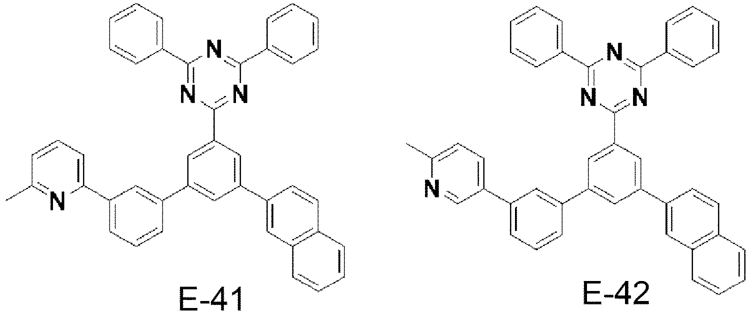

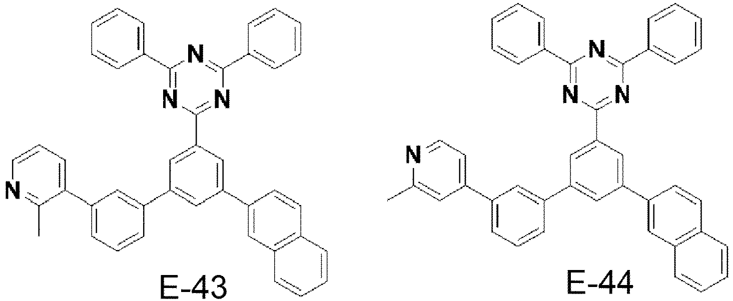

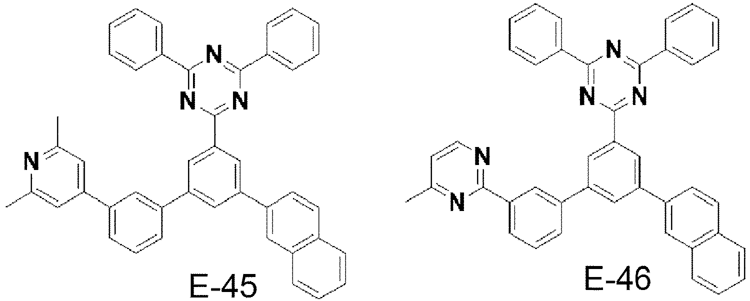

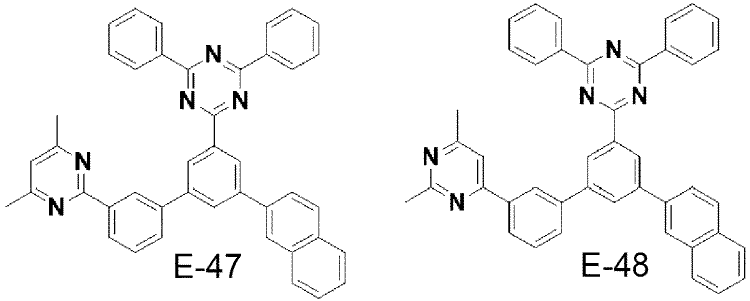

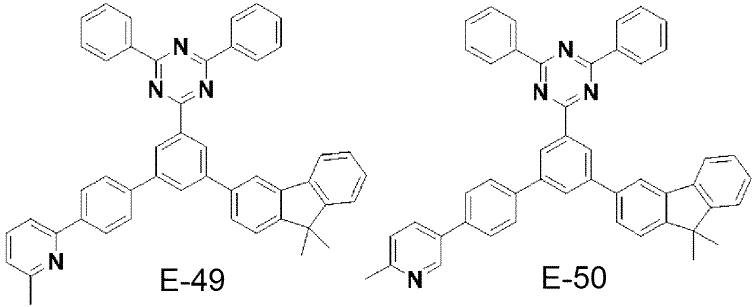

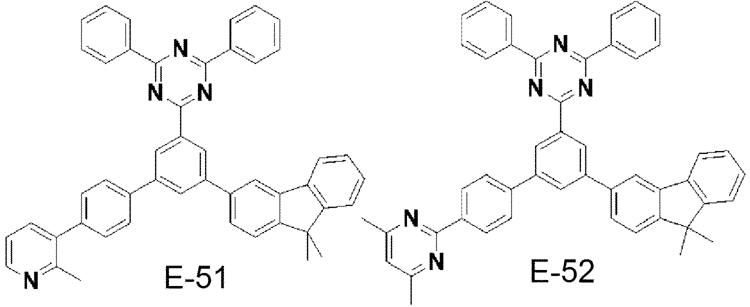

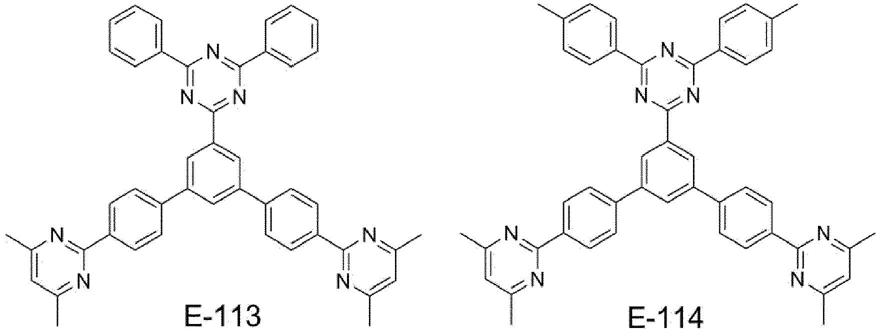

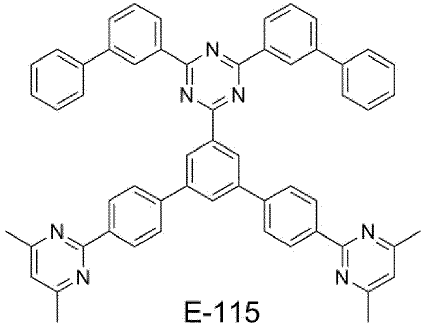

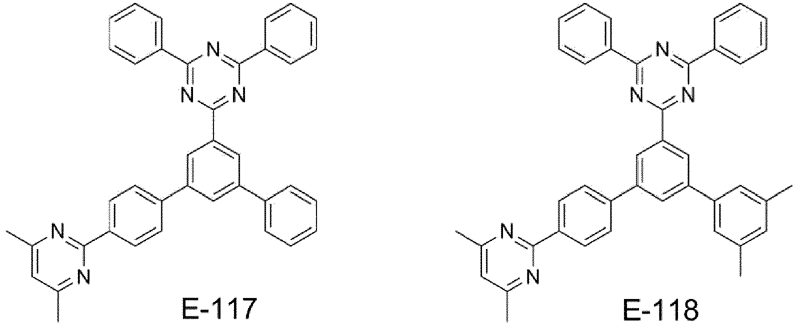

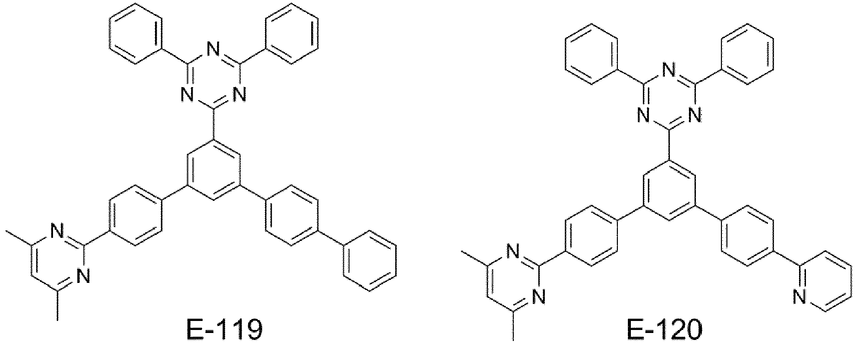

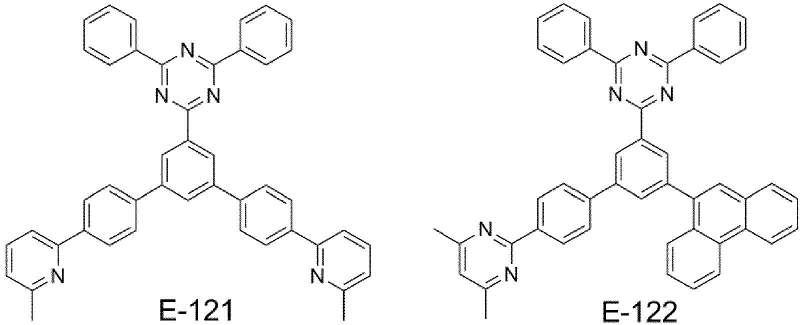

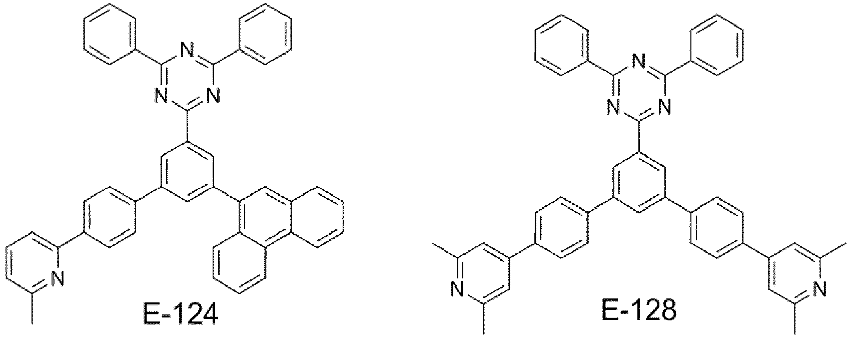

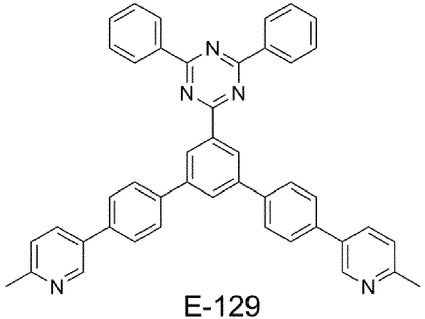

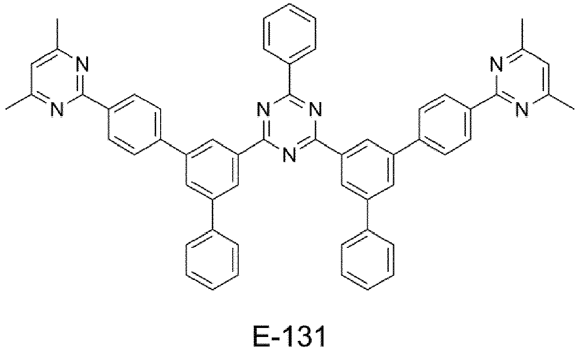

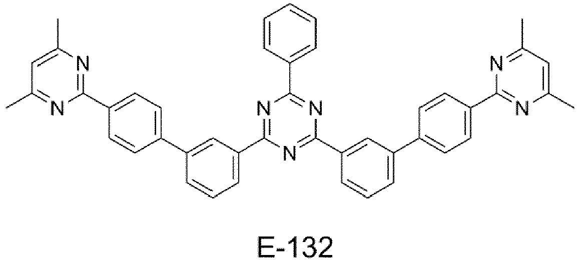

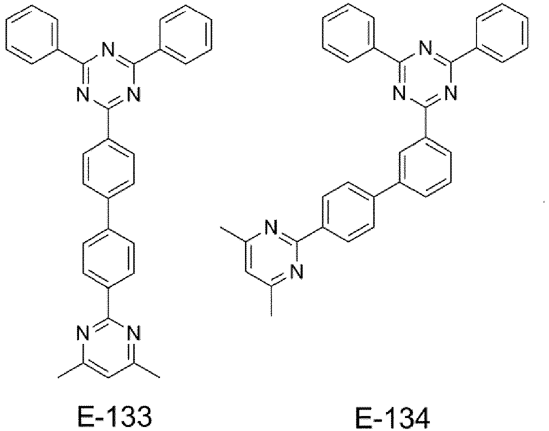

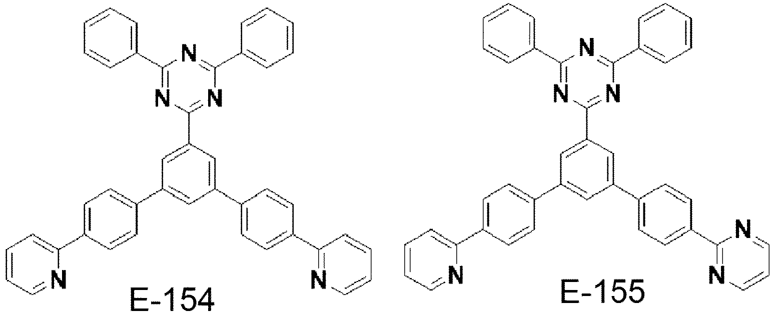

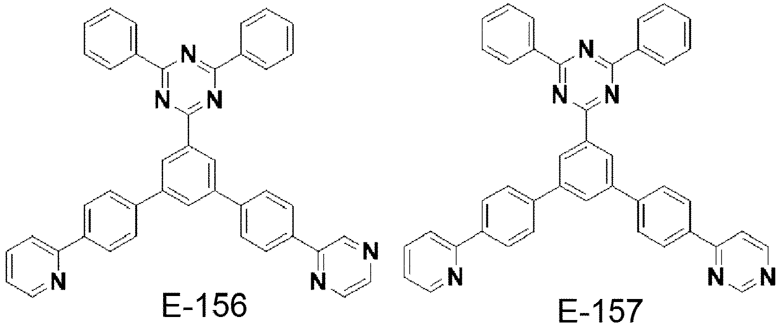

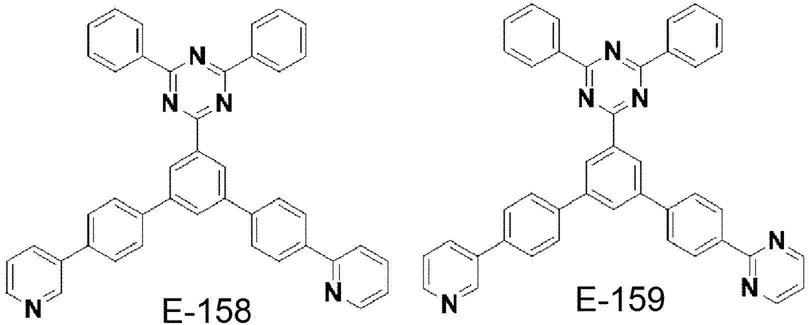

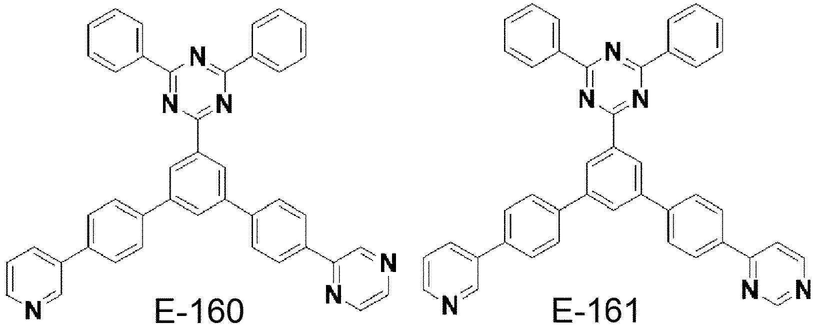

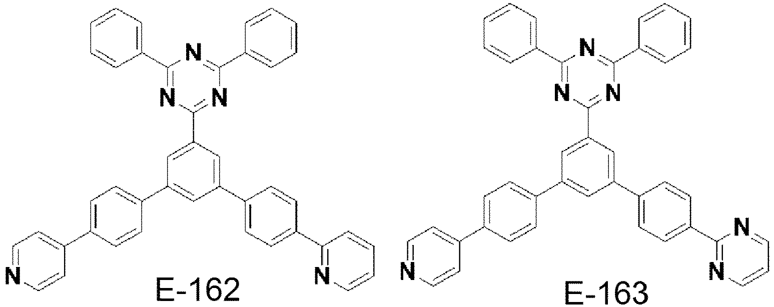

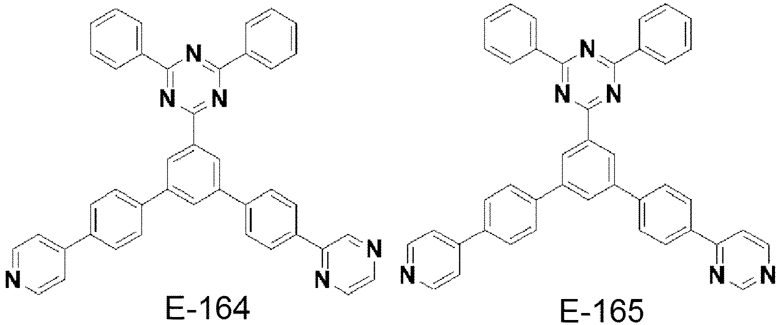

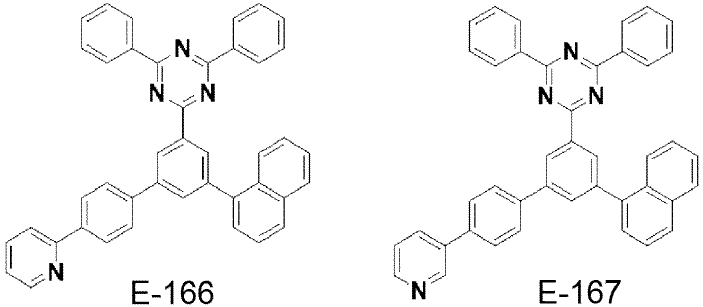

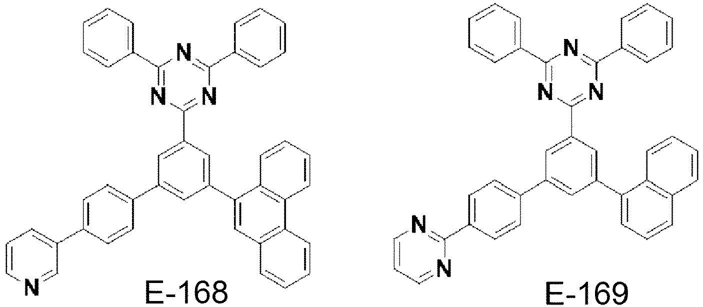

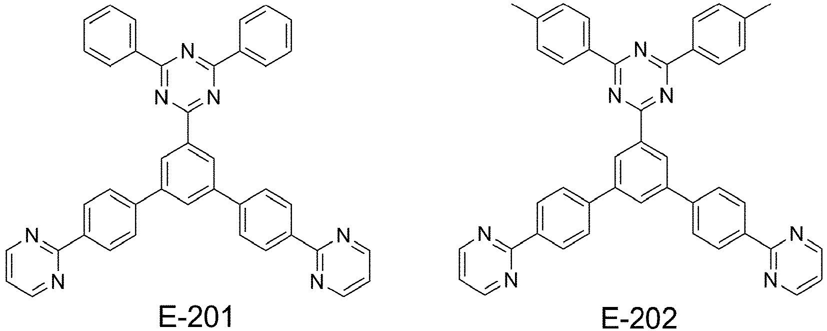

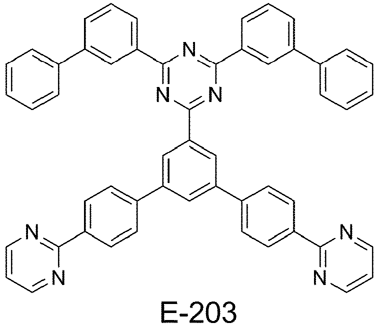

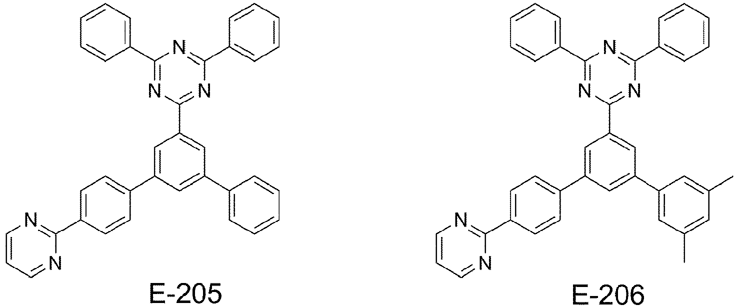

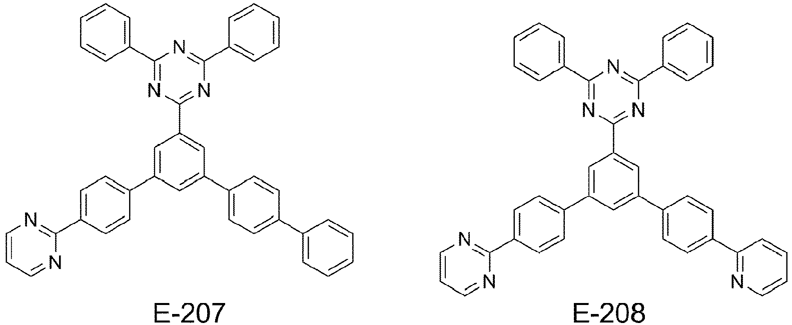

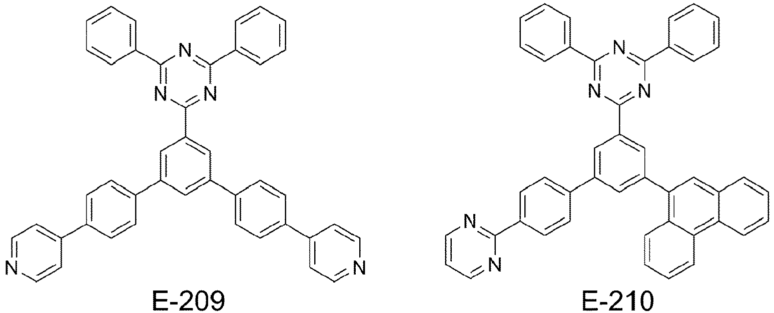

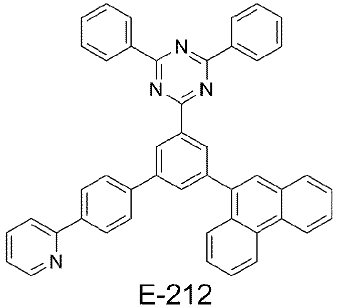

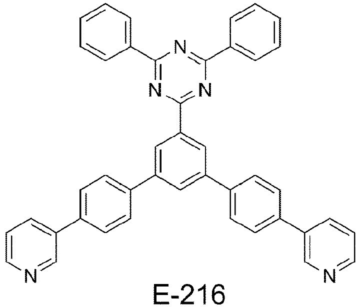

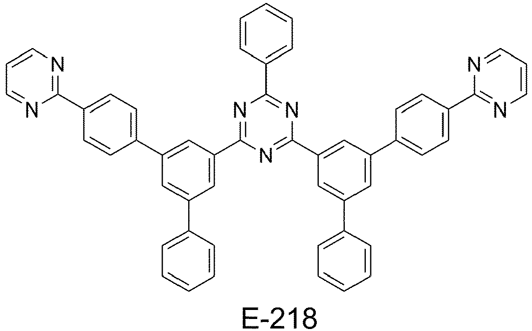

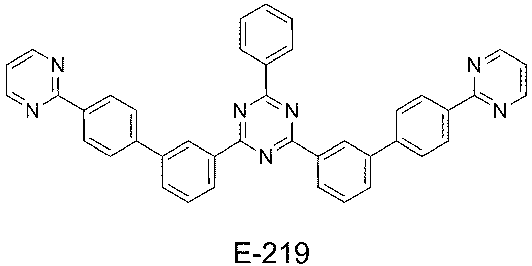

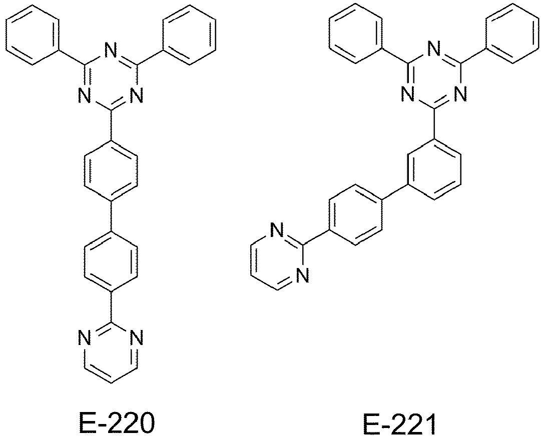

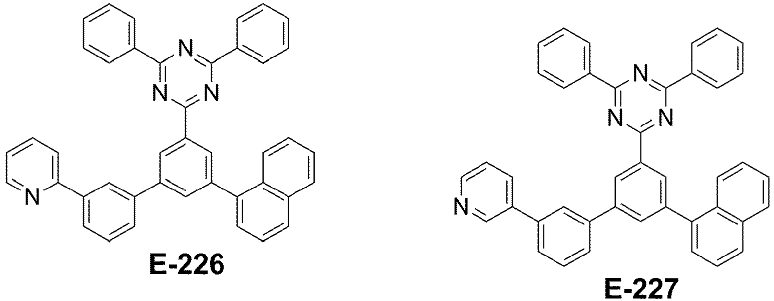

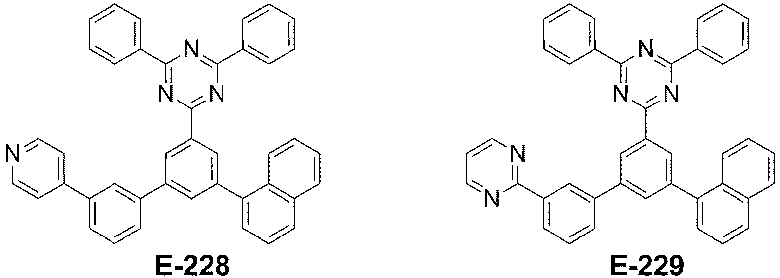

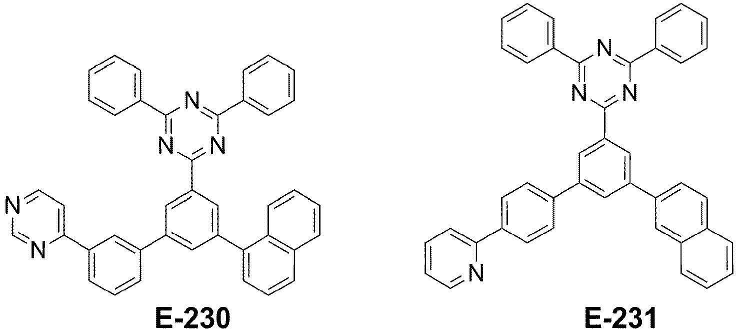

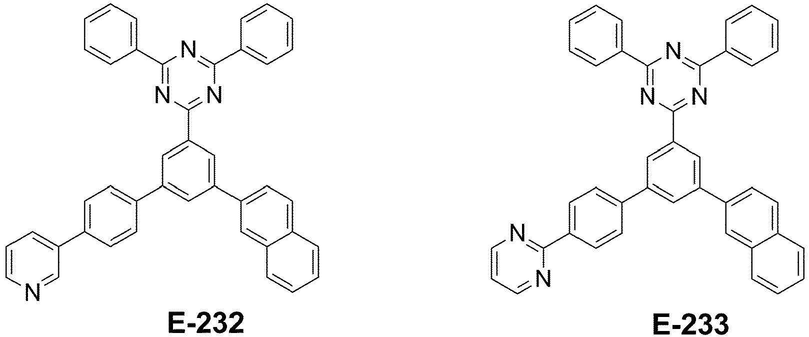

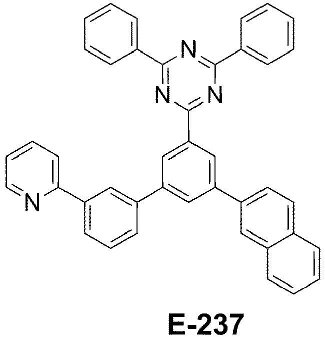

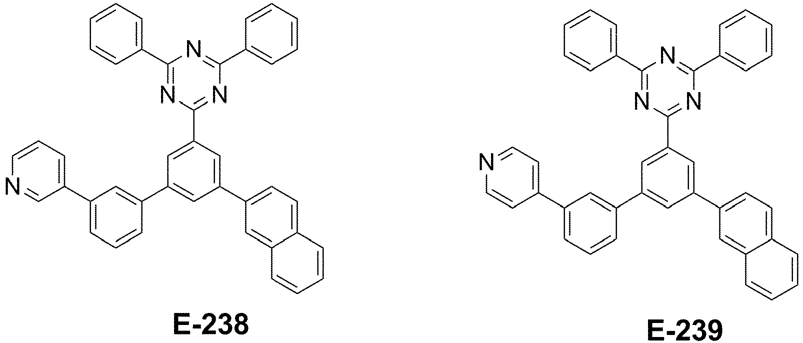

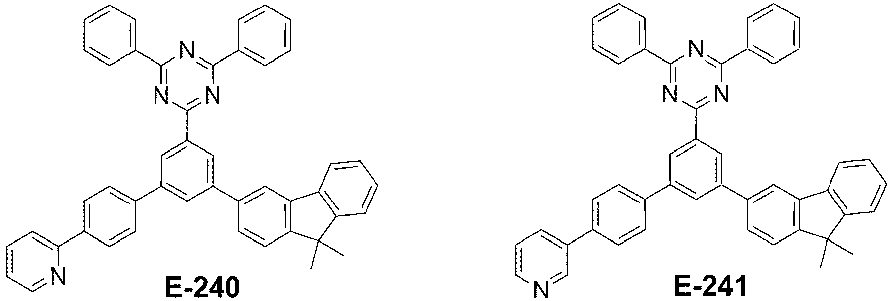

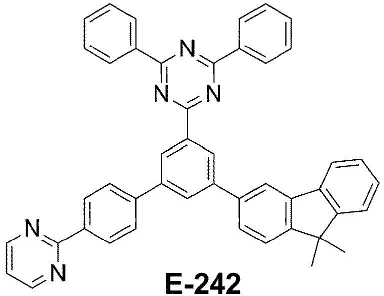

11. The organic light-emitting device of any one of the preceding claims, wherein
the emission layer further comprises a dopant, and the dopant is an organometallic complex represented by Formula 401:
**Formula 401** M(L₄₀₁)_{xc1}(L₄₀₂)_{xc2}
in which L₄₀₁ is a ligand represented by Formula 402, 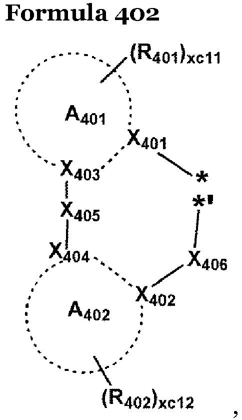 wherein, in Formulae 401 and 402,
M is selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
xc1 is 1, 2, or 3, wherein when xc1 is two or more, two or more L₄₀₁(S) are identical to or different from each other,
L₄₀₂ is an organic ligand,
xc2 is an integer selected from 0 to 4, wherein when xc2 is two or more, two or more L₄₀₂(s) are identical to or different from each other,
X₄₀₁ to X₄₀₄ are each independently nitrogen or carbon,
X₄₀₁ and X₄₀₃ are linked to each other via a single bond or a double bond, and X₄₀₂ and X₄₀₄ are linked to each other via a single bond or a double bond,
A₄₀₁ and A₄₀₂ are each independently a C₅-C₆₀ carbocyclic group or a C₁-C₆₀ heterocyclic group,
X₄₀₅ is a single bond, -O-, -S-, -C(=O)-, -N(Q₄₁₁)-, -C(Q₄₁₁)(Q₄₁₂)-, -C(Q₄₁₁)=C(Q₄₁₂)-, - C(Q₄₁₁)=, or =C(Q₄₁₁)=, wherein Q₄₁₁ and Q₄₁₂ are each independently hydrogen, deuterium, a C₁-C₂₀ alkyl group, a C₁-C₂₀ alkoxy group, a phenyl group, a biphenyl group, a terphenyl group, or a naphthyl group,
X₄₀₆ is a single bond, O, or S,
R₄₀₁ and R₄₀₂ are each independently selected from hydrogen, deuterium, -F, -Cl, -Br, -I, -CD₃, -CF₃, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed C8-C60 polycyclic group and a substituted or unsubstituted monovalent non-aromatic condensed 8- to 60-membered heteropolycyclic group, -Si(Q₄₀₁)(Q₄₀₂)(Q₄₀₃), -N(Q₄₀₁)(Q₄₀₂), - B(Q₄₀₁)(Q₄₀₂), -C( =O)(Q₄₀₁), -S(=O)₂(Q₄₀₁), and -P(=O)(Q₄₀₁)(Q₄₀₂), wherein Q₄₀₁ to Q₄₀₃ are each independently selected from a C₁-C₁₀ alkyl group, a C₁-C₁₀ alkoxy group, a C₆-C₂₀ aryl group, and a C₁-C₂₀ heteroaryl group,
xc11 and xc12 are each independently an integer selected from 0 to 10, and
* and *' in Formula 402 are each independently a binding site to M in Formula 401.

## Patentansprüche

1. Organische lichtemittierende Vorrichtung (10, 20, 30, 40), umfassend:
eine erste Elektrode (110);
eine zweite Elektrode (190), die der ersten Elektrode (110) gegenüberliegt; und
eine organische Schicht (150) zwischen der ersten Elektrode und der zweiten Elektrode, wobei die organische Schicht (150) eine Emissionsschicht und einen Elektronentransportbereich, der zwischen der Emissionsschicht und der zweiten Elektrode angeordnet ist, umfasst,
wobei die Emissionsschicht eine erste Verbindung, dargestellt durch eine ausgewählte aus den Formeln 1-14a bis 1-14g, umfasst, und **dadurch gekennzeichnet, dass** der Elektronentransportbereich eine zweite Verbindung, dargestellt durch Formel 2, umfasst: 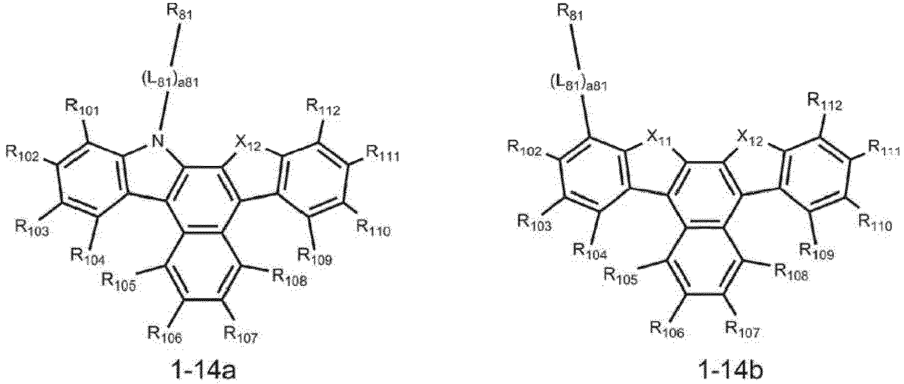 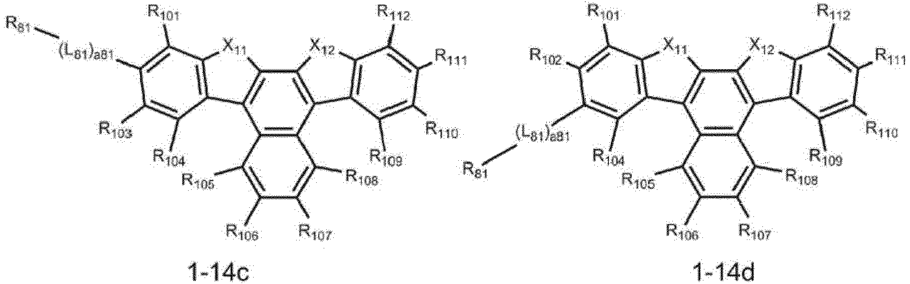 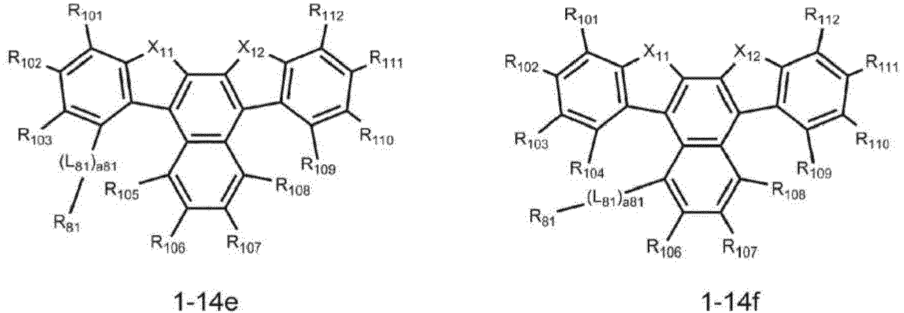 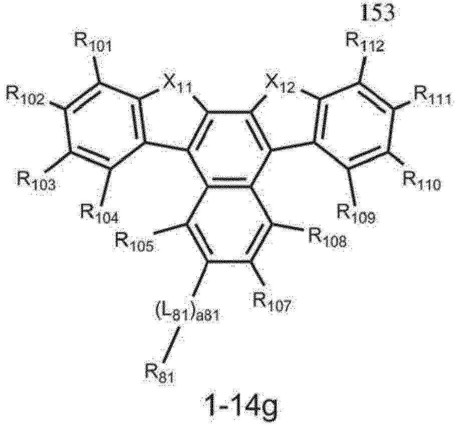 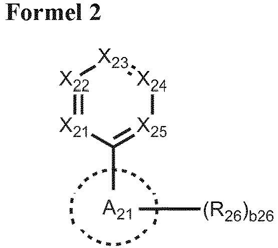 wobei in den Formeln 1-14a bis 1-14g und 2:
X₁₁ ausgewählt ist aus N(R₁₁), C(R₁₁)(R₁₂), O und S,
X₁₂ ausgewählt ist aus N(R₁₃), C(R₁₃)(R₁₄), O und S,
A₂₁ ausgewählt ist aus einer C₆-C₂₀-Arengruppe und einer C₁-C₂₀-Heteroarengruppe, mit der Maßgabe, dass A₂₁ keine Anthracen-, Pyridin- oder Pyrimidingruppe ist,
i) X₂₁ N ist, X₂₂ C(R₂₂) ist, X₂₃ N ist, X₂₄ C(R₂₄) ist und X₂₅ N ist, b26 ausgewählt ist aus 1, 2, 3, 4, 5 und 6,
R₁₁ bis R₁₄ und R₁₀₁ bis R₁₁₂ jeweils unabhängig ausgewählt sind aus einer durch Formel 8 dargestellten Gruppe, Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer substituierten oder nicht substituierten C₁-C₆₀-Alkylgruppe, einer substituierten oder nicht substituierten C₁-C₆₀-Alkoxygruppe, einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten einwertigen nichtaromatischen kondensierten polycyclischen C₈-C₆₀-Gruppe, einer substituierten oder nicht substituierten einwertigen nichtaromatischen kondensierten 8- bis 60-gliedrigen heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂), wobei wenigstens eines, ausgewählt aus R₁₁ bis R₁₄ oder R₁₀₁ bis R₁₁₂, die durch Formel 8 dargestellte Gruppe ist,
**Formel 8** *-(L₈₁)ₐ₈₁-R₈₁,
wobei L₈₁ ausgewählt ist aus einer substituierten oder nicht substituierten C₃-C₁₀-Cycloalkylengruppe, einer substituierten oder nicht substituierten C₁-C₁₀-Heterocycloalkylengruppe, einer substituierten oder nicht substituierten C₃-C₁₀-Cycloalkenylengruppe, einer substituierten oder nicht substituierten C₁-C₁₀-Heterocycloalkenylengruppe, einer substituierten oder nicht substituierten C₆-C₆₀-Arylengruppe, einer substituierten oder nicht substituierten C₁-C₆₀-Heteroarylengruppe, einer substituierten oder nicht substituierten zweiwertigen nichtaromatischen kondensierten polycyclischen C₈-C₆₀-Gruppe und einer substituierten oder nicht substituierten zweiwertigen nichtaromatischen kondensierten 8- bis 60-gliedrigen heteropolycyclischen Gruppe,
a81 ausgewählt ist aus 0, 1 und 2,
R₈₁ ausgewählt ist aus einer substituierten oder nicht substituierten C₆-C₆₀-Arylgruppe, einer substituierten oder nicht substituierten C₁-C₆₀-Heteroarylgruppe, einer substituierten oder nicht substituierten einwertigen nichtaromatischen kondensierten polycyclischen C₈-C₆₀-Gruppe und einer substituierten oder nicht substituierten einwertigen nichtaromatischen kondensierten 8- bis 60-gliedrigen heteropolycyclischen Gruppe,
R₂₂, R₂₄ und R₂₆ jeweils unabhängig ausgewählt sind aus einer durch Formel 9 dargestellten Gruppe, Wasserstoff, Deuterium, -F, -Cl, -Br, -I, einer Hydroxygruppe, einer Cyanogruppe, einer Nitrogruppe, einer Amidinogruppe, einer Hydrazinogruppe, einer Hydrazonogruppe, einer substituierten oder nicht substituierten C₁-C₆₀-Alkylgruppe, einer substituierten oder nicht substituierten C₁-C₆₀-Alkoxygruppe, einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten einwertigen nichtaromatischen kondensierten polycyclische C₈-C₆₀-Gruppe und einer substituierten oder nicht substituierten einwertigen nichtaromatischen kondensierten 8- bis 60-gliedrigen heteropolycyclischen Gruppe, -Si(Q₁)(Q₂)(Q₃), -N(Q₁)(Q₂), -B(Q₁)(Q₂), -C(=O)(Q₁), -S(=O)₂(Q₁) und -P(=O)(Q₁)(Q₂), mit der Maßgabe, dass R₂₆ keine Anthracenyl-, Pyridinyl- oder Pyrimidinylgruppe ist, wobei wenigstens eines, ausgewählt aus R₂₂, R₂₄ und R₂₆, die durch Formel 9 dargestellte Gruppe ist,
**Formel 9** *-(L₉₁)ₐ₉₁-R₉₁,
wobei L₉₁ ausgewählt ist aus einer substituierten oder nicht substituierten C₆-C₆₀-Arylengruppe und einer substituierten oder nicht substituierten C₁-C₆₀-Heteroarylengruppe, mit der Maßgabe, dass L₉₁ keine Anthracenylen-, Pyridinylen- oder Pyrimidinylengruppe ist,
a91 ausgewählt ist aus 0, 1 und 2,
R₉₁ ausgewählt ist aus einer substituierten oder nicht substituierten C₆-C₆₀-Arylgruppe und einer substituierten oder nicht substituierten C₁-C₆₀-Heteroarylgruppe, mit der Maßgabe, dass R₉₁ keine Anthracenyl-, Pyridinyl- oder Pyrimidinylgruppe ist,
Q₁ bis Q₃ jeweils unabhängig ausgewählt sind aus Wasserstoff, Deuterium, -F, -Cl, - Br, -I, einer Hydroxygruppe, einer Cyanogruppe, einer Nitrogruppe, einer Amidinogruppe, einer Hydrazinogruppe, einer Hydrazonogruppe, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, einer Biphenylgruppe und einer Terphenylgruppe und
* eine Bindungsstelle mit einem Nachbaratom anzeigt.

2. Organische lichtemittierende Vorrichtung nach Anspruch 1, wobei R₁₀₁ bis R₁₁₂ jeweils unabhängig ausgewählt sind aus der Gruppe, bestehend aus:
einer durch Formel 8 dargestellten Gruppe, Wasserstoff, Deuterium, -F, -Cl, -Br, -I, einer C₁-C₂₀-Alkylgruppe, einer C₁-C₂₀-Alkoxygruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₁)(Q₂) und -Si(Q₁)(Q₂)(Q₃);
einer C₁-C₂₀-Alkylgruppe und einer C₁-C₂₀-Alkoxygruppe, jeweils substituiert mit wenigstens einem, ausgewählt aus Deuterium, -F, -Cl, -Br, -I, einer Cyanogruppe und einer Nitrogruppe; und
einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, jeweils substituiert mit wenigstens einem, ausgewählt aus Deuterium, -F, -Cl, -Br, -I, einer Cyanogruppe, einer Nitrogruppe, einer Methylgruppe, einer Methoxygruppe, einer Phenylgruppe, einer Naphthylgruppe, -N(Q₃₁)(Q₃₂) und -Si(Q₃₁)(Q₃₂)(Q₃₃), und
Q₁ bis Q₃ und Q₃₁ bis Q₃₃ jeweils unabhängig ausgewählt sind aus einer C₁-C₂₀-Alkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, einer Biphenylgruppe und einer Terphenylgruppe,
wobei wenigstens eines, ausgewählt aus R₁₀₁ bis R₁₁₂, eine durch Formel 8 dargestellte Gruppe ist.

3. Organische lichtemittierende Vorrichtung nach einem der vorangehenden Ansprüche, wobei L₈₁ ausgewählt ist aus der Gruppe bestehend aus:
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Benzocarbazolylengruppe und einer Dibenzocarbazolylengruppe; und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirobifluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Dibenzosilolylengruppe, einer Benzocarbazolylengruppe und einer Dibenzocarbazolylengruppe, jeweils substituiert mit wenigstens einem, ausgewählt aus Deuterium, -F, -Cl, -Br, -I, einer Cyanogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁) und -P(=O)(Q₃₁)(Q₃₂), und
Q₃₁ bis Q₃₃ jeweils unabhängig ausgewählt sind aus Wasserstoff, einer Methylgruppe, einer Ethylgruppe, einer n-Propylgruppe, einer Isopropylgruppe, einer tert-Butylgruppe, einer Phenylgruppe, einer Biphenylgruppe und einer Terphenylgruppe.

4. Organische lichtemittierende Vorrichtung nach einem der vorangehenden Ansprüche, wobei R₈₁ ausgewählt ist aus der Gruppe bestehend aus:
einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe;
einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, jeweils substituiert mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₃₁)(Q₃₂) und -Si(Q₃₁)(Q₃₂)(Q₃₃); und
einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, jeweils substituiert mit wenigstens einem Substituenten, ausgewählt aus einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, wobei jeder des wenigstens einen Substituenten substituiert ist mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₂₁)(Q₂₂) und -Si(Q₂₁)(Q₂₂)(Q₂₃), und
Q₂₁ bis Q₂₃ und Q₃₁ bis Q₃₃ jeweils unabhängig ausgewählt sind aus einer C₁-C₆₀-Alkylgruppe und einer C₆-C₆₀-Arylgruppe.

5. Organische lichtemittierende Vorrichtung nach einem der Ansprüche 1 bis 3, wobei R₈₁ ausgewählt ist aus Gruppen, die durch die Formeln 5-1 bis 5-86 dargestellt sind: 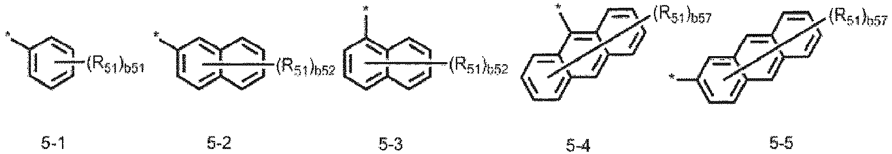 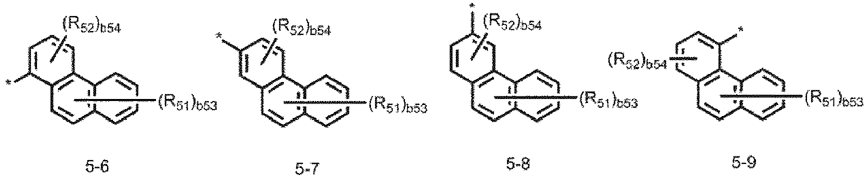 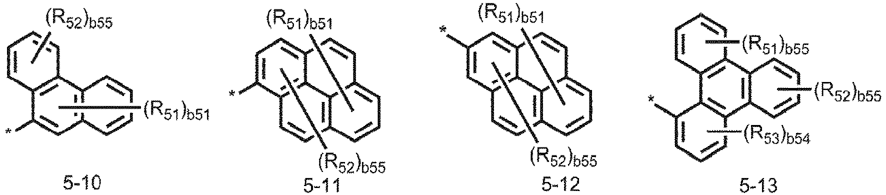 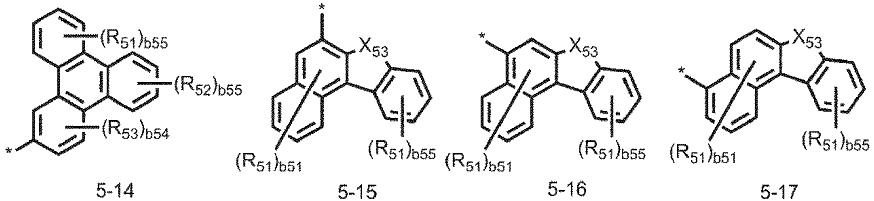 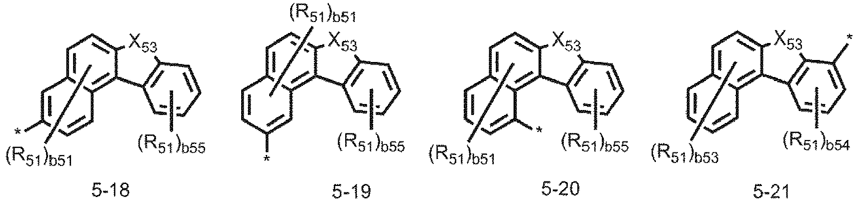 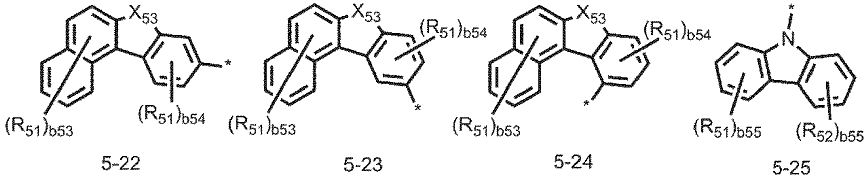 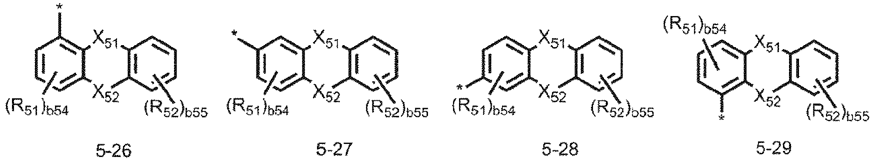 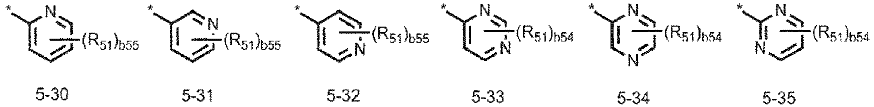 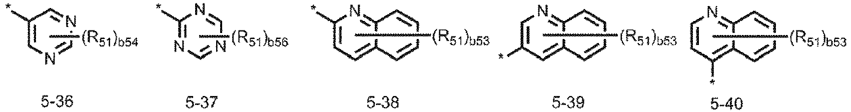 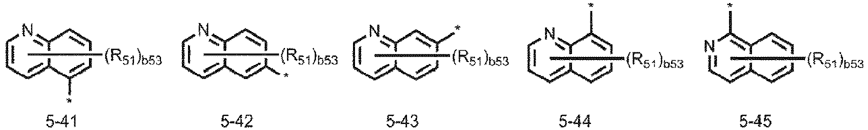 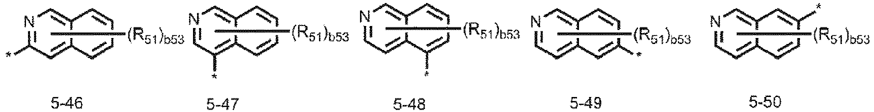 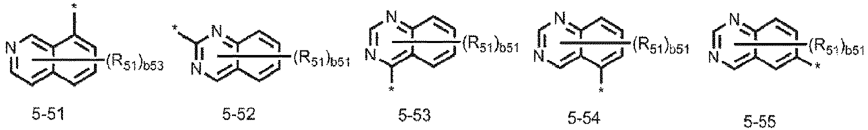 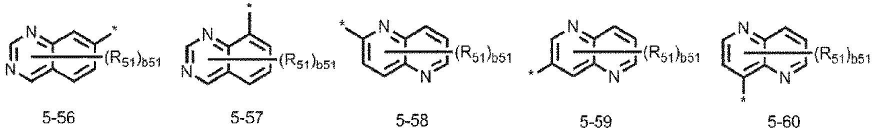 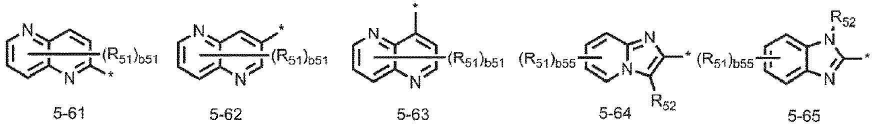 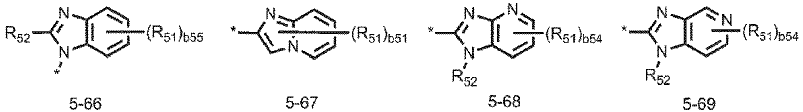 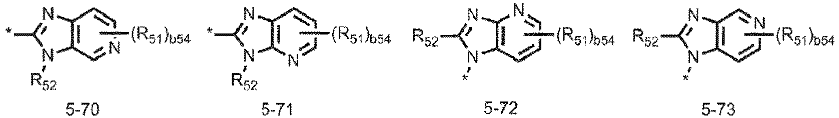 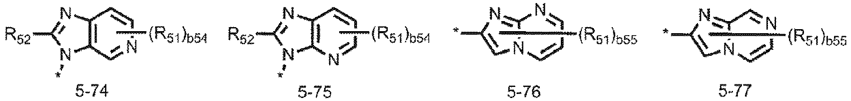 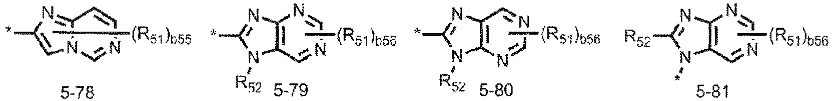 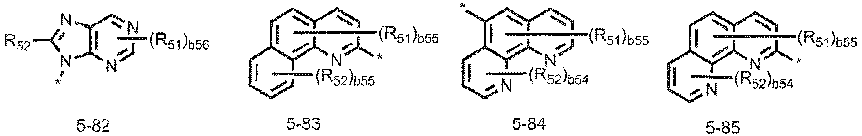 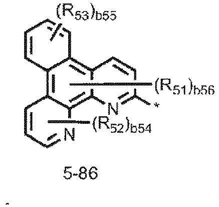 wobei in den Formeln 5-1 bis 5-86:
X₅₁ ausgewählt ist aus einer Einfachbindung, N(R₅₄), C(R₅₄)(R₅₅), O und S,
X₅₂ ausgewählt ist aus N(R₅₆), C(R₅₆)(R₅₇), O und S,
X₅₃ C(R₅₈)(R₅₉) ist,
R₅₁ bis R₅₉ jeweils unabhängig ausgewählt sind aus der Gruppe bestehend aus:
Wasserstoff, Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₃₁)(Q₃₂) und -Si(Q₃₁)(Q₃₂)(Q₃₃); und
einer Phenylgruppe, einer Biphenylgruppe, einer Terphenylgruppe, einer Naphthylgruppe, einer Pyridinylgruppe, einer Pyrimidinylgruppe, einer Pyridazinylgruppe, und einer Triazinylgruppe, jeweils substituiert mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₂₁)(Q₂₂) und -Si(Q₂₁)(Q₂₂)(Q₂₃),
Q₂₁ bis Q₂₃ und Q₃₁ bis Q₃₃ jeweils unabhängig ausgewählt sind aus einer Methylgruppe, einer Ethylgruppe, einer Phenylgruppe, einer Biphenylgruppe, einer Terphenylgruppe und einer Naphthylgruppe,
b51 ausgewählt ist aus 1, 2, 3, 4 und 5,
b52 ausgewählt ist aus 1, 2, 3, 4, 5, 6 und 7,
b53 ausgewählt ist aus 1, 2, 3, 4, 5 und 6,
b54 ausgewählt ist aus 1, 2 und 3,
b55 ausgewählt ist aus 1, 2, 3 und 4,
b56 ausgewählt ist aus 1 und 2,
b57 ausgewählt ist aus 1, 2, 3, 4, 5, 6, 7, 8 und 9 und
* eine Bindungsstelle mit einem Nachbaratom anzeigt.

6. Organische lichtemittierende Vorrichtung nach einem der vorangehenden Ansprüche, wobei:
(a) A₂₁ ausgewählt ist aus einer Benzolgruppe, einer Naphthalengruppe, einer Phenanthrengruppe, einer Pyrazingruppe, einer Triazingruppe, einer Chinolingruppe, einer Isochinolingruppe, einer Chinoxalingruppe und einer Chinazolingruppe; und/oder
(c) R₂₂, R₂₄ und R₂₆ jeweils unabhängig ausgewählt sind aus der Gruppe bestehend aus:
einer durch Formel 9 dargestellten Gruppe, Wasserstoff, einer C₁-C₂₀-Alkylgruppe und einer C₃-C₁₀-Cycloalkylgruppe;
einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe;
einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, jeweils substituiert mit wenigstens einem, ausgewählt aus Deuterium, -F, -Cl, -Br, -I, einer C₁-C₂₀-Alkylgruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, - N(Q₃₁)(Q₃₂) und -Si(Q₃₁)(Q₃₂)(Q₃₃); und
einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, jeweils substituiert mit wenigstens einem Substituenten, ausgewählt aus einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, wobei jeder des wenigstens einen Substituenten substituiert ist mit wenigstens einem, ausgewählt aus Deuterium, -F, -Cl, -Br, -I, einer C₁-C₂₀-Alkylgruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₂₁)(Q₂₂) und -Si(Q₂₁)(Q₂₂)(Q₂₃), mit der Maßgabe, dass R₂₆ keine Anthracenyl-, Pyridinyl- oder Pyrimidinylgruppe ist, und
Q₂₁ bis Q₂₃ und Q₃₁ bis Q₃₃ jeweils unabhängig ausgewählt sind aus einer C₁-C₆₀-Alkylgruppe und einer C₆-C₆₀-Arylgruppe,
wobei wenigstens eines, ausgewählt aus R₂₂, R₂₄ und R₂₆, die durch Formel 9 dargestellte Gruppe ist.

7. Organische lichtemittierende Vorrichtung nach einem der vorangehenden Ansprüche, wobei L₉₁ ausgewählt ist aus der Gruppe bestehend aus:
einer Phenylengruppe, einer Naphthylengruppe, einer Phenanthrenylengruppe, einer Triphenylenylengruppe, einer Pyrenylengruppe, einer Chrysenylengruppe, einer Pyrazinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe; und
einer Phenylengruppe, einer Naphthylengruppe, einer Phenanthrenylengruppe, einer Triphenylenylengruppe, einer Pyrenylengruppe, einer Chrysenylengruppe, einer Pyrazinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Phenanthridinylengruppe, einer Acridinylengruppe, einer Phenanthrolinylengruppe und einer Triazinylengruppe, jeweils substituiert mit wenigstens einem, ausgewählt aus Deuterium, -F, -Cl, -Br, -I, einer Cyanogruppe, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Biphenylgruppe, einer Terphenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirobifluorenylgruppe, einer Benzofluorenylgruppe, einer Dibenzofluorenylgruppe, einer Phenalenylgruppe, einer Phenanthrenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, eine Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁) und -P(=O)(Q₃₁)(Q₃₂), und
Q₃₁ bis Q₃₃ jeweils unabhängig ausgewählt sind aus Wasserstoff, einer Methylgruppe, einer Ethylgruppe, einer n-Propylgruppe, einer Isopropylgruppe, einer tert-Butylgruppe, einer Phenylgruppe, einer Biphenylgruppe und einer Terphenylgruppe.

8. Organische lichtemittierende Vorrichtung nach einem der vorangehenden Ansprüche, wobei R₉₁ ausgewählt ist aus der Gruppe bestehend aus:
einer C₆-C₆₀-Arylgruppe und einer C₁-C₆₀-Heteroarylgruppe;
einer C₆-C₆₀-Arylgruppe und einer C₁-C₆₀-Heteroarylgruppe, jeweils substituiert mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₃₁)(Q₃₂) und -Si(Q₃₁)(Q₃₂)(Q₃₃); und
einer C₆-C₆₀-Arylgruppe und einer C₁-C₆₀-Heteroarylgruppe, jeweils substituiert mit wenigstens einem Substituenten, ausgewählt aus einer C₆-C₆₀-Arylgruppe, einer C₁-C₆₀-Heteroarylgruppe, einer einwertigen nichtaromatischen kondensierten polycyclischen C₈-C₆₀-Gruppe und einer einwertigen nichtaromatischen kondensierten 8- bis 60-gliedrigen heteropolycyclischen Gruppe, wobei jeder des wenigstens einen Substituenten substituiert ist mit wenigstens einem, ausgewählt aus Deuterium, -F, -Cl, -Br, -I, einer C₁-C₂₀-Alkylgruppe, einer C₁-C₂₀-Alkoxygruppe, einer C₃-C₁₀-Cycloalkylgruppe, einer C₆-C₆₀-Arylgruppe, einer C₁-C₆₀-Heteroarylgruppe, einer einwertigen nichtaromatischen kondensierten polycyclischen C₈-C₆₀-Gruppe, einer einwertigen nichtaromatischen kondensierten 8- bis 60-gliedrigen heteropolycyclischen Gruppe, -N(Q₂₁)(Q₂₂) und -Si(Q₂₁)(Q₂₂)(Q₂₃), mit der Maßgabe, dass R₉₁ keine Anthracenyl-, Pyridinyl- oder Pyrimidinylgruppe ist, und
Q₂₁ bis Q₂₃ und Q₃₁ bis Q₃₃ jeweils unabhängig ausgewählt sind aus einer C₁-C₆₀-Alkylgruppe und einer C₆-C₆₀-Arylgruppe.

9. Organische lichtemittierende Vorrichtung nach Anspruch 8, wobei R₉₁ ausgewählt ist aus Gruppen, die durch die Formeln 5-1 bis 5-3, 5-6 bis 5-14, 5-37 bis 5-63 und 5-83 bis 5-86 dargestellt sind,
wobei die Formeln 5-1 bis 5-3, 5-6 bis 5-14, 5-37 bis 5-63 und 5-83 bis 5-86 der Definition in Anspruch 5 entsprechen.

10. Organische lichtemittierende Vorrichtung nach Anspruch 1, wobei die erste Verbindung, die durch eine, ausgewählt aus den Formeln 1-14a bis 1-14g, dargestellt ist, ausgewählt ist aus den Verbindungen B-101 bis B-205 und die zweite Verbindung, die durch Formel 2 dargestellt ist, ausgewählt ist aus den Verbindungen E-1 bis E-20, E-25 bis E-36, E-41 bis E-52, E-113 bis E-115, E-117 bis E-122, E-124, E-128, E-129, E-131 bis E-134, E-154 bis E-169, E-201 bis E-203, E-205 bis E-210, E-212, E-216, E-218 bis E-221, E-226 bis E-233, E-237 bis: E-242:

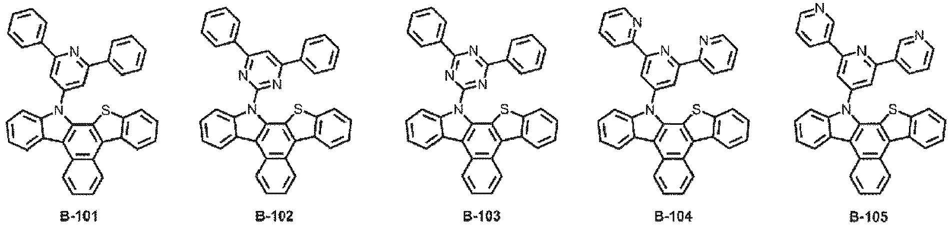

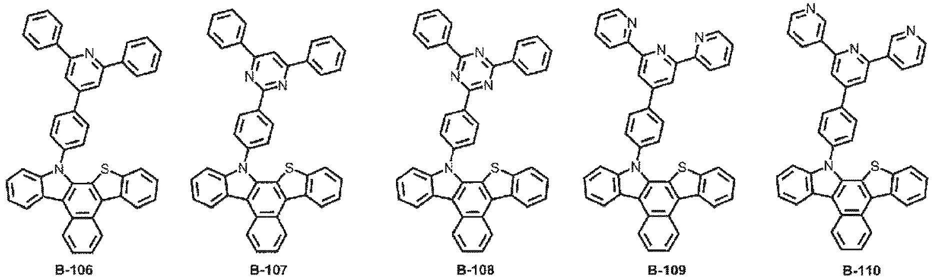

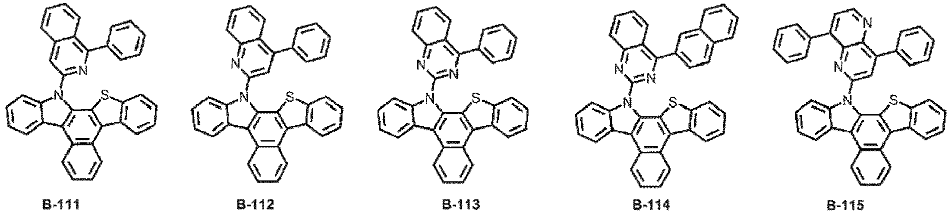

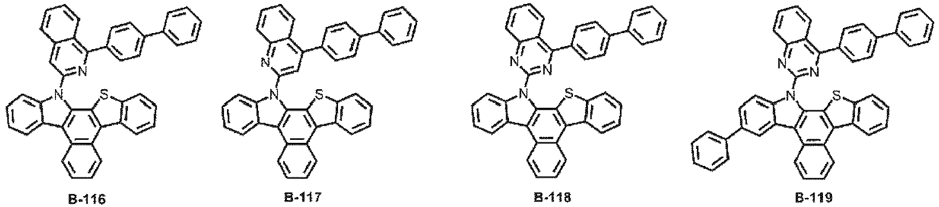

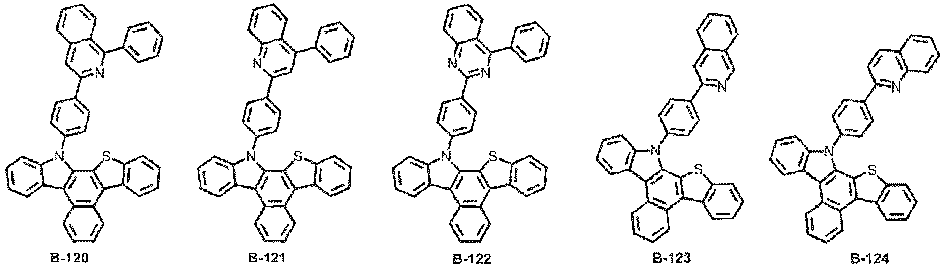

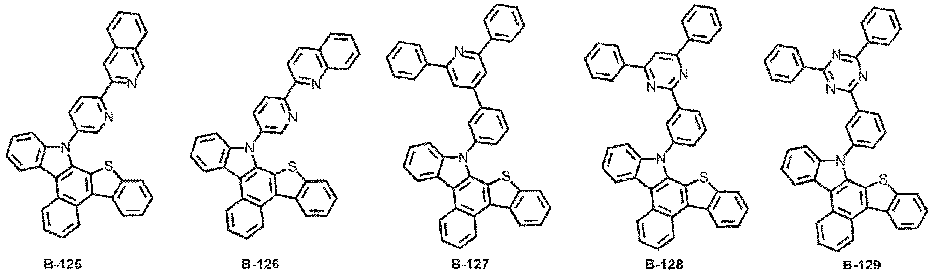

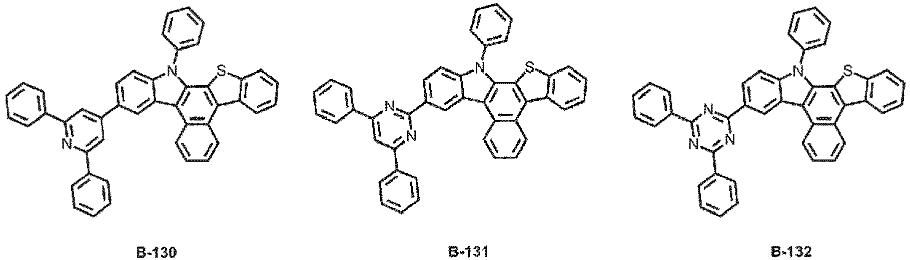

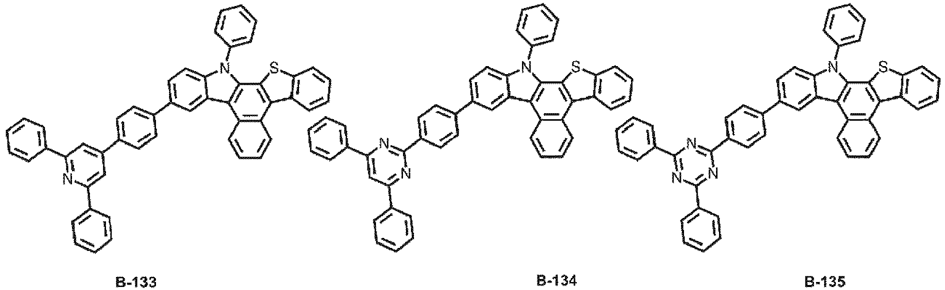

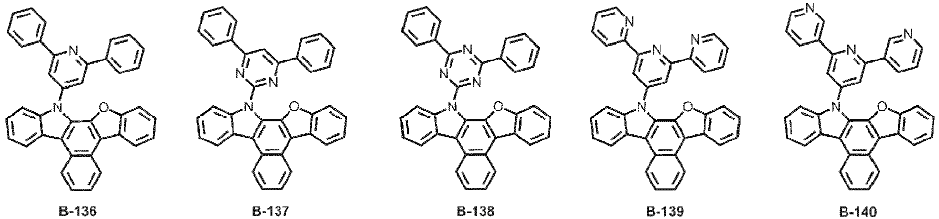

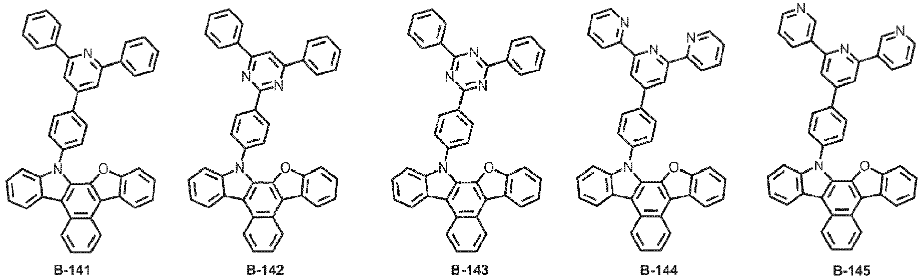

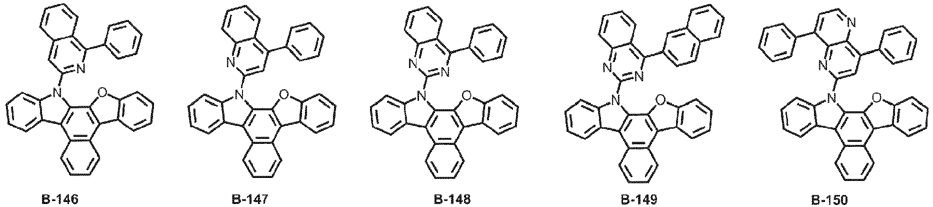

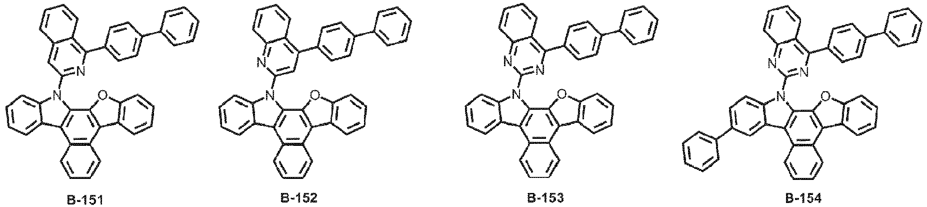

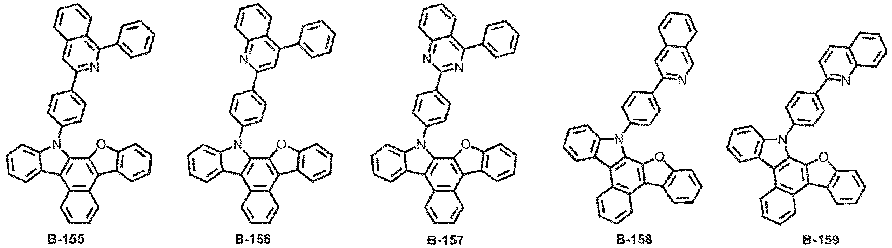

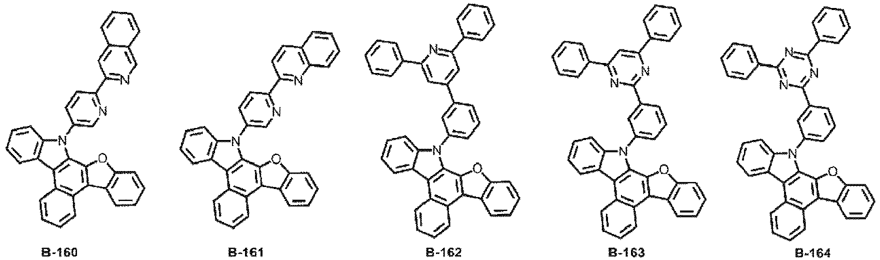

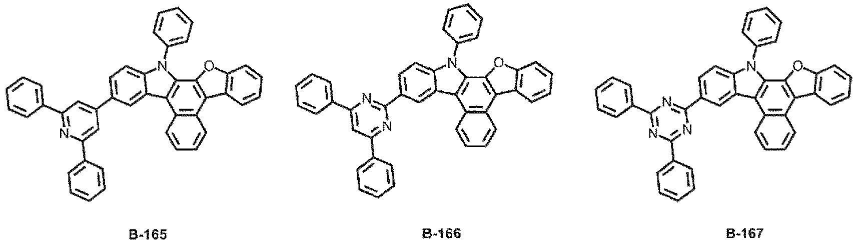

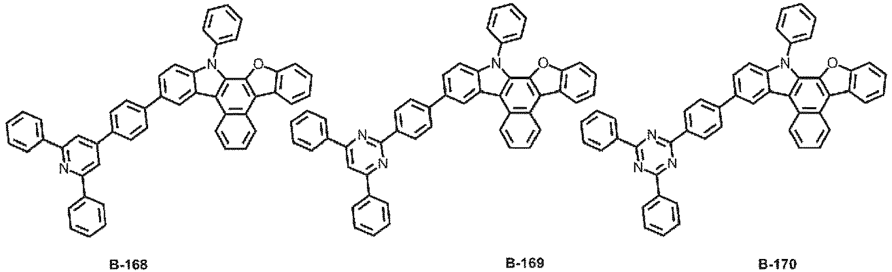

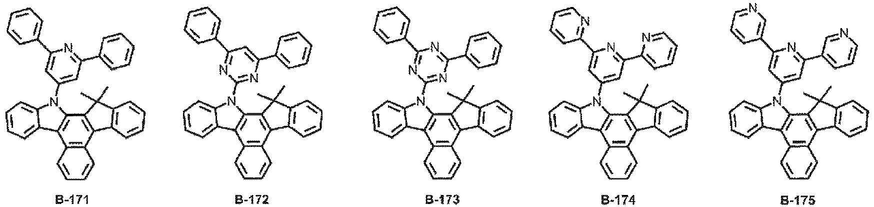

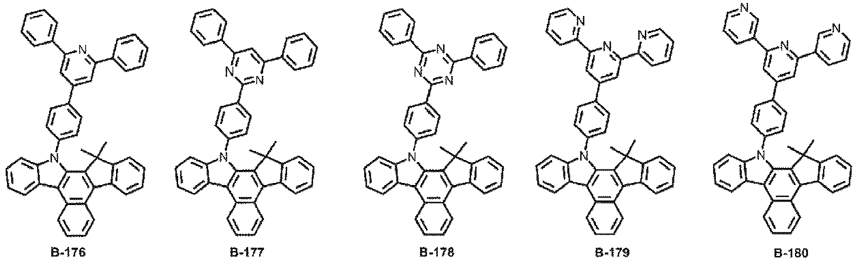

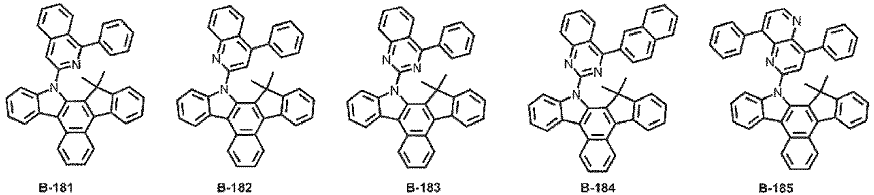

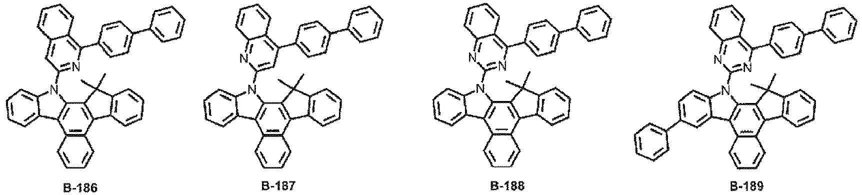

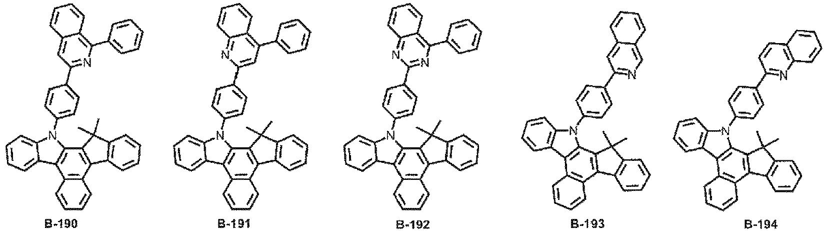

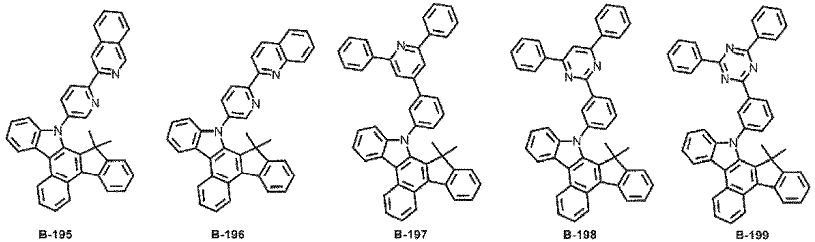

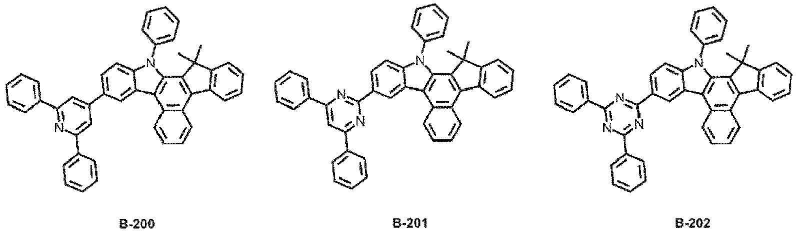

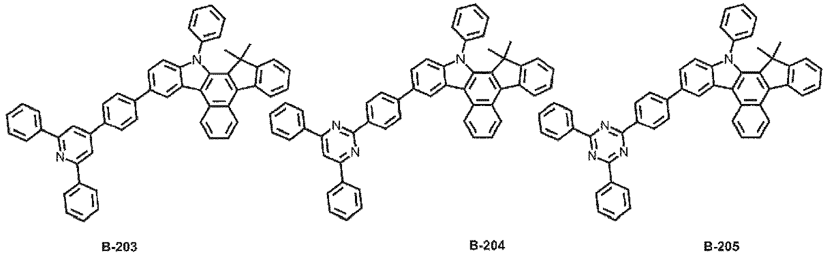

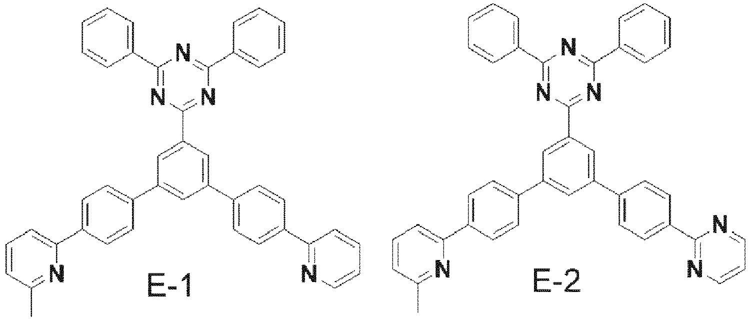

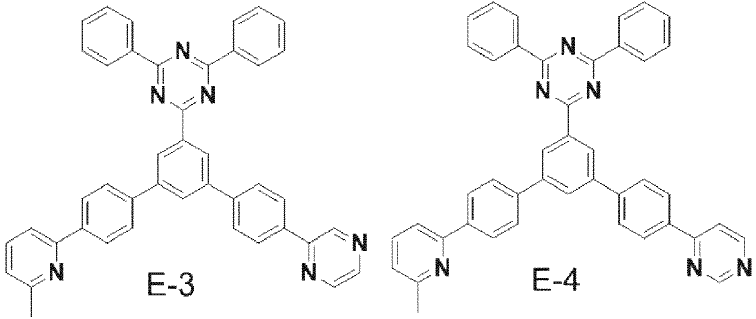

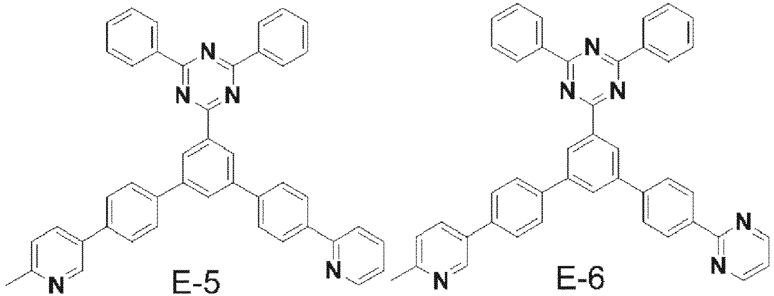

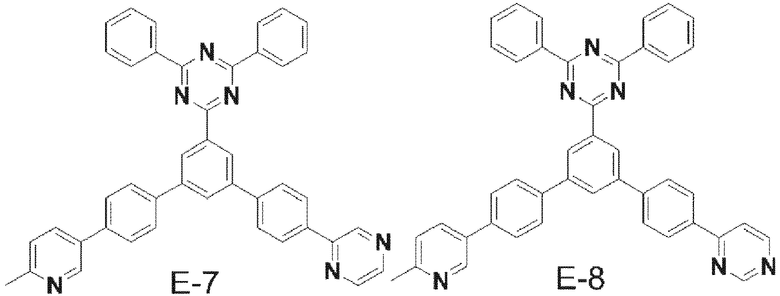

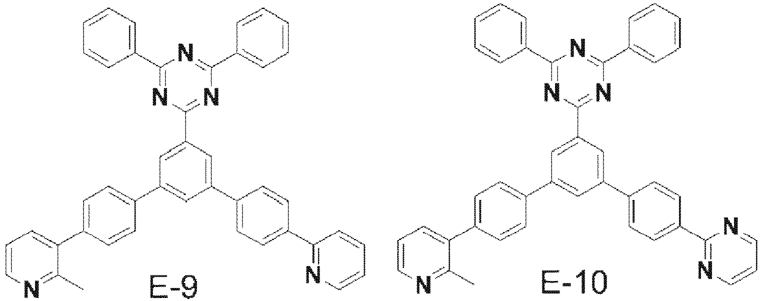

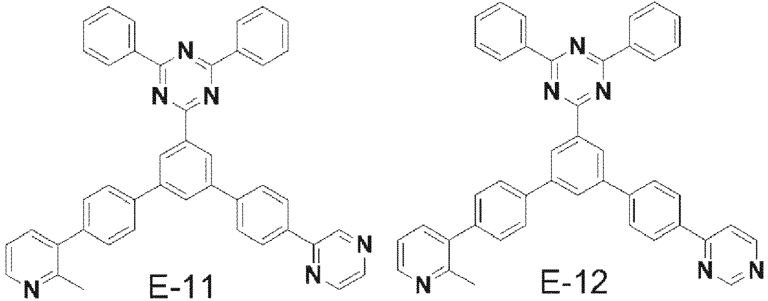

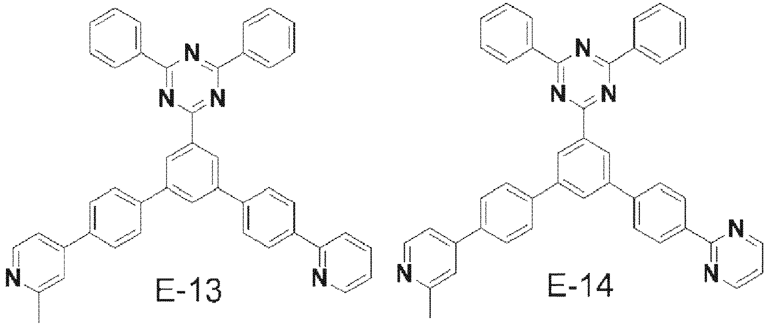

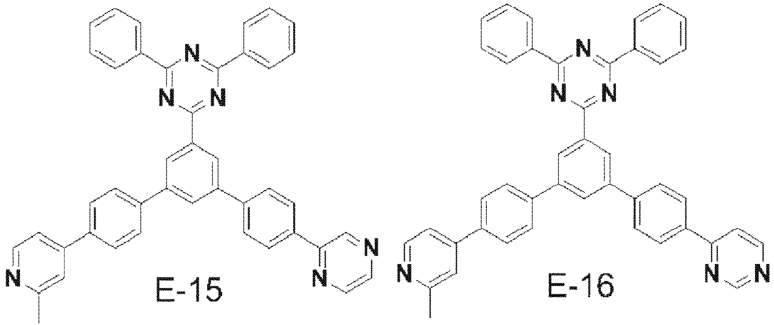

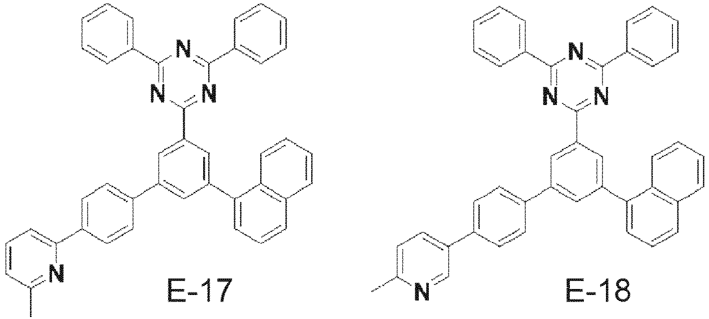

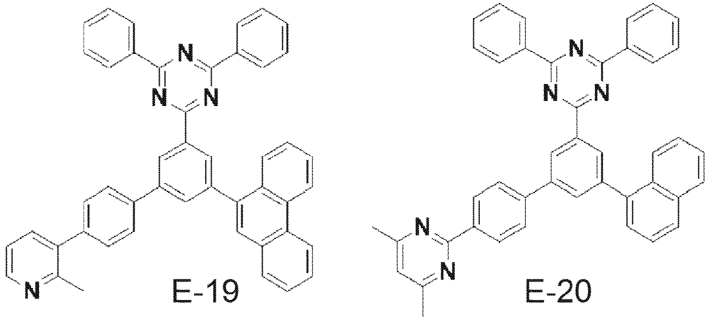

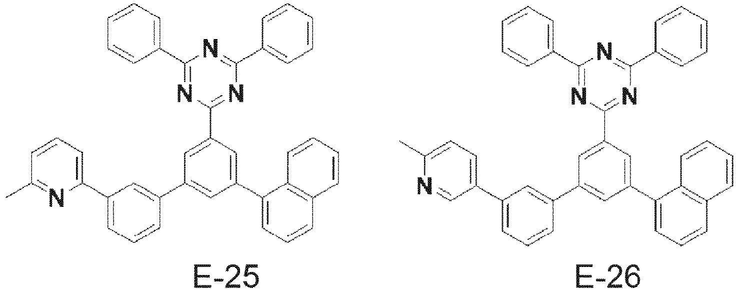

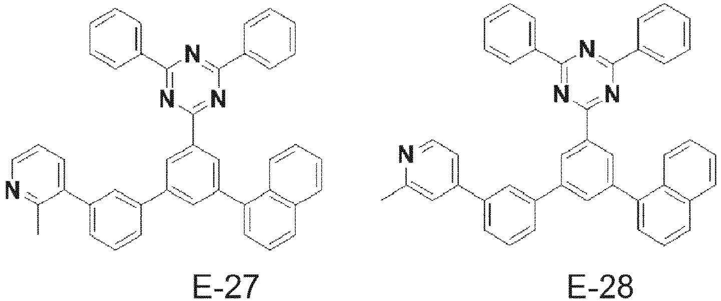

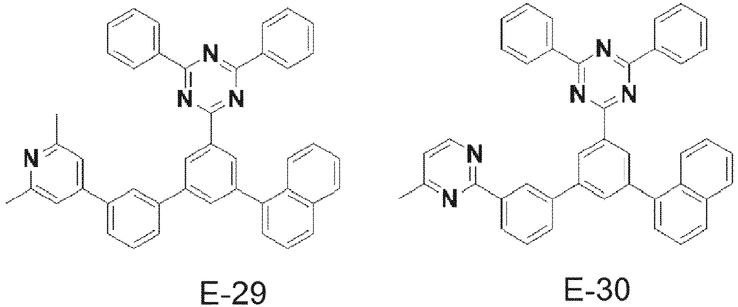

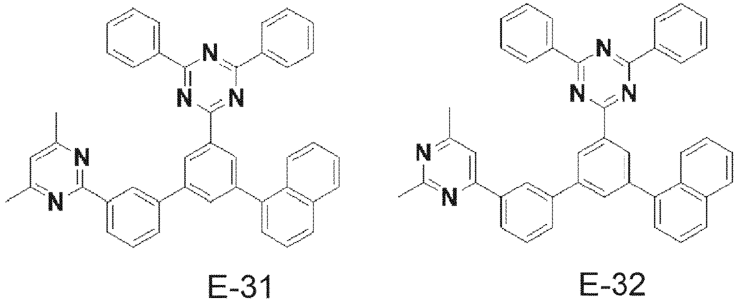

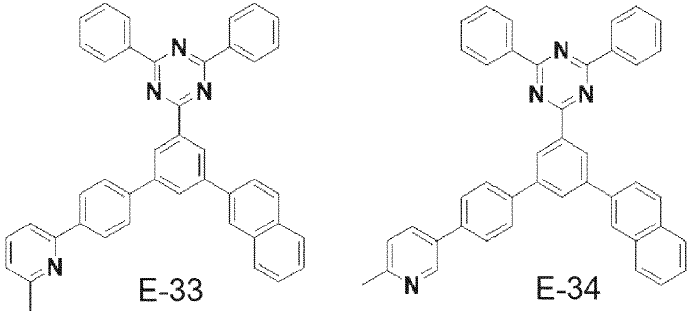

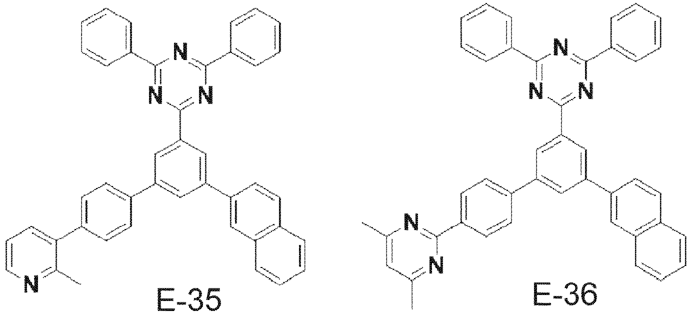

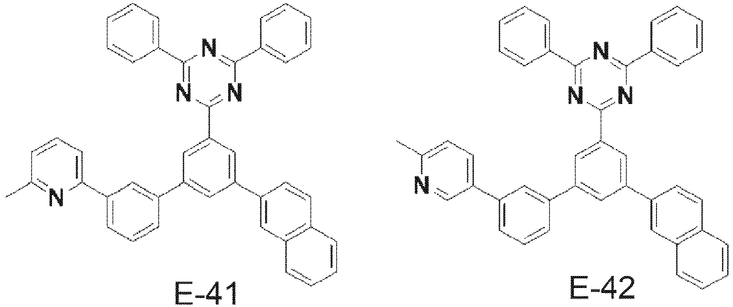

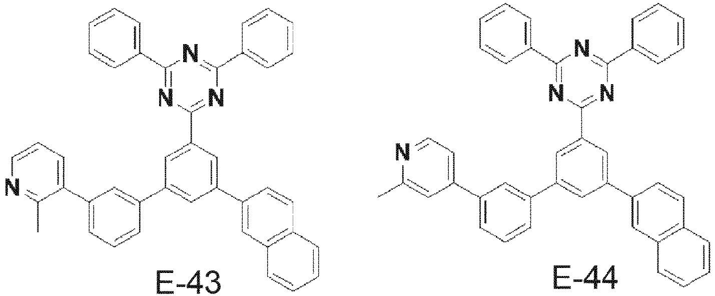

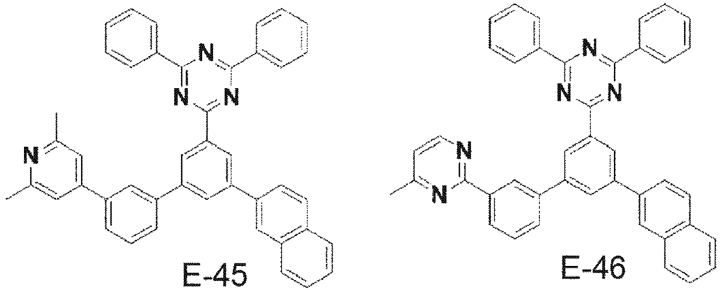

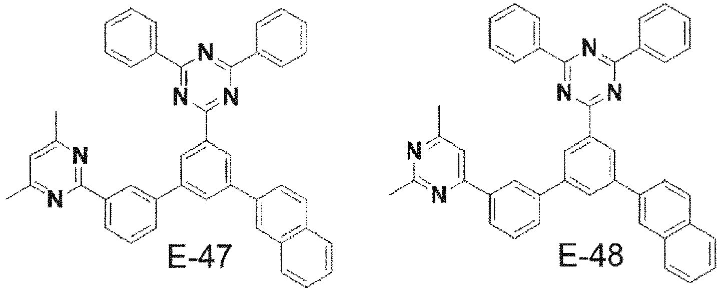

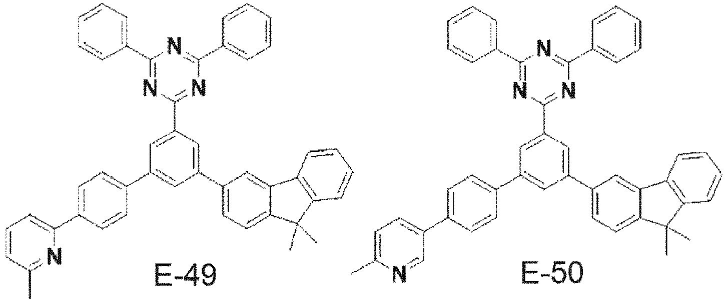

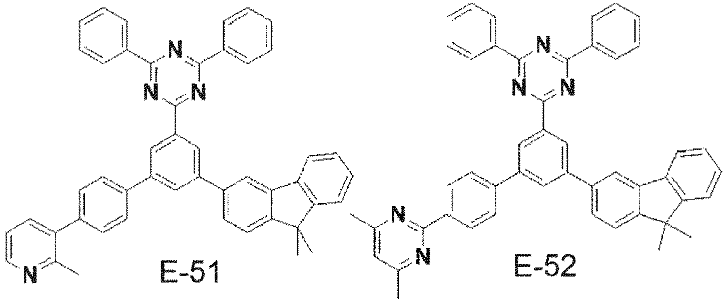

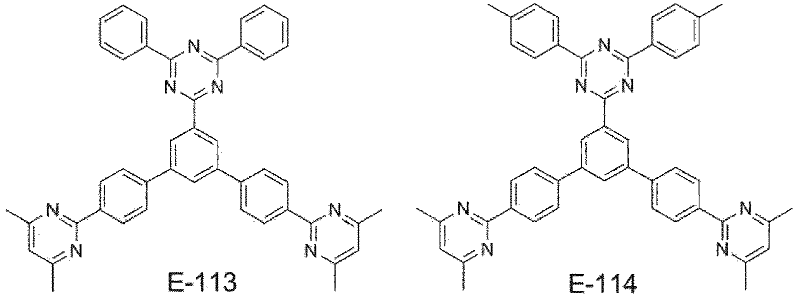

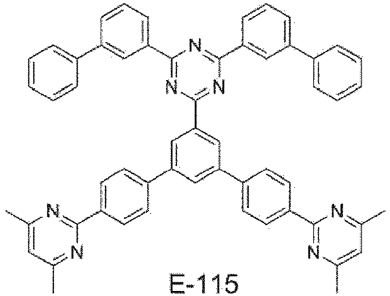

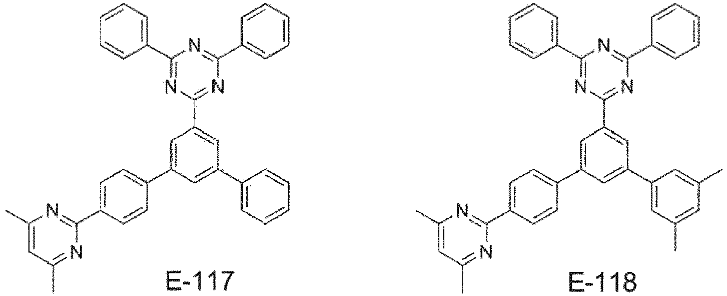

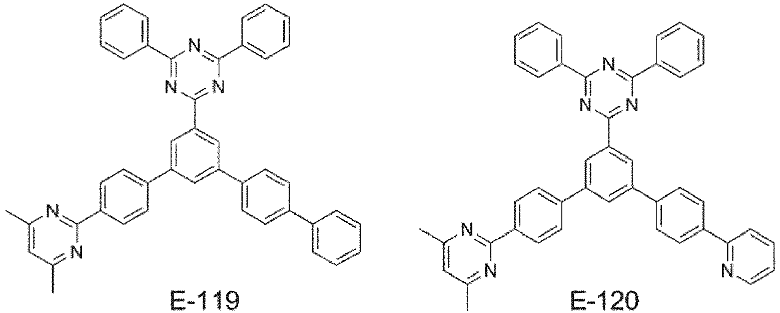

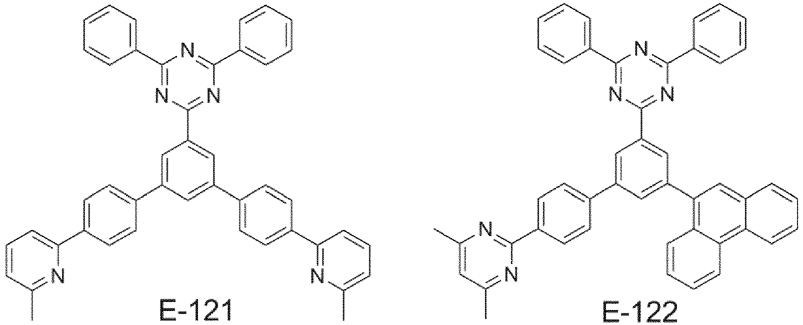

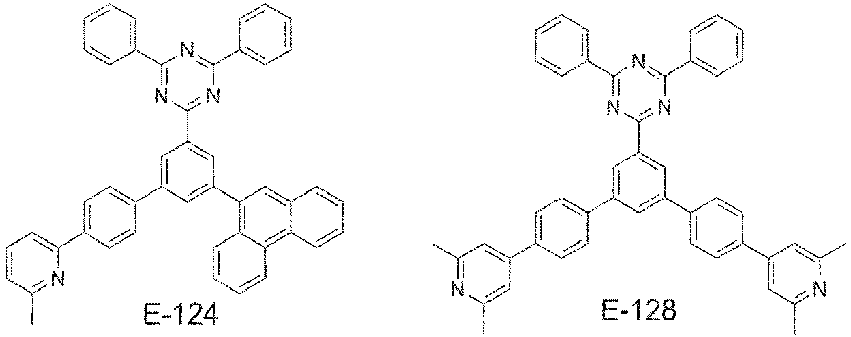

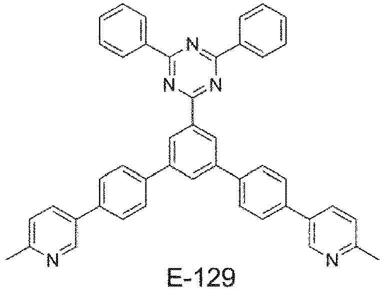

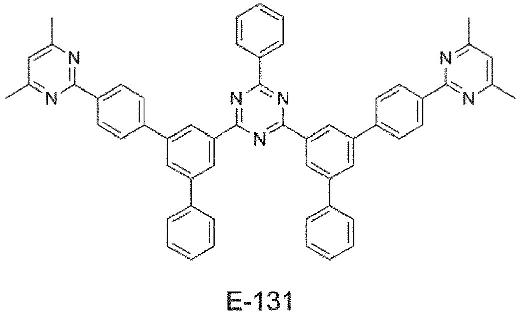

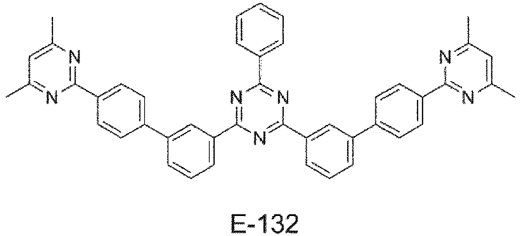

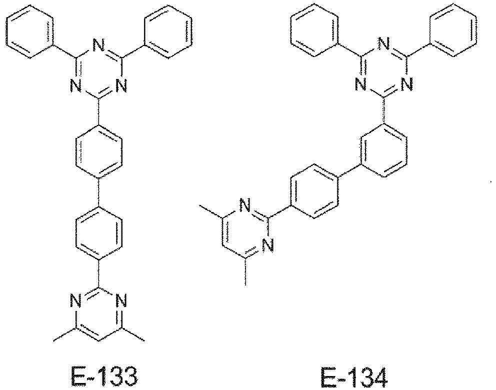

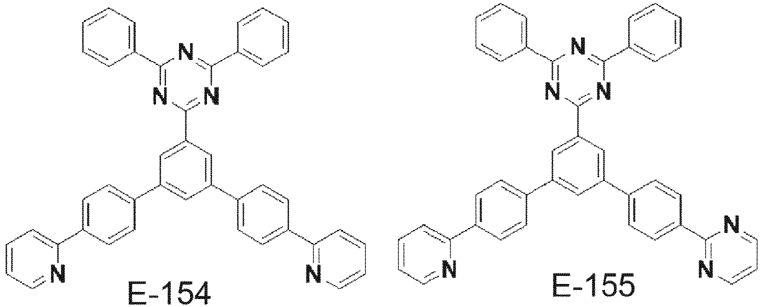

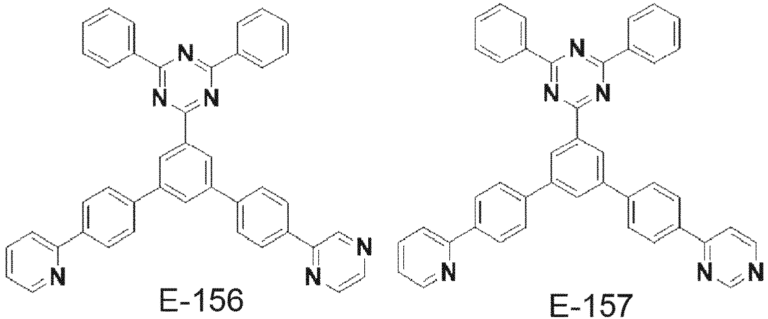

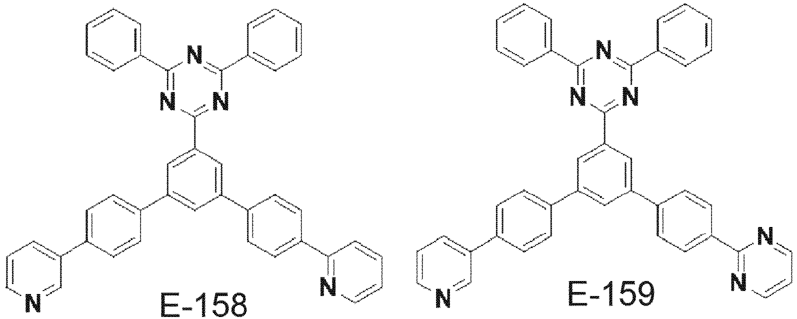

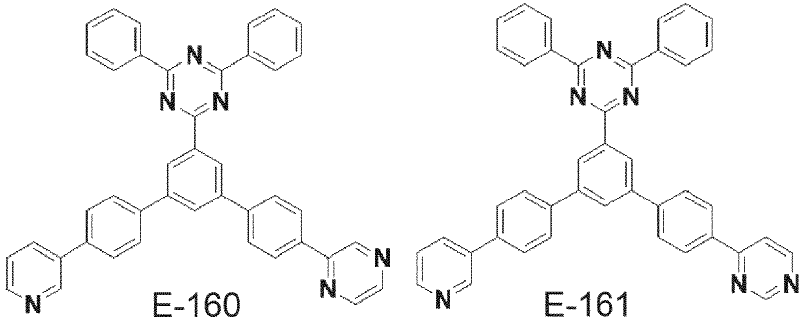

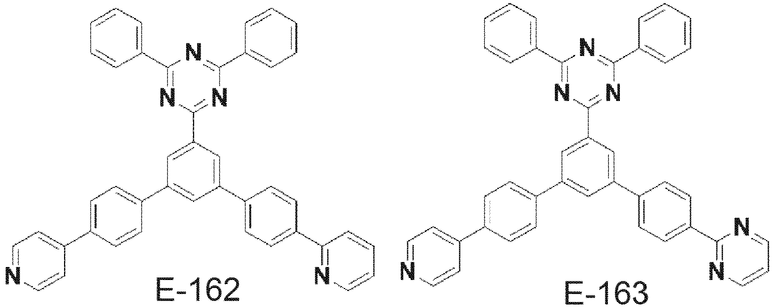

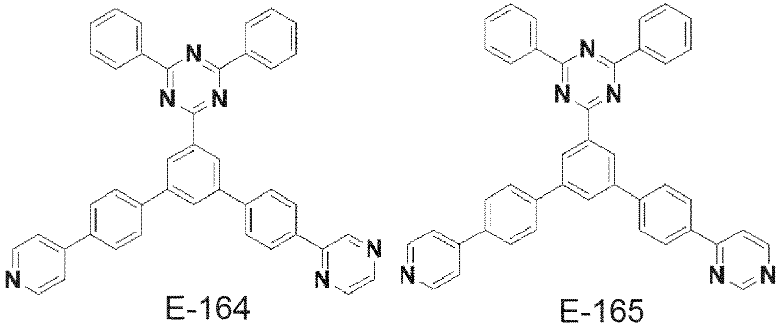

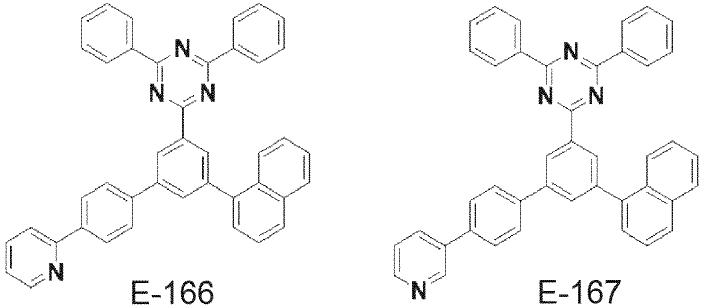

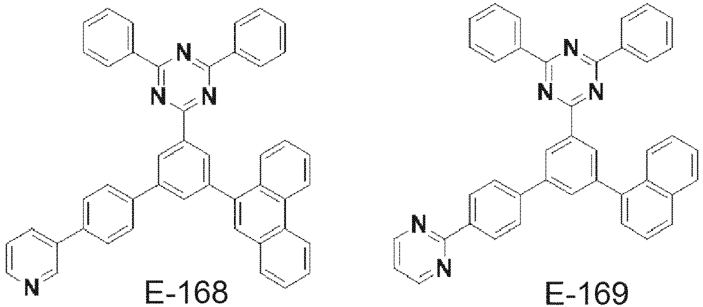

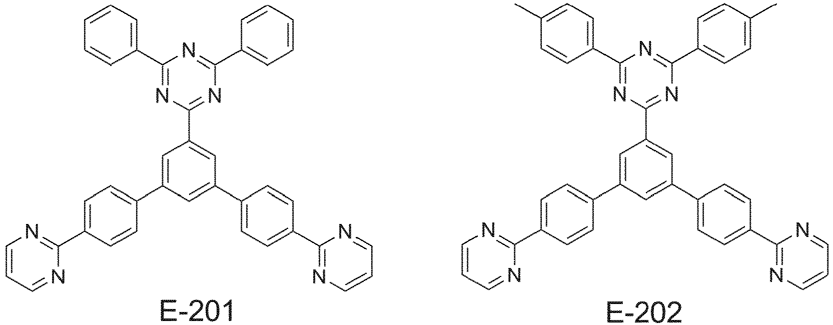

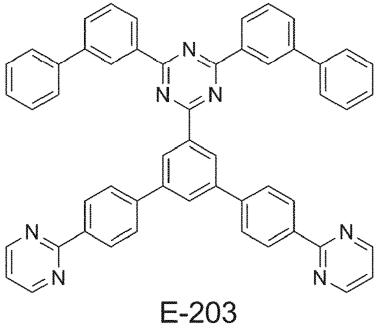

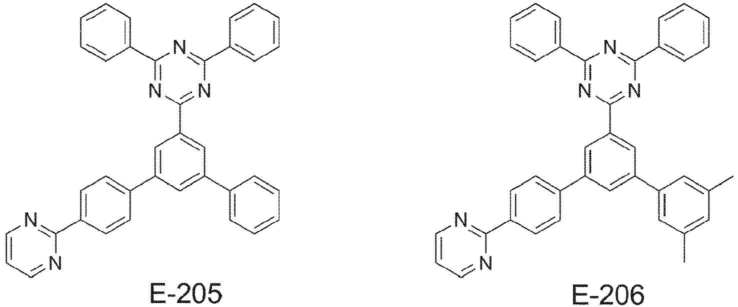

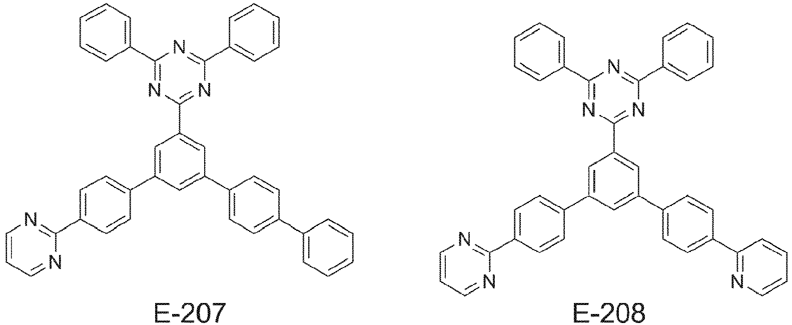

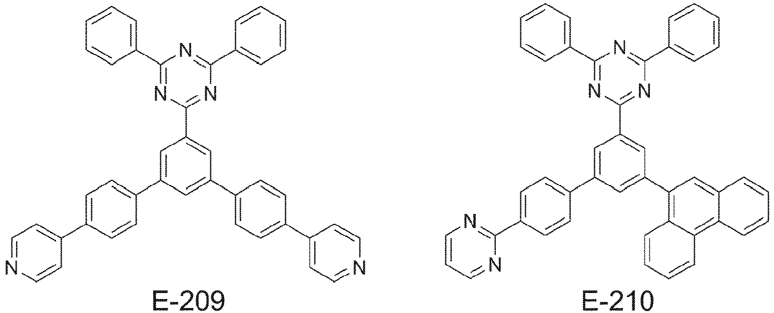

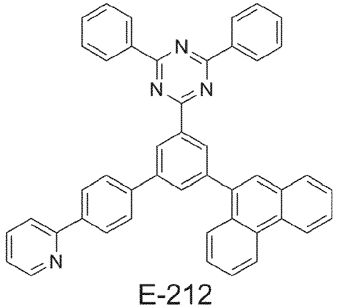

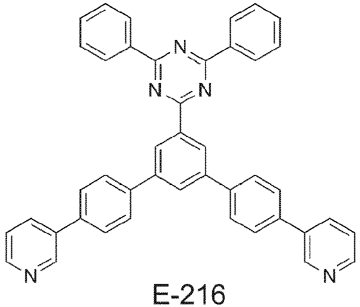

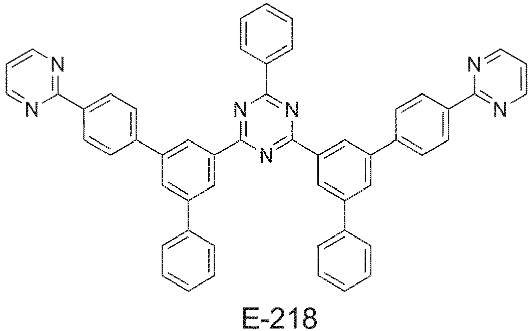

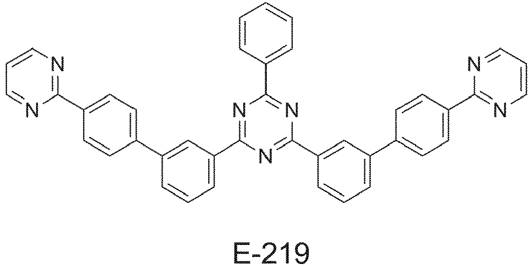

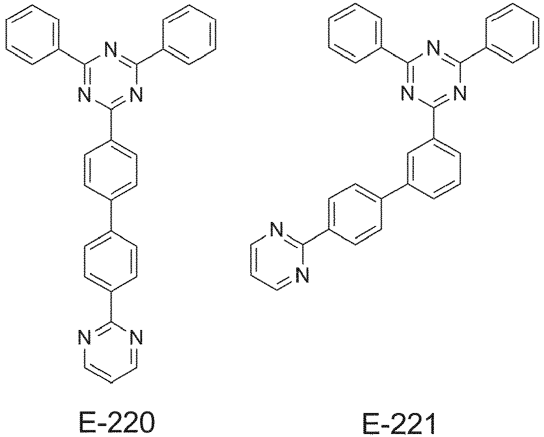

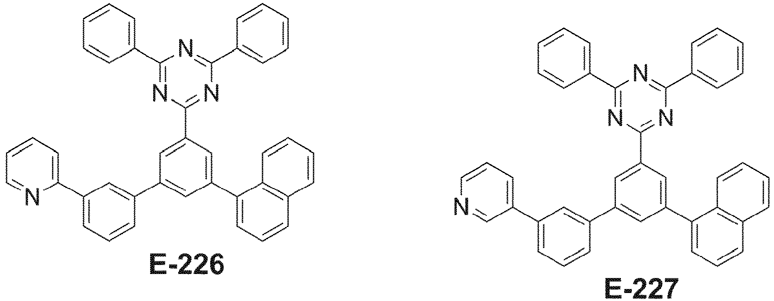

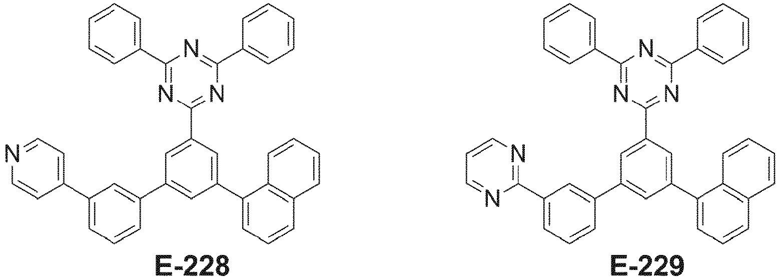

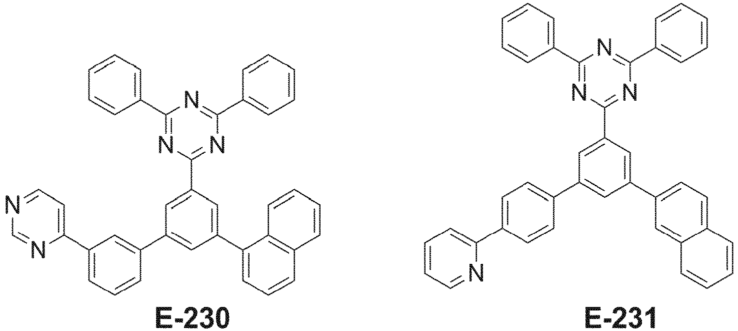

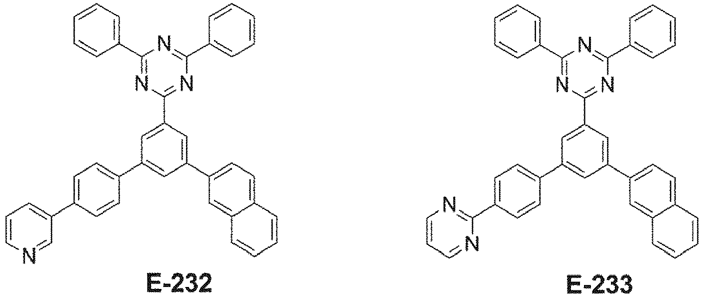

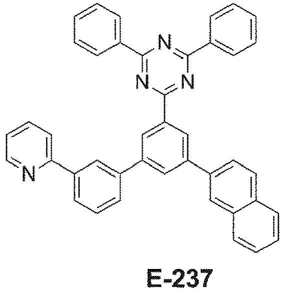

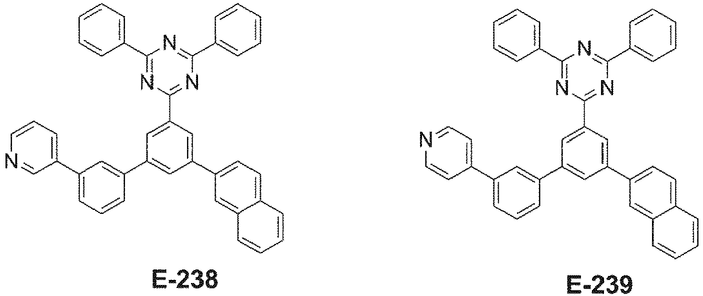

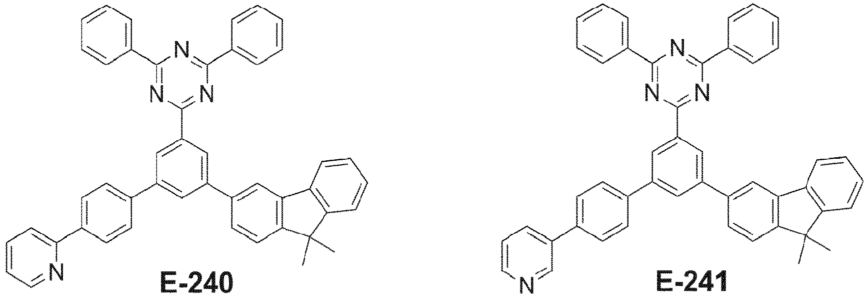

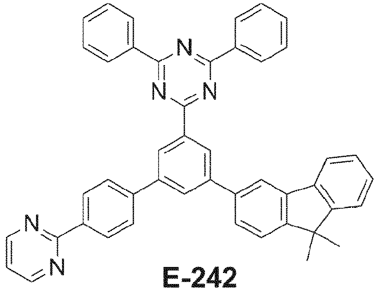

11. Organische lichtemittierende Vorrichtung nach einem der vorangehenden Ansprüche, wobei
die Emissionsschicht ferner einen Dotierstoff umfasst und der Dotierstoff ein metallorganischer Komplex, dargestellt durch Formel 401, ist:
**Formel 401** M(L₄₀₁)_{xc1}(L₄₀₂)_{xc2},
wobei L₄₀₁ ein Ligand, dargestellt durch Formel 402, ist, 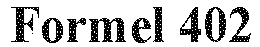 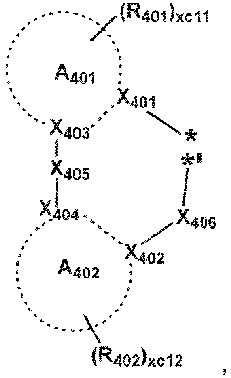 wobei in den Formeln 401 und 402:
M ausgewählt ist aus Iridium (Ir), Platin (Pt), Palladium (Pd), Osmium (Os), Titan (Ti), Zirconium (Zr), Hafnium (Hf), Europium (Eu), Terbium (Tb), Rhodium (Rh) und Thulium (Tm),
xc1 1, 2 oder 3 ist, wobei, wenn xc1 zwei oder mehr beträgt, die zwei oder mehr L₄₀₁ gleich oder voneinander verschieden sind,
L₄₀₂ ein organischer Ligand ist,
xc2 eine ganze Zahl, ausgewählt aus 0 bis 4, ist, wobei, wenn xc2 zwei oder mehr beträgt, die zwei oder mehr L₄₀₂ gleich oder voneinander verschieden sind,
X₄₀₁ bis X₄₀₄ jeweils unabhängig Stickstoff oder Kohlenstoff sind,
X₄₀₁ und X₄₀₃ über eine Einfachbindung oder eine Doppelbindung miteinander verbunden sind und X₄₀₂ und X₄₀₄ über eine Einfachbindung oder eine Doppelbindung miteinander verbunden sind,
A₄₀₁ und A₄₀₂ jeweils unabhängig eine carbocyclische C₅-C₆₀-Gruppe oder eine heterocyclische C₁-C₆₀-Gruppe sind,
X₄₀₅ eine Einfachbindung, -O-, -S-, -C(=O)-, -N(Q₄₁₁)-, -C(Q₄₁₁)(Q₄₁₂)-, -C(Q₄₁₁)=C(Q₄₁₂)-, -C(Q₄₁₁)= oder =C(Q₄₁₁)= ist, wobei Q₄₁₁ und Q₄₁₂ jeweils unabhängig Wasserstoff, Deuterium, eine C₁-C₂₀-Alkylgruppe, eine C₁-C₂₀-Alkoxygruppe, eine Phenylgruppe, eine Biphenylgruppe, eine Terphenylgruppe oder eine Naphthylgruppe sind,
X₄₀₆ eine Einfachbindung, O oder S ist,
R₄₀₁ und R₄₀₂ jeweils unabhängig ausgewählt sind aus Wasserstoff, Deuterium, -F, -Cl, -Br, -I, -CD₃, -CF₃, einer Hydroxygruppe, einer Cyanogruppe, einer Nitrogruppe, einer Amidinogruppe, einer Hydrazinogruppe, einer Hydrazonogruppe, einer substituierten oder nicht substituierten C₁-C₂₀-Alkylgruppe, einer substituierten oder nicht substituierten C₁-C₂₀-Alkoxygruppe, einer substituierten oder nicht substituierten C₃-C₁₀-Cycloalkylgruppe, einer substituierten oder nicht substituierten C₁-C₁₀-Heterocycloalkylgruppe, einer substituierten oder nicht substituierten C₃-C₁₀-Cycloalkenylgruppe, einer substituierten oder nicht substituierten C₁-C₁₀-Heterocycloalkenylgruppe, einer substituierten oder nicht substituierten C₆-C₆₀-Arylgruppe, einer substituierten oder nicht substituierten C₆-C₆₀-Aryloxygruppe, einer substituierten oder nicht substituierten C₆-C₆₀-Arylthiogruppe, einer substituierten oder nicht substituierten C₁-C₆₀-Heteroarylgruppe, einer substituierten oder nicht substituierten einwertigen nichtaromatischen kondensierten polycyclischen C₈-C₆₀-Gruppe und einer substituierten oder nicht substituierten einwertigen nichtaromatischen kondensierten 8- bis 60-gliedrigen heteropolycyclischen Gruppe, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁) und -P(=O)(Q₄₀₁)(Q₄₀₂), wobei Q₄₀₁ bis Q₄₀₃ jeweils unabhängig ausgewählt sind aus einer C₁-C₁₀-Alkylgruppe, einer C₁-C₁₀-Alkoxygruppe, einer C₆-C₂₀-Arylgruppe und einer C₁-C₂₀-Heteroarylgruppe,
xc1 1 und xc12 jeweils unabhängig eine ganze Zahl, ausgewählt aus 0 bis 10, sind und
* und *' in Formel 402 jeweils unabhängig eine Bindungsstelle mit M in Formel 401 sind.

## Revendications

1. Dispositif électroluminescent organique (10, 20, 30, 40) comprenant :
une première électrode (110) ;
une deuxième électrode (190) faisant face à la première électrode (110) ; et
une couche organique (150) entre la première électrode et la deuxième électrode, la couche organique (150) comprenant une couche d'émission, et une région de transport d'électrons disposée entre la couche d'émission et la deuxième électrode,
dans lequel la couche d'émission comprend un premier composé représenté par l'une choisie parmi les formules 1-14a à 1-14g, et **caractérisé en ce que** la région de transport d'électrons comprend un deuxième composé représenté par la formule 2 : 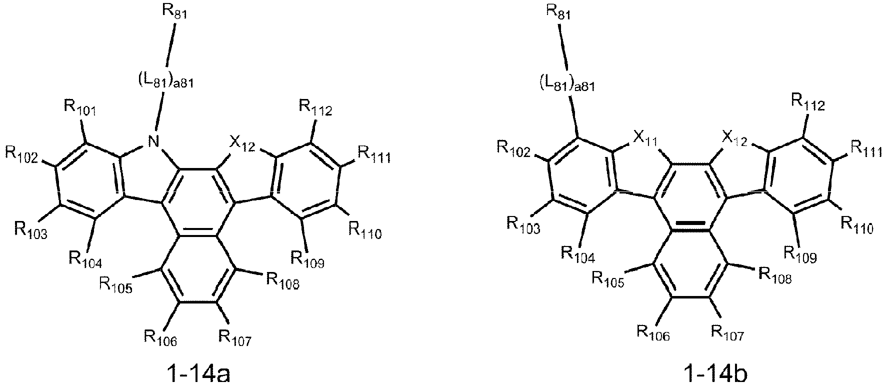 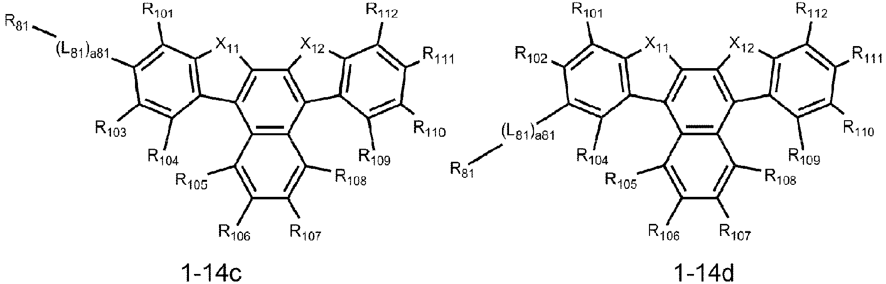 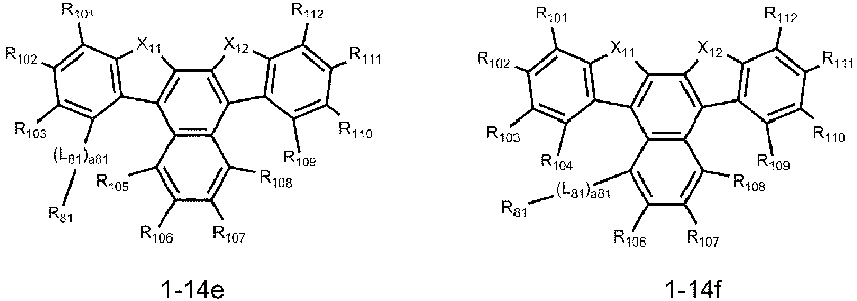 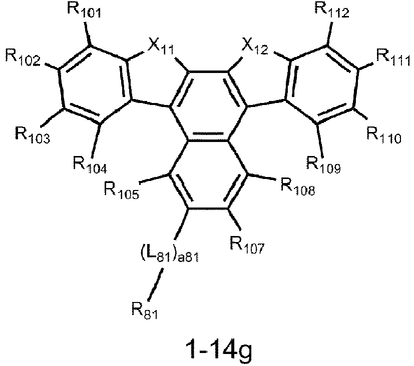 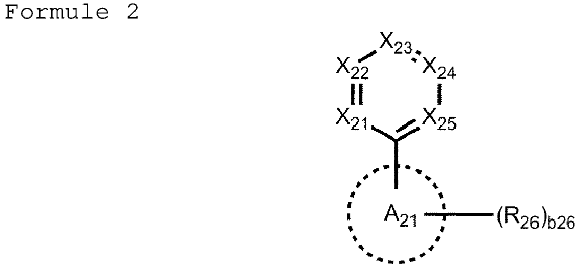 où, dans les formules 1-14a à 1-14g et 2,
X₁₁ est choisi parmi N (R₁₁), C(R₁₁)(R₁₂), O et S,
X₁₂ est choisi parmi N(R₁₃), C(R₁₃)(R₁₄), O et S,
A₂₁ est choisi parmi un groupe arène en C₆ à C₂₀ et un groupe hétéroarène en C₁ à C₂₀, sous réserve que A₂₁ ne soit pas un groupe anthracène, pyridine ou pyrimidine,
i) X₂₁ est N, X₂₂ est C(R₂₂), X₂₃ est N, X₂₄ est C(R₂₄), et X₂₅ est N,
b26 est choisi parmi 1, 2, 3, 4, 5 et 6,
chacun de R₁₁ à R₁₄ et de R₁₀₁ à R₁₁₂ est indépendamment choisi parmi un groupe représenté par la formule 8, l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, un groupe hétéropolycyclique à 8 à 60 chaînons condensé non aromatique monovalent substitué ou non substitué, -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂), où au moins l'un choisi parmi R₁₁ à R₁₄ et R₁₀₁ à R₁₁₂ est le groupe représenté par la formule 8,
formule 8 *-(L₈₁)ₐ₈₁-R₈₁
L₈₁ est choisi parmi un groupe cycloalkylène en C₃ à C₁₀ substitué ou non substitué, un groupe hétérocycloalkylène en C₁ à C₁₀ substitué ou non substitué, un groupe cycloalcénylène en C₃ à C₁₀ substitué ou non substitué, un groupe hétérocycloalcénylène en C₁ à C₁₀ substitué ou non substitué, un groupe arylène en C₆ à C₆₀ substitué ou non substitué, un groupe hétéroarylène en C₁ à C₆₀ substitué ou non substitué, un groupe polycyclique en C₈ à C₆₀ condensé non aromatique divalent substitué ou non substitué, et un groupe hétéropolycyclique à 8 à 60 chaînons condensé non aromatique divalent substitué ou non substitué,
a₈₁ est choisi parmi 0, 1 et 2,
R₈₁ est choisi parmi un groupe aryle en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, et un groupe hétéropolycyclique à 8 à 60 chaînons condensé non aromatique monovalent substitué ou non substitué,
chacun de R₂₂, R₂₄ et R₂₆ est indépendamment choisi parmi un groupe représenté par la formule 9, l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀ substitué ou non substitué, un groupe alkoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, et un groupe hétéropolycyclique à 8 à 60 chaînons condensé non aromatique monovalent substitué ou non substitué, -Si(Q₁)(Q₂)(Q₃), -N(Q₁)(Q₂), -B(Q₁)(Q₂), -C(=O)(Q₁), -S(=O)₂(Q₁), et -P(=O)(Q₁)(Q₂), sous réserve que R₂₆ ne soit pas un groupe anthracényle, pyridinyle ou pyrimidinyle, où au moins l'un choisi parmi R₂₂, R₂₄ et R₂₆ est le groupe représenté par la formule 9,
formule 9 *-(L₉₁)ₐ₉₁-R₉₁
L₉₁ est choisi parmi un groupe arylène en C₆ à C₆₀ substitué ou non substitué et un groupe hétéroarylène en C₁ à C₆₀ substitué ou non substitué, sous réserve que L₉₁ ne soit pas un groupe anthracénylène, pyridinylène ou pyrimidinylène,
a91 est choisi parmi 0, 1 et 2
R₉₁ est choisi parmi un groupe aryle en C₆ à C₆₀ substitué ou non substitué et un groupe hétéroaryle en C₁ à C₆₀ substitué ou non substitué, sous réserve que R₉₁ ne soit pas un groupe anthracényle, pyridinyle ou pyrimidinyle,
chacun de Q₁ à Q₃ est indépendamment choisi parmi l'hydrogène, le deutérium, -F, -Cl, -Br, -I, un groupe hydroxyle, un groupe cyano, un groupe nitro, un groupe amidino, un groupe hydrazino, un groupe hydrazono, un groupe alkyle en C₁ à C₆₀, un groupe alcényle en C₂ à C₆₀, un groupe alcynyle en C₂ à C₆₀, un groupe alkoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, un groupe biphényle, et un groupe terphényle, et
* indique un site de liaison à un atome voisin.

2. Dispositif électroluminescent organique selon la revendication 1, dans lequel chacun de R₁₀₁ à R₁₁₂ est indépendamment choisi dans l'ensemble constitué par :
un groupe représenté par la formule 8, l'hydrogène, le deutérium, -F, -Cl, -Br, -I, un groupe alkyle en C₁ à C₂₀, un groupe alkoxy en C₁ à C₂₀, un groupe aryle en C₆ à C₆₀, un groupe aryloxy en C₆ à C₆₀, un groupe arylthio en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₁)(Q₂), et -Si(Q₁)(Q₂)(Q₃) ;
un groupe alkyle en C₁ à C₂₀ et un groupe alkoxy en C₁ à C₂₀, chacun substitué par au moins l'un choisi parmi le deutérium, -F, -Cl, -Br, -I, un groupe cyano, et un groupe nitro ; et
un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun substitué par au moins l'un choisi parmi le deutérium, -F, -Cl, -Br, -I, un groupe cyano, un groupe nitro, un groupe méthyle, un groupe méthoxy, un groupe phényle, un groupe naphtyle, -N(Q₃₁)(Q₃₂), et -Si(Q₃₁)(Q₃₂)(Q₃₃), et
chacun de Q₁ à Q₃ et de Q₃₁ à Q₃₃ est indépendamment choisi parmi un groupe alkyle en C₁ à C₂₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, un groupe biphényle, et un groupe terphényle ;
dans lequel au moins l'un choisi parmi R₁₀₁ à R₁₁₂ est un groupe représenté par la formule 8.

3. Dispositif électroluminescent organique selon l'une quelconque des revendications précédentes, dans lequel L₈₁ est choisi dans l'ensemble constitué par :
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-bifluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosiloléylène, un groupe benzocarbazolylène, et un groupe dibenzo-carbazolylène ; et
un groupe phénylène, un groupe pentalénylène, un groupe indénylène, un groupe naphtylène, un groupe azulénylène, un groupe heptalénylène, un groupe indacénylène, un groupe acénaphtylène, un groupe fluorénylène, un groupe spiro-bifluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphtacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzimidazolylène, un groupe benzofuranylène, un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe dibenzosiloléylène, un groupe benzocarbazolylène, et un groupe dibenzo-carbazolylène, chacun substitué par au moins l'un choisi parmi le deutérium, -F, -Cl, -Br, -I, un groupe cyano, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), et -P(=O)(Q₃₁)(Q₃₂), et
chacun de Q₃₁ à Q₃₃ est indépendamment choisi parmi l'hydrogène, un groupe méthyle, un groupe éthyle, un groupe n-propyle, un groupe isopropyle, un groupe tert-butyle, un groupe phényle, un groupe biphényle, et un groupe terphényle.

4. Dispositif électroluminescent organique selon l'une quelconque des revendications précédentes, dans lequel R₈₁ est choisi dans l'ensemble constitué par :
un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent ;
un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₃₁)(Q₃₂), et -Si(Q₃₁)(Q₃₂)(Q₃₃) ; et
un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun substitué par au moins un substituant choisi parmi un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun de l'au moins un substituant étant substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₂₁)(Q₂₂), et -Si(Q₂₁)(Q₂₂)(Q₂₃) ; et
chacun de Q₂₁ à Q₂₃ et de Q₃₁ à Q₃₃ est indépendamment choisi parmi un groupe alkyle en C₁ à C₆₀ et un groupe aryle en C₆ à C₆₀.

5. Dispositif électroluminescent organique selon l'une quelconque des revendications 1 à 3, dans lequel R₈₁ est choisi parmi les groupes représentés par les formules 5-1 à 5-86 : 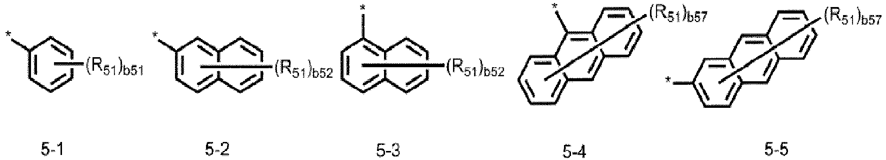 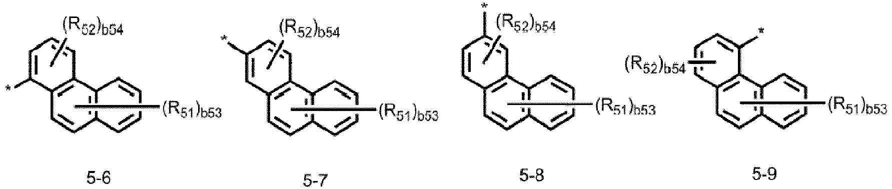 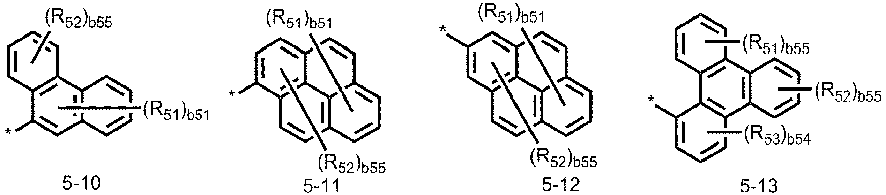 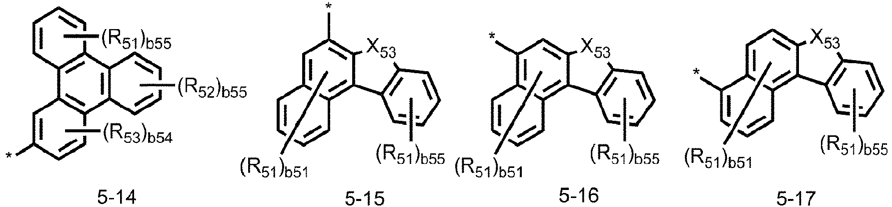 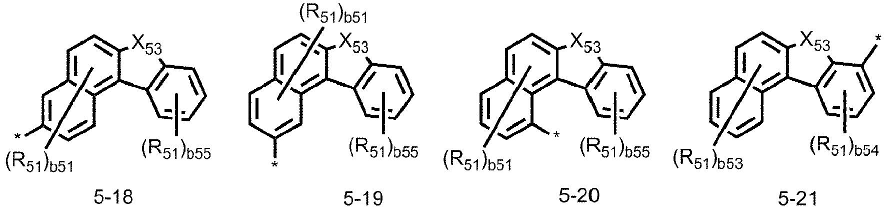 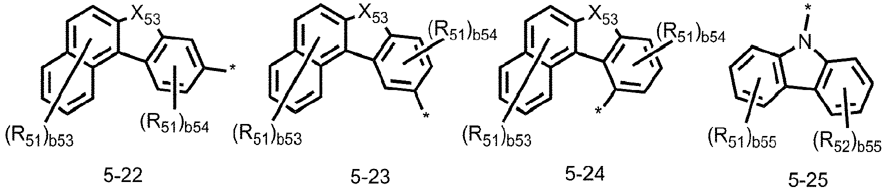 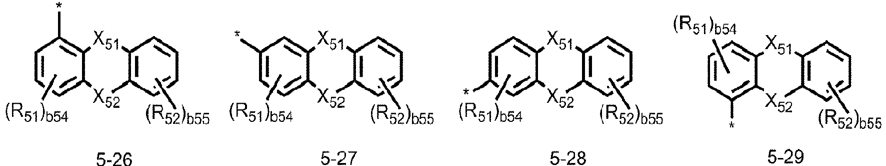 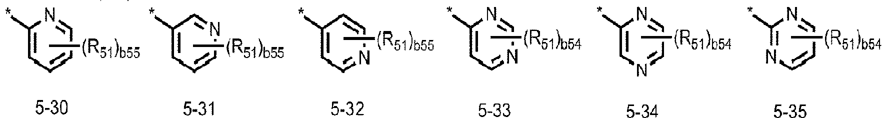 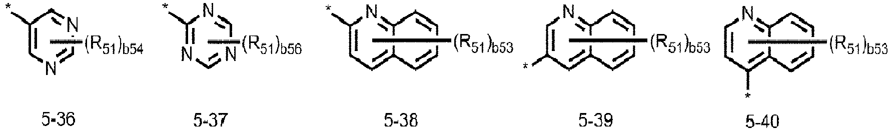 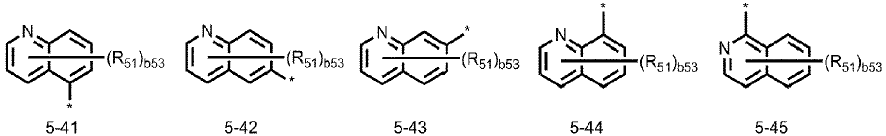 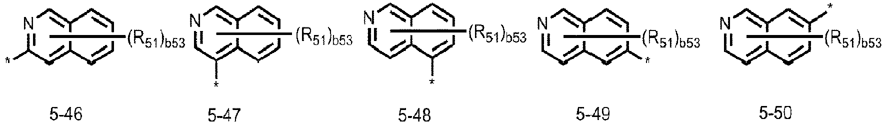 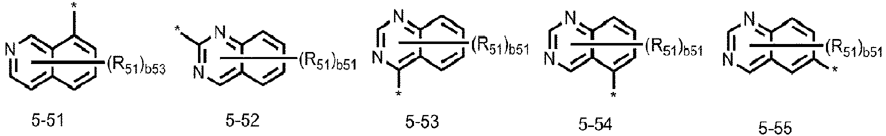 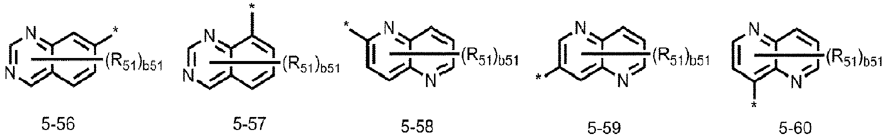 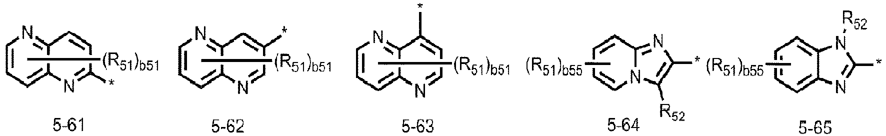 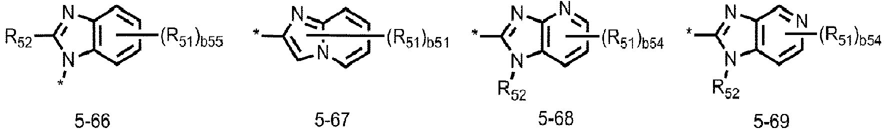 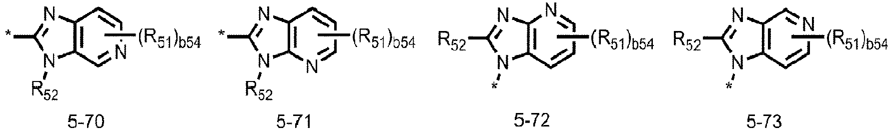 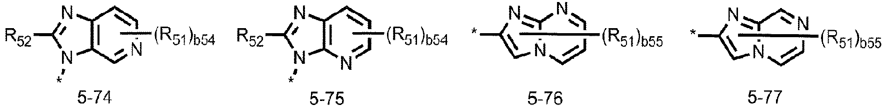 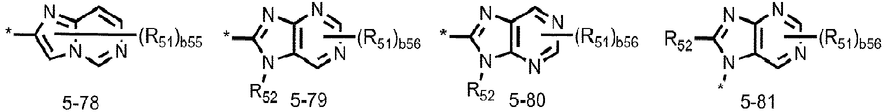 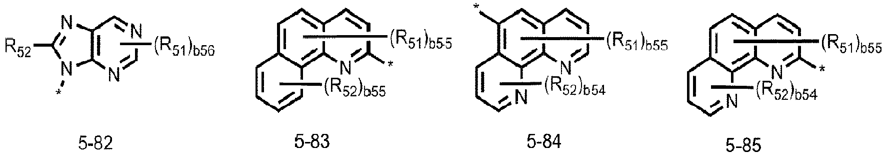 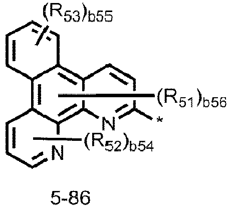 où, dans les formules 5-1 à 5-86,
X₅₁ est choisi parmi une liaison simple, N(R₅₄), C(R₅₄)(R₅₅), O, et S,
X₅₂ est choisi parmi N(R₅₆), C(R₅₆)(R₅₇), O, et S,
X₅₃ est C(R₅₈)(R₅₉),
chacun de R₅₁ à R₅₉ est indépendamment choisi dans l'ensemble constitué par :
l'hydrogène, le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₃₁)(Q₃₂), et -Si(Q₃₁)(Q₃₂)(Q₃₃) ; et
un groupe phényle, un groupe biphényle, un groupe terphényle, un groupe naphtyle, un groupe pyridinyle, un groupe pyrimidinyle, un groupe pyridazinyle, et un groupe triazinyle, chacun substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₂₁)(Q₂₂), et -Si(Q₂₁)(Q₂₂)(Q₂₃),
chacun de Q₂₁ à Q₂₃ et de Q₃₁ à Q₃₃ est indépendamment choisi parmi un groupe méthyle, un groupe éthyle, un groupe phényle, un groupe biphényle, un groupe terphényle, et un groupe naphtyle,
b₅₁ est choisi parmi 1, 2, 3, 4 et 5,
b₅₂ est choisi parmi 1, 2, 3, 4, 5, 6 et 7,
b₅₃ est choisi parmi 1, 2, 3, 4, 5 et 6,
b₅₄ est choisi parmi 1, 2 et 3,
b₅₅ est choisi parmi 1, 2, 3 et 4,
b₅₆ est choisi parmi 1 et 2,
b_{S7} est choisi parmi 1, 2, 3, 4, 5, 6, 7, 8 et 9, et
* indique un site de liaison à un atome voisin.

6. Dispositif électroluminescent organique selon l'une quelconque des revendications précédentes, dans lequel :
(a) A₂₁ est choisi parmi un groupe benzène, un groupe naphtalène, un groupe phénanthrène, un groupe pyrazine, un groupe triazine, un groupe quinoline, un groupe isoquinoline, un groupe quinoxaline, et un groupe quinazoline ; et/ou
(c) chacun de R₂₂, R₂₄ et R₂₆ est indépendamment choisi dans l'ensemble constitué par :
un groupe représenté par la formule 9, l'hydrogène, un groupe alkyle en C₁ à C₂₀, et un groupe cycloalkyle en C₃ à C₁₀ ;
un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent ;
un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun substitué par au moins l'un choisi parmi le deutérium, -F, -Cl, -Br, -I, un groupe alkyle en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₃₁ (Q₃₂), et -Si(Q₃₁) (Q₃₂) (Q₃₃) ; et
un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun substitué par au moins un substituant choisi parmi un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun de l'au moins un substituant étant substitué par au moins l'un choisi parmi le deutérium, -F, -Cl, -Br, -I, un groupe alkyle en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₂₁)(Q₂₂), et -Si (Q₂₁) (Q₂₂) (Q₂₃), sous réserve que R₂₆ ne soit pas un groupe anthracényle, pyridinyle ou pyrimidinyle, et
chacun de Q₂₁ à Q₂₃ et de Q₃₁ à Q₃₃ est indépendamment choisi parmi un groupe alkyle en C₁ à C₆₀ et un groupe aryle en C₆ à C₆₀,
où au moins l'un choisi parmi R₂₂, R₂₄ et R₂₆ est le groupe représenté par la formule 9.

7. Dispositif électroluminescent organique selon l'une quelconque des revendications précédentes, dans lequel L₉₁ est choisi dans l'ensemble constitué par :
un groupe phénylène, un groupe naphtylène, un groupe phénanthrénylène, un groupe triphénylénylène, un groupe pyrénylène, un groupe chrysénylène, un groupe pyrazinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène ; et
un groupe phénylène, un groupe naphtylène, un groupe phénanthrénylène, un groupe triphénylénylène, un groupe pyrénylène, un groupe chrysénylène, un groupe pyrazinylène, un groupe quinolinylène, un groupe isoquinolinylène, un groupe benzoquinolinylène, un groupe phtalazinylène, un groupe naphtyridinylène, un groupe quinoxalinylène, un groupe quinazolinylène, un groupe phénanthridinylène, un groupe acridinylène, un groupe phénanthrolinylène, et un groupe triazinylène, chacun substitué par au moins l'un choisi parmi le deutérium, -F, -Cl, -Br, -I, un groupe cyano, un groupe alkyle en C₁ à C₂₀, un groupe alkoxy en C₁ à C₂₀, un groupe cyclopentyle, un groupe cyclohexyle, un groupe cycloheptyle, un groupe cyclopentényle, un groupe cyclohexényle, un groupe phényle, un groupe biphényle, un groupe terphényle, un groupe pentalényle, un groupe indényle, un groupe naphtyle, un groupe azulényle, un groupe heptalényle, un groupe indacényle, un groupe acénaphtyle, un groupe fluorényle, un groupe spiro-bifluorényle, un groupe benzofluorényle, un groupe dibenzofluorényle, un groupe phénalényle, un groupe phénanthrényle, un groupe fluoranthényle, un groupe triphénylényle, un groupe pyrényle, un groupe chrysényle, un groupe naphtacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phtalazinyle, un groupe naphtyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, -Si (Q₃₁) (Q₃₂) (Q₃₃), -N(Q₃₁) (Q₃₂), -B(Q₃₁) (Q₃₂), -C(=O) (Q₃₁), -S(=O)₂ (Q₃₁) , et -P(=O) (Q₃₁) (Q₃₂), et
chacun de Q₃₁ à Q₃₃ est indépendamment choisi parmi l'hydrogène, un groupe méthyle, un groupe éthyle, un groupe n-propyle, un groupe isopropyle, un groupe tert-butyle, un groupe phényle, un groupe biphényle, et un groupe terphényle.

8. Dispositif électroluminescent organique selon l'une quelconque des revendications précédentes, dans lequel R₉₁ est choisi dans l'ensemble constitué par :
un groupe aryle en C₆ à C₆₀ et un groupe hétéroaryle en C₁ à C₆₀ ;
un groupe aryle en C₆ à C₆₀ et un groupe hétéroaryle en C₁ à C₆₀, chacun substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₃₁) (Q₃₂), et -Si(Q₃₁) (Q₃₂) (Q₃₃) ; et
un groupe aryle en C₆ à C₆₀ et un groupe hétéroaryle en C₁ à C₆₀, chacun substitué par au moins un substituant choisi parmi un groupe aryle en C₆ à C₆₀, un groupe hétéroaryle en C₁ à C₆₀, un groupe polycyclique en C₈ à C₆₀ condensé non aromatique monovalent, et un groupe hétéropolycyclique à 8 à 60 chaînons condensé non aromatique monovalent, chacun de l'au moins un substituant étant substitué par au moins l'un choisi parmi le deutérium, -F, -Cl, -Br, -I, un groupe alkyle en C₁ à C₂₀, un groupe alkoxy en C₁ à C₂₀, un groupe cycloalkyle en C₃ à C₁₀, un groupe aryle en C₆ à C₆₀, un groupe hétéroaryle en C₁ à C₆₀, un groupe polycyclique en C₈ à C₆₀ condensé non aromatique monovalent, un groupe hétéropolycyclique à 8 à 60 chaînons condensé non aromatique monovalent, -N(Q₂₁) (Q₂₂), et -Si(Q₂₁) (Q₂₂₎ (Q₂₃), sous réserve que R₉₁ ne soit pas un groupe anthracényle, pyridinyle ou pyrimidinyle, et
chacun de Q₂₁ à Q₂₃ et de Q₃₁ à Q₃₃ est indépendamment choisi parmi un groupe alkyle en C₁ à C₆₀ et un groupe aryle en C₆ à C₆₀.

9. Dispositif électroluminescent organique selon la revendication 8, dans lequel R₉₁ est choisi parmi les groupes représentés par les formules 5-1 à 5-3, 5-6 à 5-14, 5-37 à 5-63, et 5-83 à 5-86, où les formules 5-1 à 5-3, 5-6 à 5-14, 5-37 à 5-63, et 5-83 à 5-86 sont telles que définies dans la revendication 5.

10. Dispositif électroluminescent organique selon la revendication 1, dans lequel le premier composé représenté par l'une choisie parmi les formules 1-14a à 1-14g est choisi parmi les composés B-101 à B-205, et le deuxième composé représenté par la formule 2 est choisi parmi les composés E-1 à E-20, E-25 à E-36, E-41 à E-52, E-113 à E-115, E-117 à E-122, E-124, E-128, E-129, E-131 à E-134, E-154 à E-169, E-201 à E-203, E-205 à E-210, E-212, E-216, E-218 à E-221, E-226 à E-233, E-237 à E-242 :

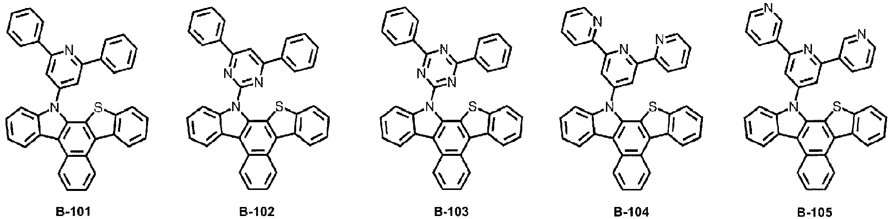

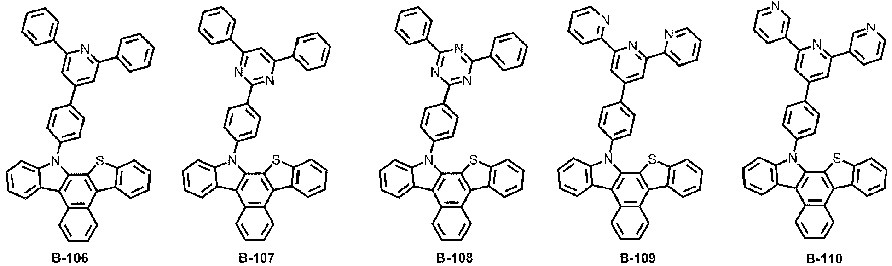

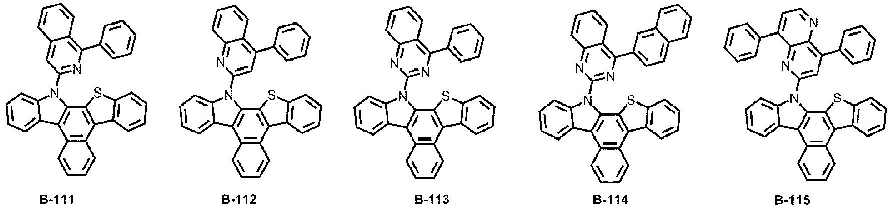

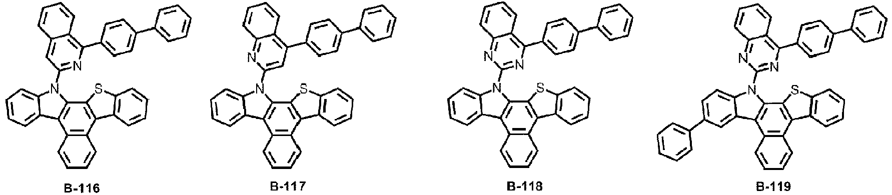

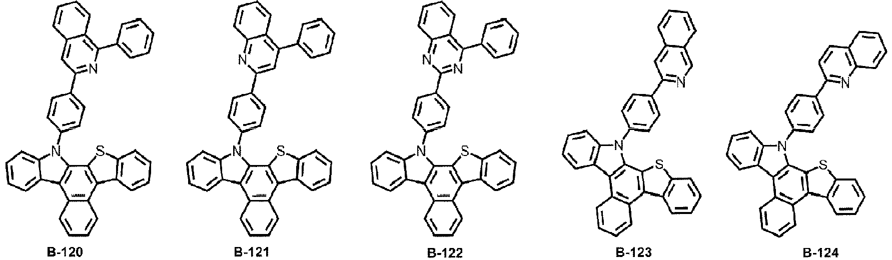

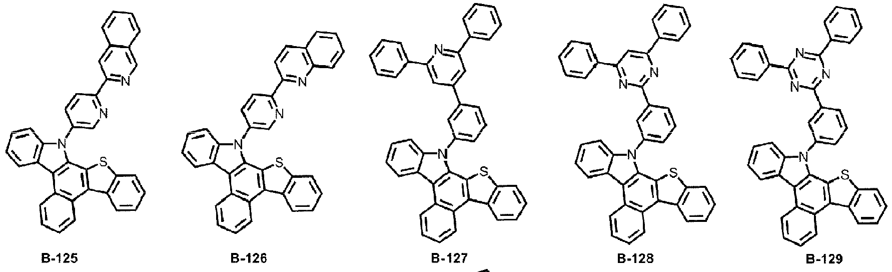

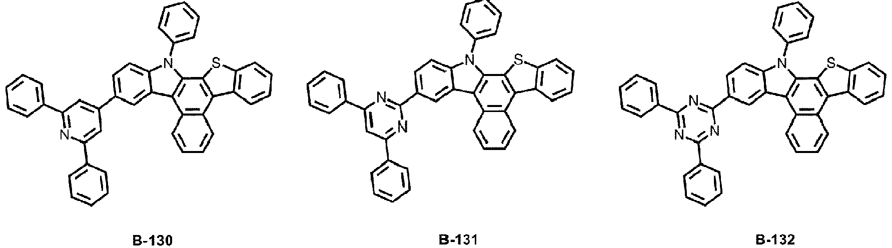

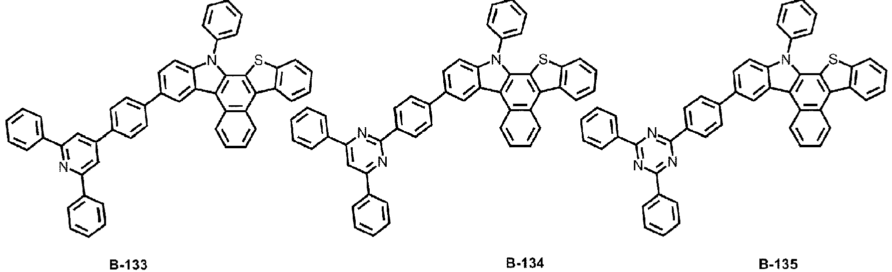

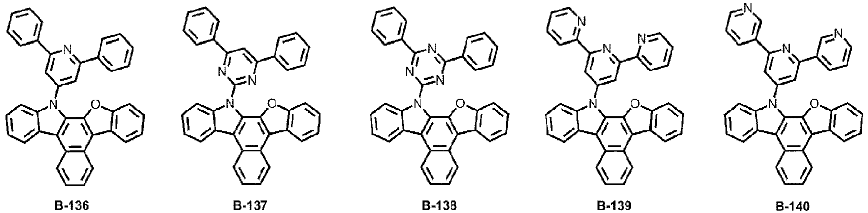

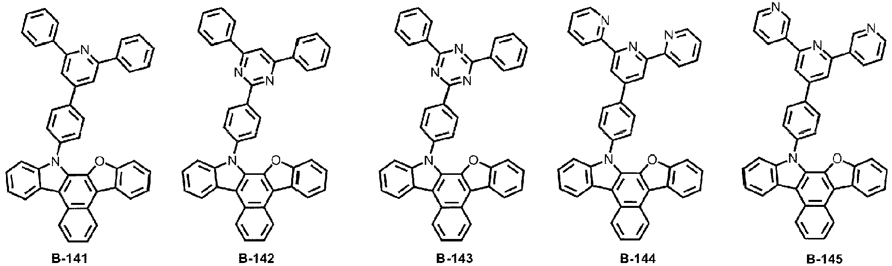

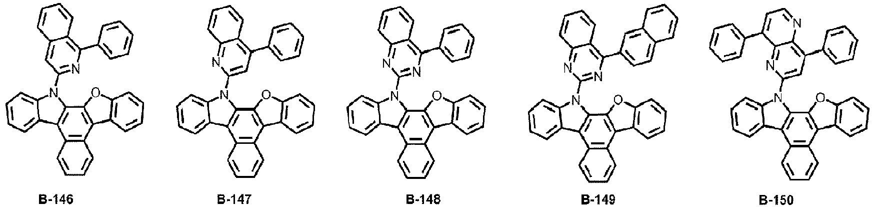

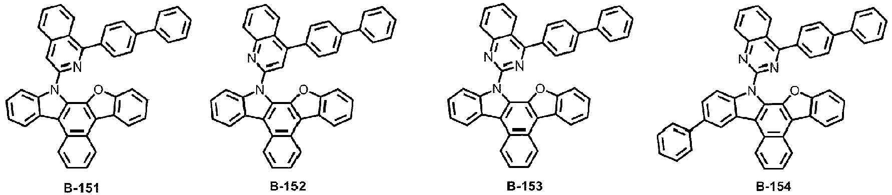

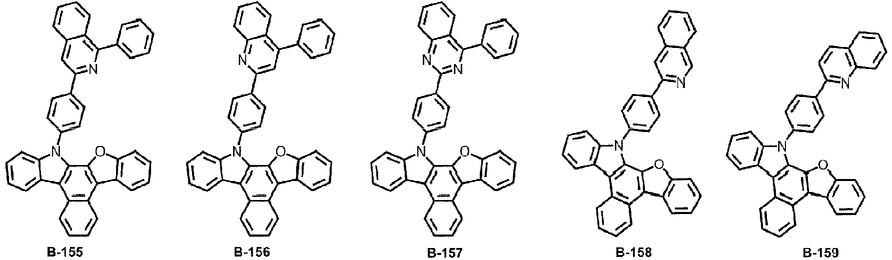

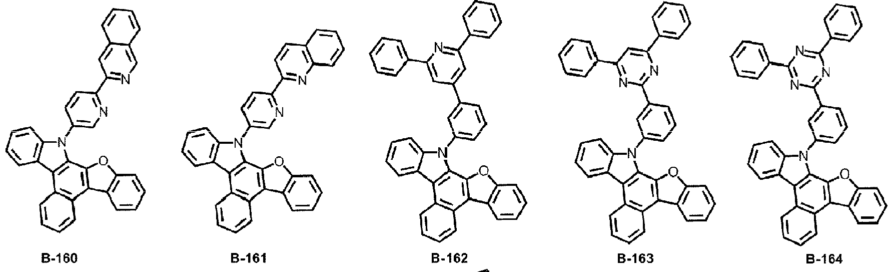

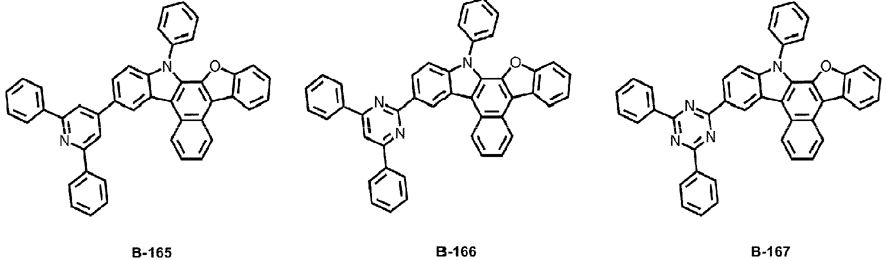

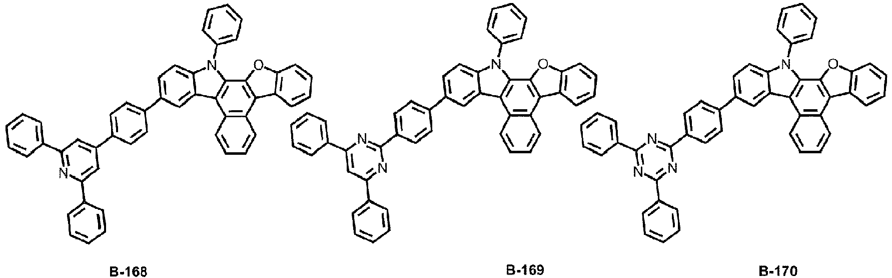

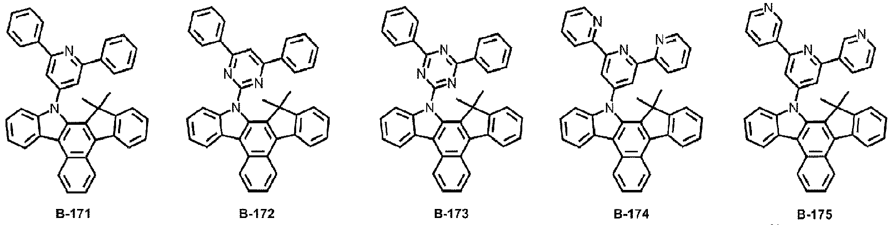

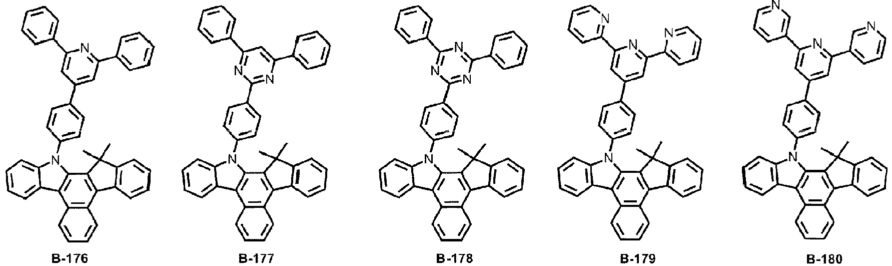

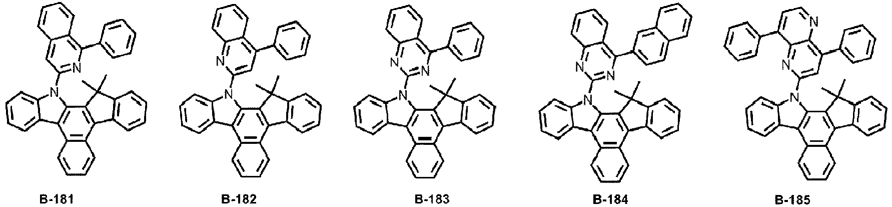

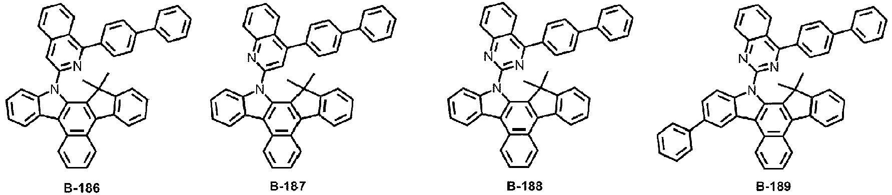

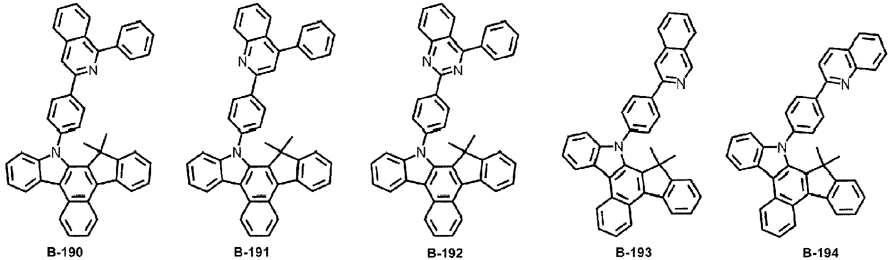

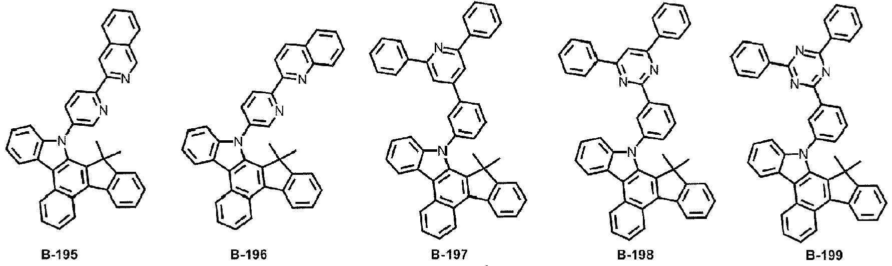

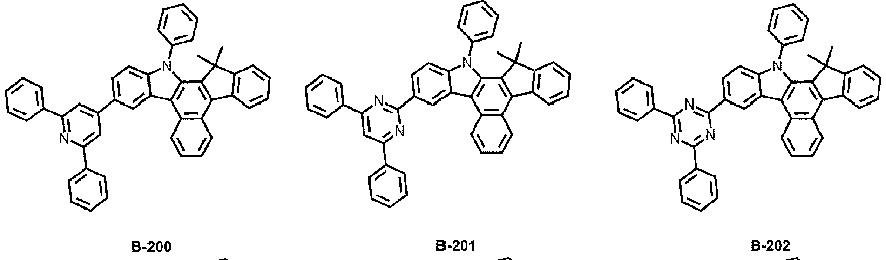

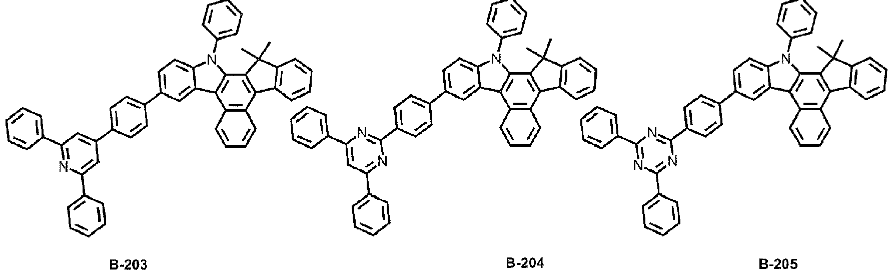

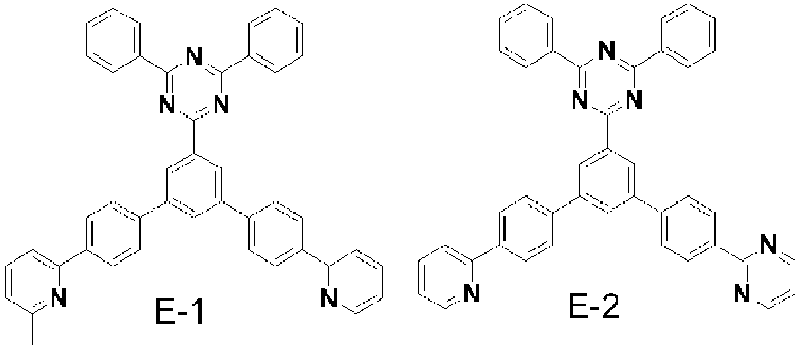

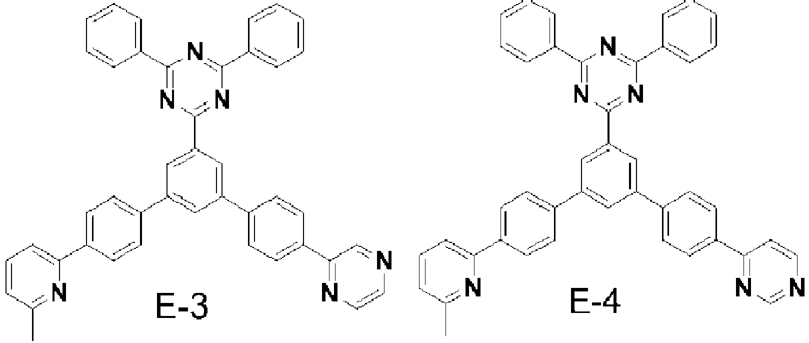

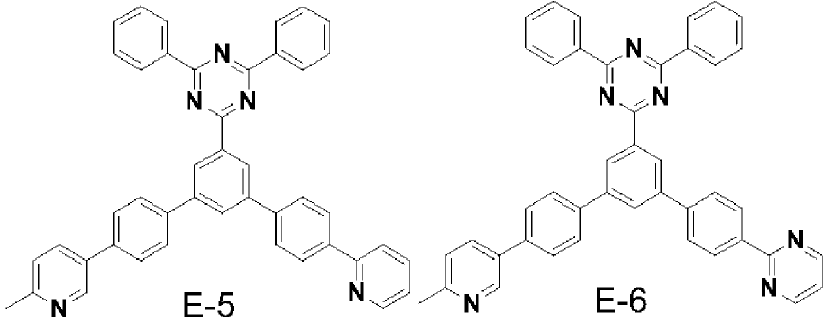

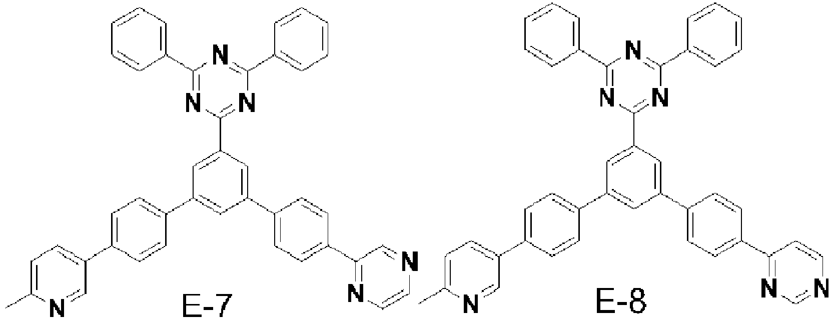

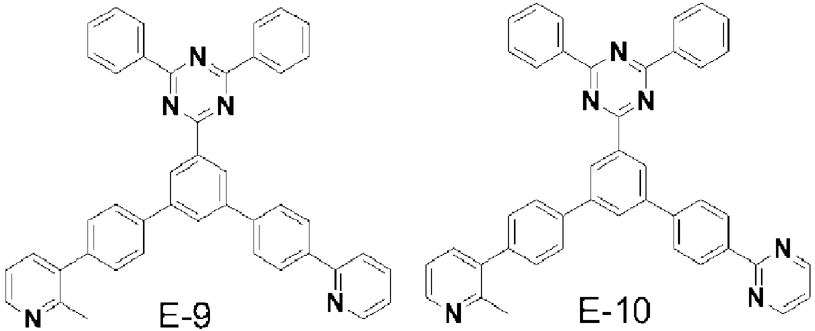

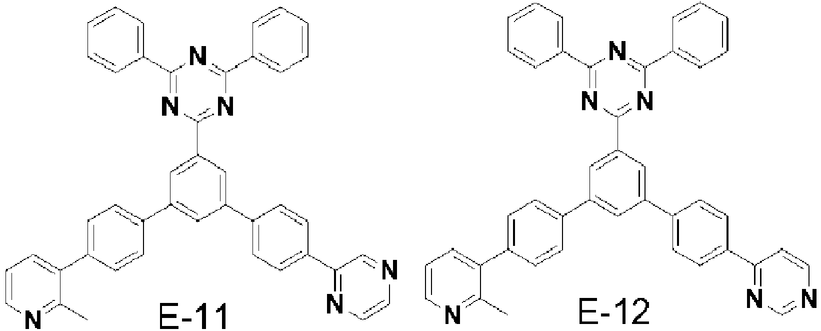

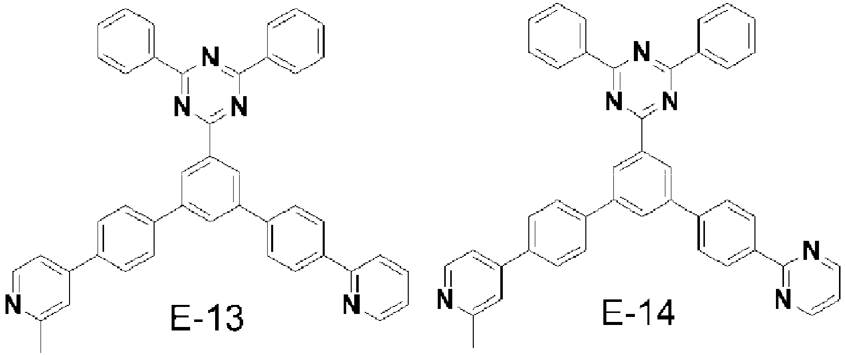

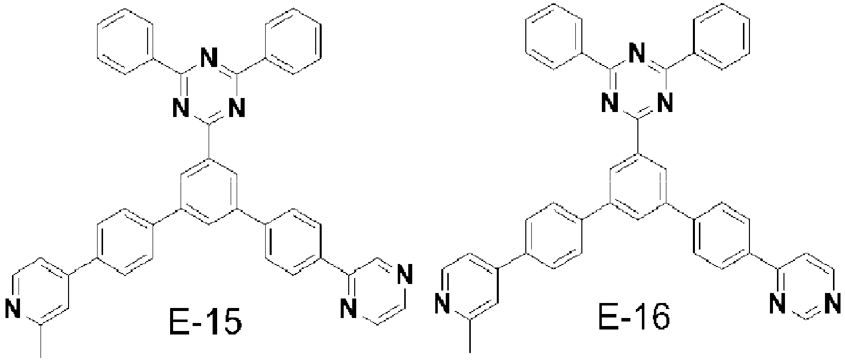

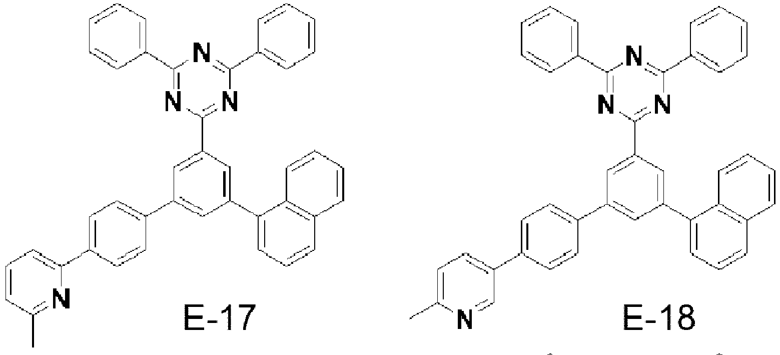

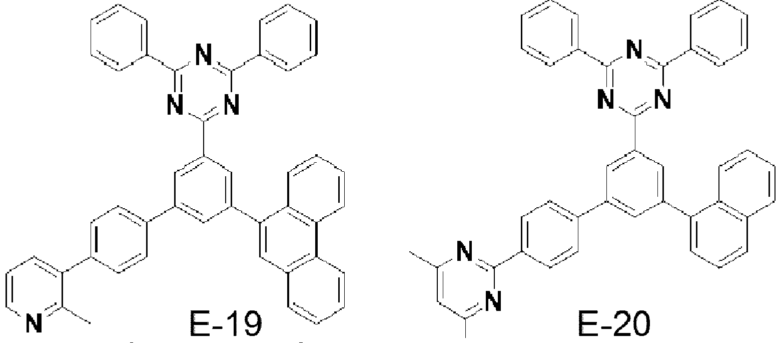

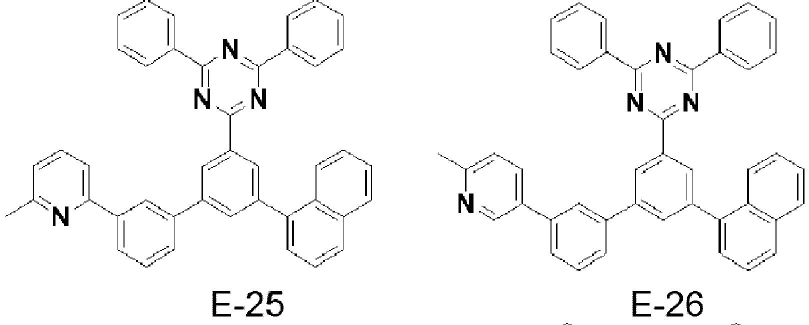

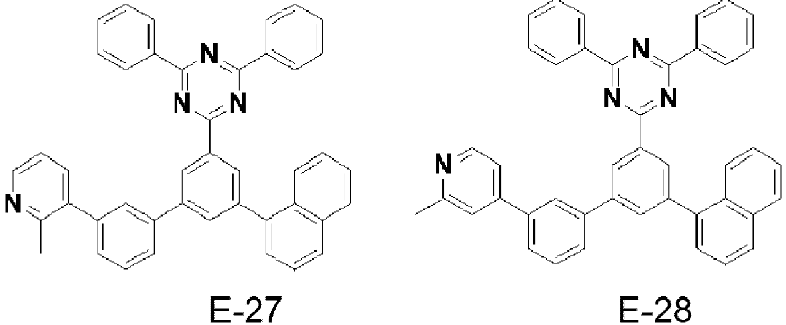

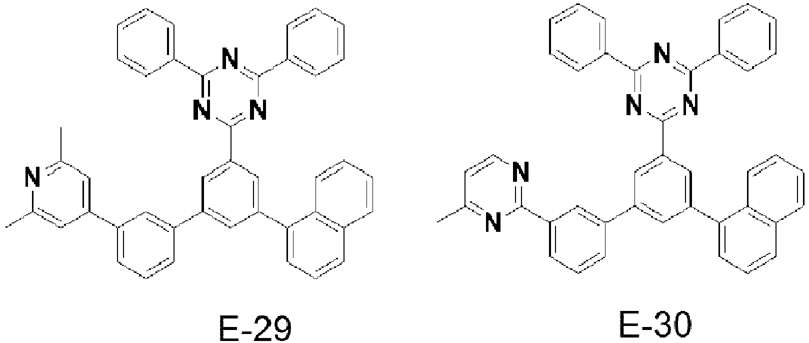

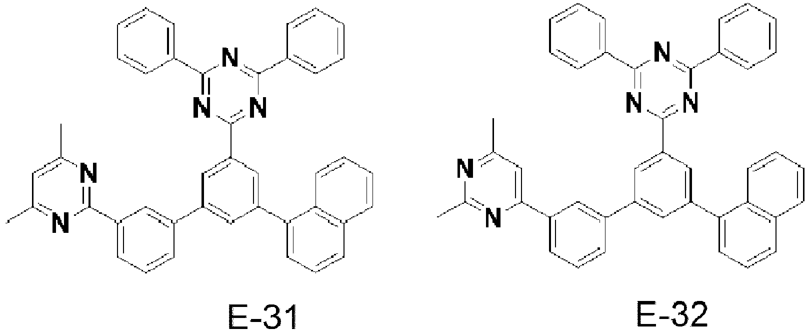

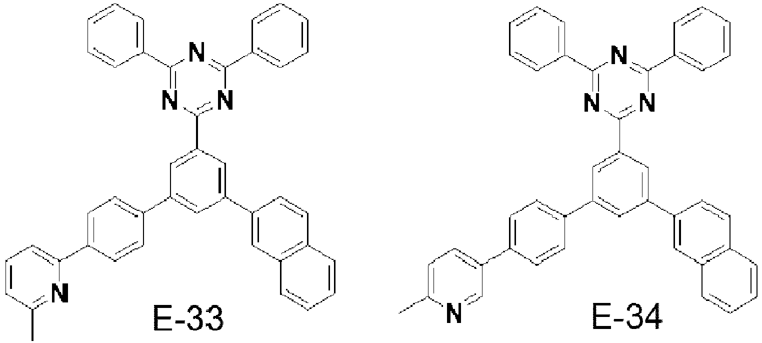

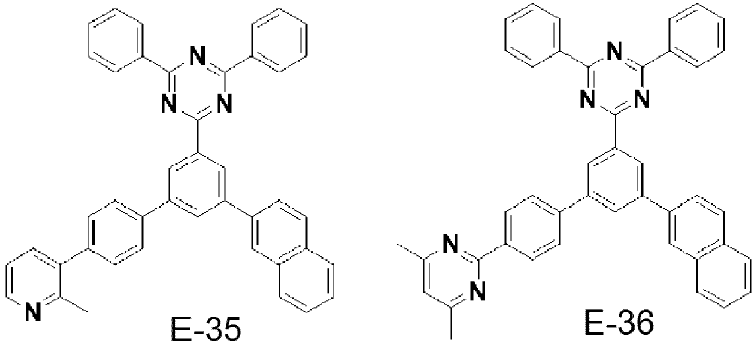

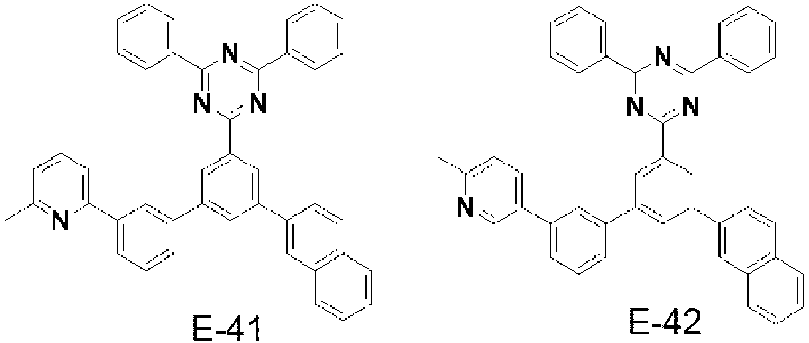

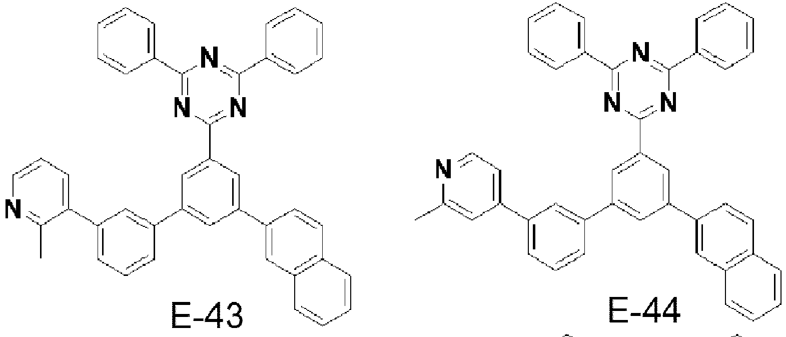

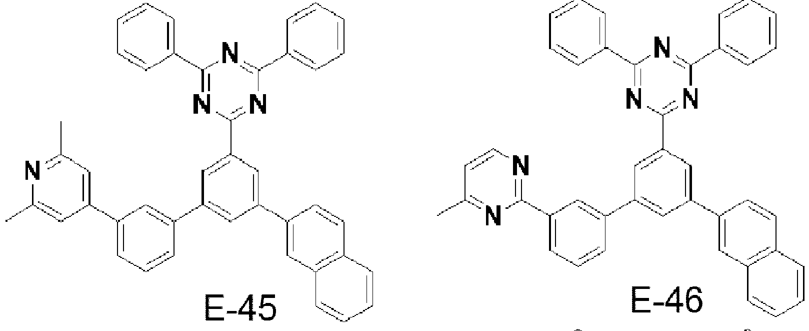

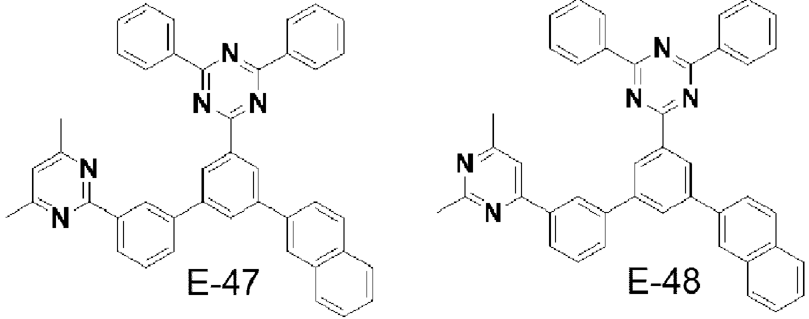

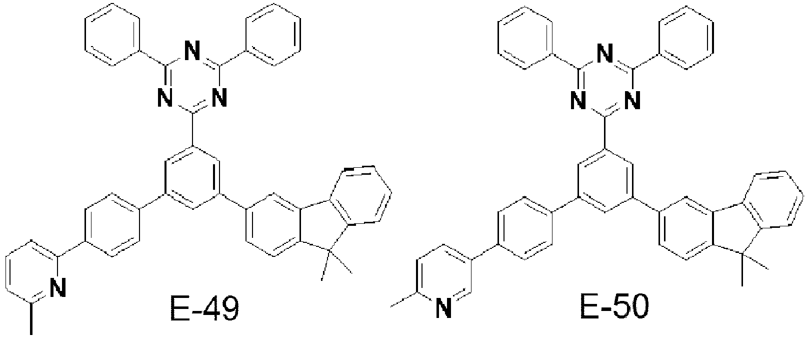

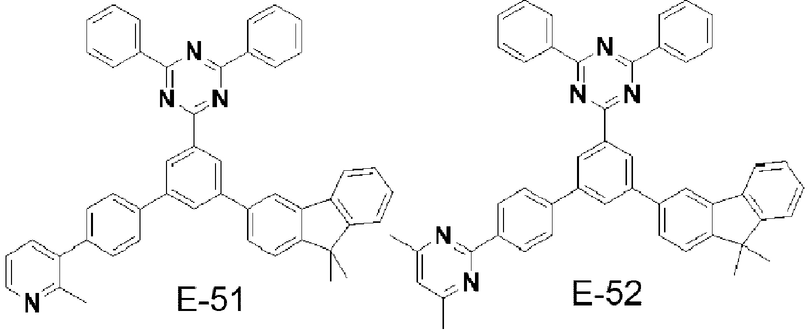

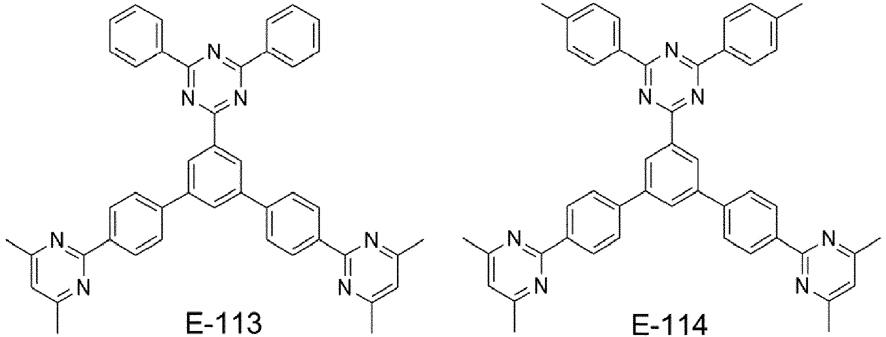

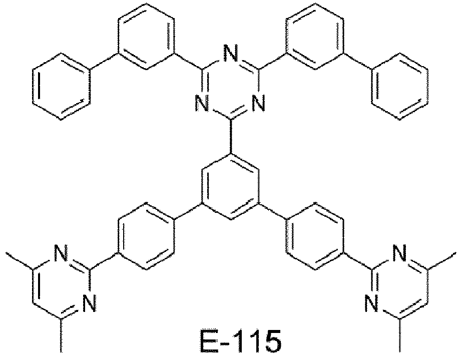

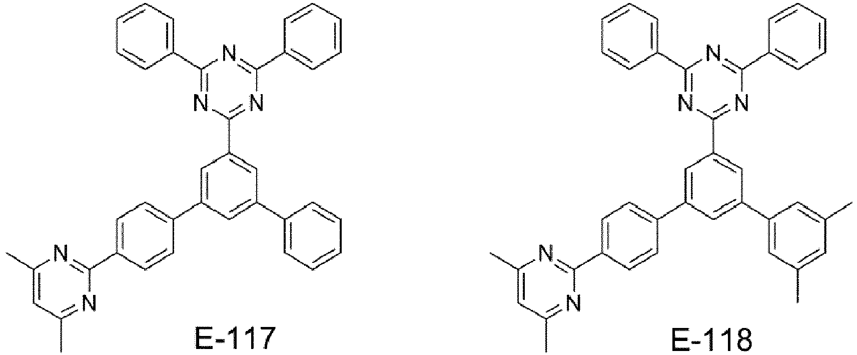

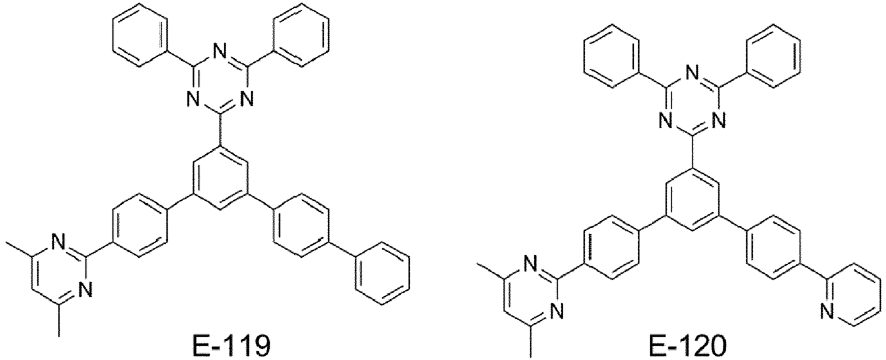

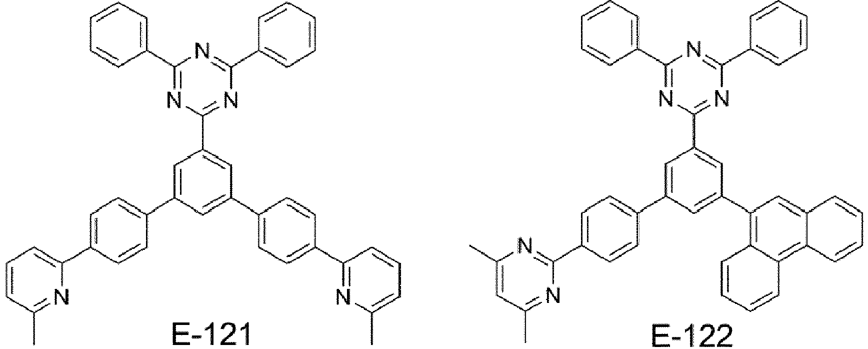

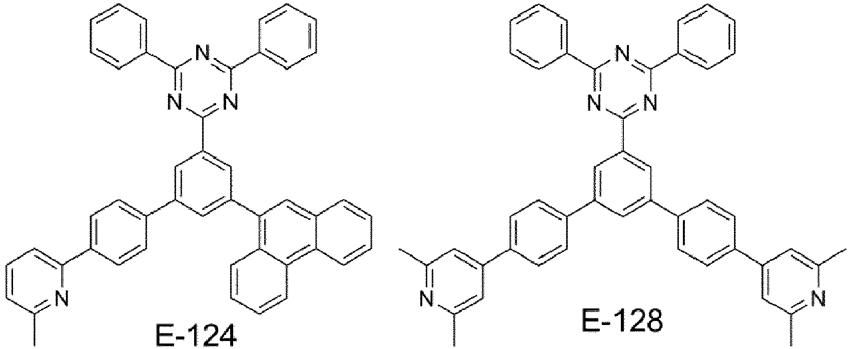

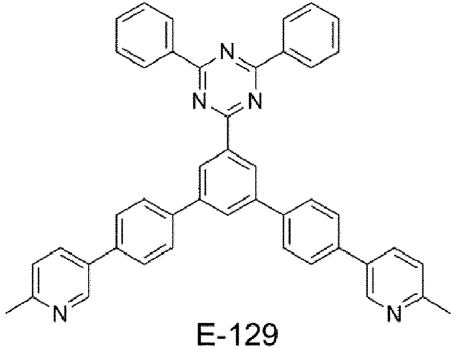

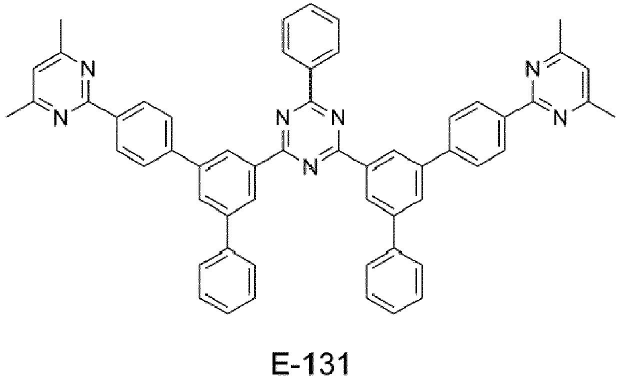

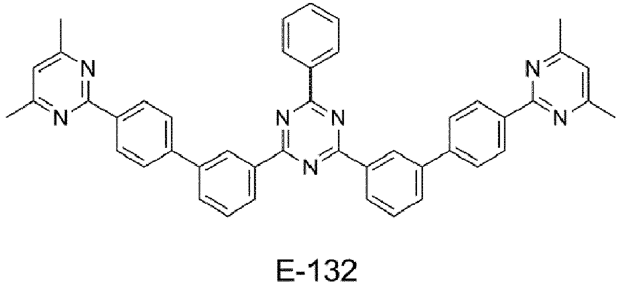

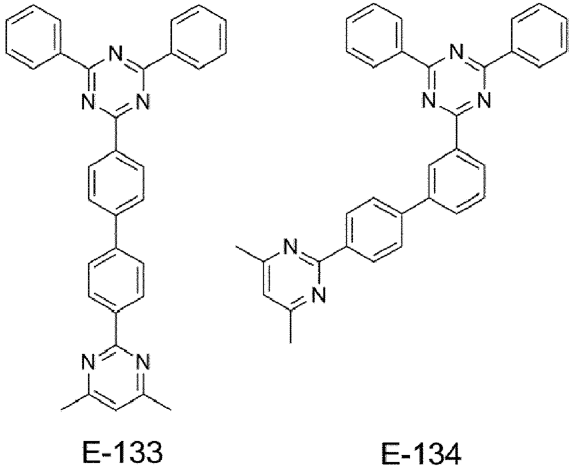

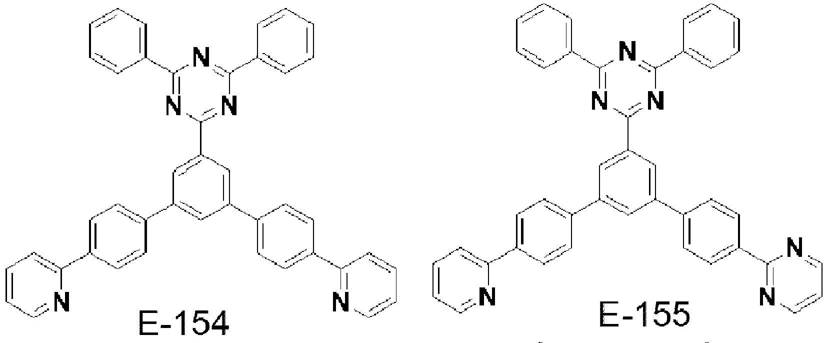

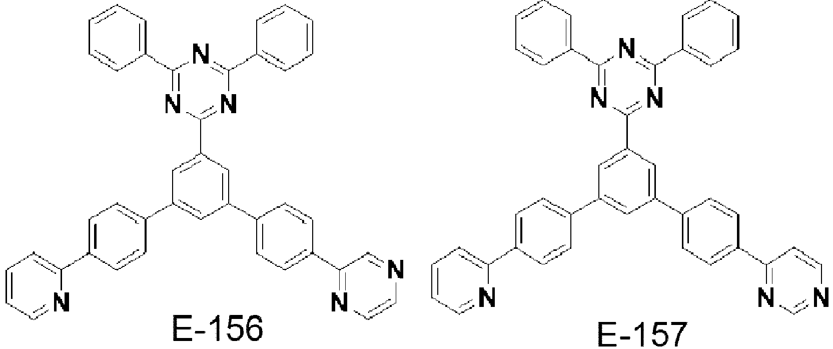

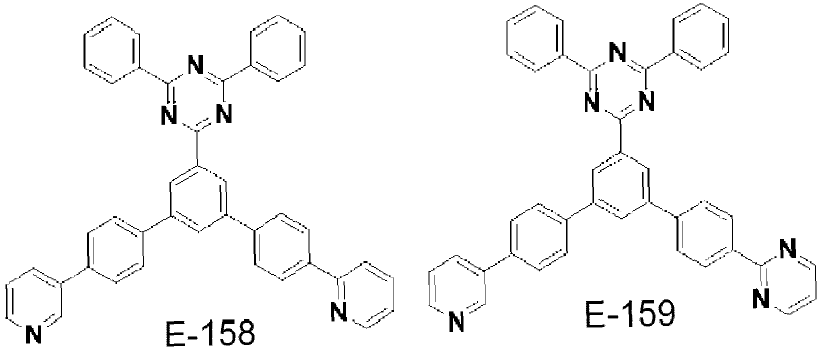

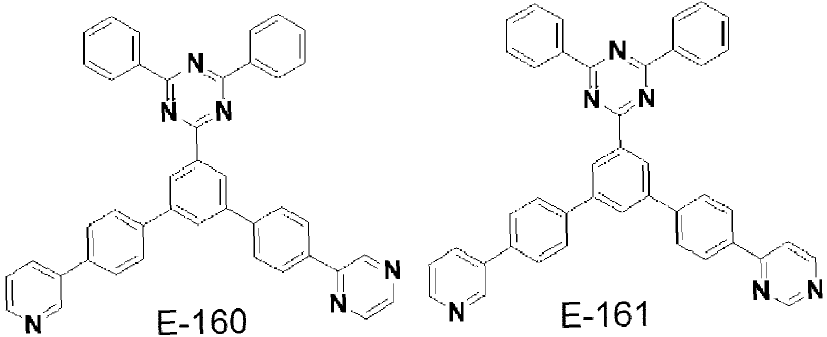

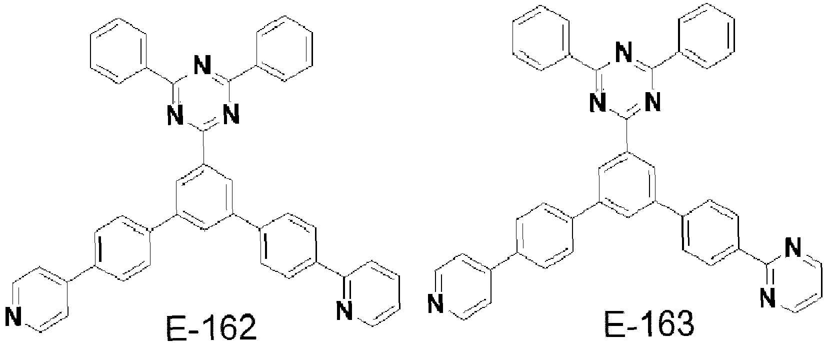

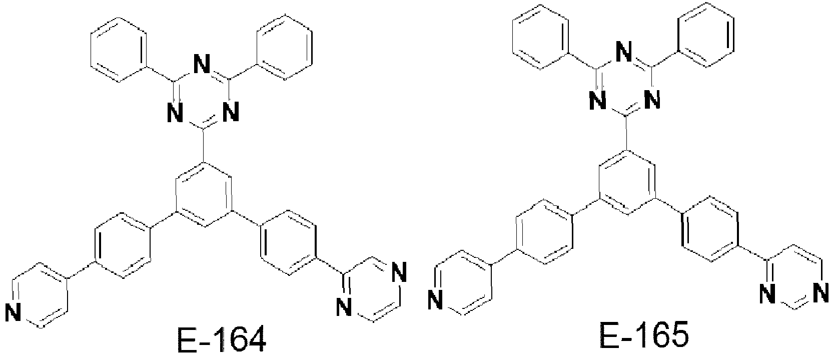

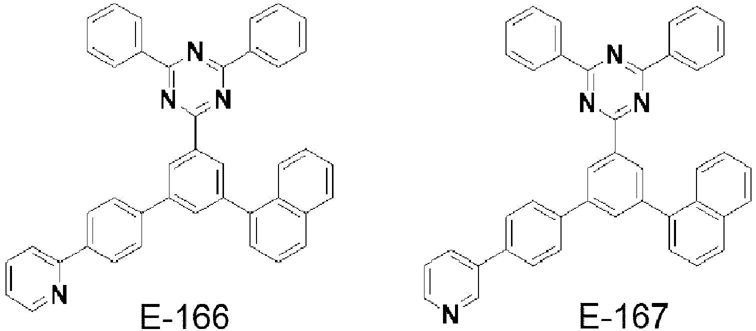

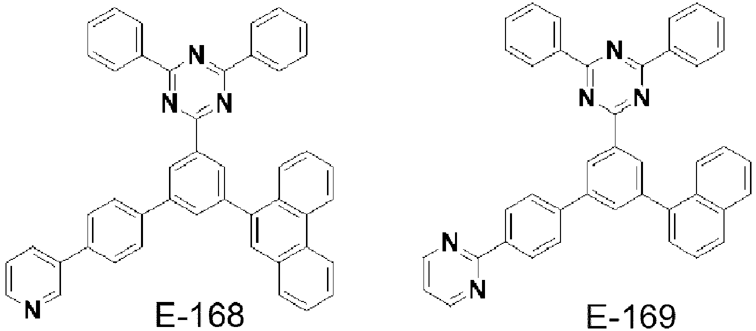

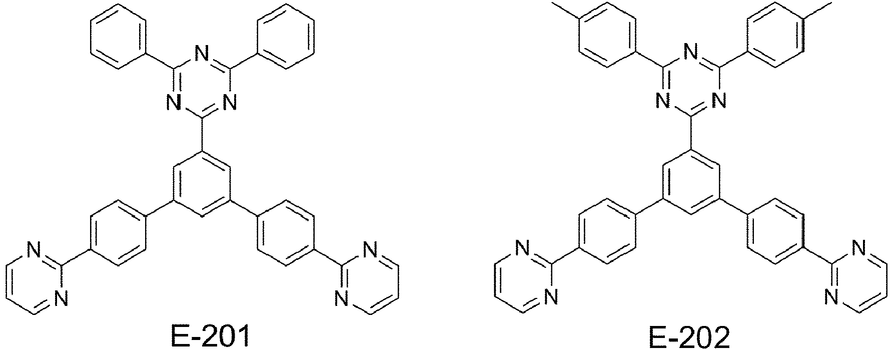

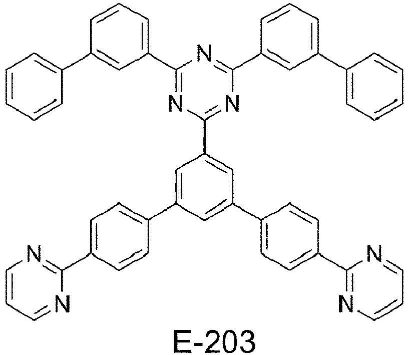

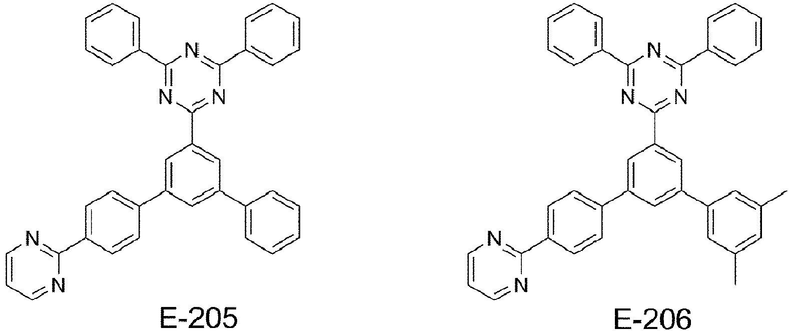

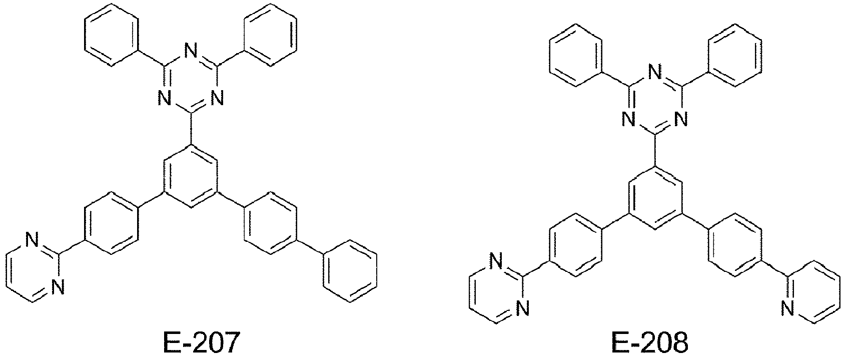

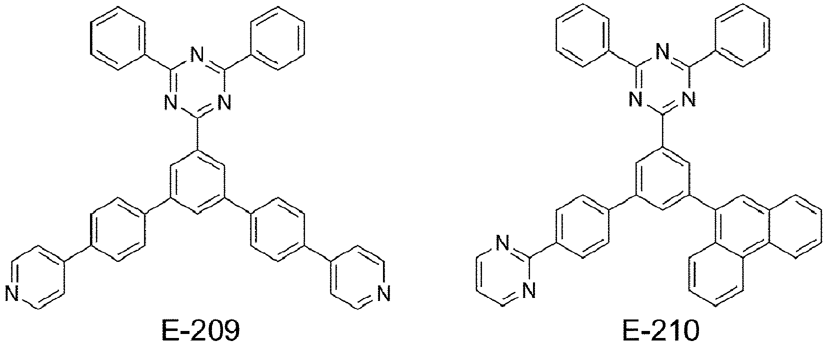

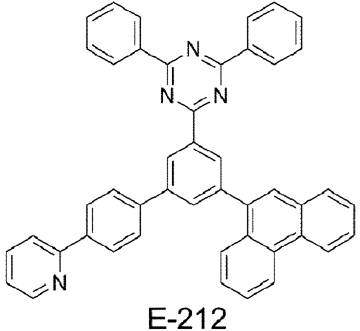

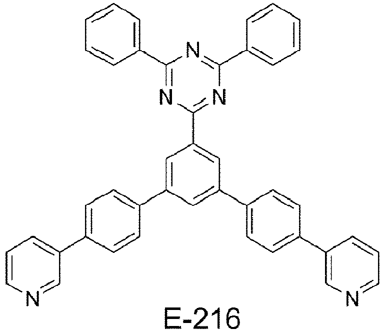

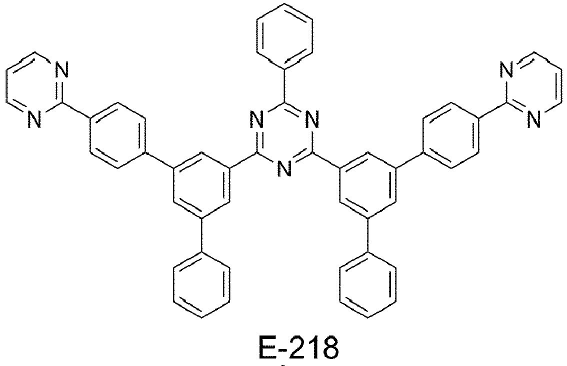

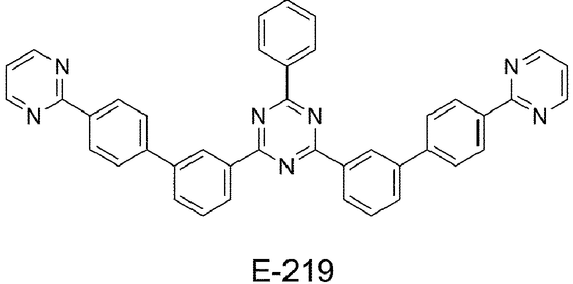

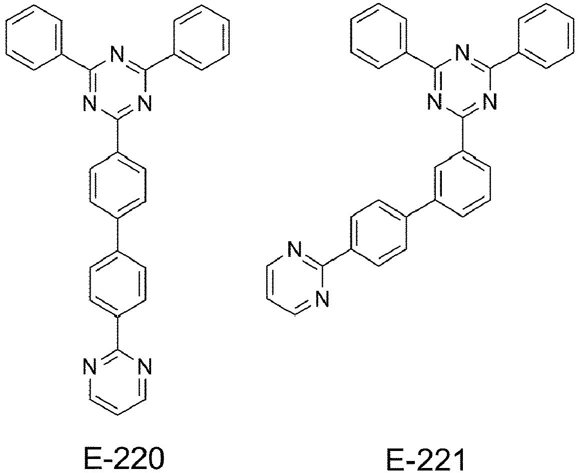

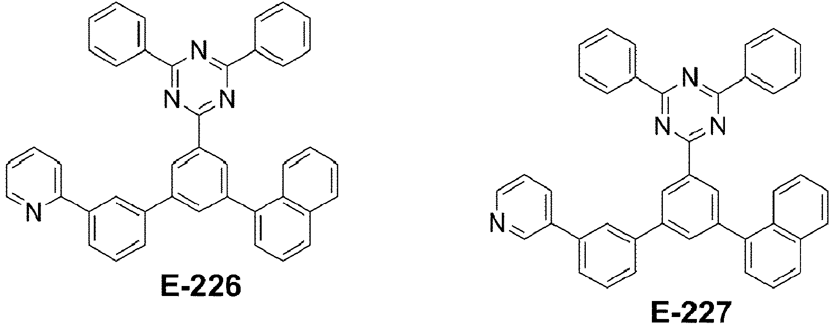

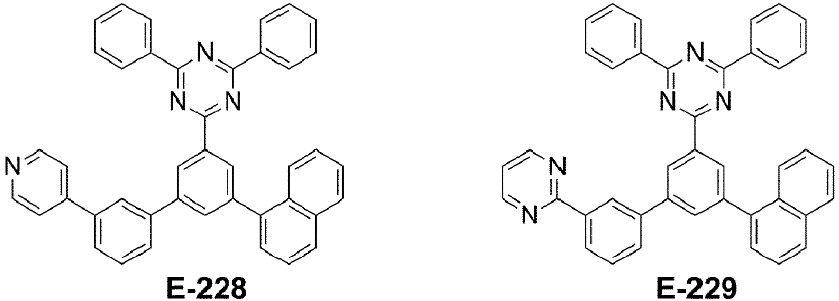

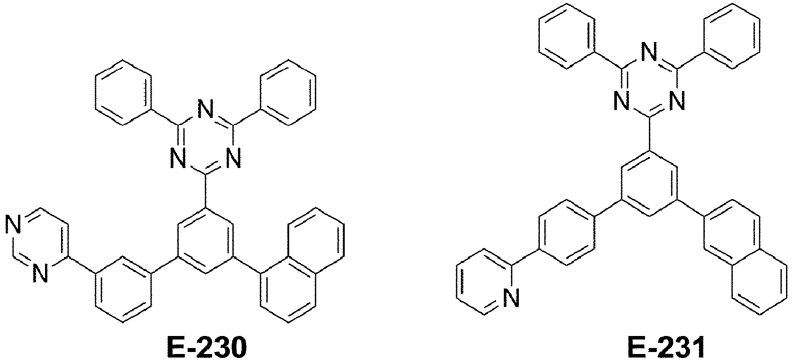

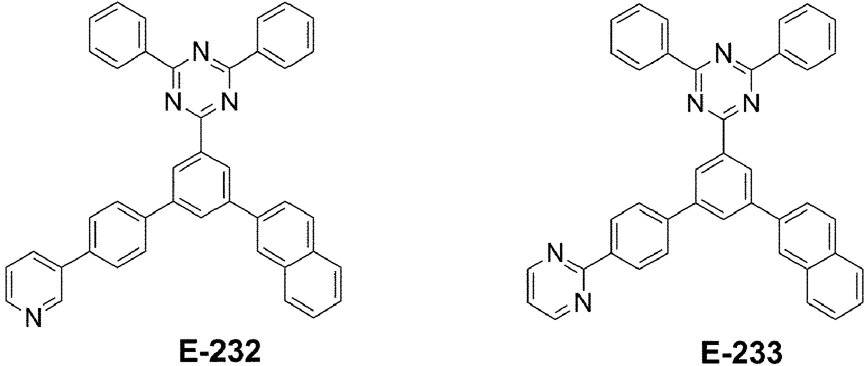

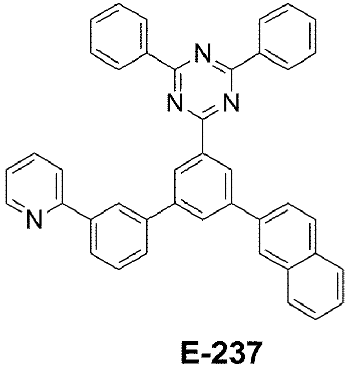

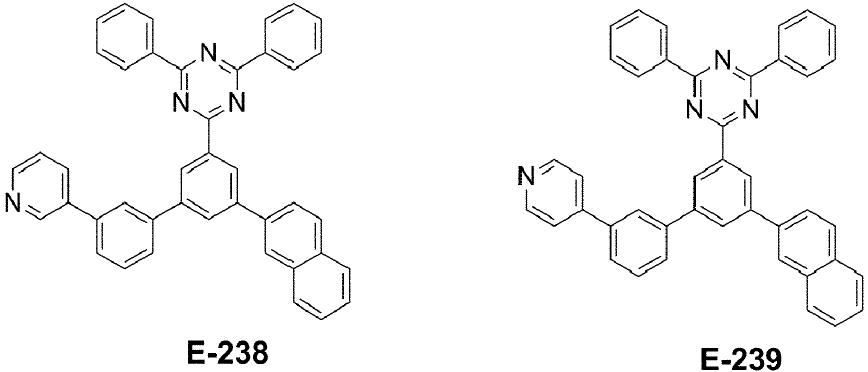

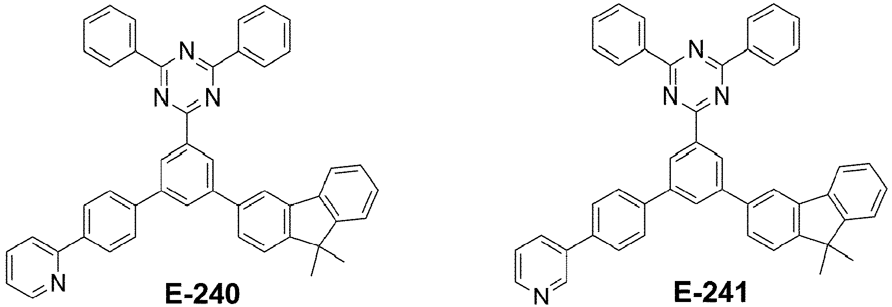

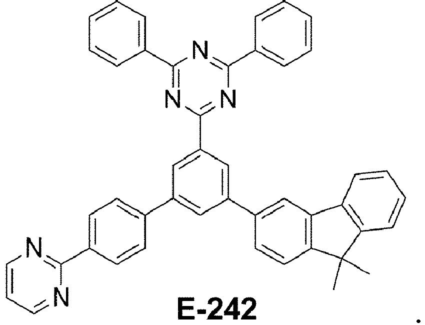

11. Dispositif électroluminescent organique selon l'une quelconque des revendications précédentes, dans lequel
la couche d'émission comprend en outre un dopant, et le dopant est un complexe organométallique représenté par la formule 401 :
formule 401 M(L₄₀₁)ₓₑ₁(L₄₀₂)ₓₑ₂
dans laquelle L₄₀₁ est un ligand représenté par la formule 402, 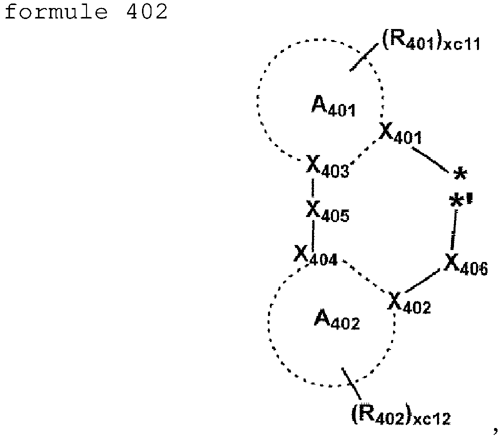 où, dans les formules 401 et 402,
M est choisi parmi l'iridium (Ir), le platine (Pt), le palladium (Pd), l'osmium (Os), le titane (Ti), le zirconium (Zr), le hafnium (Hf), l'europium (Eu), le terbium (Tb), le rhodium (Rh), et le thulium (Tm),
xc1 vaut 1, 2 ou 3 et, quand xc1 vaut deux ou plus de deux, deux ou plus de deux L₄₀₁ sont identiques ou différents,
L₄₀₂ est un ligand organique,
xc2 est un entier choisi parmi 0 à 4 et, quand xc2 vaut deux ou plus de deux, deux ou plus de deux L₄₀₂ sont identiques ou différents,
chacun de X₄₀₁ à X₄₀₄ est indépendamment l'azote ou le carbone,
X₄₀₁ et X₄₀₃ sont liés l'un à l'autre via une liaison simple ou une double liaison, et X₄₀₂ et X₄₀₄ sont liés l'un à l'autre via une liaison simple ou une double liaison,
chacun de A₄₀₁ et A₄₀₂ est indépendamment un groupe carbocyclique en C₅ à C₆₀ ou un groupe hétérocyclique en C₁ à C₆₀,
X₄₀₅ est une liaison simple, -O-, -S-, -C(=O)-, -N(Q₄₁₁)-, -C(Q₄₁₁)(Q₄₁₂)-, -C(Q₄₁₁)=C(Q₄₁₂)-, -C(Q₄₁₁)=, ou =C(Q₄₁₁) =, où chacun de Q₄₁₁ et Q₄₁₂ est indépendamment l'hydrogène, le deutérium, un groupe alkyle en C₁ à C₂₀, un groupe alkoxy en C₁ à C₂₀, un groupe phényle, un groupe biphényle, un groupe terphényle, ou un groupe naphtyle,
X₄₀₆ est une liaison simple, O, ou S,
chacun de R₄₀₁ et R₄₀₂ est indépendamment choisi parmi l'hydrogène, le deutérium, -F, -Cl, -Br, -I, -CD₃, -CF₃, un groupe hydroxyle, un groupe cyano, un groupe nitro, un groupe amidino, un groupe hydrazino, un groupe hydrazono, un groupe alkyle en C₁ à C₂₀ substitué ou non substitué, un groupe alkoxy en C₁ à C₂₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe polycyclique en C₈ à C₆₀ condensé non aromatique monovalent substitué ou non substitué, ou un groupe hétéropolycyclique à 8 à 60 chaînons condensé non aromatique monovalent substitué ou non substitué, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), et -P(=O)(Q₄₀₁)(Q₄₀₂), où chacun de Q₄₀₁ à Q₄₀₃ est indépendamment choisi parmi un groupe alkyle en C₁ à C₁₀, un groupe alkoxy en C₁ à C₁₀, un groupe aryle en C₆ à C₂₀, et un groupe hétéroaryle en C₁ à C₂₀,
chacun de xc11 et xc12 est indépendamment un entier de 0 à 10, et
chacun de * et *' dans la formule 402 est indépendamment un site de liaison à M dans la formule 401.
